(19) Europäisches Patentamt
European Patent Office
Office européen des brevets

(11) EP 3 800 678 B1

(12) EUROPEAN PATENT SPECIFICATION

(45) Date of publication and mention of the grant of the patent:
**29.05.2024 Bulletin 2024/22**

(21) Application number: **20181652.7**

(22) Date of filing: **23.06.2020**

(51) International Patent Classification (IPC):
***C07D 487/00*** *(2006.01)* ***C07F 15/00*** *(2006.01)*
***H10K 50/12*** *(2023.01)* ***H10K 85/30*** *(2023.01)*
***H10K 85/60*** *(2023.01)* *H10K 59/10* *(2023.01)*

(52) Cooperative Patent Classification (CPC):
**H10K 85/631; H10K 50/121; H10K 85/342; H10K 85/346; H10K 85/654; H10K 85/656; H10K 85/657; H10K 85/6572; H10K 85/6574;**
H10K 59/10; H10K 2101/20; H10K 2101/90

# (54) ORGANIC LIGHT-EMITTING DEVICE AND APPARATUS INCLUDING THE SAME

ORGANISCHE LICHTEMITTIERENDE VORRICHTUNG UND EINRICHTUNG DAMIT

DISPOSITIF ÉLECTROLUMINESCENT ET APPAREIL LE COMPRENANT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **04.10.2019 KR 20190123353**

(43) Date of publication of application:
**07.04.2021 Bulletin 2021/14**

(73) Proprietor: **Samsung Display Co., Ltd.**
**Yongin-si**
**Gyeonggi-do**
**17113 (KR)**

(72) Inventors:
- **KIM, Hyunyoung**
  **Yongin-si Gyeonggi-do 17113 (KR)**
- **CHOI, Youngeun**
  **Yongin-si Gyeonggi-do 17113 (KR)**
- **KIM, Minje**
  **Yongin-si Gyeonggi-do 17113 (KR)**
- **KIM, Eungdo**
  **Yongin-si Gyeonggi-do 17113 (KR)**
- **KIM, Hyojeong**
  **Yongin-si Gyeonggi-do 17113 (KR)**
- **SHIN, Hyosup**
  **Yongin-si Gyeonggi-do 17113 (KR)**
- **YOON, Seokgyu**
  **Yongin-si Gyeonggi-do 17113 (KR)**
- **LEE, Youngki**
  **Yongin-si Gyeonggi-do 17113 (KR)**
- **LEE, Jungsub**
  **Yongin-si Gyeonggi-do 17113 (KR)**
- **LEE, Jiyoung**
  **Yongin-si Gyeonggi-do 17113 (KR)**
- **JUNG, Hyejin**
  **Yongin-si Gyeonggi-do 17113 (KR)**
- **CHO, Kunwook**
  **Yongin-si Gyeonggi-do 17113 (KR)**
- **CHO, Hyeongu**
  **Yongin-si Gyeonggi-do 17113 (KR)**
- **CHOI, Minsoo**
  **Yongin-si Gyeonggi-do 17113 (KR)**
- **LYU, Jaejin**
  **Yongin-si Gyeonggi-do 17113 (KR)**

(74) Representative: **Marks & Clerk LLP**
**15 Fetter Lane**
**London EC4A 1BW (GB)**

(56) References cited:
**EP-A1- 3 800 679**
**WO-A1-2019/128105**
**US-A1- 2017 346 029**
**US-A1- 2018 033 987**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

## BACKGROUND

### 1. Field

One or more embodiments relate to an organic light-emitting device and an apparatus including the same.

### 2. Description of Related Art

Organic light-emitting devices are self-emission devices that produce full-color images, and also have wide viewing angles, high contrast ratios, short response times, as well as suitable (e.g., excellent) characteristics in terms of brightness, driving voltage, and/or response speed.

An example of the organic light-emitting devices may include a first electrode disposed on a substrate, and a hole transport region, an emission layer, an electron transport region, and a second electrode, which are sequentially disposed on the first electrode. Holes provided from the first electrode may move toward the emission layer through the hole transport region, and electrons provided from the second electrode may move toward the emission layer through the electron transport region. Carriers, such as holes and electrons, recombine in the emission layer to produce excitons. These excitons transit from an excited state to a ground state, thereby generating (e.g., emitting) light.

US 2018/033987 A1 discloses an organic light-emitting device including: a first electrode; a second electrode; and an organic layer between the first electrode and the second electrode, wherein the organic layer includes an emission layer; the emission layer includes a first compound, a second compound, a third compound, and a fourth compound and a lowest excited triplet energy level ($H_{T1}$) of the first compound, a lowest excited triplet energy level ($DFD_{T1}$) of the third compound, and a lowest excited triplet energy level ($FD_{T1}$) of the fourth compound satisfy $H_{T1} > DFD_{T1} > FD_{T1}$.

WO 2019/128105 A1 discloses an organic electroluminescent device that comprises a light-emitting layer; the light-emitting layer comprises an exciplex consisting of a donor molecule and an acceptor molecule, and a wide-band gap material used for increasing intermolecular spacing between the donor molecule and the acceptor molecule.

EP 3800679 A1 (cited pursuant to Article 54(3) EPC) relates to an organic electroluminescence device that includes a first electrode, a second electrode, and an emission layer.

## SUMMARY

Aspects according to one or more embodiments are directed toward an organic light-emitting device and an apparatus including the same.

Additional aspects will be set forth in part in the description which follows and, in part, will be apparent from the description, or may be learned by practice of the presented embodiments of the disclosure.

According to one embodiment, an organic light-emitting device includes:

a first electrode;
a second electrode; and
an organic layer between the first electrode and the second electrode,
wherein the organic layer includes an emission layer,
the emission layer according to the claims that includes a first compound, a second compound, a third compound, and a fourth compound,
the first compound is represented by Formula 1,
the second compound is represented by Formula 2A or Formula 2B,
the third compound is represented by Formula 3,
the fourth compound is represented by any one of Formulae 4-1 to 4-3, and
the first compound, the second compound, the third compound, and the fourth compound are different from each other:

Formula 1

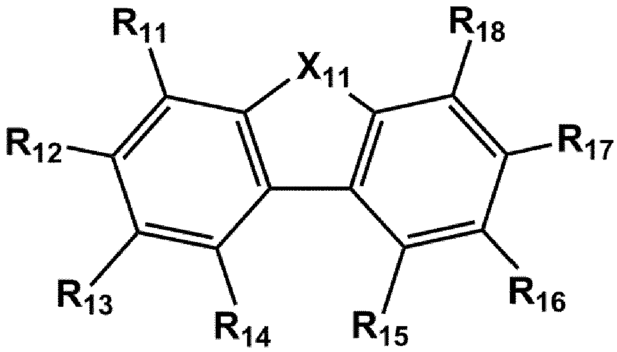

Formula 2A

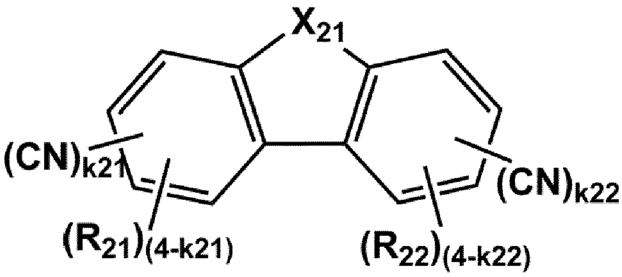

Formula 2B

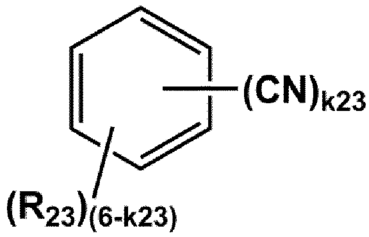

Formula 3 $M_{31}(L_{31})_{n31}(L_{32})_{n32}$

Formula 3A

Formula 3B

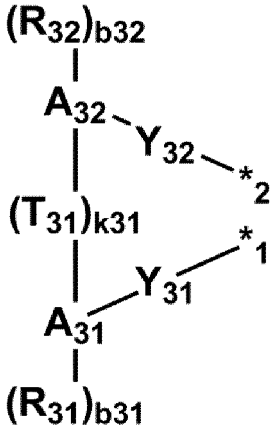

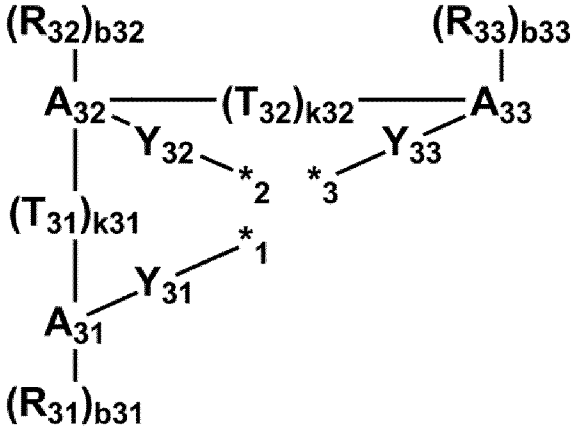

Formula 3C

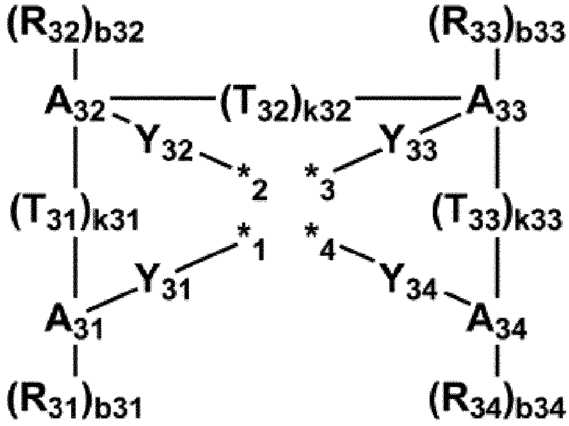

Formula 3D

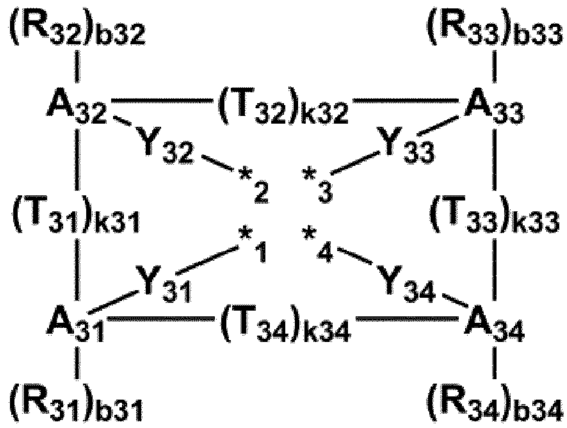

Formula 4-1 $(D_{41})_{n41}$-$(L_{41})_{a41}$-$(A_{41})_{m41}$

Formula 4-2 $(D_{41})_{n41}$-$(L_{41})_{a41}$-$(A_{41})_{m41}$-$(L_{42})_{a42}$-$(D_{42})_{n42}$

Formula 4-3 $(A_{41})_{m41}$-$(L_{41})_{a41}$-$(D_{41})_{n41}$-$(L_{42})_{a42}$-$(A_{42})_{m42}$

In Formula 1,

$X_{11}$ is selected from O, S, $N(R_{19})$, and $C(R_{19})(R_{20})$,
$R_{11}$ to $R_{26}$ are each independently selected from:

a group represented by *-$(L_{11})_{a11}$-$A_{11}$, hydrogen, deuterium, a $C_1$-$C_{60}$ alkyl group, a π electron-depleted nitrogen-free cyclic group, -$C(Q_1)(Q_2)(Q_3)$, - $Si(Q_1)(Q_2)(Q_3)$, -$B(Q_1)(Q_2)$, and -$N(Q_1)(Q_2)$;
a π electron-depleted nitrogen-free cyclic group substituted with at least one selected from deuterium, a $C_1$-$C_{60}$ alkyl group, a π electron-depleted nitrogen-free cyclic group, -$C(Q_{31})(Q_{32})(Q_{33})$, -$Si(Q_{31})(Q_{32})(Q_{33})$, -$B(Q_{31})(Q_{32})$, and -$N(Q_{31})(Q_{32})$; and
a π electron-depleted nitrogen-free cyclic group substituted with a π electron-depleted nitrogen-free cyclic group substituted with at least one selected from deuterium, a $C_1$-$C_{60}$ alkyl group, a π electron-depleted nitrogen-free cyclic group, - $C(Q_{21})(Q_{22})(Q_{23})$, -$Si(Q_{21})(Q_{22})(Q_{23})$, -$B(Q_{21})(Q_{22})$, and -$N(Q_{21})(Q_{22})$,

$L_{11}$ is selected from:

a π electron-depleted nitrogen-free cyclic group, -$C(Q_1)(Q_2)$-, -$Si(Q_1)(Q_2)$-, - $B(Q_1)$-, and -$N(Q_1)$-; and
a π electron-depleted nitrogen-free cyclic group substituted with at least one selected from deuterium, a $C_1$-$C_{60}$ alkyl group, a π electron-depleted nitrogen-free cyclic group, -$C(Q_{31})(Q_{32})(Q_{33})$, -$Si(Q_{31})(Q_{32})(Q_{33})$, -$B(Q_{31})(Q_{32})$, and -$N(Q_{31})(Q_{32})$,

a11 is selected from 1, 2, and 3, and

$A_{11}$ is selected from:

a $\pi$ electron-depleted nitrogen-free cyclic group;
a $\pi$ electron-depleted nitrogen-free cyclic group substituted with at least one selected from deuterium, a $C_1$-$C_{60}$ alkyl group, a $\pi$ electron-depleted nitrogen-free cyclic group, $-C(Q_{31})(Q_{32})(Q_{33})$, $-Si(Q_{31})(Q_{32})(Q_{33})$, $-B(Q_{31})(Q_{32})$, and $-N(Q_{31})(Q_{32})$; and
a $\pi$ electron-depleted nitrogen-free cyclic group substituted with a $\pi$ electron-depleted nitrogen-free cyclic group substituted with at least one selected from deuterium, a $C_1$-$C_{60}$ alkyl group, a $\pi$ electron-depleted nitrogen-free cyclic group, $-C(Q_{21})(Q_{22})(Q_{23})$, $-Si(Q_{21})(Q_{22})(Q_{23})$, $-B(Q_{21})(Q_{22})$, and $-N(Q_{21})(Q_{22})$.

In Formulae 2A to 2B,

$X_{21}$ is selected from O, S, $N(R_{24})$, and $C(R_{24})(R_{25})$,
k21 and k22 are each independently selected from 0, 1, 2, 3, and 4, wherein the sum of k21 and k22 is 1 or more,
k23 is selected from 1, 2, 3, 4, 5, and 6,
$R_{21}$ to $R_{25}$ are each independently selected from:

a group represented by $*-(L_{21})_{a21}-A_{21}$, hydrogen, deuterium, -F, a cyano group, a $C_1$-$C_{60}$ alkyl group, a $\pi$ electron-depleted nitrogen-containing cyclic group, a $\pi$ electron-depleted nitrogen-free cyclic group, $-C(Q_1)(Q_2)(Q_3)$, $-Si(Q_1)(Q_2)(Q_3)$, $-B(Q_1)(Q_2)$, $-N(Q_1)(Q_2)$, $-S(=O)(Q_1)$, $-S(=O)_2(Q_1)$, $-P(=O)(Q_1)(Q_2)$, and $-P(=S)(Q_1)(Q_2)$;
a $\pi$ electron-depleted nitrogen-containing cyclic group and a $\pi$ electron-depleted nitrogen-free cyclic group, each substituted with at least one selected from deuterium, -F, a cyano group, a $C_1$-$C_{60}$ alkyl group, a $\pi$ electron-depleted nitrogen-containing cyclic group, a $\pi$ electron-depleted nitrogen-free cyclic group, $-C(Q_{31})(Q_{32})(Q_{33})$, $-Si(Q_{31})(Q_{32})(Q_{33})$, $-B(Q_{31})(Q_{32})$, $-N(Q_{31})(Q_{32})$, $-S(=O)(Q_{31})$, $-S(=O)_2(Q_{31})$, $-P(=O)(Q_{31})(Q_{32})$, and $-P(=S)(Q_{31})(Q_{32})$; and
a $\pi$ electron-depleted nitrogen-containing cyclic group and a $\pi$ electron-depleted nitrogen-free cyclic group, each substituted with at least one selected from a $\pi$ electron-depleted nitrogen-containing cyclic group and a $\pi$ electron-depleted nitrogen-free cyclic group that are each independently substituted with at least one selected from deuterium, -F, a cyano group, a $C_1$-$C_{60}$ alkyl group, a $\pi$ electron-depleted nitrogen-containing cyclic group, a $\pi$ electron-depleted nitrogen-free cyclic group, $-C(Q_{21})(Q_{22})(Q_{23})$, $-Si(Q_{21})(Q_{22})(Q_{23})$, $-B(Q_{21})(Q_{22})$, $-N(Q_{21})(Q_{22})$, $-S(=O)(Q_{21})$, $-S(=O)_2(Q_{21})$, $-P(=O)(Q_{21})(Q_{22})$, and $-P(=S)(Q_{21})(Q_{22})$,

$L_{21}$ is selected from:

a $\pi$ electron-depleted nitrogen-containing cyclic group, a $\pi$ electron-depleted nitrogen-free cyclic group, $-C(Q_1)(Q_2)-$, $-Si(Q_1)(Q_2)-$, $-B(Q_1)-$, $-N(Q_1)-$, $-S(=O)-$, $-S(=O)_2-$, $-P(=O)(Q_7)-$, and $-P(=S)(Q_1)-$; and
a $\pi$ electron-depleted nitrogen-containing cyclic group and a $\pi$ electron-depleted nitrogen-free cyclic group, each substituted with at least one selected from deuterium, -F, a cyano group, a $C_1$-$C_{60}$ alkyl group, a $\pi$ electron-depleted nitrogen-containing cyclic group, a $\pi$ electron-depleted nitrogen-free cyclic group, $-C(Q_{31})(Q_{32})(Q_{33})$, $-Si(Q_{31})(Q_{32})(Q_{33})$, $-B(Q_{31})(Q_{32})$, $-N(Q_{31})(Q_{32})$, $-S(=O)(Q_{31})$, $-S(=O)_2(Q_{31})$, $-P(=O)(Q_{31})(Q_{32})$, and $-P(=S)(Q_{31})(Q_{32})$;
a21 is selected from 1, 2, and 3, and

$A_{21}$ is selected from:

a $\pi$ electron-depleted nitrogen-containing cyclic group and a $\pi$ electron-depleted nitrogen-free cyclic group;
a $\pi$ electron-depleted nitrogen-containing cyclic group and a $\pi$ electron-depleted nitrogen-free cyclic group, each substituted with at least one selected from deuterium, -F, a cyano group, a $C_1$-$C_{60}$ alkyl group, a $\pi$ electron-depleted nitrogen-containing cyclic group, a $\pi$ electron-depleted nitrogen-free cyclic group, $-C(Q_{31})(Q_{32})(Q_{33})$, $-Si(Q_{31})(Q_{32})(Q_{33})$, $-B(Q_{31})(Q_{32})$, $-N(Q_{31})(Q_{32})$, $-S(=O)(Q_{31})$, $-S(=O)_2(Q_{31})$, $-P(=O)(Q_{31})(Q_{32})$, and $-P(=S)(Q_{31})(Q_{32})$; and
a $\pi$ electron-depleted nitrogen-containing cyclic group and a $\pi$ electron-depleted nitrogen-free cyclic group, each substituted with at least one selected from a $\pi$ electron-depleted nitrogen-containing cyclic group and a $\pi$ electron-depleted nitrogen-free cyclic group that are each independently substituted with at least one selected from deuterium, -F, a cyano group, a $C_1$-$C_{60}$ alkyl group, a $\pi$ electron-depleted nitrogen-containing cyclic group,

a $\pi$ electron-depleted nitrogen-free cyclic group, $-C(Q_{21})(Q_{22})(Q_{23})$, $-Si(Q_{21})(Q_{22})(Q_{23})$, $-B(Q_{21})(Q_{22})$, $-N(Q_{21})(Q_{22})$, $-S(=O)(Q_{21})$, $-S(=O)_2(Q_{21})$, $-P(=O)(Q_{21})(Q_{22})$, and $-P(=S)(Q_{21})(Q_{22})$.

In Formula 3,

$M_{31}$ is selected from transition metals of Period 4, Period 5, and Period 6 of the Periodic Table of Elements,
$L_{31}$ is a ligand represented by one selected from Formulae 3A to 3D,
$L_{32}$ is selected from a monodentate ligand, a bidentate ligand, and a tridentate ligand,
n31 is 1 or 2,
n32 is selected from 0, 1, 2, 3, and 4,
$A_{31}$ to $A_{34}$ are each independently selected from a $C_5$-$C_{30}$ carbocyclic group and a $C_1$-$C_{30}$ heterocyclic group,
$T_{31}$ to $T_{34}$ are each independently selected from a single bond, a double bond, *-O-*', *-S-*', *-C(=O)-*', *-S(=O)-*', $*-C(R_{35})(R_{36})-*'$, $*-C(R_{35})=C(R_{36})-*'$, $*-C(R_{35})=*'$, $*-Si(R_{35})(R_{36})-*'$, $*-B(R_{35})-*'$, $*-N(R_{35})-*'$, and $*-P(R_{35})-*'$,
k31 to k34 are each independently selected from 1, 2, and 3,
$Y_{31}$ to $Y_{34}$ are each independently selected from a single bond, *-O-*', *-S-*', $*-C(R_{37})(R_{38})-*'$, $*-Si(R_{37})(R_{38})-*'$, $*-B(R_{37})-*'$, $*-N(R_{37})-*'$, and $*-P(R_{37})-*'$,
$*_1$, $*_2$, $*_3$, and $*_4$ each indicate a binding site to $M_{31}$,
$R_{31}$ to $R_{38}$ are each independently selected from hydrogen, deuterium, -F, - Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, $-C(Q_1)(Q_2)(Q_3)$, $-Si(Q_1)(Q_2)(Q_3)$, $-B(Q_1)(Q_2)$, $-N(Q_1)(Q_2)$, $-P(Q_1)(Q_2)$, $-C(=O)(Q_1)$, $-S(=O)(Q_1)$, $-S(=O)_2(Q_1)$, $-P(=O)(Q_1)(Q_2)$, and $-P(=S)(Q_1)(Q_2)$, wherein $R_{31}$ to $R_{38}$ are optionally linked to each other to form a substituted or unsubstituted $C_5$-$C_{60}$ carbocyclic group or a substituted or unsubstituted $C_1$-$C_{60}$ heterocyclic group, and
b31 to b34 are each independently an integer from 0 to 10.

In Formulae 4-1 to 4-3,
$A_{41}$ and $A_{42}$ are each independently selected from:

a group represented by Formula 12 of claim 1, $-Si(Q_1)(Q_2)(Q_3)$, $-B(Q_1)(Q_2)$, and $-N(Q_7)(Q_2)$;
m41 and m42 are each independently selected from 1, 2, and 3,
$D_{41}$ and $D_{42}$ are each independently selected from a group according to the claims.
n41 and n42 are each independently selected from 1, 2, and 3,
$L_{41}$ and $L_{42}$ are each independently selected from a group according to the claims.
a41 and a42 are each independently selected from 0, 1, 2, and 3.

In Formulae 1, 2A, 2B, 3 and 4-1 to 4-3,
$Q_1$ to $Q_3$, $Q_{21}$ to $Q_{23}$, and $Q_{31}$ to $Q_{33}$ are each independently selected from hydrogen, deuterium, -F, -Cl, -Br, -I, a hydroxyl group, a cyano group, a nitro group, an amidino group, a hydrazino group, a hydrazono group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, a biphenyl group, and a terphenyl group.

According to another embodiment, an apparatus includes: a thin-film transistor including a source electrode, a drain electrode, and an activation layer; a sealing part; and the organic light-emitting device as described above, wherein the first electrode of the organic light-emitting device is electrically connected to the source electrode or the drain electrode of the thin-film transistor.

The present invention is defined by the claims.

## BRIEF DESCRIPTION OF THE DRAWINGS

The above and other aspects, features, and enhancements of certain embodiments of the disclosure will be more apparent from the following description taken in conjunction with the accompanying drawings, in which:

FIG. 1 is a schematic view of an organic light-emitting device according to an embodiment;
FIG. 2 is a schematic view of an organic light-emitting device according to another embodiment;
FIG. 3 is a schematic cross-sectional view of an organic light-emitting device according to another embodiment; and
FIG. 4 is a schematic view of an organic light-emitting device according to another embodiment.

## DETAILED DESCRIPTION

Reference will now be made in more detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Throughout the disclosure, the expression "at least one of a, b or c" indicates only a, only b, only c, both a and b, both a and c, both b and c, all of a, b, and c, or variations thereof.

Hereinafter, embodiments of the present disclosure will be described in more detail with reference to the accompanying drawings. The same or corresponding components will be denoted by the same reference numerals, and thus redundant description thereof will be omitted (i.e., will not be provided).

As used herein, the singular forms "a," "an" and "the" are intended to include the plural forms as well, unless the context clearly indicates otherwise.

It will be further understood that the terms "comprises" and/or "comprising" used herein specify the presence of stated features or components, but do not preclude the presence or addition of one or more other features or components.

It will be understood that when a layer, region, or component is referred to as being "on" or "onto" another layer, region, or component, it may be directly or indirectly formed on the other layer, region, or component. That is, for example, intervening layers, regions, or components may be present.

Sizes of elements in the drawings may be exaggerated for convenience of explanation. In other words, because sizes and thicknesses of components in the drawings are arbitrarily illustrated for convenience of explanation, the following embodiments of the present disclosure are not limited thereto.

The term "organic layer" as used herein refers to a single layer and/or a plurality of layers disposed between the first electrode and the second electrode of the organic light-emitting device. A material included in the "organic layer" is not limited to an organic material.

The organic light-emitting device is according to the claims and includes a first electrode, a second electrode, an organic layer interposed between the first electrode and the second electrode, wherein the organic layer includes an emission layer, the emission layer includes a first compound, a second compound, a third compound, and a fourth compound, the first compound is represented by Formula 1, the second compound is represented by Formula 2A or Formula 2B, the third compound is represented by Formula 3, the fourth compound is represented by any one of Formulae 4-1 to 4-3, and the first compound, the second compound, the third compound, and the fourth compound are different from each other:

Formula 1

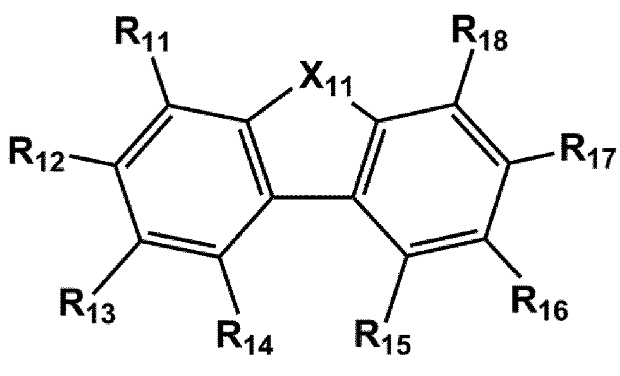

Formula 2A

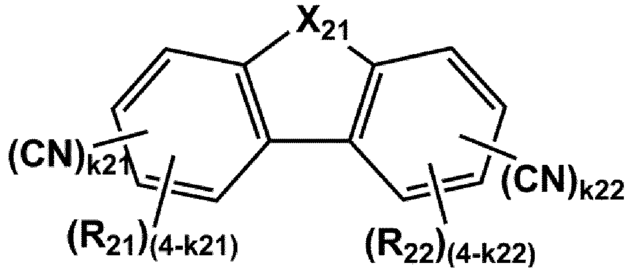

Formula 2B

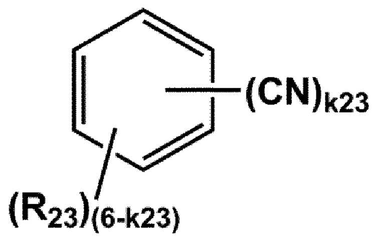

Formula 3 $M_{31}(L_{31})_{n31}(L_{32})_{n32}$

Formula 3A

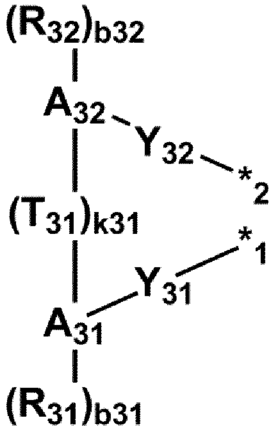

Formula 3B

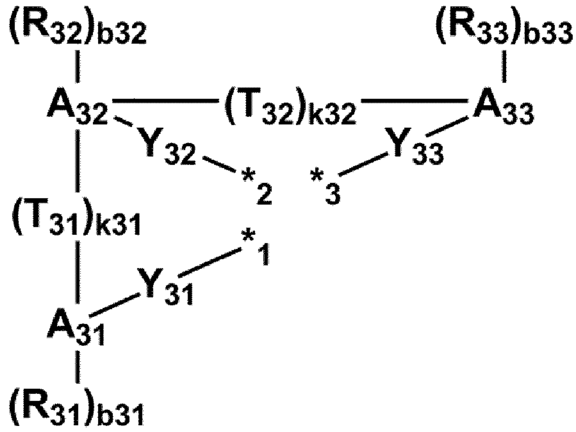

Formula 3C

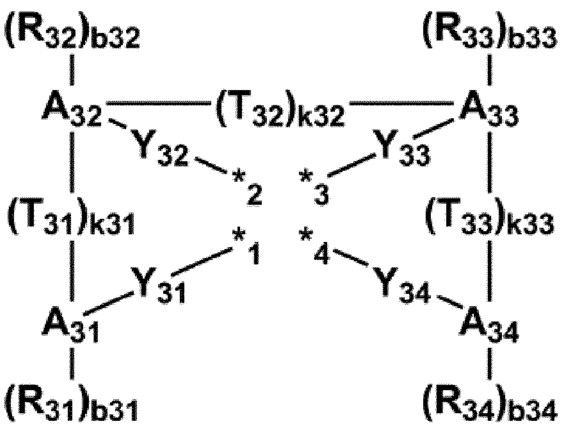

Formula 3D

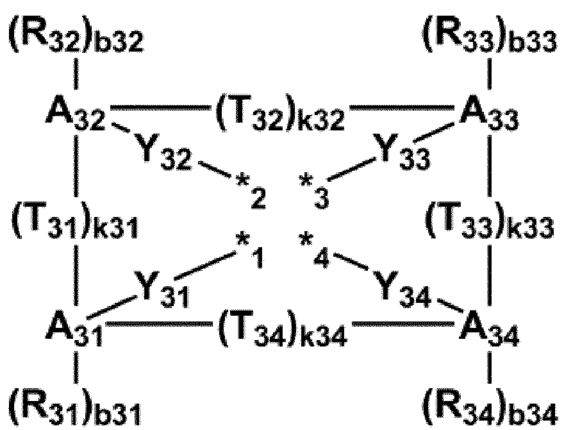

Formula 4-1 $(D_{41})_{n41}\text{-}(L_{41})_{a41}\text{-}(A_{41})_{m41}$

Formula 4-2 $(D_{41})_{n41}\text{-}(L_{41})_{a41}\text{-}(A_{41})_{m41}\text{-}(L_{42})_{a42}\text{-}(D_{42})_{n42}$

Formula 4-3 $(A_{41})_{m41}\text{-}(L_{41})_{a41}\text{-}(D_{41})_{n41}\text{-}(L_{42})_{a42}\text{-}(A_{42})_{m42}$

In Formulae 1, 2A, 2B, 3, and 4-1 to 4-3,

$X_{11}$ is selected from O, S, $N(R_{19})$, and $C(R_{19})(R_{20})$,
$R_{11}$ to $R_{20}$ are each independently selected from:

a group represented by *-$(L_{11})_{a11}$-$A_{11}$, hydrogen, deuterium, a $C_1$-$C_{60}$ (*e.g.* $C_1$-$C_{20}$) alkyl group, a π electron-depleted nitrogen-free cyclic group, -$C(Q_1)(Q_2)(Q_3)$, - $Si(Q_1)(Q_2)(Q_3)$, -$B(Q_1)(Q_2)$, and -$N(Q_1)(Q_2)$;

a π electron-depleted nitrogen-free cyclic group substituted with at least one selected from deuterium, a $C_1$-$C_{60}$ (*e.g.* $C_1$-$C_{20}$) alkyl group, a π electron-depleted nitrogen-free cyclic group, -$C(Q_{31})(Q_{32})(Q_{33})$, -$Si(Q_{31})(Q_{32})(Q_{33})$, -$B(Q_{31})(Q_{32})$, and - $N(Q_{31})(Q_{32})$; and

a π electron-depleted nitrogen-free cyclic group substituted with a π electron-depleted nitrogen-free cyclic group substituted with at least one selected from deuterium, a $C_1$-$C_{60}$ (*e.g.* $C_1$-$C_{20}$) alkyl group, a π electron-depleted nitrogen-free cyclic group, -$C(Q_{21})(Q_{22})(Q_{23})$, -$Si(Q_{21})(Q_{22})(Q_{23})$, -$B(Q_{21})(Q_{22})$, and -$N(Q_{21})(Q_{22})$,

$L_{11}$ is selected from:

a π electron-depleted nitrogen-free cyclic group, -$C(Q_1)(Q_2)$-, -$Si(Q_1)(Q_2)$-, - $B(Q_1)$-, and -$N(Q_1)$-; and

a π electron-depleted nitrogen-free cyclic group substituted with at least one selected from deuterium, a $C_1$-$C_{60}$ (e.g. $C_1$-$C_{20}$) alkyl group, a π electron-depleted nitrogen-free cyclic group, -$C(Q_{31})(Q_{32})(Q_{33})$, -$Si(Q_{31})(Q_{32})(Q_{33})$, -$B(Q_{31})(Q_{32})$, and - N (Q31) (Q32),

a11 is selected from 1, 2, and 3,

$A_{11}$ is selected from:

a π electron-depleted nitrogen-free cyclic group;

a π electron-depleted nitrogen-free cyclic group substituted with at least one selected from deuterium, a $C_1$-$C_{60}$ (*e.g.* $C_1$-$C_{20}$) alkyl group, a π electron-depleted nitrogen-free cyclic group, -$C(Q_{31})(Q_{32})(Q_{33})$, -$Si(Q_{31})(Q_{32})(Q_{33})$, -$B(Q_{31})(Q_{32})$, and - $N(Q_{31})(Q_{32})$; and

a π electron-depleted nitrogen-free cyclic group substituted with a π electron-depleted nitrogen-free cyclic group substituted with at least one selected from deuterium, a $C_1$-$C_{60}$ (*e.g.* $C_1$-$C_{20}$) alkyl group, a π electron-depleted nitrogen-free cyclic group, -$C(Q_{21})(Q_{22})(Q_{23})$, -$Si(Q_{21})(Q_{22})(Q_{23})$, -$B(Q_{21})(Q_{22})$, and -$N(Q_{21})(Q_{22})$,

$X_{21}$ is selected from O, S, $N(R_{24})$, and $C(R_{24})(R_{25})$,

k21 and k22 are each independently selected from 0, 1, 2, 3, and 4, wherein the sum of k21 and k22 is 1 or more,

k23 is selected from 1, 2, 3, 4, 5, and 6,

$R_{21}$ to $R_{25}$ are each independently selected from:

a group represented by *-$(L_{21})_{a21}$-$A_{21}$, hydrogen, deuterium, -F, a cyano group, a $C_1$-$C_{60}$ (*e.g.* $C_1$-$C_{20}$) alkyl group, a π electron-depleted nitrogen-containing cyclic group, a π electron-depleted nitrogen-free cyclic group, -$C(Q_1)(Q_2)(Q_3)$, - $Si(Q_1)(Q_2)(Q_3)$, -$B(Q_1)(Q_2)$, -$N(Q_1)(Q_2)$, -$S(=O)(Q_1)$, -$S(=O)_2(Q_1)$, -$P(=O)(Q_1)(Q_2)$, and -$P(=S)(Q_1)(Q_2)$;

a π electron-depleted nitrogen-containing cyclic group and a π electron-depleted nitrogen-free cyclic group, each substituted with at least one selected from deuterium, -F, a cyano group, a $C_1$-$C_{60}$ (*e.g.* $C_1$-$C_{20}$) alkyl group, a π electron-depleted nitrogen-containing cyclic group, a π electron-depleted nitrogen-free cyclic group, - $C(Q_{31})(Q_{32})(Q_{33})$, -$Si(Q_{31})(Q_{32})(Q_{33})$, -$B(Q_{31})(Q_{32})$, -$N(Q_{31})(Q_{32})$, -$S(=O)(Q_{31})$, - $S(=O)_2(Q_{31})$, -$P(=O)(Q_{31})(Q_{32})$, and -$P(=S)(Q_{31})(Q_{32})$; and

a π electron-depleted nitrogen-containing cyclic group and a π electron-depleted nitrogen-free cyclic group, each substituted with at least one selected from a π electron-depleted nitrogen-containing cyclic group and a π electron-depleted nitrogen-free cyclic group that are each independently substituted with at least one selected from deuterium, -F, a cyano group, a $C_1$-$C_{60}$ (*e.g.* $C_1$-$C_{20}$) alkyl group, a π electron-depleted nitrogen-containing cyclic group, a π electron-depleted nitrogen-free cyclic group, -$C(Q_{21})(Q_{22})(Q_{23})$, -$Si(Q_{21})(Q_{22})(Q_{23})$, -$B(Q_{21})(Q_{22})$, -$N(Q_{21})(Q_{22})$, - $S(=O)(Q_{21})$, -$S(=O)_2(Q_{21})$, -$P(=O)(Q_{21})(Q_{22})$, and -$P(=S)(Q_{21})(Q_{22})$,

$L_{21}$ is selected from:

a π electron-depleted nitrogen-containing cyclic group, a π electron-depleted nitrogen-free cyclic group, -$C(Q_1)(Q_2)$-, -$Si(Q_1)(Q_2)$-, -$B(Q_1)$-, -$N(Q_1)$-, -S(=O)-, -$S(=O)_2$-, -$P(=O)(Q_7)$-, and -$P(=S)(Q_1)$-; and

a π electron-depleted nitrogen-containing cyclic group and a π electron-depleted nitrogen-free cyclic group, each substituted with at least one selected from deuterium, -F, a cyano group, a $C_1$-$C_{60}$ (*e.g.* $C_1$-$C_{20}$) alkyl group, a π electron-depleted nitrogen-containing cyclic group, a π electron-depleted nitrogen-free cyclic group, - $C(Q_{31})(Q_{32})(Q_{33})$, -$Si(Q_{31})(Q_{32})(Q_{33})$, -$B(Q_{31})(Q_{32})$, -$N(Q_{31})(Q_{32})$, -$S(=O)(Q_{31})$, - $S(=O)_2(Q_{31})$, -$P(=O)(Q_{31})(Q_{32})$, and -$P(=S)$ $(Q_{31})(Q_{32})$;

a21 is selected from 1, 2, and 3,

$A_{21}$ is selected from:

a π electron-depleted nitrogen-containing cyclic group and a π electron-depleted nitrogen-free cyclic group;

a π electron-depleted nitrogen-containing cyclic group and a π electron-depleted nitrogen-free cyclic group, each substituted with at least one selected from deuterium, -F, a cyano group, a $C_1$-$C_{60}$ (*e.g.* $C_1$-$C_{20}$) alkyl group, a π electron-depleted nitrogen-containing cyclic group, a π electron-depleted nitrogen-free cyclic group, - $C(Q_{31})(Q_{32})(Q_{33})$, $-Si(Q_{31})(Q_{32})(Q_{33})$, $-B(Q_{31})(Q_{32})$, $-N(Q_{31})(Q_{32})$, $-S(=O)(Q_{31})$, - $S(=O)_2(Q_{31})$, $-P(=O)(Q_{31})(Q_{32})$, and -P(=S) $(Q_{31})(Q_{32})$; and

a π electron-depleted nitrogen-containing cyclic group and a π electron-depleted nitrogen-free cyclic group, each substituted with at least one selected from a π electron-depleted nitrogen-containing cyclic group and a π electron-depleted nitrogen-free cyclic group that are each independently substituted with at least one selected from deuterium, -F, a cyano group, a $C_1$-$C_{60}$ (*e.g.* $C_1$-$C_{20}$) alkyl group, a π electron-depleted nitrogen-containing cyclic group, a π electron-depleted nitrogen-free cyclic group, $-C(Q_{21})(Q_{22})(Q_{23})$, $-Si(Q_{21})(Q_{22})(Q_{23})$, $-B(Q_{21})(Q_{22})$, $-N(Q_{21})(Q_{22})$, - $S(=O)(Q_{21})$, $-S(=O)_2(Q_{21})$, $-P(=O)(Q_{21})(Q_{22})$, and -P(=S) $(Q_{21})(Q_{22})$,

$M_{31}$ is selected from transition metals of Period 4, Period 5, and Period 6 of the Periodic Table of Elements,

$L_{31}$ is a ligand represented by one selected from Formulae 3A to 3D,

$L_{32}$ is selected from a monodentate ligand, a bidentate ligand, and a tridentate ligand,

n31 is 1 or 2,

n32 is selected from 0, 1, 2, 3, and 4,

$A_{31}$ to $A_{34}$ are each independently selected from a $C_5$-$C_{30}$ carbocyclic group and a $C_1$-$C_{30}$ (*e.g.* $C_1$-$C_{20}$) heterocyclic group,

$T_{31}$ to $T_{34}$ are each independently selected from a single bond, a double bond, *-O-*', *-S-*', *-C(=O)-*', *-S(=O)-*', $*-C(R_{35})(R_{36})-*'$, $*-C(R_{35})=C(R_{36})-*'$, $*-C(R_{35})=*'$, $*-Si(R_{35})(R_{36})-*'$, $*-B(R_{35})-*'$, $*-N(R_{35})-*'$, and $*-P(R_{35})-*'$,

k31 to k34 are each independently selected from 1, 2, and 3,

$Y_{31}$ to $Y_{34}$ are each independently selected from a single bond, *-O-*', *-S-*', $*-C(R_{37})(R_{38})-*'$, $*-Si(R_{37})(R_{38})-*'$, $*-B(R_{37})-*'$, $*-N(R_{37})-*'$, and $*-P(R_{37})-*'$,

$*_1$, $*_2$, $*_3$, and $*_4$ each indicate a binding site to $M_{31}$,

$R_{31}$ to $R_{38}$ are each independently selected from hydrogen, deuterium, -F, - Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ (*e.g.* $C_1$-$C_{20}$) alkyl group, a substituted or unsubstituted $C_2$-$C_{60}$ (*e.g.* $C_2$-$C_{20}$) alkenyl group, a substituted or unsubstituted $C_2$-$C_{60}$ (*e.g.* $C_2$-$C_{20}$) alkynyl group, a substituted or unsubstituted $C_1$-$C_{60}$ (*e.g.* $C_1$-$C_{20}$) alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ (*e.g.* $C_6$-$C_{30}$) aryl group, a substituted or unsubstituted $C_6$-$C_{60}$ (*e.g.* $C_6$-$C_{30}$) aryloxy group, a substituted or unsubstituted $C_6$-$C_{60}$ (*e.g.* $C_6$-$C_{30}$) arylthio group, a substituted or unsubstituted $C_1$-$C_{60}$ (*e.g.* $C_1$-$C_{20}$) heteroaryl group, a substituted or unsubstituted monovalent non-aromatic condensed polycyclic group, a substituted or unsubstituted monovalent non-aromatic condensed heteropolycyclic group, $-C(Q_1)(Q_2)(Q_3)$, $-Si(Q_1)(Q_2)(Q_3)$, $-B(Q_1)(Q_2)$, $-N(Q_1)(Q_2)$, - $P(Q_1)(Q_2)$, $-C(=O)(Q_1)$, $-S(=O)(Q_1)$, $-S(=O)_2(Q_1)$, $-P(=O)(Q_1)(Q_2)$, and $-P(=S)(Q_1)(Q_2)$, wherein $R_{31}$ to $R_{38}$ (e.g., adjacent $R_{31}$ to $R_{38}$) are optionally linked to each other to form a substituted or unsubstituted $C_5$-$C_{60}$ (*e.g.* $C_5$-$C_{30}$) carbocyclic group or a substituted or unsubstituted $C_1$-$C_{60}$ (*e.g.* $C_1$-$C_{20}$) heterocyclic group,

b31 to b34 are each independently an integer from 0 to 10,

$A_{41}$ and $A_{42}$ are as defined in the claims.

m41 and m42 are each independently selected from 1, 2, and 3,

D41 and D42 are defined by the claims.

n41 and n42 are each independently selected from 1, 2, and 3,

$L_{41}$ and $L_{42}$ are as defined in the claims.

a41 and a42 are each independently selected from 0, 1, 2, and 3, and

$Q_1$ to $Q_3$, $Q_{21}$ to $Q_{23}$, and $Q_{31}$ to $Q_{33}$ are each independently selected from hydrogen, deuterium, -F, -Cl, -Br, -I, a hydroxyl group, a cyano group, a nitro group, an amidino group, a hydrazino group, a hydrazono group, a $C_1$-$C_{60}$ (*e.g.* $C_1$-$C_{20}$) alkyl group, a $C_2$-$C_{60}$ (*e.g.* $C_2$-$C_{20}$) alkenyl group, a $C_2$-$C_{60}$ (*e.g.* $C_2$-$C_{20}$) alkynyl group, a $C_1$-$C_{60}$ (*e.g.* $C_1$-$C_{20}$) alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ (*e.g.* $C_6$-$C_{30}$) aryl group, a $C_6$-$C_{60}$ (*e.g.* $C_6$-$C_{30}$) aryloxy group, a $C_6$-$C_{60}$ (*e.g.* $C_6$-$C_{30}$) arylthio group, a $C_1$-$C_{60}$ (*e.g.* $C_1$-$C_{20}$) heteroaryl group, a $C_1$-$C_{60}$ (*e.g.* $C_1$-$C_{20}$) heteroaryloxy group, a $C_1$-$C_{60}$ (*e.g.* $C_1$-$C_{20}$) heteroarylthio group, a monovalent non-aromatic condensed polycyclic group, a monovalent non-aromatic condensed heteropolycyclic group, a biphenyl group, and

a terphenyl group.

For example, at least one selected from $R_{11}$ to $R_{19}$ in Formula 1 may be a group represented by *-$(L_{11})_{a11}$-$A_{11}$.

For example, $X_{11}$ in Formula 1 may be N($R_{19}$).

For example, $R_{11}$ to $R_{20}$ in Formula 1 may each independently be selected from:

a group represented by *-$(L_{11})_{a11}$-$A_{11}$, hydrogen, deuterium, a $C_1$-$C_{20}$ (*e.g.* $C_1$-$C_{10}$) alkyl group, a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a benzofluorenyl group, a benzocarbazolyl group, a benzonaphthofuranyl group, a benzonaphthothiophenyl group, a dibenzofluorenyl group, a dibenzocarbazolyl group, a dinaphthofuranyl group, a dinaphthothiophenyl group, -C($Q_1$)($Q_2$)($Q_3$), -Si($Q_1$)($Q_2$)($Q_3$), -B($Q_1$)($Q_2$), and -N($Q_1$)($Q_2$);

a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a benzofluorenyl group, a benzocarbazolyl group, a benzonaphthofuranyl group, a benzonaphthothiophenyl group, a dibenzofluorenyl group, a dibenzocarbazolyl group, a dinaphthofuranyl group, and a dinaphthothiophenyl group, each substituted with at least one selected from deuterium, a $C_1$-$C_{20}$ (*e.g.* $C_1$-$C_{10}$) alkyl group, a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a benzofluorenyl group, a benzocarbazolyl group, a benzonaphthofuranyl group, a benzonaphthothiophenyl group, a dibenzofluorenyl group, a dibenzocarbazolyl group, a dinaphthofuranyl group, a dinaphthothiophenyl group, - C($Q_{31}$)($Q_{32}$)($Q_{33}$), -Si($Q_{31}$)($Q_{32}$)($Q_{33}$), -B($Q_{31}$)($Q_{32}$), and -N($Q_{31}$)($Q_{32}$); and

a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a benzofluorenyl group, a benzocarbazolyl group, a benzonaphthofuranyl group, a benzonaphthothiophenyl group, a dibenzofluorenyl group, a dibenzocarbazolyl group, a dinaphthofuranyl group, and a dinaphthothiophenyl group, each substituted with at least one selected from a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a benzofluorenyl group, a benzocarbazolyl group, a benzonaphthofuranyl group, a benzonaphthothiophenyl group, a dibenzofluorenyl group, a dibenzocarbazolyl group, a dinaphthofuranyl group, and a dinaphthothiophenyl group that are each independently substituted with at least one selected from deuterium, a $C_1$-$C_{20}$ (*e.g.* $C_1$-$C_{10}$) alkyl group, a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a benzofluorenyl group, a benzocarbazolyl group, a benzonaphthofuranyl group, a benzonaphthothiophenyl group, a dibenzofluorenyl group, a dibenzocarbazolyl group, a dinaphthofuranyl group, a dinaphthothiophenyl group, -C($Q_{21}$)($Q_{22}$)($Q_{23}$), - Si($Q_{21}$)($Q_{22}$)($Q_{23}$), -B($Q_{21}$)($Q_{22}$), and -N($Q_{21}$)($Q_{22}$).

For example, $L_{11}$ in Formula 1 may be selected from:

a benzene group, a naphthalene group, a phenalene group, an anthracene group, a fluoranthene group, a triphenylene group, a phenanthrene group, a pyrene group, a chrysene group, a perylene group, a fluorene group, a carbazole group, a dibenzofuran group, a dibenzothiophene group, -C($Q_1$)($Q_2$)-, and -Si($Q_1$)($Q_2$)-; and

a benzene group, a naphthalene group, a phenalene group, an anthracene group, a fluoranthene group, a triphenylene group, a phenanthrene group, a pyrene group, a chrysene group, a perylene group, a fluorene group, a carbazole group, a dibenzofuran group, and a dibenzothiophene group, each substituted with at least one selected from deuterium, a $C_1$-$C_{20}$ (*e.g.* $C_1$-$C_{10}$) alkyl group, a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a benzofluorenyl group, a benzocarbazolyl group, a benzonaphthofuranyl group, a benzonaphthothiophenyl group, a dibenzofluorenyl group, a dibenzocarbazolyl group, a dinaphthofuranyl group, a dinaphthothiophenyl group, -C($Q_{31}$)($Q_{32}$)($Q_{33}$), and -Si($Q_{31}$)($Q_{32}$)($Q_{33}$).

In one embodiment, $L_{11}$ in Formula 1 may be selected from:

a benzene group, a fluorene group, a carbazole group, a dibenzofuran group, a dibenzothiophene group, -C($Q_1$)($Q_2$)-, and -Si($Q_1$)($Q_2$)-; and

a benzene group, a fluorene group, a carbazole group, a dibenzofuran group, and a dibenzothiophene group, each substituted with at least one selected from deuterium, a $C_1$-$C_{20}$ (*e.g.* $C_1$-$C_{10}$) alkyl group, a phenyl group, a biphenyl

group, a terphenyl group, a fluorenyl group, a carbazolyl group, a dibenzofuranyl group, a dibenzothiophenyl group, $-C(Q_{31})(Q_{32})(Q_{33})$, and $-Si(Q_{31})(Q_{32})(Q_{33})$.

For example, a11 in Formula 1 may be 1 or 2.

For example, $A_{11}$ in Formula 1 may be selected from:

a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a benzofluorenyl group, a benzocarbazolyl group, a benzonaphthofuranyl group, a benzonaphthothiophenyl group, a dibenzofluorenyl group, a dibenzocarbazolyl group, a dinaphthofuranyl group, and a dinaphthothiophenyl group;
a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a benzofluorenyl group, a benzocarbazolyl group, a benzonaphthofuranyl group, a benzonaphthothiophenyl group, a dibenzofluorenyl group, a dibenzocarbazolyl group, a dinaphthofuranyl group, and a dinaphthothiophenyl group, each substituted with at least one selected from deuterium, a $C_1$-$C_{20}$ (*e.g.* $C_1$-$C_{10}$) alkyl group, a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a benzofluorenyl group, a benzocarbazolyl group, a benzonaphthofuranyl group, a benzonaphthothiophenyl group, a dibenzofluorenyl group, a dibenzocarbazolyl group, a dinaphthofuranyl group, a dinaphthothiophenyl group, $-C(Q_{31})(Q_{32})(Q_{33})$, $-Si(Q_{31})(Q_{32})(Q_{33})$, $-B(Q_{31})(Q_{32})$, and $-N(Q_{31})(Q_{32})$; and
a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a benzofluorenyl group, a benzocarbazolyl group, a benzonaphthofuranyl group, a benzonaphthothiophenyl group, a dibenzofluorenyl group, a dibenzocarbazolyl group, a dinaphthofuranyl group, and a dinaphthothiophenyl group, each substituted with at least one selected from a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a benzofluorenyl group, a benzocarbazolyl group, a benzonaphthofuranyl group, a benzonaphthothiophenyl group, a dibenzofluorenyl group, a dibenzocarbazolyl group, a dinaphthofuranyl group, and a dinaphthothiophenyl group that are each independently substituted with at least one selected from deuterium, a $C_1$-$C_{20}$ (*e.g.* $C_1$-$C_{10}$) alkyl group, a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a benzofluorenyl group, a benzocarbazolyl group, a benzonaphthofuranyl group, a benzonaphthothiophenyl group, a dibenzofluorenyl group, a dibenzocarbazolyl group, a dinaphthofuranyl group, a dinaphthothiophenyl group, $-C(Q_{21})(Q_{22})(Q_{23})$, $-Si(Q_{21})(Q_{22})(Q_{23})$, $-B(Q_{21})(Q_{22})$, and $-N(Q_{21})(Q_{22})$.

In one embodiment, $A_{11}$ in Formula 1 may be selected from:

a phenyl group, a biphenyl group, a terphenyl group, a fluorenyl group, a carbazolyl group, a dibenzofuranyl group, and a dibenzothiophenyl group;
a phenyl group, a biphenyl group, a terphenyl group, a fluorenyl group, a carbazolyl group, a dibenzofuranyl group, and a dibenzothiophenyl group, each substituted with at least one selected from deuterium, a $C_1$-$C_{20}$ (*e.g.* $C_1$-$C_{10}$) alkyl group, a phenyl group, a biphenyl group, a terphenyl group, a fluorenyl group, a carbazolyl group, a dibenzofuranyl group, a dibenzothiophenyl group, $-C(Q_{31})(Q_{32})(Q_{33})$, and $-Si(Q_{31})(Q_{32})(Q_{33})$; and
a phenyl group, a biphenyl group, a terphenyl group, a fluorenyl group, a carbazolyl group, a dibenzofuranyl group, and a dibenzothiophenyl group, each substituted with at least one selected from a phenyl group, a biphenyl group, a terphenyl group, a fluorenyl group, a carbazolyl group, a dibenzofuranyl group, and a dibenzothiophenyl group that are each independently substituted with at least one selected from deuterium, a $C_1$-$C_{20}$ (*e.g.* $C_1$-$C_{10}$) alkyl group, a phenyl group, a biphenyl group, a terphenyl group, a fluorenyl group, a carbazolyl group, a dibenzofuranyl group, a dibenzothiophenyl group, $-C(Q_{21})(Q_{22})(Q_{23})$, and $-Si(Q_{21})(Q_{22})(Q_{23})$.

In one or more embodiments, $A_{11}$ in Formula 1 may be represented by one of Formulae 8-1 to 8-5 below:

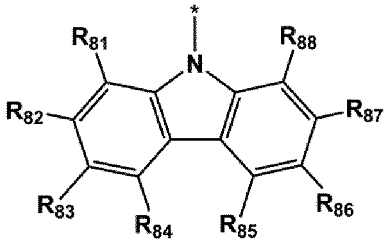

8-1

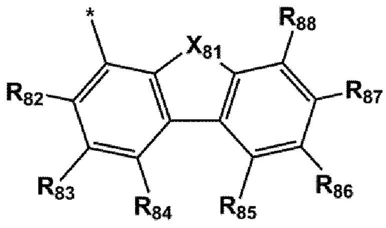

8-2

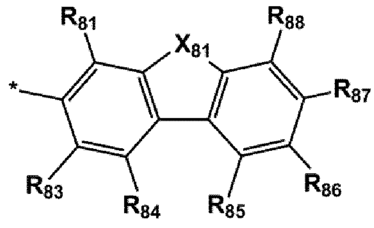

8-3

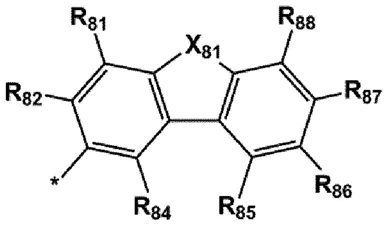

8-4

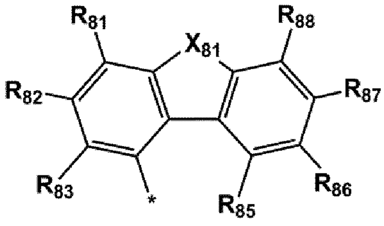

8-5

In Formulae 8-1 to 8-5,

$X_{81}$ is selected from O, S, N($R_{89}$), and C($R_{89}$)($R_{90}$),
$R_{81}$ to $R_{90}$ are each independently selected from hydrogen, deuterium, a $C_1$-$C_{20}$ (*e.g.* $C_1$-$C_{10}$) alkyl group, a phenyl group, a biphenyl group, a terphenyl group, a fluorenyl group, a carbazolyl group, a dibenzofuranyl group, and a dibenzothiophenyl group, and
* indicates a binding site to a neighboring atom.

In one embodiment, the first compound may be represented by one of Formulae 1-1 to 1-5 below:

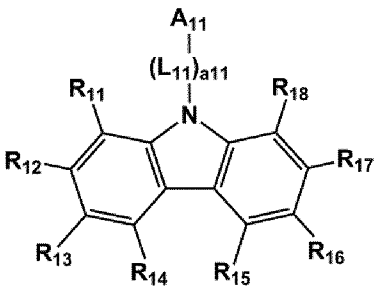

1-1

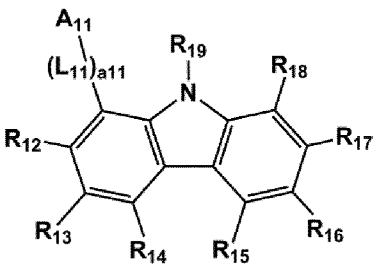

1-2

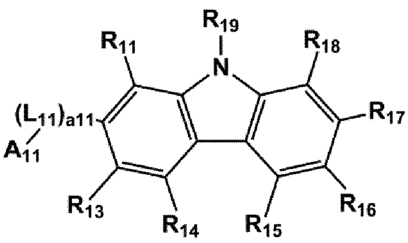

1-3

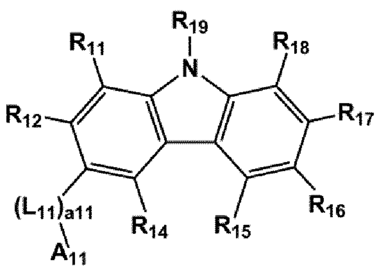

1-4

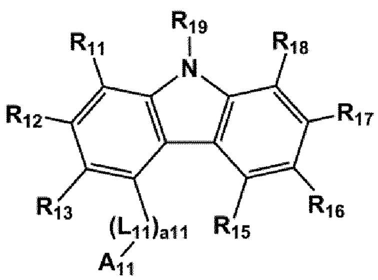

1-5

In Formulae 1-1 to 1-5,
$L_{11}$, a11, $A_{11}$, and $R_{11}$ to $R_{19}$ are each understood by referring to the descriptions provided in connection with Formula 1. That is, $L_{11}$, a11, $A_{11}$, and $R_{11}$ to $R_{19}$ are each the same as respectively defined in connection with Formula 1.
For example, $A_{11}$ in Formulae 1-1 to 1-5 may be represented by one of Formulae 8-1 to 8-5 below:

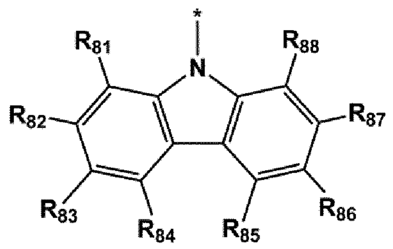

8-1

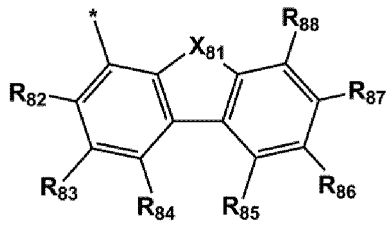

8-2

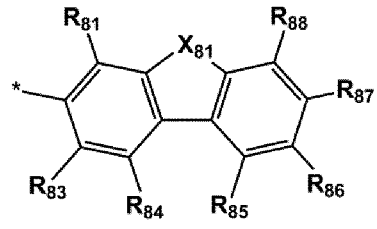

8-3

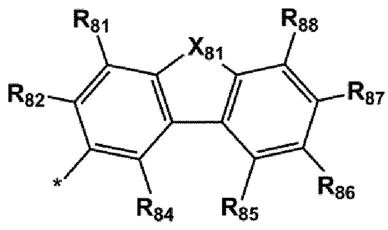

8-4

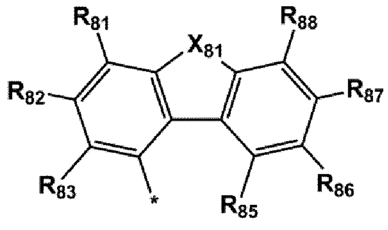

8-5

In Formulae 8-1 to 8-5,

$X_{81}$ is selected from O, S, N($R_{89}$), and C($R_{89}$)($R_{90}$),
$R_{81}$ to $R_{90}$ are each independently selected from hydrogen, deuterium, a $C_1$-$C_{20}$ (*e.g.* $C_1$-$C_{10}$) alkyl group, a phenyl group, a biphenyl group, a terphenyl group, a fluorenyl group, a carbazolyl group, a dibenzofuranyl group, and a dibenzothiophenyl group, and
* indicates a binding site to a neighboring atom.

For example, at least one selected from $R_{21}$, $R_{22}$, $R_{24}$, and $R_{25}$ in Formula 2A may be a group represented by $*-(L_{21})_{a21}-A_{21}$, and at least one $R_{23}$ in the number of (6-k23) in Formula 2B may be a group represented by $*-(L_{21})_{a21}-A_{21}$.
For example, $R_{21}$ to $R_{25}$ in Formulae 2A and 2B may each independently be a group represented by $*-(L_{21})_{a21}-A_{21}$, hydrogen,deuterium, -F, a cyano group, a $C_1$-$C_{20}$ (*e.g.* $C_1$-$C_{10}$) alkyl group, a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a benzofluorenyl group, a benzocarbazolyl group, a benzonaphthofuranyl group, a benzonaphthothiophenyl group, a dibenzofluorenyl group, a dibenzocarbazolyl group, a dinaphthofuranyl group, a dinaphthothiophenyl group, an indeno fluorenyl group, an indolofluorenyl group, a benzofurofluorenyl group, a benzothienofluorenyl group, an indeno carbazolyl group, an indolocarbazolyl group, a benzofurocarbazolyl group, a benzothienocarbazolyl group, an indenodibenzofuranyl group, an indolodibenzofuranyl group, a benzofurodibenzofuranyl group, a benzothienodibenzofuranyl group, an indenodibenzothiophenyl group, an indolodibenzothiophenyl group, a benzofurodibenzothiophenyl group, a benzothienodibenzothiophenyl group, a pyridinyl group, a pyrazinyl group, a pyridazinyl group, a pyrimidinyl group, a triazinyl group, a quinolinyl group, an isoquinolinyl group, a benzoquinolinyl group, a benzoisoquinolinyl group, a naphthyridinyl group, a quinoxalinyl group, a quinazolinyl group, an azafluorenyl group, an azacarbazolyl group, an azadibenzofuranyl group, an azadibenzothiophenyl group, a diazafluorenyl group, a diazacarbazolyl group, a diazadibenzofuranyl group, a diazadibenzothiophenyl group, -C($Q_1$)($Q_2$)($Q_3$), -Si($Q_1$)($Q_2$)($Q_3$), -B($Q_1$)($Q_2$), -N($Q_1$)($Q_2$), -S(=O)($Q_7$), $-S(=O)_2(Q_1)$, -P(=O)($Q_1$)($Q_2$), and -P(=S)($Q_1$)($Q_2$);

a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a benzofluorenyl group, a benzocarbazolyl group, a benzonaphthofuranyl group, a benzonaphthothiophenyl group, a dibenzofluorenyl group, a dibenzocarbazolyl group, a dinaphthofuranyl group, a dinaphthothiophenyl group, an indeno fluorenyl group, an indolofluorenyl group, a benzofurofluorenyl group, a benzothienofluorenyl group, an indeno carbazolyl group, an indolocarbazolyl group, a benzofurocarbazolyl group, a benzothienocarbazolyl group, an indenodibenzofuranyl group, an indolodibenzofuranyl group, a benzofurodibenzofuranyl group, a benzothienodibenzofuranyl group, an indenodibenzothiophenyl group, an indolodibenzothiophenyl group, a benzofurodibenzothiophenyl group, a benzothienodibenzothiophenyl group, a pyridinyl group, a pyrazinyl group, a pyridazinyl group, a pyrimidinyl group, a triazinyl group, a quinolinyl group, an isoquinolinyl group, a benzoquinolinyl

group, a benzoisoquinolinyl group, a naphthyridinyl group, a quinoxalinyl group, a quinazolinyl group, an azafluorenyl group, an azacarbazolyl group, an azadibenzofuranyl group, an azadibenzothiophenyl group, a diazafluorenyl group, a diazacarbazolyl group, a diazadibenzofuranyl group, and a diazadibenzothiophenyl group, each substituted with at least one selected from deuterium, -F, a cyano group, a $C_1$-$C_{20}$ (*e.g.* $C_1$-$C_{10}$) alkyl group, a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a benzofluorenyl group, a benzocarbazolyl group, a benzonaphthofuranyl group, a benzonaphthothiophenyl group, a dibenzofluorenyl group, a dibenzocarbazolyl group, a dinaphthofuranyl group, a dinaphthothiophenyl group, an indeno fluorenyl group, an indolofluorenyl group, a benzofurofluorenyl group, a benzothienofluorenyl group, an indeno carbazolyl group, an indolocarbazolyl group, a benzofurocarbazolyl group, a benzothienocarbazolyl group, an indenodibenzofuranyl group, an indolodibenzofuranyl group, a benzofurodibenzofuranyl group, a benzothienodibenzofuranyl group, an indenodibenzothiophenyl group, an indolodibenzothiophenyl group, a benzofurodibenzothiophenyl group, a benzothienodibenzothiophenyl group, a pyridinyl group, a pyrazinyl group, a pyridazinyl group, a pyrimidinyl group, a triazinyl group, a quinolinyl group, an isoquinolinyl group, a benzoquinolinyl group, a benzoisoquinolinyl group, a naphthyridinyl group, a quinoxalinyl group, a quinazolinyl group, an azafluorenyl group, an azacarbazolyl group, an azadibenzofuranyl group, an azadibenzothiophenyl group, a diazafluorenyl group, a diazacarbazolyl group, a diazadibenzofuranyl group, a diazadibenzothiophenyl group, $-C(Q_{31})(Q_{32})(Q_{33})$, $-Si(Q_{31})(Q_{32})(Q_{33})$, $-B(Q_{31})(Q_{32})$, $-N(Q_{31})(Q_{32})$, $-S(=O)(Q_{31})$, $-S(=O)_2(Q_{31})$, $-P(=O)(Q_{31})(Q_{32})$, and $-P(=S)(Q_{31})(Q_{32})$; and

a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a benzofluorenyl group, a benzocarbazolyl group, a benzonaphthofuranyl group, a benzonaphthothiophenyl group, a dibenzofluorenyl group, a dibenzocarbazolyl group, a dinaphthofuranyl group, a dinaphthothiophenyl group, an indeno fluorenyl group, an indolofluorenyl group, a benzofurofluorenyl group, a benzothienofluorenyl group, an indeno carbazolyl group, an indolocarbazolyl group, a benzofurocarbazolyl group, a benzothienocarbazolyl group, an indenodibenzofuranyl group, an indolodibenzofuranyl group, a benzofurodibenzofuranyl group, a benzothienodibenzofuranyl group, an indenodibenzothiophenyl group, an indolodibenzothiophenyl group, a benzofurodibenzothiophenyl group, a benzothienodibenzothiophenyl group, a pyridinyl group, a pyrazinyl group, a pyridazinyl group, a pyrimidinyl group, a triazinyl group, a quinolinyl group, an isoquinolinyl group, a benzoquinolinyl group, a benzoisoquinolinyl group, a naphthyridinyl group, a quinoxalinyl group, a quinazolinyl group, an azafluorenyl group, an azacarbazolyl group, an azadibenzofuranyl group, an azadibenzothiophenyl group, a diazafluorenyl group, a diazacarbazolyl group, a diazadibenzofuranyl group, and a diazadibenzothiophenyl group , each substituted with at least one selected from a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a benzofluorenyl group, a benzocarbazolyl group, a benzonaphthofuranyl group, a benzonaphthothiophenyl group, a dibenzofluorenyl group, a dibenzocarbazolyl group, a dinaphthofuranyl group, a dinaphthothiophenyl group, an indeno fluorenyl group, an indolofluorenyl group, a benzofurofluorenyl group, a benzothienofluorenyl group, an indeno carbazolyl group, an indolocarbazolyl group, a benzofurocarbazolyl group, a benzothienocarbazolyl group, an indenodibenzofuranyl group, an indolodibenzofuranyl group, a benzofurodibenzofuranyl group, a benzothienodibenzofuranyl group, an indenodibenzothiophenyl group, an indolodibenzothiophenyl group, a benzofurodibenzothiophenyl group, a benzothienodibenzothiophenyl group, a pyridinyl group, a pyrazinyl group, a pyridazinyl group, a pyrimidinyl group, a triazinyl group, a quinolinyl group, an isoquinolinyl group, a benzoquinolinyl group, a benzoisoquinolinyl group, a naphthyridinyl group, a quinoxalinyl group, a quinazolinyl group, an azafluorenyl group, an azacarbazolyl group, an azadibenzofuranyl group, an azadibenzothiophenyl group, a diazafluorenyl group, a diazacarbazolyl group, a diazadibenzofuranyl group, and a diazadibenzothiophenyl group that are each independently substituted with at least one selected from deuterium, -F, a cyano group, a $C_1$-$C_{20}$ (e.g. $C_1$-$C_{10}$) alkyl group, a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a benzofluorenyl group, a benzocarbazolyl group, a benzonaphthofuranyl group, a benzonaphthothiophenyl group, a dibenzofluorenyl group, a dibenzocarbazolyl group, a dinaphthofuranyl group, a dinaphthothiophenyl group, an indeno fluorenyl group, an indolofluorenyl group, a benzofurofluorenyl group, a benzothienofluorenyl group, an indeno carbazolyl group, an indolocarbazolyl group, a benzofurocarbazolyl group, a benzothienocarbazolyl group, an indenodibenzofuranyl group, an indolodibenzofuranyl group, a benzofurodibenzofuranyl group, a benzothienodibenzofuranyl group, an indenodibenzothiophenyl group, an indolodibenzothiophenyl group, a benzofurodibenzothiophenyl group, a benzothienodibenzothiophenyl group, a pyridinyl group, a pyrazinyl group, a pyridazinyl group, a pyrimidinyl group, a triazinyl group, a quinolinyl group, an isoquinolinyl group, a benzoquinolinyl group, a benzoisoquinolinyl group, a naphthyridinyl group, a quinoxalinyl group, a quinazolinyl group, an azafluorenyl group, an azacarbazolyl group, an azadibenzofuranyl

group, an azadibenzothiophenyl group, a diazafluorenyl group, a diazacarbazolyl group, a diazadibenzofuranyl group, a diazadibenzothiophenyl group, $-C(Q_{21})(Q_{22})(Q_{23})$, $-Si(Q_{21})(Q_{22})(Q_{23})$, $-B(Q_{21})(Q_{22})$, $-N(Q_{21})(Q_{22})$, $-S(=O)(Q_{21})$, $-S(=O)_2(Q_{21})$, $-P(=O)(Q_{21})(Q_{22})$, and $-P(=S)(Q_{21})(Q_{22})$, and

$Q_1$ to $Q_3$, $Q_{21}$ to $Q_{23}$, and $Q_{31}$ to $Q_{33}$ are the same as described above.

For example, $L_{21}$ in Formulae 2A and 2B may be selected from:

a benzene group, a naphthalene group, a phenalene group, an anthracene group, a fluoranthene group, a triphenylene group, a phenanthrene group, a pyrene group, a chrysene group, a perylene group, a pyridine group, a pyrimidine group, a pyrazine group, a pyridazine group, a triazine group, a quinoline group, an isoquinoline group, a benzoquinoline group, a benzoisoquinoline group, a phthalazine group, a naphthyridine group, a quinoxaline group, a benzoquinoxaline group, a quinazoline group, a benzoquinazoline group, a fluorene group, a carbazole group, a dibenzofuran group, a dibenzothiophene group, $-C(Q_1)(Q_2)-$, $-Si(Q_1)(Q_2)-$, $-S(=O)-$, and $-P(=O)(Q_1)-$; and

a benzene group, a naphthalene group, a phenalene group, an anthracene group, a fluoranthene group, a triphenylene group, a phenanthrene group, a pyrene group, a chrysene group, a perylene group, a pyridine group, a pyrimidine group, a pyrazine group, a pyridazine group, a triazine group, a quinoline group, an isoquinoline group, a benzoquinoline group, a benzoisoquinoline group, a phthalazine group, a naphthyridine group, a quinoxaline group, a benzoquinoxaline group, a quinazoline group, a benzoquinazoline group, a fluorene group, a carbazole group, a dibenzofuran group, and a dibenzothiophene group, each substituted with at least one selected from deuterium, -F, a cyano group, a $C_1$-$C_{20}$ (*e.g.* $C_1$-$C_{10}$) alkyl group, a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a benzofluorenyl group, a benzocarbazolyl group, a benzonaphthofuranyl group, a benzonaphthothiophenyl group, a dibenzofluorenyl group, a dibenzocarbazolyl group, a dinaphthofuranyl group, a dinaphthothiophenyl group, an indeno fluorenyl group, an indolofluorenyl group, a benzofurofluorenyl group, a benzothienofluorenyl group, an indeno carbazolyl group, an indolocarbazolyl group, a benzofurocarbazolyl group, a benzothienocarbazolyl group, an indenodibenzofuranyl group, an indolodibenzofuranyl group, a benzofurodibenzofuranyl group, a benzothienodibenzofuranyl group, an indenodibenzothiophenyl group, an indolodibenzothiophenyl group, a benzofurodibenzothiophenyl group, a benzothienodibenzothiophenyl group, a pyridinyl group, a pyrazinyl group, a pyridazinyl group, a pyrimidinyl group, a triazinyl group, a quinolinyl group, an isoquinolinyl group, a benzoquinolinyl group, a benzoisoquinolinyl group, a naphthyridinyl group, a quinoxalinyl group, a quinazolinyl group, an azafluorenyl group, an azacarbazolyl group, an azadibenzofuranyl group, an azadibenzothiophenyl group, a diazafluorenyl group, a diazacarbazolyl group, a diazadibenzofuranyl group, a diazadibenzothiophenyl group, $-C(Q_{31})(Q_{32})(Q_{33})$, $-Si(Q_{31})(Q_{32})(Q_{33})$, $-S(=O)(Q_{31})$, and $-P(=O)(Q_{31})(Q_{32})$, and

$Q_1$ to $Q_3$ and $Q_{31}$ to $Q_{33}$ are the same as described above.

In one embodiment, $L_{21}$ in Formulae 2A and 2B may be selected from:

a benzene group, a pyridine group, a pyrimidine group, a pyrazine group, a pyridazine group, a triazine group, a fluorene group, a carbazole group, a dibenzofuran group, a dibenzothiophene group, $-C(Q_1)(Q_2)-$, $-Si(Q_1)(Q_2)-$, $-S(=O)-$, and $-P(=O)(Q_1)-$; and

a benzene group, a pyridine group, a pyrimidine group, a pyrazine group, a pyridazine group, a triazine group, a fluorene group, a carbazole group, a dibenzofuran group, and a dibenzothiophene group, each substituted with at least one selected from deuterium, -F, a cyano group, a $C_1$-$C_{20}$ (*e.g.* $C_1$-$C_{10}$) alkyl group, a phenyl group, a biphenyl group, a terphenyl group, a fluorenyl group, a carbazolyl group, a dibenzofuranyl group, a dibenzothiophenyl group, a pyridinyl group, a pyrazinyl group, a pyridazinyl group, a pyrimidinyl group, a triazinyl group, $-C(Q_{31})(Q_{32})(Q_{33})$, $-Si(Q_{31})(Q_{32})(Q_{33})$, $-S(=O)(Q_{31})$, and $-P(=O)(Q_{31})(Q_{32})$, and

$Q_1$ to $Q_3$ and $Q_{31}$ to $Q_{33}$ are the same as described above.

For example, a21 in Formulae 2A and 2B may be 1 or 2.

For example, $A_{21}$ in Formulae 2A and 2B may be selected from:

a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a pyridinyl group, a pyrazinyl group, a pyridazinyl group, a pyrimidinyl group, a triazinyl group, a quinolinyl group, an isoquinolinyl group, a naphthyridinyl group, a quinoxalinyl group, and a quinazolinyl group;

a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a pyridinyl group, a pyrazinyl group, a pyridazinyl group, a pyrimidinyl group, a triazinyl group, a quinolinyl group, an isoquinolinyl group, a naphthyridinyl group, a quinoxalinyl group, and a quinazolinyl group, each substituted with at least one selected from deuterium, -F, a cyano group, a $C_1$-$C_{20}$ (*e.g.* $C_1$-$C_{10}$) alkyl group, a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a pyridinyl group, a pyrazinyl group, a pyridazinyl group, a pyrimidinyl group, a triazinyl group, a quinolinyl group, an isoquinolinyl group, a naphthyridinyl group, a quinoxalinyl group, a quinazolinyl group, $-C(Q_{31})(Q_{32})(Q_{33})$, $-Si(Q_{31})(Q_{32})(Q_{33})$, $-B(Q_{31})(Q_{32})$, $-N(Q_{31})(Q_{32})$, $-S(=O)(Q_{31})$, $-S(=O)_2(Q_{31})$, $-P(=O)(Q_{31})(Q_{32})$, and $-P(=S)(Q_{31})(Q_{32})$; and

a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a pyridinyl group, a pyrazinyl group, a pyridazinyl group, a pyrimidinyl group, a triazinyl group, a quinolinyl group, an isoquinolinyl group, a naphthyridinyl group, a quinoxalinyl group, and a quinazolinyl group, each substituted with at least one selected from a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a pyridinyl group, a pyrazinyl group, a pyridazinyl group, a pyrimidinyl group, a triazinyl group, a quinolinyl group, an isoquinolinyl group, a naphthyridinyl group, a quinoxalinyl group, and a quinazolinyl group that are each independently substituted with at least one selected from deuterium, -F, a cyano group, a $C_1$-$C_{20}$ (*e.g.* $C_1$-$C_{10}$) alkyl group, a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a pyridinyl group, a pyrazinyl group, a pyridazinyl group, a pyrimidinyl group, a triazinyl group, a quinolinyl group, an isoquinolinyl group, a naphthyridinyl group, a quinoxalinyl group, a quinazolinyl group, $-C(Q_{21})(Q_{22})(Q_{23})$, $-Si(Q_{21})(Q_{22})(Q_{23})$, $-B(Q_{21})(Q_{22})$, $-N(Q_{21})(Q_{22})$, $-S(=O)(Q_{21})$, $-S(=O)_2(Q_{21})$, $-P(=O)(Q_{21})(Q_{22})$, and $-P(=S)(Q_{21})(Q_{22})$, and

$Q_1$ to $Q_3$, $Q_{21}$ to $Q_{23}$, and $Q_{31}$ to $Q_{33}$ are the same as described above.

In one embodiment, $A_{21}$ in Formula 2A and $A_{21}$ in Formula 2B may each independently be selected from:

a phenyl group, a biphenyl group, a terphenyl group, a fluorenyl group, a carbazolyl group, a dibenzofuranyl group, a dibenzothiophenyl group, a pyridinyl group, a pyrazinyl group, a pyridazinyl group, a pyrimidinyl group, and a triazinyl group;

a phenyl group, a biphenyl group, a terphenyl group, a fluorenyl group, a carbazolyl group, a dibenzofuranyl group, a dibenzothiophenyl group, a pyridinyl group, a pyrazinyl group, a pyridazinyl group, a pyrimidinyl group, and a triazinyl group, each substituted with at least one selected from deuterium, -F, a cyano group, a $C_1$-$C_{20}$ (*e.g.* $C_1$-$C_{10}$) alkyl group, a phenyl group, a biphenyl group, a terphenyl group, a fluorenyl group, a carbazolyl group, a dibenzofuranyl group, a dibenzothiophenyl group, a pyridinyl group, a pyrazinyl group, a pyridazinyl group, a pyrimidinyl group, a triazinyl group, $-C(Q_{31})(Q_{32})(Q_{33})$, $-Si(Q_{31})(Q_{32})(Q_{33})$, and $-P(=O)(Q_{31})(Q_{32})$; and

a phenyl group, a biphenyl group, a terphenyl group, a fluorenyl group, a carbazolyl group, a dibenzofuranyl group, a dibenzothiophenyl group, a pyridinyl group, a pyrazinyl group, a pyridazinyl group, a pyrimidinyl group, and a triazinyl group, each substituted with at least one selected from a phenyl group, a biphenyl group, a terphenyl group, a fluorenyl group, a carbazolyl group, a dibenzofuranyl group, a dibenzothiophenyl group, a pyridinyl group, a pyrazinyl group, a pyridazinyl group, a pyrimidinyl group, and a triazinyl group that are each independently substituted with at least one selected from deuterium, -F, a cyano group, a $C_1$-$C_{20}$ (*e.g.* $C_1$-$C_{10}$) alkyl group, a phenyl group, a biphenyl group, a terphenyl group, a fluorenyl group, a carbazolyl group, a dibenzofuranyl group, a dibenzothiophenyl group, a pyridinyl group, a pyrazinyl group, a pyridazinyl group, a pyrimidinyl group, a triazinyl group, $-C(Q_{21})(Q_{22})(Q_{23})$, $-Si(Q_{21})(Q_{22})(Q_{23})$, and $-P(=O)(Q_{21})(Q_{22})$, and

$Q_1$ to $Q_3$, $Q_{21}$ to $Q_{23}$, and $Q_{31}$ to $Q_{33}$ are the same as described above.

In one embodiment, the second compound may be represented by one of Formulae 2-1 and 2-2 below:

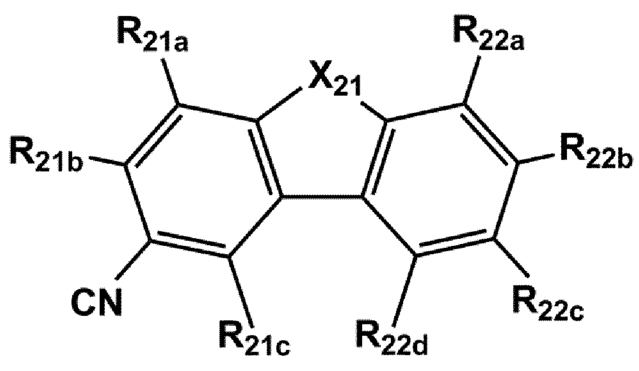

2-1

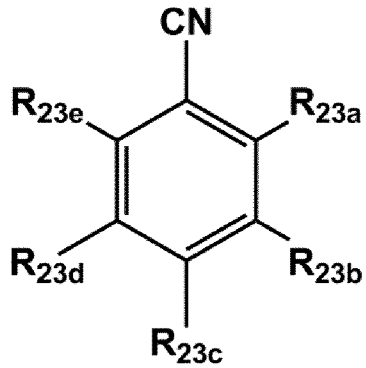

2-2

In Formulae 2-1 and 2-2,

$X_{21}$ is selected from O, S, $N(R_{24})$, and $C(R_{24})(R_{25})$,

$R_{21a}$ to $R_{21c}$, $R_{22a}$ to $R_{22d}$, $R_{23a}$ to $R_{23e}$, $R_{24}$, and $R_{25}$ are each independently selected from:

a group represented by *-$(L_{21})_{a21}$-$A_{21}$, hydrogen, deuterium, -F, a cyano group, a $C_1$-$C_{60}$ (*e.g.* $C_1$-$C_{20}$) alkyl group, a $\pi$ electron-depleted nitrogen-containing cyclic group, a $\pi$ electron-depleted nitrogen-free cyclic group, $-C(Q_1)(Q_2)(Q_3)$, - $Si(Q_1)(Q_2)(Q_3)$, $-B(Q_1)(Q_2)$, $-N(Q_1)(Q_2)$, $-S(=O)(Q_1)$, $-S(=O)_2(Q_1)$, $-P(=O)(Q_1)(Q_2)$, and - $P(=S)(Q_1)(Q_2)$;

a $\pi$ electron-depleted nitrogen-containing cyclic group and a $\pi$ electron-depleted nitrogen-free cyclic group, each substituted with at least one selected from deuterium, -F, a cyano group, a $C_1$-$C_{60}$ (*e.g.* $C_1$-$C_{20}$) alkyl group, a $\pi$ electron-depleted nitrogen-containing cyclic group, a $\pi$ electron-depleted nitrogen-free cyclic group, - $C(Q_{31})(Q_{32})(Q_{33})$, $-Si(Q_{31})(Q_{32})(Q_{33})$, $-B(Q_{31})(Q_{32})$, $-N(Q_{31})(Q_{32})$, $-S(=O)(Q_{31})$, - $S(=O)_2(Q_{31})$, $-P(=O)(Q_{31})(Q_{32})$, and $-P(=S)(Q_{31})(Q_{32})$; and

a $\pi$ electron-depleted nitrogen-containing cyclic group and a $\pi$ electron-depleted nitrogen-free cyclic group, each substituted with at least one selected from a $\pi$ electron-depleted nitrogen-containing cyclic group and a $\pi$ electron-depleted nitrogen-free cyclic group that are each independently substituted with at least one selected from deuterium, -F, a cyano group, a $C_1$-$C_{60}$ (*e.g.* $C_1$-$C_{20}$) alkyl group, a $\pi$ electron-depleted nitrogen-containing cyclic group, a $\pi$ electron-depleted nitrogen-free cyclic group, $-C(Q_{21})(Q_{22})(Q_{23})$, $-Si(Q_{21})(Q_{22})(Q_{23})$, $-B(Q_{21})(Q_{22})$, $-N(Q_{21})(Q_{22})$, - $S(=O)(Q_{21})$, $-S(=O)_2(Q_{21})$, $-P(=O)(Q_{21})(Q_{22})$, and $-P(=S)(Q_{21})(Q_{22})$,

at least one selected from $R_{21a}$ to $R_{21c}$, $R_{22a}$ to $R_{22d}$, $R_{24}$, and $R_{25}$ in Formula 2-1 is the group represented by *-$(L_{21})_{a21}$-$A_{21}$,

at least one selected from $R_{23a}$ to $R_{23e}$ in Formula 2-2 is the group represented by *-$(L_{21})_{a21}$-$A_{21}$,

b41 to b43 may each independently be an integer from 0 to 10, and

$Q_1$ to $Q_3$, $Q_{21}$ to $Q_{23}$, and $Q_{31}$ to $Q_{33}$ are each independently selected from hydrogen, deuterium, -F, -Cl, -Br, -I, a hydroxyl group, a cyano group, a nitro group, an amidino group, a hydrazino group, a hydrazono group, a $C_1$-$C_{60}$ (*e.g.* $C_1$-$C_{20}$) alkyl group, a $C_2$-$C_{60}$ (*e.g.* $C_2$-$C_{20}$) alkenyl group, a $C_2$-$C_{60}$ (*e.g.* $C_2$-$C_{20}$) alkynyl group, a $C_1$-$C_{60}$ (*e.g.* $C_1$-$C_{20}$) alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ (*e.g.* $C_6$-$C_{30}$) aryl group, a $C_6$-$C_{60}$ (*e.g.* $C_6$-$C_{30}$) aryloxy group, a $C_6$-$C_{60}$ (*e.g.* $C_6$-$C_{30}$) arylthio group, a $C_1$-$C_{60}$ (*e.g.* $C_1$-$C_{20}$) heteroaryl group, a $C_1$-$C_{60}$ (*e.g.* $C_1$-$C_{20}$) heteroaryloxy group, a $C_1$-$C_{60}$ (*e.g.* $C_1$-$C_{20}$) heteroarylthio group, a monovalent non-aromatic condensed polycyclic group, a monovalent non-aromatic condensed heteropolycyclic group, a biphenyl group, and a terphenyl group.

For example, $M_{31}$ in Formula 3 may be selected from platinum (Pt), palladium (Pd), copper (Cu), silver (Ag), gold (Au), rhodium (Rh), iridium (Ir), ruthenium (Ru), osmium (Os), titanium (Ti), zirconium (Zr), hafnium (Hf), europium (Eu), terbium (Tb), and thulium (Tm).

In one embodiment, $M_{31}$ in Formula 3 may be selected from Pt and Ir.

For example, $A_{31}$ to $A_{34}$ in Formulae 3A to 3D may each independently be i) a first ring, ii) a second ring, iii) a condensed ring in which two or more first rings are condensed with each other, iv) a condensed ring in which two or more second rings are condensed with each other, or v) a condensed ring in which one or more first rings and one or more second rings are condensed with each other,

wherein the first ring may be selected from a cyclopentane group, a cyclopentene group, a cyclopentadiene group, a furan group, a thiophene group, a pyrrole group, a borole group, a phosphole group, a silole group, a germole group, a selenophene group, an oxazole group, a dihydroxazole group, an isoxazole group, a dihydroisoxazole group, an oxadiazole group, a dihydroxydiazole group, an isoxadiazole group, a dihydroisoxadiazole group, an oxatriazole group, a dihydroxytriazole group, an isoxatriazole group, a dihydroisoxatriazole group, a thiazole group, a dihydrothiazole group, an isothiazole group, a dihydroisothiazole group, a thiadiazole group, a dihydrothiadiazole group, an isothiadiazole group, a dihydroisothiadiazole group, a thiatriazole group, a dihydrothiatriazole group, an isothiatriazole group, a dihydroisothiatriazole group, a pyrazole group, a dihydropyrazole group, an imidazole group, a dihydroimidazole group, a triazole group, a dihydrotriazole group, a tetrazole group, a dihydrotetrazole group, an azasilole group, a diazasilole group, and a triazasilole group, and

the second ring may be selected from a cyclohexane group, a cyclohexene group, a cyclohexadiene group, an adamantane group, a norbornane group, a norbornene group, a benzene group, a pyridine group, a dihydropyridine group, a tetrahydropyridine group, a pyrimidine group, a dihydropyrimidine group, a tetrahydropyrimidine group, a pyrazine group, a dihydropyrazine group, a tetrahydropyrazine group, a pyridazine group, a dihydropyridazine group, a tetrahydropyridazine group, and a triazine group.

In one embodiment, $A_{31}$ to $A_{34}$ in Formulae 3A to 3D may each independently be selected from a benzene group, a naphthalene group, an anthracene group, a phenanthrene group, a triphenylene group, a pyrene group, a chrysene group, a furan group, a thiophene group, a silole group, an indene group, a fluorene group, a benzofuran group, a dibenzofuran group, a benzothiophene group, a dibenzothiophene group, a benzosilole group, a dibenzosilole group, an indole group, a carbazole group, an indenopyridine group, an indolopyridine group, a benzofuropyridine group, a benzothienopyridine group, a benzosilolopyridine group, an indenopyrimidine group, an indolopyrimidine group, a benzofuropyrimidine group, a benzothienopyrimidine group, a benzosilolopyrimidine group, a pyridine group, a pyrimidine group, a pyrazine group, a pyridazine group, a triazine group, a quinoline group, an isoquinoline group, a quinoxaline group, a quinazoline group, a cinnoline group, a phthalazine group, a phenanthroline group, a pyrrole group, a pyrazole group, an imidazole group, a dihydroimidazole group, a triazole group, a dihydrotriazole group, an oxazole group, a dihydroxazole group, an isoxazole group, a thiazole group, a dihydrothiazole group, an isothiazole group, an oxadiazole group, a dihydroxydiazole group, a thiadiazole group, a dihydrothiadiazole group, a benzopyrazole group, a benzimidazole group, a dihydrobenzimidazole group, an imidazopyridine group, an imidazopyrimidine group, an imidazopyrazine group, a benzoxazole group, a dihydrobenzoxazole group, a benzothiazole group, a dihydrobenzothiazole group, a benzoxadiazole group, a dihydrobenzoxadiazole group, a benzothiadiazole group, and a dihydrobenzothiadiazole group.

For example, $T_{31}$ to $T_{34}$ in Formulae 3A to 3D may each independently be selected from a single bond, a double bond, *-O-*', *-S-*', *-C($R_{35}$)($R_{36}$)-*', and *-N($R_{35}$)-*'

For example, $Y_{31}$ to $Y_{34}$ in Formulae 3A to 3D may each independently be selected from a single bond, *-O-*', and *-S-*'.

For example, $R_{31}$ to $R_{38}$ in Formulae 3A to 3D may each independently be selected from:

hydrogen, deuterium, -F, -Cl, -Br, -I, a cyano group, a $C_1$-$C_{20}$ (e.g. $C_1$-$C_{10}$) alkyl group, and a $C_1$-$C_{20}$ (*e.g.* $C_1$-$C_{10}$) alkoxy group;

a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a benzofluorenyl group, a benzocarbazolyl group, a benzonaphthofuranyl group, a benzonaphthothiophenyl group, a dibenzofluorenyl group, a dibenzocarbazolyl group, a dinaphthofuranyl group, a dinaphthothiophenyl group, a pyridinyl group, a pyrazinyl group, a pyridazinyl group, a pyrimidinyl group, a triazinyl group, a quinolinyl group, an isoquinolinyl group, a quinolinyl group, an isoquinolinyl group, a naphthyridinyl group, a quinoxalinyl group, a quinazolinyl group, an azafluorenyl group, an azacarbazolyl group, an azadibenzofuranyl group, an azadibenzothiophenyl group, a diazafluorenyl group, a diazacarbazolyl group, a diazadibenzofuranyl group, and a diazadibenzothiophenyl group;

a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a benzofluorenyl group, a benzocarbazolyl group, a benzonaphthofuranyl group, a benzonaphthothiophenyl group, a dibenzofluorenyl group, a dibenzocarbazolyl group, a dinaphthofuranyl group, a dinaphthothiophenyl group, a pyridinyl group, a pyrazinyl group, a pyridazinyl group, a pyrimidinyl group, a triazinyl group, a quinolinyl group, an isoquinolinyl group, a quinolinyl group, an isoquinolinyl group, a naphthyridinyl group, a quinoxalinyl group, a quinazolinyl group, an azafluorenyl group, an azacarbazolyl group, an azadibenzofuranyl group, an azadibenzothiophenyl group, a diazafluorenyl group, a diazacarbazolyl group, a diazadibenzofuranyl group, and a diazadibenzothiophenyl group, each substituted with at least one selected from deuterium, -F, -Cl, -Br, -I, a cyano group, a $C_1$-$C_{20}$ (*e.g.* $C_1$-$C_{16}$) alkyl group, a $C_1$-$C_{20}$ (*e.g.* $C_1$-$C_{10}$) alkoxy group, a phenyl group, a biphenyl group,

a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a benzofluorenyl group, a benzocarbazolyl group, a benzonaphthofuranyl group, a benzonaphthothiophenyl group, a dibenzofluorenyl group, a dibenzocarbazolyl group, a dinaphthofuranyl group, a dinaphthothiophenyl group, a pyridinyl group, a pyrazinyl group, a pyridazinyl group, a pyrimidinyl group, a triazinyl group, a quinolinyl group, an isoquinolinyl group, a quinolinyl group, an isoquinolinyl group, a naphthyridinyl group, a quinoxalinyl group, a quinazolinyl group, an azafluorenyl group, an azacarbazolyl group, an azadibenzofuranyl group, an azadibenzothiophenyl group, a diazafluorenyl group, a diazacarbazolyl group, a diazadibenzofuranyl group, and a diazadibenzothiophenyl group; and
-B($Q_1$)($Q_2$) and -N($Q_1$)($Q_2$), and
$Q_1$ and $Q_2$ may each independently be selected from:

hydrogen, deuterium, and a $C_1$-$C_{20}$ (*e.g.* $C_1$-$C_{10}$) alkyl group;
a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a benzofluorenyl group, a benzocarbazolyl group, a benzonaphthofuranyl group, a benzonaphthothiophenyl group, a dibenzofluorenyl group, a dibenzocarbazolyl group, a dinaphthofuranyl group, a dinaphthothiophenyl group, a pyridinyl group, a pyrazinyl group, a pyridazinyl group, a pyrimidinyl group, a triazinyl group, a quinolinyl group, an isoquinolinyl group, a quinolinyl group, an isoquinolinyl group, a naphthyridinyl group, a quinoxalinyl group, a quinazolinyl group, an azafluorenyl group, an azacarbazolyl group, an azadibenzofuranyl group, an azadibenzothiophenyl group, a diazafluorenyl group, a diazacarbazolyl group, a diazadibenzofuranyl group, and a diazadibenzothiophenyl group; and
a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a benzofluorenyl group, a benzocarbazolyl group, a benzonaphthofuranyl group, a benzonaphthothiophenyl group, a dibenzofluorenyl group, a dibenzocarbazolyl group, a dinaphthofuranyl group, a dinaphthothiophenyl group, a pyridinyl group, a pyrazinyl group, a pyridazinyl group, a pyrimidinyl group, a triazinyl group, a quinolinyl group, an isoquinolinyl group, a quinolinyl group, an isoquinolinyl group, a naphthyridinyl group, a quinoxalinyl group, a quinazolinyl group, an azafluorenyl group, an azacarbazolyl group, an azadibenzofuranyl group, an azadibenzothiophenyl group, a diazafluorenyl group, a diazacarbazolyl group, a diazadibenzofuranyl group, and a diazadibenzothiophenyl group, each substituted with at least one selected from deuterium, a $C_1$-$C_{20}$ (*e.g.* $C_1$-$C_{10}$) alkyl group, a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a benzofluorenyl group, a benzocarbazolyl group, a benzonaphthofuranyl group, a benzonaphthothiophenyl group, a dibenzofluorenyl group, a dibenzocarbazolyl group, a dinaphthofuranyl group, a dinaphthothiophenyl group, a pyridinyl group, a pyrazinyl group, a pyridazinyl group, a pyrimidinyl group, a triazinyl group, a quinolinyl group, an isoquinolinyl group, a quinolinyl group, an isoquinolinyl group, a naphthyridinyl group, a quinoxalinyl group, a quinazolinyl group, an azafluorenyl group, an azacarbazolyl group, an azadibenzofuranyl group, an azadibenzothiophenyl group, a diazafluorenyl group, a diazacarbazolyl group, a diazadibenzofuranyl group, and a diazadibenzothiophenyl group.

In one embodiment, $R_{31}$ to $R_{38}$ in Formulae 3A to 3D may each independently be selected from:

hydrogen, deuterium, -F, -Cl, -Br, -I, a cyano group, a methyl group, an ethyl group, an n-propyl group, an isopropyl group, an n-butyl group, an isobutyl group, a sec-butyl group, a tert-butyl group, a methoxy group, an ethoxy group, a propoxy group and butoxy group;
a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, and a dibenzothiophenyl group;
a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, and a dibenzothiophenyl group, each substituted with at least one selected from deuterium, -F, -Cl, -Br, -I, a cyano group, a methyl group, an ethyl group, an n-propyl group, an isopropyl group, an n-butyl group, an isobutyl group, a sec-butyl group, a tert-butyl group, a methoxy group, an ethoxy group, a propoxy group, a butoxy group, a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, and a dibenzothiophenyl group; and
-B($Q_1$)($Q_2$) and -N($Q_1$)($Q_2$), and

$Q_1$ and $Q_2$ may each independently be selected from:

hydrogen, deuterium, a methyl group, an ethyl group, an n-propyl group, an isopropyl group, an n-butyl group, an isobutyl group, a sec-butyl group, and a tert-butyl group;
a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, and a dibenzothiophenyl group; and
a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, and a dibenzothiophenyl group, each substituted with at least one selected from deuterium, a methyl group, an ethyl group, an n-propyl group, an isopropyl group, an n-butyl group, an isobutyl group, a sec-butyl group, a tert-butyl group, a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, and a dibenzothiophenyl group.

In one embodiment, the third compound may be represented by one selected from Formulae 3-1 and 3-2 below:

Formula 3-1

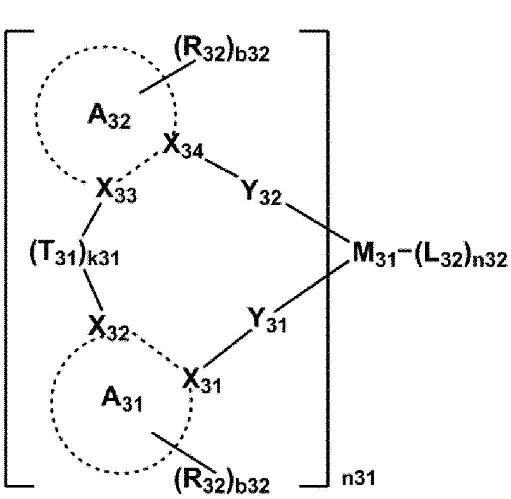

Formula 3-2

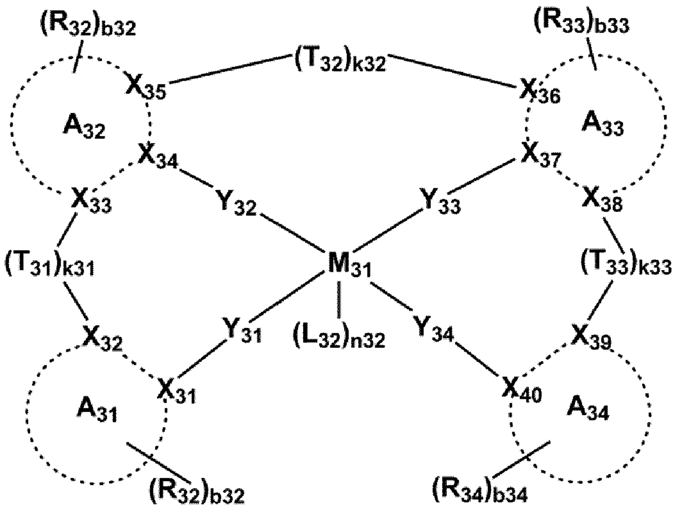

In Formulae 3-1 and 3-2,

$X_{31}$ to $X_{40}$ are each independently selected from N and C, and
the remaining components are each understood by referring to the corresponding descriptions thereof provided herein in connection with Formula 3.

In Formulae 3-1 and 3-2, $X_{31}$ and $X_{32}$ may each independently be a ring member of $A_{31}$, and $X_{33}$ to $X_{40}$ may be also understood by referring to descriptions provided in connection with Formulae 3-1 and 3-2 above. That is, $X_{33}$ to $X_{40}$ may each independently be N or C.
For example, $A_{41}$ and $A_{42}$ in Formulae 4-1 to 4-3 are each independently selected from a group represented by Formula 12, -Si($Q_1$)($Q_2$)($Q_3$), -B($Q_1$)($Q_2$), and - N($Q_1$)($Q_2$):

Formula 12

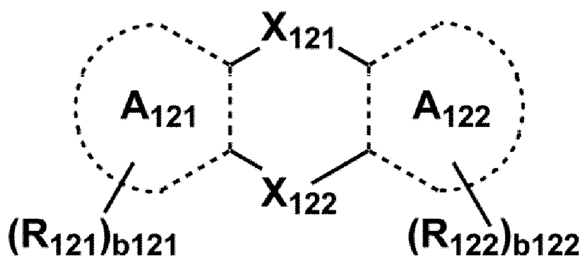

In Formula 12,

$X_{121}$ is selected from O, S, $N(R_{123})$, and $C(R_{123})(R_{124})$,
$X_{122}$ is selected from a single bond, O, S, $N(R_{125})$, and $C(R_{125})(R_{126})$,
$A_{121}$ and $A_{122}$ are each independently selected from a benzene group, a naphthalene group, a phenalene group, an anthracene group, a fluoranthene group, a triphenylene group, a phenanthrene group, a pyrene group, a chrysene group, a perylene group, a fluorene group, a carbazole group, a dibenzofuran group, and a dibenzothiophene group,
$R_{121}$ to $R_{126}$ are each independently selected from:

a binding site, hydrogen, deuterium, a $C_1$-$C_{20}$ (*e.g.* $C_1$-$C_{10}$) alkyl group, a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a benzofluorenyl group, a benzocarbazolyl group, a benzonaphthofuranyl group, a benzonaphthothiophenyl group, a dibenzofluorenyl group, a dibenzocarbazolyl group, a dinaphthofuranyl group, a dinaphthothiophenyl group, $-Si(Q_{31})(Q_{32})(Q_{33})$, $-B(Q_{31})(Q_{32})$, and $-N(Q_{31})(Q_{32})$; and
a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a benzofluorenyl group, a benzocarbazolyl group, a benzonaphthofuranyl group, a benzonaphthothiophenyl group, a dibenzofluorenyl group, a dibenzocarbazolyl group, a dinaphthofuranyl group, and a dinaphthothiophenyl group, each substituted with at least one selected from deuterium, a $C_1$-$C_{20}$ (*e.g.* $C_1$-$C_{10}$) alkyl group, a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a benzofluorenyl group, a benzocarbazolyl group, a benzonaphthofuranyl group, a benzonaphthothiophenyl group, a dibenzofluorenyl group, a dibenzocarbazolyl group, a dinaphthofuranyl group, a dinaphthothiophenyl group, - Si(Q21)(Q22)(Q23), $-B(Q_{21})(Q_{22})$, and $-N(Q_{21})(Q_{22})$,
wherein $R_{123}$ and $R_{124}$ are optionally linked to each other to form a $\pi$ electron-depleted nitrogen-free cyclic group, $R_{125}$ and $R_{126}$ are optionally linked to each other to form a $\pi$ electron-depleted nitrogen-free cyclic group, and at least one selected from $R_{121}$ to $R_{126}$ is a binding site,
b121 and b122 are each independently selected from 1, 2, 3, 4, 5, and 6, and
$Q_1$ to $Q_3$, $Q_{21}$ to $Q_{23}$, and $Q_{31}$ to $Q_{33}$ are understood by referring to descriptions thereof provided above.

In one embodiment, $A_{41}$ and $A_{42}$ in Formulae 4-1 to 4-3 may each independently be selected from a group represented by Formula 12 below, and $-N(Q_1)(Q_2)$:

Formula 12

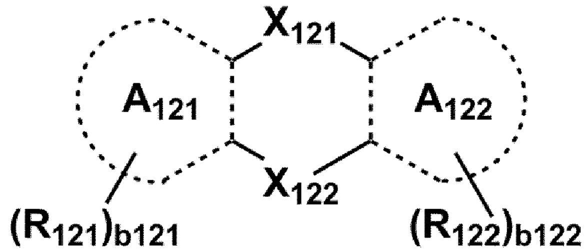

In Formula 12,

$X_{121}$ may be selected from O, S, $N(R_{123})$, and $C(R_{123})(R_{124})$,
$X_{122}$ may be selected from a single bond, O, S, $N(R_{125})$, and $C(R_{125})(R_{126})$,
$A_{121}$ and $A_{122}$ may each independently be selected from a benzene group, a naphthalene group, a fluorene group, a carbazole group, a dibenzofuran group, and a dibenzothiophene group,
$R_{121}$ to $R_{126}$ may each independently be selected from:

a binding site, hydrogen, deuterium, a $C_1$-$C_{20}$ (e.g. $C_1$-$C_{10}$) alkyl group, a phenyl group, a biphenyl group, a terphenyl group, a fluorenyl group, a carbazolyl group, a dibenzofuranyl group, a dibenzothiophenyl group and $-N(Q_{31})(Q_{32})$; and
a phenyl group, a biphenyl group, a terphenyl group, a fluorenyl group, a carbazolyl group, a dibenzofuranyl group, and a dibenzothiophenyl group, each substituted with at least one selected from deuterium, a $C_1$-$C_{20}$

(e.g. $C_1$-$C_{10}$) alkyl group, a phenyl group, a biphenyl group, a terphenyl group, a fluorenyl group, a carbazolyl group, a dibenzofuranyl group, a dibenzothiophenyl group and -N($Q_{21}$)($Q_{22}$), wherein $R_{123}$ and $R_{124}$ may optionally be linked to each other to form a $\pi$ electron-depleted nitrogen-free cyclic group, $R_{125}$ and $R_{126}$ may optionally be linked to each other to form a $\pi$ electron-depleted nitrogen-free cyclic group, and at least one selected from $R_{121}$ to $R_{126}$ is a binding site,

b121 and b122 may each independently be selected from 1, 2, 3, 4, 5, and 6, and

$Q_1$ to $Q_3$, $Q_{21}$ to $Q_{23}$, and $Q_{31}$ to $Q_{33}$ may be understood by referring to descriptions thereof provided above.

For example, $D_{41}$ and $D_{42}$ in Formulae 4-1 to 4-3 are each independently selected from:

-F, a cyano group, a pyrazole group, an imidazole group, a triazole group, an oxazole group, an isoxazole group, an oxadiazole group, an isozadiazole group, a thiazole group, an isothiazole group, a thiadiazole group, an isothiadiazole group, a pyridine group, a pyrazine group, a pyridazine group, a pyrimidine group, a triazine group, a quinoline group, an isoquinoline group, a naphthyridine group, a quinoxaline group, a quinazoline group, and a group represented by one selected from Formulae 13-1 to 13-3;

a pyrazole group, an imidazole group, a triazole group, an oxazole group, an isoxazole group, an oxadiazole group, an isozadiazole group, a thiazole group, an isothiazole group, a thiadiazole group, an isothiadiazole group, a pyridine group, a pyrazine group, a pyridazine group, a pyrimidine group, a triazine group, a quinoline group, an isoquinoline group, a naphthyridine group, a quinoxaline group, and a quinazoline group, each substituted with at least one selected from deuterium, -F, a cyano group, a $C_1$-$C_{20}$ (*e.g.* $C_1$-$C_{10}$) alkyl group, a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a benzofluorenyl group, a benzocarbazolyl group, a benzonaphthofuranyl group, a benzonaphthothiophenyl group, a dibenzofluorenyl group, a dibenzocarbazolyl group, a dinaphthofuranyl group, a dinaphthothiophenyl group, a pyrazolyl group, an imidazolyl group, a triazolyl group, an oxazolyl group, an isoxazolyl group, an oxadiazolyl group, an isoxadiazolyl group, a thiazolyl group, an isothiazolyl group, a thiadiazolyl group, an isothiadiazolyl group, a pyridinyl group, a pyrazinyl group, a pyridazinyl group, a pyrimidinyl group, a triazinyl group, a quinolinyl group, an isoquinolinyl group, a naphthyridinyl group, a quinoxalinyl group, and a quinazolinyl group;

a pyrazole group, an imidazole group, a triazole group, an oxazole group, an isoxazole group, an oxadiazole group, an isozadiazole group, a thiazole group, an isothiazole group, a thiadiazole group, an isothiadiazole group, a pyridine group, a pyrazine group, a pyridazine group, a pyrimidine group, a triazine group, a quinoline group, an isoquinoline group, a naphthyridine group, a quinoxaline group, and a quinazoline group, each substituted with at least one selected from a $C_1$-$C_{20}$ (*e.g.* $C_1$-$C_{10}$) alkyl group, a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a benzofluorenyl group, a benzocarbazolyl group, a benzonaphthofuranyl group, a benzonaphthothiophenyl group, a dibenzofluorenyl group, a dibenzocarbazolyl group, a dinaphthofuranyl group, a dinaphthothiophenyl group, a pyrazolyl group, an imidazolyl group, a triazolyl group, an oxazolyl group, an isoxazolyl group, an oxadiazolyl group, an isoxadiazolyl group, a thiazolyl group, an isothiazolyl group, a thiadiazolyl group, an isothiadiazolyl group, a pyridinyl group, a pyrazinyl group, a pyridazinyl group, a pyrimidinyl group, a triazinyl group, a quinolinyl group, an isoquinolinyl group, a naphthyridinyl group, a quinoxalinyl group, and a quinazolinyl group that are each independently substituted with at least one selected from deuterium, -F, a cyano group, a $C_1$-$C_{20}$ (*e.g.* $C_1$-$C_{10}$) alkyl group, a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a benzofluorenyl group, a benzocarbazolyl group, a benzonaphthofuranyl group, a benzonaphthothiophenyl group, a dibenzofluorenyl group, a dibenzocarbazolyl group, a dinaphthofuranyl group, a dinaphthothiophenyl group, a pyrazolyl group, an imidazolyl group, a triazolyl group, an oxazolyl group, an isoxazolyl group, an oxadiazolyl group, an isoxadiazolyl group, a thiazolyl group, an isothiazolyl group, a thiadiazolyl group, an isothiadiazolyl group, a pyridinyl group, a pyrazinyl group, a pyridazinyl group, a pyrimidinyl group, a triazinyl group, a quinolinyl group, an isoquinolinyl group, a naphthyridinyl group, a quinoxalinyl group, and a quinazolinyl group;

a $C_1$-$C_{20}$ (*e.g.* $C_1$-$C_{10}$) alkyl group, a benzene group, a biphenyl group, a terphenyl group, a naphthalene group, a phenanthrene group, a triphenylene group, a chrysene group, a fluoranthene group, a fluorene group, a carbazole group, a dibenzofuran group, a dibenzothiophene group, a benzofluorene group, a benzocarbazole group, a benzonaphthofuran group, a benzonaphthothiophene group, a dibenzofluorene group, a dibenzocarbazole group, a dinaphthofuran group, and a dinaphthothiophene group, each substituted with at least one selected from -F, a cyano group, a pyrazolyl group, an imidazolyl group, a triazolyl group, an oxazolyl group, an isoxazolyl group, an oxadiazolyl group, an isoxadiazolyl group, a thiazolyl group, an isothiazolyl group, a thiadiazolyl group, an isothiadiazolyl group, a pyridinyl group, a pyrazinyl group, a pyridazinyl group, a pyrimidinyl group, a triazinyl group, a quinolinyl group,

an isoquinolinyl group, a naphthyridinyl group, a quinoxalinyl group, and a quinazolinyl group;

a $C_1$-$C_{20}$ (*e.g.* $C_1$-$C_{10}$) alkyl group, a benzene group, a biphenyl group, a terphenyl group, a naphthalene group, a phenanthrene group, a triphenylene group, a chrysene group, a fluoranthene group, a fluorene group, a carbazole group, a dibenzofuran group, a dibenzothiophene group, a benzofluorene group, a benzocarbazole group, a benzonaphthofuran group, a benzonaphthothiophene group, a dibenzofluorene group, a dibenzocarbazole group, a dinaphthofuran group, and a dinaphthothiophene group, each substituted with at least one selected from a pyrazolyl group, an imidazolyl group, a triazolyl group, an oxazolyl group, an isoxazolyl group, an oxadiazolyl group, an isoxadiazolyl group, a thiazolyl group, an isothiazolyl group, a thiadiazolyl group, an isothiadiazolyl group, a pyridinyl group, a pyrazinyl group, a pyridazinyl group, a pyrimidinyl group, a triazinyl group, a quinolinyl group, an isoquinolinyl group, a naphthyridinyl group, a quinoxalinyl group, and a quinazolinyl group that are each independently substituted with at least one selected from deuterium, -F, a cyano group, a $C_1$-$C_{20}$ (*e.g.* $C_1$-$C_{10}$) alkyl group, a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a benzofluorenyl group, a benzocarbazolyl group, a benzonaphthofuranyl group, a benzonaphthothiophenyl group, a dibenzofluorenyl group, a dibenzocarbazolyl group, a dinaphthofuranyl group, a dinaphthothiophenyl group, a pyrazolyl group, an imidazolyl group, a triazolyl group, an oxazolyl group, an isoxazolyl group, an oxadiazolyl group, an isoxadiazolyl group, a thiazolyl group, an isothiazolyl group, a thiadiazolyl group, an isothiadiazolyl group, a pyridinyl group, a pyrazinyl group, a pyridazinyl group, a pyrimidinyl group, a triazinyl group, a quinolinyl group, an isoquinolinyl group, a naphthyridinyl group, a quinoxalinyl group, and a quinazolinyl group; and

a $C_1$-$C_{20}$ (*e.g.* $C_1$-$C_{10}$) alkyl group, a benzene group, a biphenyl group, a terphenyl group, a naphthalene group, a phenanthrene group, a triphenylene group, a chrysene group, a fluoranthene group, a fluorene group, a carbazole group, a dibenzofuran group, a dibenzothiophene group, a benzofluorene group, a benzocarbazole group, a benzonaphthofuran group, a benzonaphthothiophene group, a dibenzofluorene group, a dibenzocarbazole group, a dinaphthofuran group, and a dinaphthothiophene group, each substituted with at least one selected from a $C_1$-$C_{20}$ (*e.g.* $C_1$-$C_{10}$) alkyl group, a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a benzofluorenyl group, a benzocarbazolyl group, a benzonaphthofuranyl group, a benzonaphthothiophenyl group, a dibenzofluorenyl group, a dibenzocarbazolyl group, a dinaphthofuranyl group, and a dinaphthothiophenyl group that are each independently substituted with at least one selected from -F, a cyano group, a pyrazolyl group, an imidazolyl group, a triazolyl group, an oxazolyl group, an isoxazolyl group, an oxadiazolyl group, an isoxadiazolyl group, a thiazolyl group, an isothiazolyl group, a thiadiazolyl group, an isothiadiazolyl group, a pyridinyl group, a pyrazinyl group, a pyridazinyl group, a pyrimidinyl group, a triazinyl group, a quinolinyl group, an isoquinolinyl group, a naphthyridinyl group, a quinoxalinyl group, and a quinazolinyl group:

Formula 13-1

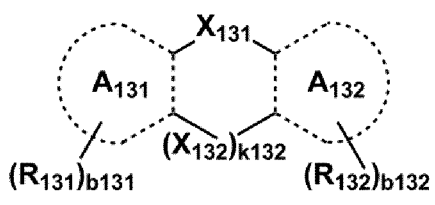

Formula 13-2

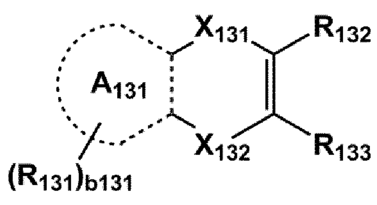

Formula 13-3

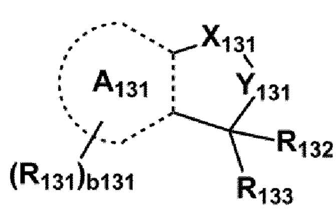

In Formulae 13-1 to 13-3,

$X_{131}$ is selected from C(=O), S(=O), $S(=O)_2$, $P(=O)(R_{134})$, and $P(=S)(R_{134})$,

$X_{132}$ is selected from O, S, C(=O), S(=O), $S(=O)_2$, $P(=O)(R_{135})$, and $P(=S)(R_{135})$,

k132 is 0 or 1, wherein, when k132 is 0, $-(X_{132})_{k132}-$ is not present.

$Y_{131}$ is selected from O and S,

$A_{131}$ and $A_{132}$ are each independently selected from a benzene group, a naphthalene group, a phenalene group, an anthracene group, a fluoranthene group, a triphenylene group, a phenanthrene group, a pyrene group, a chrysene group, a perylene group, a fluorene group, a carbazole group, a dibenzofuran group, and a dibenzothiophene group,

$R_{131}$ to $R_{135}$ are each independently selected from:

a binding site, hydrogen, deuterium, -F, a cyano group, a $C_1$-$C_{20}$ (*e.g.* $C_1$-$C_{10}$) alkyl group, a phenyl group, a

biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a benzofluorenyl group, a benzocarbazolyl group, a benzonaphthofuranyl group, a benzonaphthothiophenyl group, a dibenzofluorenyl group, a dibenzocarbazolyl group, a dinaphthofuranyl group, a dinaphthothiophenyl group, a pyrazolyl group, an imidazolyl group, a triazolyl group, an oxazolyl group, an isoxazolyl group, an oxadiazolyl group, an isoxadiazolyl group, a thiazolyl group, an isothiazolyl group, a thiadiazolyl group, an isothiadiazolyl group, a pyridinyl group, a pyrazinyl group, a pyridazinyl group, a pyrimidinyl group, a triazinyl group, a quinolinyl group, an isoquinolinyl group, a naphthyridinyl group, a quinoxalinyl group, and a quinazolinyl group; and

a $C_1$-$C_{20}$ (*e.g.* $C_1$-$C_{10}$) alkyl group, a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a benzofluorenyl group, a benzocarbazolyl group, a benzonaphthofuranyl group, a benzonaphthothiophenyl group, a dibenzofluorenyl group, a dibenzocarbazolyl group, a dinaphthofuranyl group, a dinaphthothiophenyl group, a pyrazolyl group, an imidazolyl group, a triazolyl group, an oxazolyl group, an isoxazolyl group, an oxadiazolyl group, an isoxadiazolyl group, a thiazolyl group, an isothiazolyl group, a thiadiazolyl group, an isothiadiazolyl group, a pyridinyl group, a pyrazinyl group, a pyridazinyl group, a pyrimidinyl group, a triazinyl group, a quinolinyl group, an isoquinolinyl group, a naphthyridinyl group, a quinoxalinyl group, and a quinazolinyl group, each substituted with at least one selected from deuterium, -F, a cyano group, a $C_1$-$C_{20}$ (*e.g.* $C_1$-$C_{10}$) alkyl group, a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a benzofluorenyl group, a benzocarbazolyl group, a benzonaphthofuranyl group, a benzonaphthothiophenyl group, a dibenzofluorenyl group, a dibenzocarbazolyl group, a dinaphthofuranyl group, a dinaphthothiophenyl group, a pyrazolyl group, an imidazolyl group, a triazolyl group, an oxazolyl group, an isoxazolyl group, an oxadiazolyl group, an isoxadiazolyl group, a thiazolyl group, an isothiazolyl group, a thiadiazolyl group, an isothiadiazolyl group, a pyridinyl group, a pyrazinyl group, a pyridazinyl group, a pyrimidinyl group, a triazinyl group, a quinolinyl group, an isoquinolinyl group, a naphthyridinyl group, a quinoxalinyl group, and a quinazolinyl group, wherein at least one selected from $R_{131}$ to $R_{135}$ is a binding site, and

b131 and b132 are each independently selected from 1, 2, 3, 4, 5, and 6.

In one embodiment, $D_{41}$ and $D_{42}$ in Formulae 4-1 to 4-3 may each independently be selected from:

-F, a cyano group, a pyridine group, a pyrazine group, a pyridazine group, a pyrimidine group, a triazine group, and a group represented by one selected from Formulae 13-1 to 13-3;

a pyridine group, a pyrazine group, a pyridazine group, a pyrimidine group, and a triazine group, each substituted with at least one selected from deuterium, -F, a cyano group, a $C_1$-$C_{20}$ (*e.g.* $C_1$-$C_{10}$) alkyl group, a phenyl group, a biphenyl group, a terphenyl group, a naphthyl group, a fluorenyl group, a carbazolyl group, a dibenzofuranyl group, a dibenzothiophenyl group, a pyridinyl group, a pyrazinyl group, a pyridazinyl group, a pyrimidinyl group, and a triazinyl group;

a pyridine group, a pyrazine group, a pyridazine group, a pyrimidine group, and a triazine group, each substituted with at least one selected from a $C_1$-$C_{20}$ (*e.g.* $C_1$-$C_{10}$) alkyl group, a phenyl group, a biphenyl group, a terphenyl group, a fluorenyl group, a carbazolyl group, a dibenzofuranyl group, a dibenzothiophenyl group, a pyridinyl group, a pyrazinyl group, a pyridazinyl group, a pyrimidinyl group, and a triazinyl group that are each independently substituted with at least one selected from - F, a cyano group, a $C_1$-$C_{20}$ (*e.g.* $C_1$-$C_{10}$) alkyl group, a phenyl group, a biphenyl group, a terphenyl group, a fluorenyl group, a carbazolyl group, a dibenzofuranyl group, a dibenzothiophenyl group, a pyridinyl group, a pyrazinyl group, a pyridazinyl group, a pyrimidinyl group, and a triazinyl group;

a benzene group, a fluorene group, a carbazole group, a dibenzofuran group, and a dibenzothiophene group, each substituted with at least one selected from a $C_1$-$C_{20}$ (*e.g.* $C_1$-$C_{10}$) alkyl group, a pyridinyl group, a pyrazinyl group, a pyridazinyl group, a pyrimidinyl group, and a triazinyl group that are each independently substituted with at least one selected from -F, a cyano group, a pyridinyl group, a pyrazinyl group, a pyridazinyl group, a pyrimidinyl group, and a triazinyl group;

a benzene group, a fluorene group, a carbazole group, a dibenzofuran group, and a dibenzothiophene group, each substituted with at least one selected from a pyridinyl group, a pyrazinyl group, a pyridazinyl group, a pyrimidinyl group, and a triazinyl group that are each independently substituted with at least one selected from deuterium, -F, a cyano group, a $C_1$-$C_{20}$ (*e.g.* $C_1$-$C_{10}$) alkyl group, a phenyl group, a biphenyl group, a terphenyl group, a fluorenyl group, a carbazolyl group, a dibenzofuranyl group, a dibenzothiophenyl group, a pyridinyl group, a pyrazinyl group, a pyridazinyl group, a pyrimidinyl group, and a triazinyl group; and

a $C_1$-$C_{20}$ (*e.g.* $C_1$-$C_{10}$) alkyl group, a benzene group, a fluorene group, a carbazole group, a dibenzofuran group,

and a dibenzothiophene group, each substituted with at least one selected from a $C_1$-$C_{20}$ (*e.g.* $C_1$-$C_{10}$) alkyl group, a phenyl group, a biphenyl group, a terphenyl group, a fluorenyl group, a carbazolyl group, a dibenzofuranyl group, and a dibenzothiophenyl group that are each independently substituted with at least one selected from -F, a cyano group, a pyridinyl group, a pyrazinyl group, a pyridazinyl group, a pyrimidinyl group, and a triazinyl group:

Formula 13-1

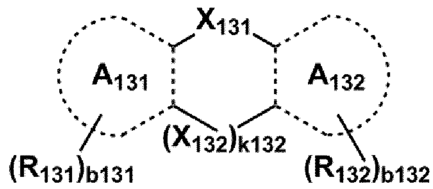

Formula 13-2

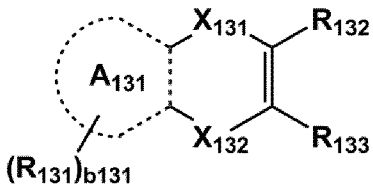

Formula 13-3

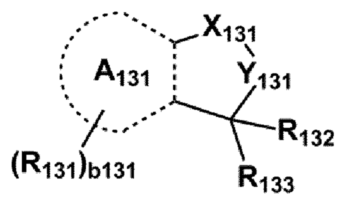

In Formulae 13-1 to 13-3,

$X_{131}$ may be selected from C(=O), S(=O), $S(=O)_2$, $P(=O)(R_{134})$, and $P(=S)(R_{134})$,
$X_{132}$ may be selected from O, S, C(=O), S(=O), $S(=O)_2$, $P(=O)(R_{135})$, and $P(=S)(R_{135})$,
k132 may be 0 or 1, wherein, when k132 is 0, $-(X_{132})_{k132}-$ is not present.
$Y_{131}$ may be selected from O and S,
$A_{131}$ and $A_{132}$ may each independently be selected from a benzene group, a naphthalene group, a fluorene group, a carbazole group, a dibenzofuran group, and a dibenzothiophene group,
$R_{131}$ to $R_{135}$ may each independently be selected from:

a binding site, hydrogen, deuterium, -F, a cyano group, a $C_1$-$C_{20}$ (e.g. $C_1$-$C_{10}$) alkyl group, a phenyl group, a biphenyl group, a terphenyl group, a fluorenyl group, a carbazolyl group, a dibenzofuranyl group, a dibenzothiophenyl group, a pyridinyl group, a pyrazinyl group, a pyridazinyl group, a pyrimidinyl group, a triazinyl group, a quinolinyl group, an isoquinolinyl group, a naphthyridinyl group, a quinoxalinyl group, and a quinazolinyl group; and
a $C_1$-$C_{20}$ (*e.g.* $C_1$-$C_{10}$) alkyl group, a phenyl group, a biphenyl group, a terphenyl group, a fluorenyl group, a carbazolyl group, a dibenzofuranyl group, a dibenzothiophenyl group, a pyridinyl group, a pyrazinyl group, a pyridazinyl group, a pyrimidinyl group, and a triazinyl group, each substituted with at least one selected from deuterium, -F, a cyano group, a $C_1$-$C_{20}$ (*e.g.* $C_1$-$C_{10}$) alkyl group, a phenyl group, a biphenyl group, a terphenyl group, a fluorenyl group, a carbazolyl group, a dibenzofuranyl group, a dibenzothiophenyl group, a pyridinyl group, a pyrazinyl group, a pyridazinyl group, a pyrimidinyl group, and a triazinyl group, wherein at least one selected from $R_{131}$ to $R_{135}$ may be a binding site, and
b131 and b132 may each independently be selected from 1, 2, 3, 4, 5, and 6.
$L_{41}$ and $L_{42}$ in Formulae 4-1 to 4-3 are each independently selected from:

a benzene group, a naphthalene group, a phenalene group, an anthracene group, a fluoranthene group, a triphenylene group, a phenanthrene group, a pyrene group, a chrysene group, a perylene group, a fluorene group, a carbazole group, a dibenzofuran group, a dibenzothiophene group, $-C(Q_1)(Q_2)-$, and $-Si(Q_1)(Q_2)-$; and
a benzene group, a naphthalene group, a phenalene group, an anthracene group, a fluoranthene group, a triphenylene group, a phenanthrene group, a pyrene group, a chrysene group, a perylene group, a fluorene group, a carbazole group, a dibenzofuran group, and a dibenzothiophene group, each substituted with at least one selected from deuterium, a $C_1$-$C_{20}$ (*e.g.* $C_1$-$C_{10}$) alkyl group, a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a benzofluorenyl group, a benzocarbazolyl group, a benzonaphthofuranyl group, a benzonaphthothiophenyl group, a dibenzofluorenyl group, a dibenzocarbazolyl group, a dinaphthofuranyl group, a dinaphthothiophenyl group, $-C(Q_{31})(Q_{32})(Q_{33})$, and $-Si(Q_{31})(Q_{32})(Q_{33})$, and
$Q_1$, $Q_2$, and $Q_{31}$ to $Q_{33}$ are the same as described above.

In one embodiment, $L_{41}$ and $L_{42}$ in Formulae 4-1 to 4-3 may each independently be selected from:

a benzene group, a fluorene group, a carbazole group, a dibenzofuran group, and a dibenzothiophene group, $-C(Q_1)(Q_2)-$, and $-Si(Q_1)(Q_2)-$; and

a benzene group, a fluorene group, a carbazole group, a dibenzofuran group, and a dibenzothiophene group, each substituted with at least one selected from deuterium, a $C_1$-$C_{20}$ (*e.g.* $C_1$-$C_{10}$) alkyl group, a phenyl group, a biphenyl group, a terphenyl group, a fluorenyl group, a carbazolyl group, a dibenzofuranyl group, a dibenzothiophenyl group, $-C(Q_{31})(Q_{32})(Q_{33})$, and $-Si(Q_{31})(Q_{32})(Q_{33})$, and
$Q_1$, $Q_2$, and $Q_{31}$ to $Q_{33}$ are the same as described above.

In one embodiment, the first compound may be selected from compounds of Group I,

the second compound may be selected from compounds of Group II,
the third compound may be selected from compounds of Group III-I and Group III-II, and
the fourth compound may be selected from compounds of Group IV:

Group I

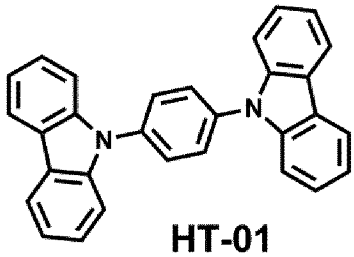

**HT-01**

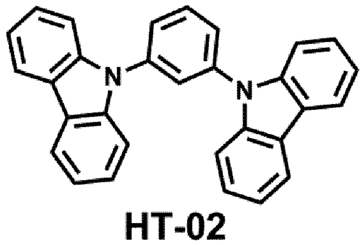

**HT-02**

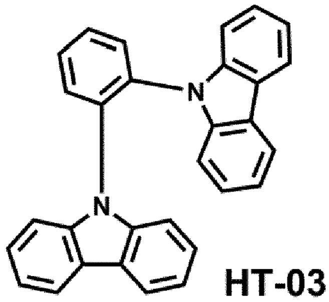

**HT-03**

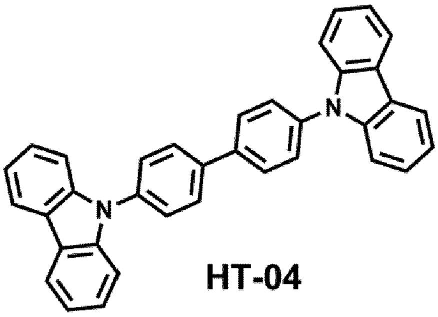

**HT-04**

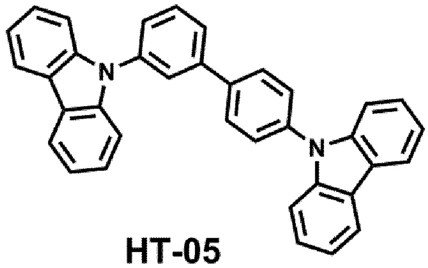

**HT-05**

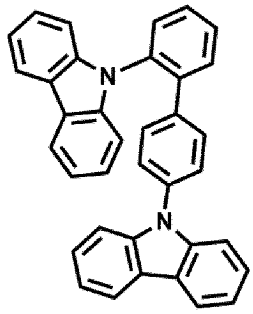

**HT-06**

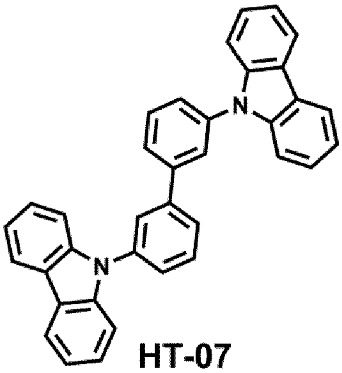

**HT-07**

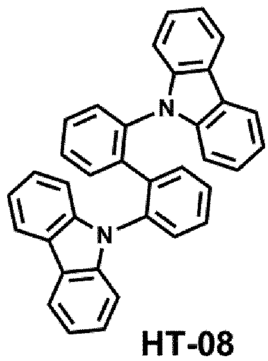

**HT-08**

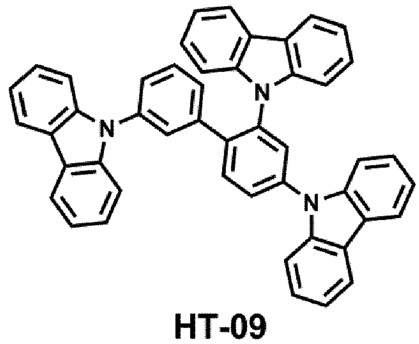

**HT-09**

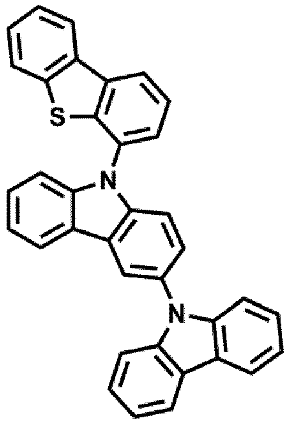

**HT-10**

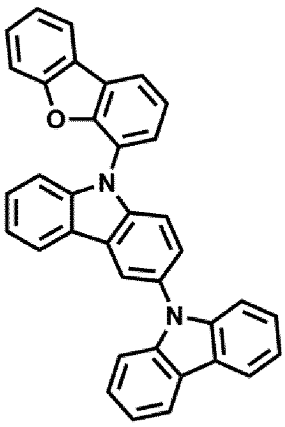

**HT-11**

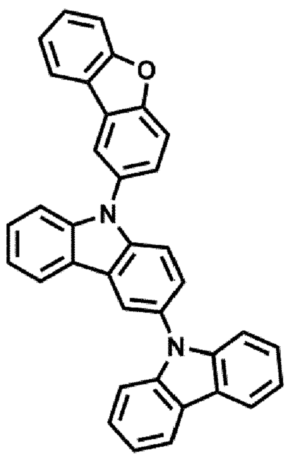

**HT-12**

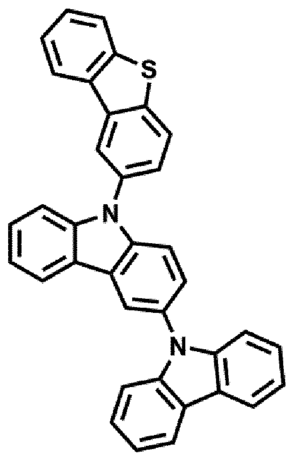

**HT-13**

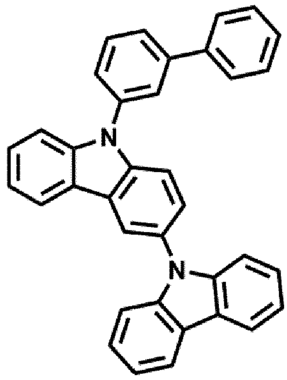
HT-14

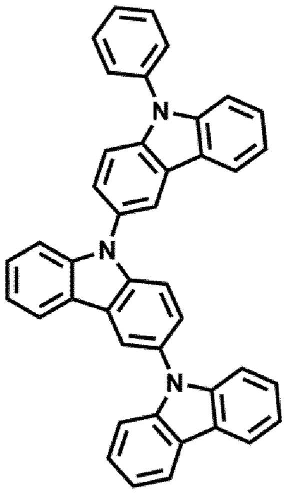
HT-15

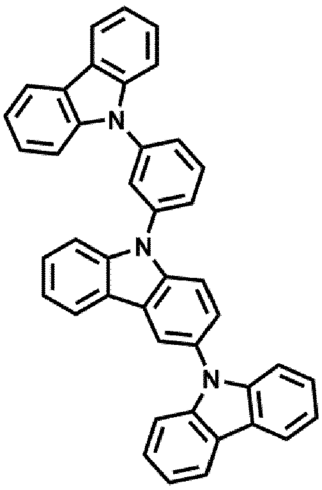
HT-16

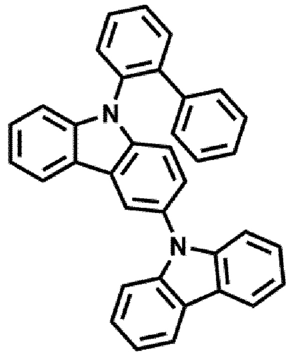
HT-17

Group II

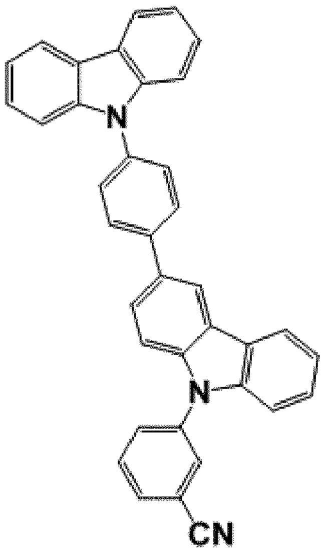
ET-1

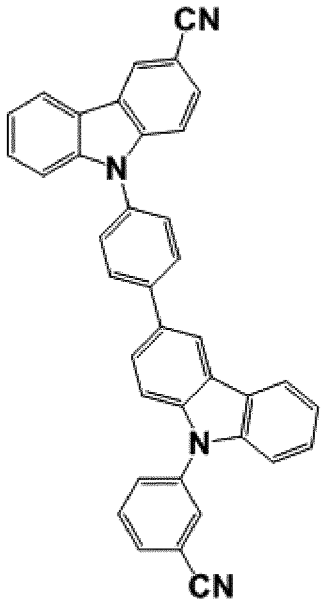
ET-2

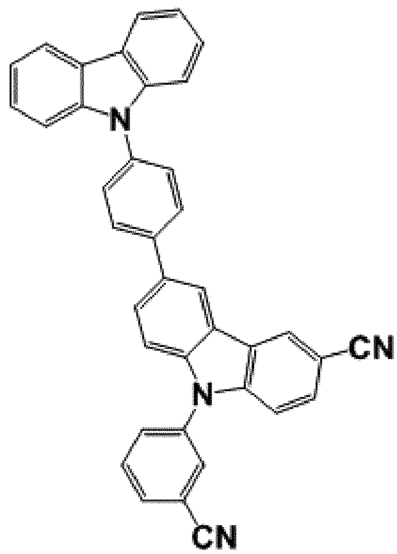
ET-3

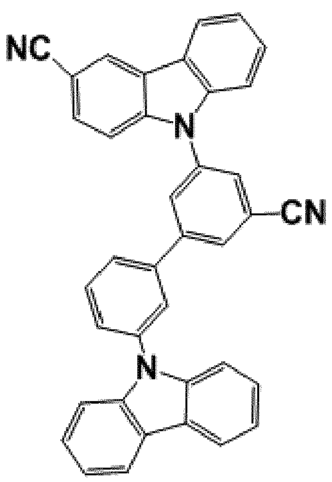

ET-4

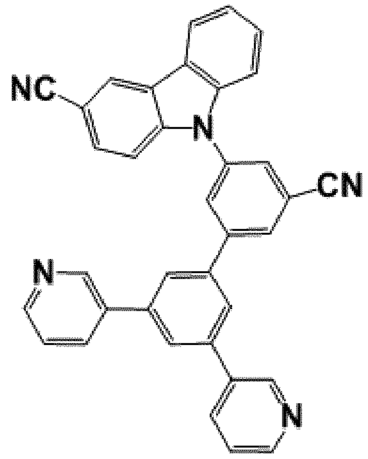

ET-5

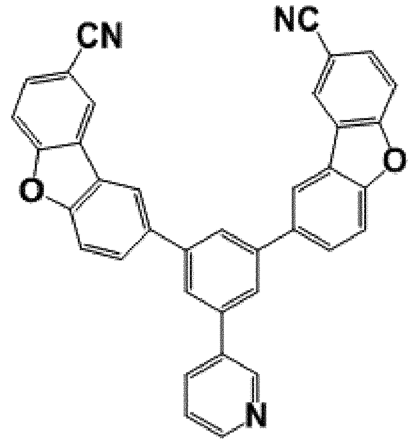

ET-6

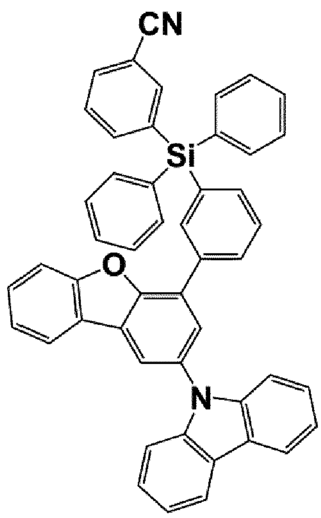

ET-7

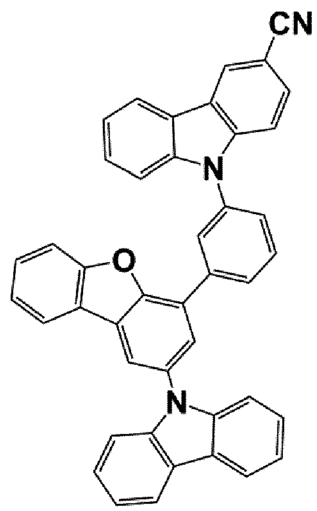

ET-8

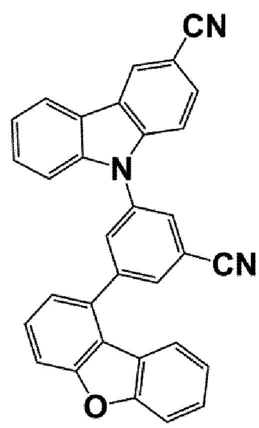

ET-9

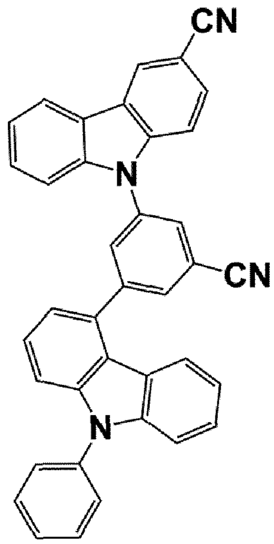

**ET-10**

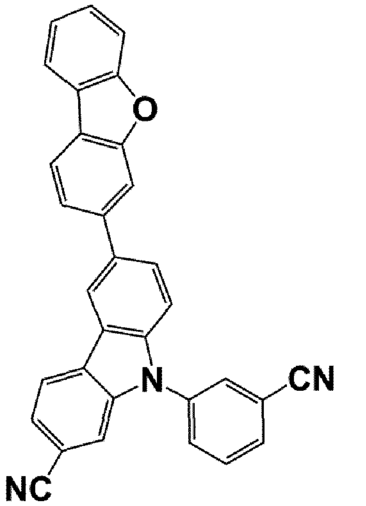

**ET-11**

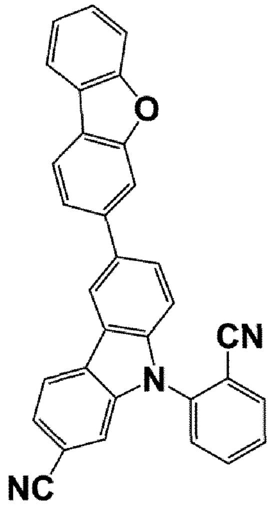

**ET-12**

Group III-I

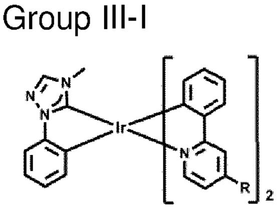

1 (R = H)
2 (R = Me)
3 (R = *iso*-Pr)
4 (R = *tert*-Bu)
5 (R = $NMe_2$)

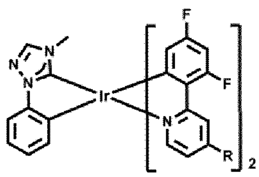

6 (R = H)
7 (R = Me)
8 (R = *iso*-Pr)
9 (R = *tert*-Bu)
10 (R = $NMe_2$)

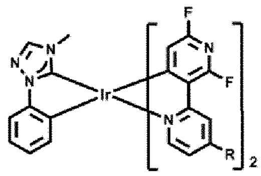

11 (R = H)
12 (R = Me)
13 (R = *iso*-Pr)
14 (R = *tert*-Bu)
15 (R = $NMe_2$)

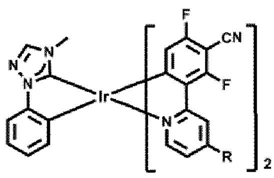

16 (R = H)
17 (R = Me)
18 (R = *iso*-Pr)
19 (R = *tert*-Bu)
20 (R = $NMe_2$)

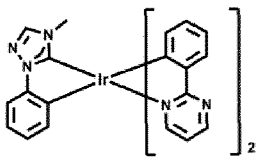

21

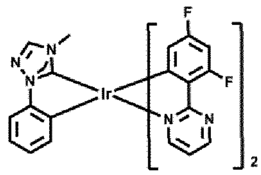

22

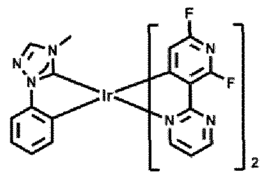

23

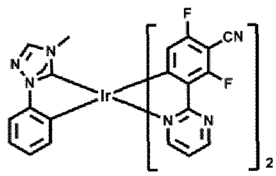

24

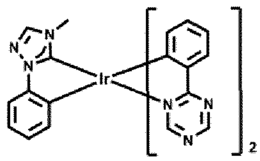

25

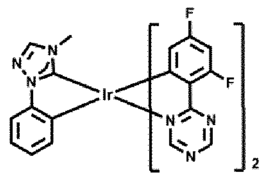

26

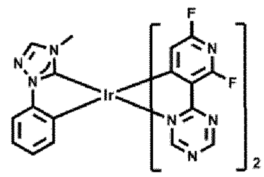

27

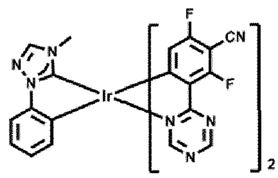

28

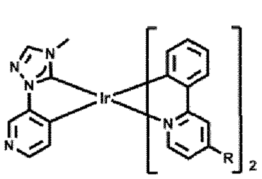

29 (R = H)
30 (R = Me)
31 (R = *iso*-Pr)
32 (R = *tert*-Bu)
33 (R = $NMe_2$)

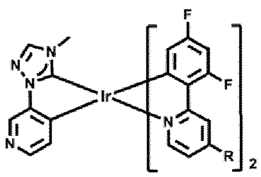

34 (R = H)
35 (R = Me)
36 (R = *iso*-Pr)
37 (R = *tert*-Bu)
38 (R = $NMe_2$)

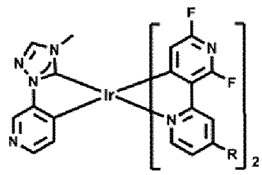

39 (R = H)
40 (R = Me)
41 (R = *iso*-Pr)
42 (R = *tert*-Bu)
43 (R = $NMe_2$)

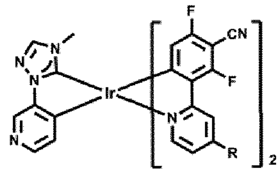

44 (R = H)
45 (R = Me)
46 (R = *iso*-Pr)
47 (R = *tert*-Bu)
48 (R = $NMe_2$)

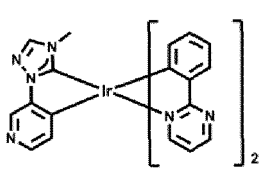

49

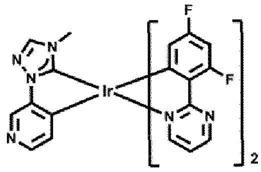

50

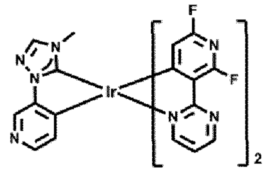

51

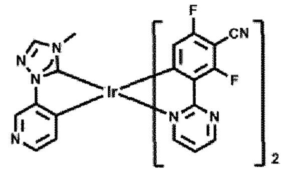

52

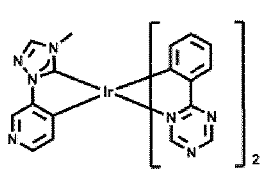

53

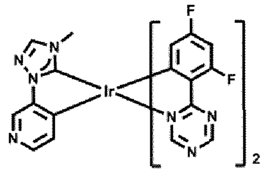

54

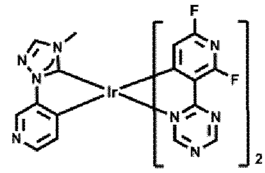

55

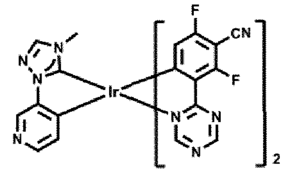

56

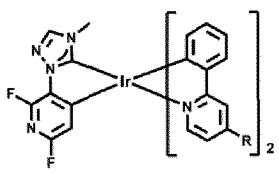

57 (R = H)
58 (R = Me)
59 (R = *iso*-Pr)
60 (R = *tert*-Bu)
61 (R = $NMe_2$)

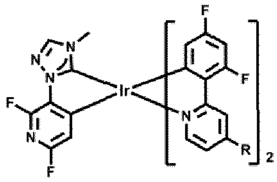

62 (R = H)
63 (R = Me)
64 (R = *iso*-Pr)
65 (R = *tert*-Bu)
66 (R = $NMe_2$)

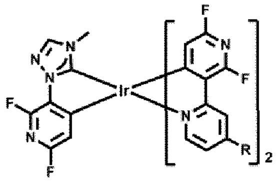

67 (R = H)
68 (R = Me)
69 (R = *iso*-Pr)
70 (R = *tert*-Bu)
71 (R = $NMe_2$)

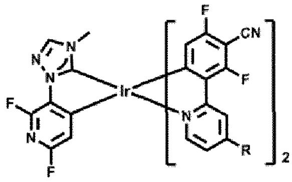

72 (R = H)
73 (R = Me)
74 (R = *iso*-Pr)
75 (R = *tert*-Bu)
76 (R = $NMe_2$)

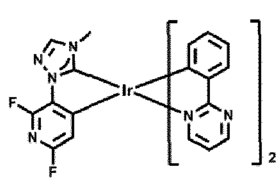

77

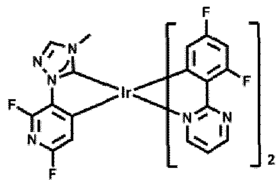

78

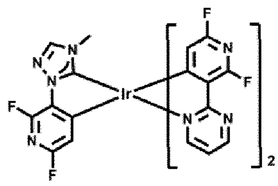

79

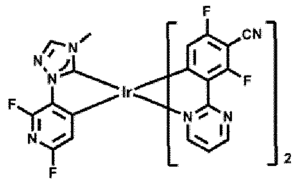

80

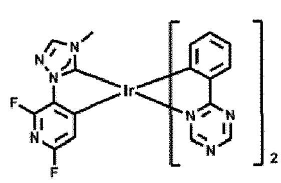

81

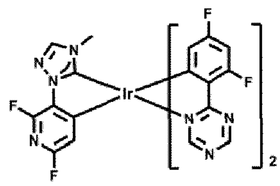

82

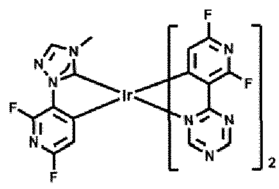

83

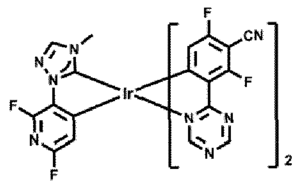

84

Group III-2

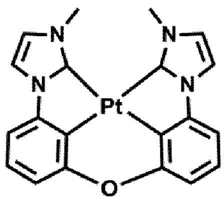

PD1

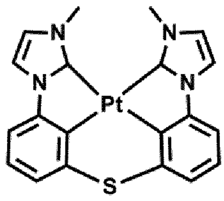

PD2

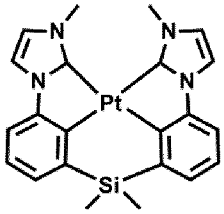

PD3

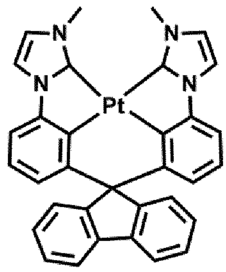

PD4

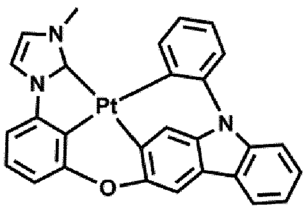

PD5

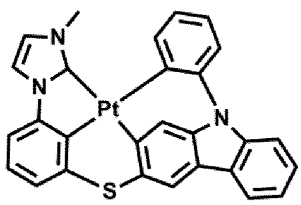

PD6

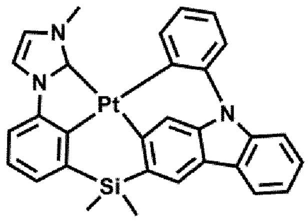

PD7

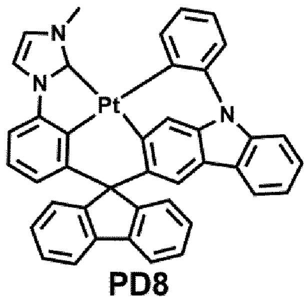

PD8

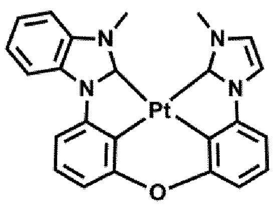

PD9

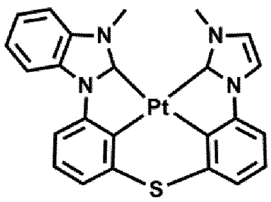

PD10

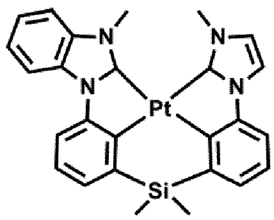

PD11

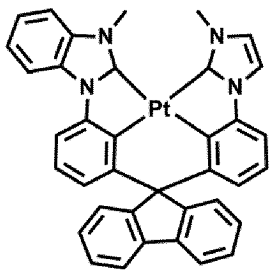

PD12

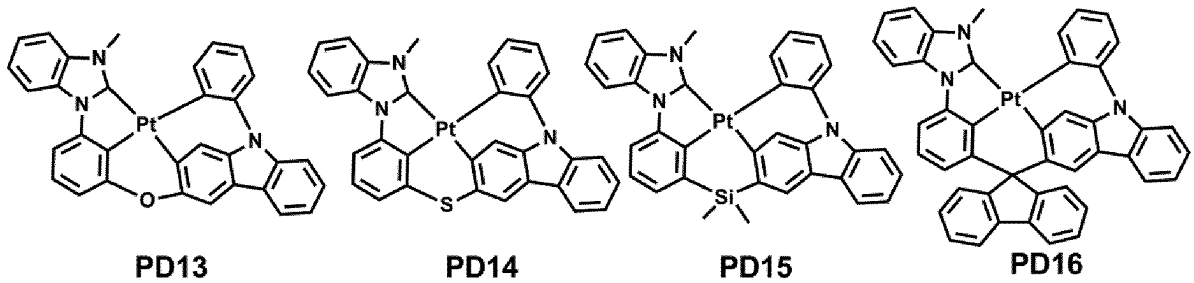

PD13 PD14 PD15 PD16

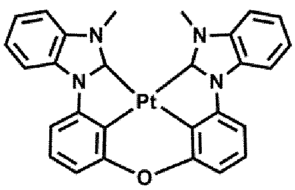

PD17

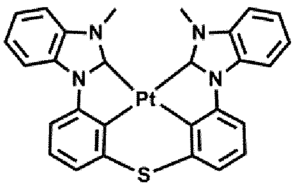

PD18

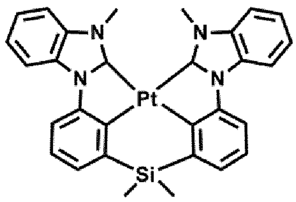

PD19

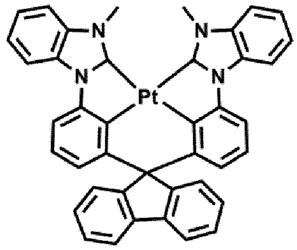

PD20

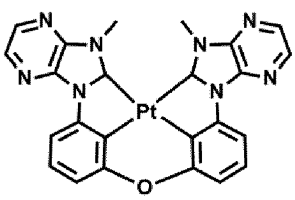

PD21

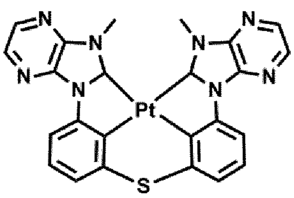

PD22

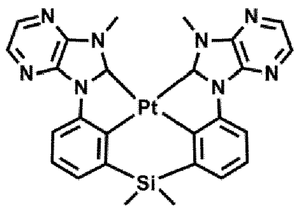

PD23

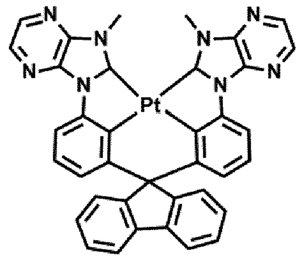

PD24

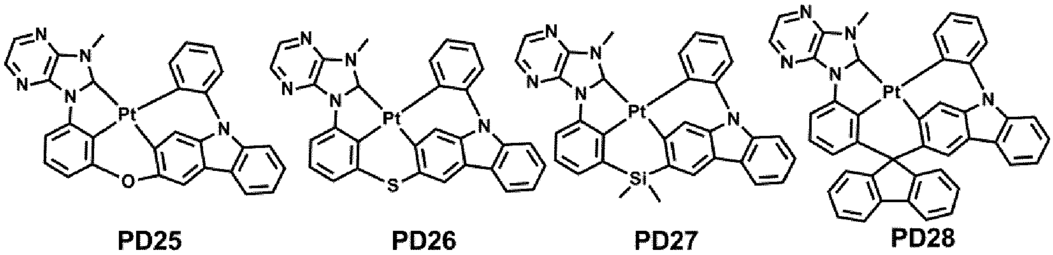

PD25 PD26 PD27 PD28

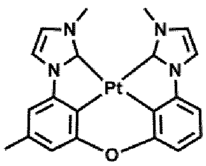

PD29

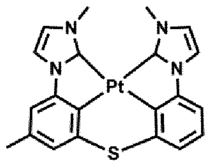

PD30

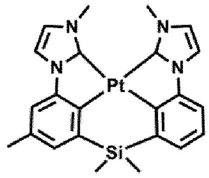

PD31

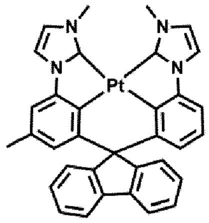

PD32

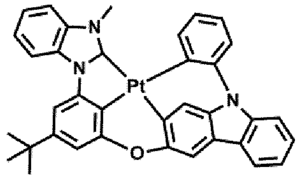

PD33

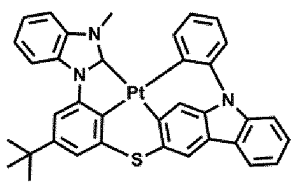

PD34

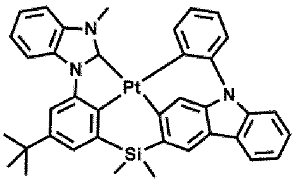

PD35

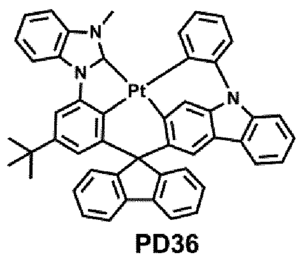

PD36

## Group IV

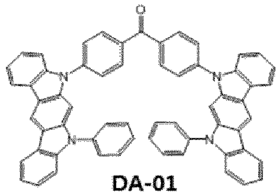
DA-01

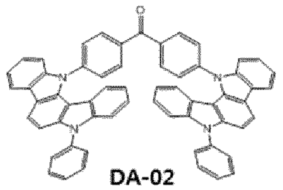
DA-02

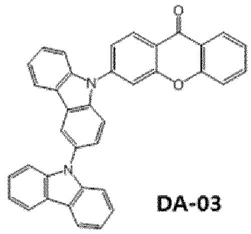
DA-03

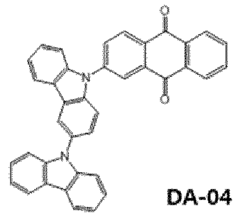
DA-04

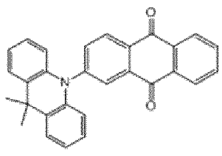
DA-05

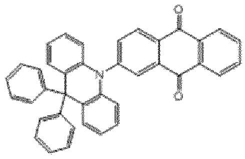
DA-06

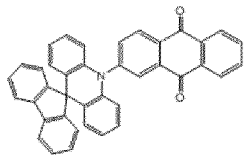
DA-07

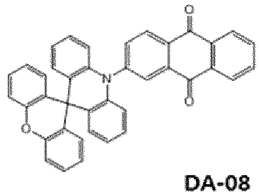
DA-08

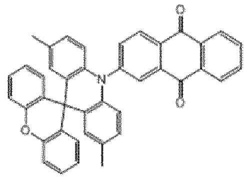
DA-09

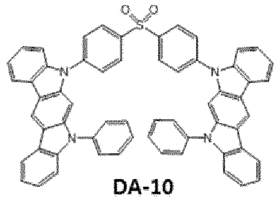
DA-10

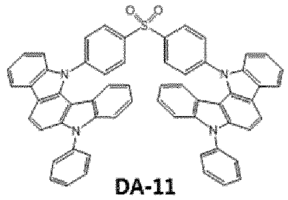
DA-11

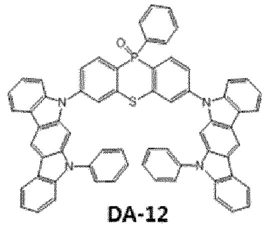
DA-12

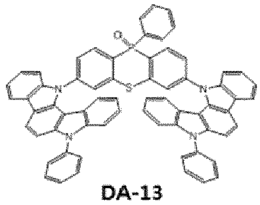
DA-13

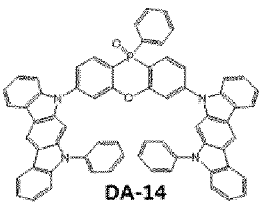
DA-14

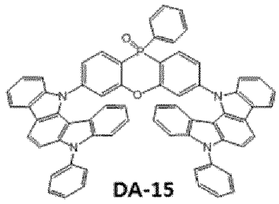
DA-15

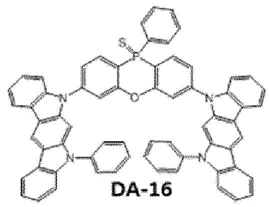
DA-16

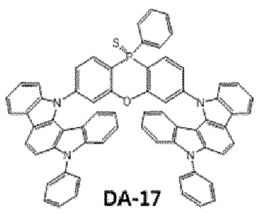
DA-17

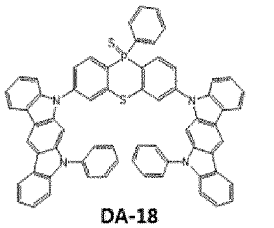
DA-18

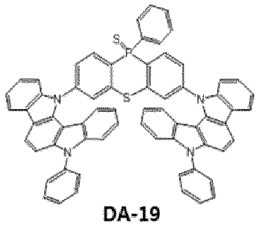
DA-19

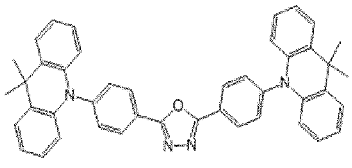
DA-20

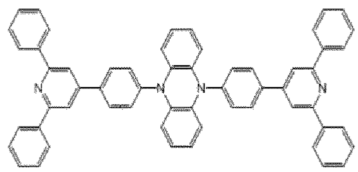
DA-21

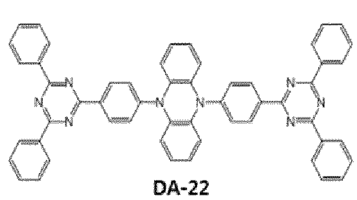
DA-22

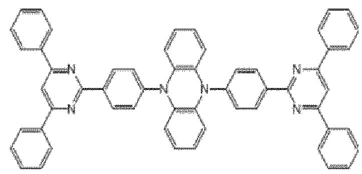
DA-23

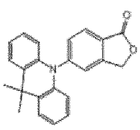
DA-24

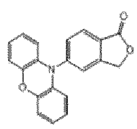
DA-25

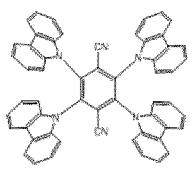
DA-26

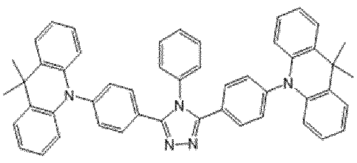
DA-27

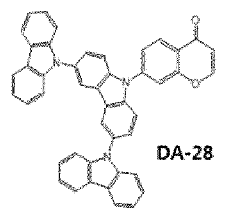
DA-28

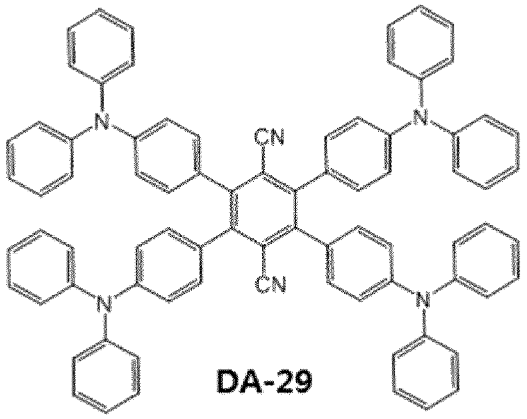
DA-29

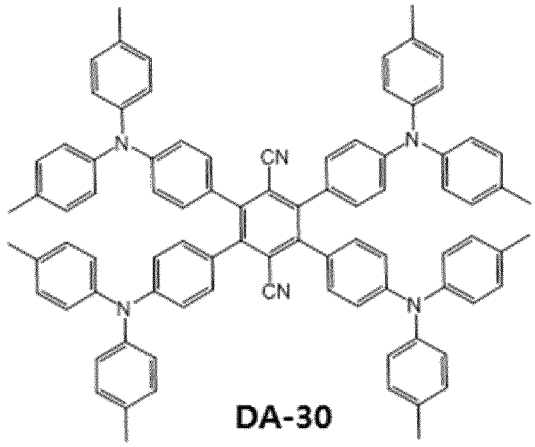
DA-30

In Group III-I, compounds 1 to 5 are represented by the first structure of this group, with the substituent R respectively defined under the corresponding structure. Compounds 6-20, 29 to 48, and 57 to 76 are defined similarly.

The first compound, the second compound, and the third compound may substantially not emit light. For example, the first compound, the second compound, and the third compound may not emit any light, or light emitted by the first compound, the second compound, and the third compound may only be of an insignificant amount compared to light emitted by the other compounds, e.g., the fourth compound.

In more detail, the third compound may not emit light, and instead, reverse intersystem crossing (RISC) and/or intersystem crossing (ISC) may actively occur therein, thereby causing triplet excitons generated from the first compound and the second compound to be delivered to the fourth compound.

Accordingly, by transferring singlet excitons and triplet excitons generated in the emission layer to the fourth compound, an organic light-emitting device having improved efficiency may be obtained. In addition, because an organic light-emitting device having a significantly reduced energy loss is obtained, the lifespan characteristics of the organic light-emitting device may be improved.

In addition, because the exciton is transitioned in the third compound and then transitioned in the fourth compound, the degradation of the fourth compound due to the exciton's energy can be suppressed, thereby improving the lifespan characteristics.

The lowest excitation triplet energy level of the third compound may be from about 2.5 eV to about 3.5 eV. Accordingly, the lowest excitation triplet level of the third compound is higher than the lowest excitation singlet energy level of the fourth compound, so that the lowest triplet excitons of the third compound may be easily transferred to the lowest excitation singlet energy level of the fourth compound.

The fourth compound emits light, and the fourth compound may be a delayed fluorescence emitter. That is, the fourth compound is configured to emit light, and the fourth compound may be a delayed fluorescence emitting material.

In one or more embodiments, the fourth compound may be a thermally activated delayed fluorescence (TADF) emitter.

In one or more embodiments, the ratio of a light-emitting component emitted from the fourth compound to the total light-emitting components emitted from the emission layer may be 80% or more. That is, the ratio of light emitted from the fourth compound to the total light emitted from the emission layer may be 80% or more.

The fourth compound may have a maximum emission wavelength in the range of about 420 nm to about 490 nm, but embodiments of the present disclosure are not limited thereto.

In more detail, the fourth compound in the emission layer may emit blue delayed fluorescent light by receiving energy from the excitons (formed in other compounds) without directly participating in the formation of the excitons.

The fourth compound may satisfy Condition 1:

Condition 1

$$\triangle E_{ST}(C4) \leq 0.3 \text{ eV}$$

In Condition 1, $\triangle E_{ST}(C4)$ is a difference between the lowest excitation singlet energy level ($E_{S1}(C4)$) and the lowest excitation triplet energy level ($E_{T1}(C4)$) of the fourth compound.

Here, $E_{S1}(C4)$ and $E_{T1}(C4)$ may each be evaluated utilizing the Density Function Theory (DFT) method of Gaussian program which is structure-optimized at a B3LYP/6-31G(d, p) level.

The $T_1$ level of the fourth compound is much higher than the $T_1$ level of a typical fluorescent dopant, which may facilitate reverse intersystem crossing (RISC).

In a related art (e.g., a typical) fluorescent dopant, for example, DCJTB, the $T_1$ level thereof is significantly lower than the $T_1$ level of the third compound, and thus the exciton at the $T_1$ level generated by the third compound is likely (e.g., highly likely) to be transitioned to the $T_1$ level of the fluorescent dopant, and even after transition, the exciton is likely (e.g., highly likely) to be quenched without participating in light emission. In addition, due to the low $T_1$ level of the fluorescent dopant, the triplet excitons generated in the first compound and the second compound are likely (e.g., highly likely) to be quenched without participating in light emission while transferring to the $T_1$ level of the fluorescent dopant, not to the $T_1$ level of the third compound. Accordingly, it would be inappropriate to replace the fourth compound with another typical fluorescent dopant. That is, when replacing the fourth compound with another related art fluorescent dopant, light emission efficiency will be significantly lowered.

However, because the fourth compound has a sufficiently high RISC efficiency even at room temperature, even when the exciton at the $T_1$ level of the third compound moves to the $T_1$ level of the fourth compound, the exciton at the T1 level of the fourth compound is reverse-intersystem transitioned to the $S_1$ level of the fourth compound, and then is emitted as fluorescence. In other words, the exciton is not quenched. The probability of exciton quenching may be significantly or substantially (e.g., extremely) reduced and the luminescence efficiency may be significantly or substantially (e.g., greatly) increased. Also, because the exciton is transitioned in the third compound and then transitioned in the fourth compound, the degradation of the fourth compound due to the exciton energy may be suppressed and lifespan properties may also be improved.

In general, when electrons are not efficiently injected from the electron transport region to the emission layer, charges are accumulated at the interface between the emission layer and the electron transport region, thus deteriorating the interface. On the contrary, when holes are not efficiently injected from the hole transport region to the emission layer, charges are accumulated at the interface between the emission layer and the hole transport region, thus deteriorating the interface. Thus, the lifespan of the organic light-emitting device is lowered.

Because the second compound is a compound essentially including an electron transport moiety, the second compound may be utilized (e.g., easily utilized) to adjust the electron transporting characteristics of the organic light-emitting device. Because the first compound is a compound not including an electron transport moiety, the first compound may be utilized (e.g., easily utilized) to adjust the hole transporting characteristics of the organic light-emitting device. In this manner, it is possible to enhance or optimize the charge balance in the emission layer of the organic light-emitting device.

An amount of the first compound in the emission layer is in a range of about 10 wt% to about 90 wt% (*e.g.* about 60 wt% to about 70 wt%) based on the total weight of the emission layer.

An amount of the second compound in the emission layer may be in a range of about 10 wt% to about 90 wt% (*e.g.* about 20 wt% to about 30 wt%) based on the total weight of the emission layer.

The amount of the third compound in the emission layer may be larger than or equal to the amount of the fourth compound.

The amount of the fourth compound in the emission layer may be in a range of about 0.25 wt% to about 5 wt% (*e.g.* about 0.25 wt% to about 1 wt%) based on the total weight of the emission layer.

The amount of the fourth compound may be in a range of about 0.01 parts by weight to about 20 parts by weight based on 100 parts by weight of the sum of the amount of the first compound and the amount of the second compound. For example, the amount of the fourth compound may be in a range of about 0.01 parts by weight to about 10 parts by weight, about 0.01 parts by weight to about 5 parts by weight, about 0.01 parts by weight to about 2 parts by weight (*e.g.* about 1 part by weight) based on 100 parts by weight of the sum of the amount of the first compound and the amount of the second compound.

When the first compound, the second compound, the third compound and the fourth compound are within these respective ranges, the organic light-emitting device having both improved efficiency and improved lifespan may be provided.

In one or more embodiments, the emission layer may consist of (i.e., include only) the first compound, the second compound, the third compound, and the fourth compound, but embodiments of the present disclosure are not limited thereto.

In one embodiment, the first electrode may be an anode, the second electrode may be a cathode, and the organic layer may further include a hole transport region between the first electrode and the emission layer and/or an electron transport region between the emission layer and the second electrode, wherein the hole transport region may include a hole injection layer, a hole transport layer, an emission auxiliary layer, and/or an electron blocking layer, and the electron transport region may include a hole blocking layer, an electron transport layer, and/or an electron injection layer, but embodiments of the present disclosure are not limited thereto.

For example, the hole blocking layer may include a hole blocking material represented by one of Formulae 2A and 2B.

The hole blocking material may be understood by referring to the description provided in connection with Formulae 2A and 2B.
The hole blocking material may be selected from compounds of Group II.

**Description of FIG. 1**

FIG. 1 is a schematic view of an organic light-emitting device 10 according to an embodiment. The organic light-emitting device 10 includes a first electrode 110, an organic layer 150, and a second electrode 190.
Hereinafter, the structure of the organic light-emitting device 10 according to an embodiment and a method of manufacturing the organic light-emitting device 10 will be described in connection with FIG. 1.

[First electrode 110]

In FIG. 1, a substrate may be additionally disposed under the first electrode 110 or above the second electrode 190. The substrate may be a glass substrate or a plastic substrate, each having suitable (e.g., excellent) mechanical strength, thermal stability, transparency, surface smoothness, ease of handling, and/or water resistance.
The first electrode 110 may be formed by depositing or sputtering a material to form the first electrode 110 on the substrate. When the first electrode 110 is an anode, the material for forming the first electrode 110 may be selected from materials with a high work function to facilitate hole injection.
The first electrode 110 may be a reflective electrode, a semi-reflective electrode, or a transmissive electrode. When the first electrode 110 is a transmissive electrode, a material to form the first electrode may be selected from indium tin oxide (ITO), indium zinc oxide (IZO), tin oxide ($SnO_2$), zinc oxide (ZnO), and any combinations thereof, but embodiments of the present disclosure are not limited thereto. In one or more embodiments, when the first electrode 110 is a semi-transmissive electrode or a reflective electrode, a material to form the first electrode 110 may be selected from magnesium (Mg), silver (Ag), aluminium (Al), aluminium-lithium (Al-Li), calcium (Ca), magnesium-indium (Mg-In), magnesium-silver (Mg-Ag), and any combinations thereof, but embodiments of the present disclosure are not limited thereto.
The first electrode 110 may have a single-layered structure, or a multi-layered structure including two or more layers. For example, the first electrode 110 may have a three-layered structure of ITO/Ag/ITO, but the structure of the first electrode 110 is not limited thereto.

**Organic layer 150**

The organic layer 150 is disposed on the first electrode 110. The organic layer 150 includes an emission layer.
The organic layer 150 may further include a hole transport region between the first electrode 110 and the emission layer and an electron transport region between the emission layer and the second electrode 190.

**Hole transport region in organic layer 150**

The hole transport region may have i) a single-layered structure including a single layer including a single material, ii) a single-layered structure including a single layer including a plurality of different materials, or iii) a multi-layered structure having a plurality of layers including a plurality of different materials.
The hole transport region may include at least one layer selected from a hole injection layer, a hole transport layer, an emission auxiliary layer, and an electron blocking layer.
For example, the hole transport region may have a single-layered structure including a single layer including a plurality of different materials, or a multi-layered structure having a hole injection layer/hole transport layer structure, a hole injection layer/hole transport layer/emission auxiliary layer structure, a hole injection layer/emission auxiliary layer structure, a hole transport layer/emission auxiliary layer structure, or a hole injection layer/hole transport layer/electron blocking layer structure, wherein for each structure, constituting layers are sequentially stacked from the first electrode 110 in the stated order, but the structure of the hole transport region is not limited thereto.
The hole transport region may include at least one selected from m-MTDATA, TDATA, 2-TNATA, NPB(NPD), β-NPB, TPD, spiro-TPD, spiro-NPB, methylated-NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), a compound represented by Formula 201 below, and a compound represented by Formula 202 below:

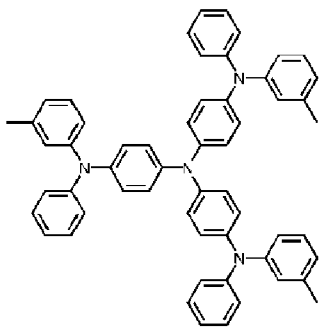

m-MTDATA

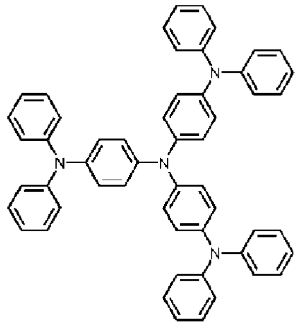

TDATA

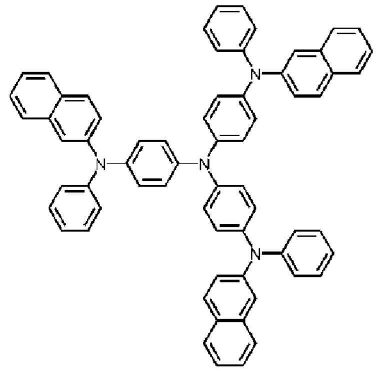

2-TNATA

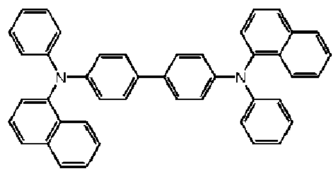

NPB

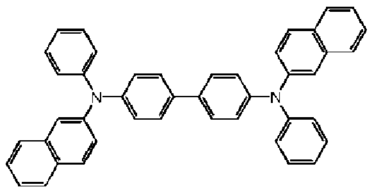

β-NPB

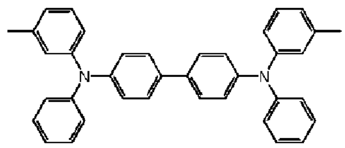

TPD

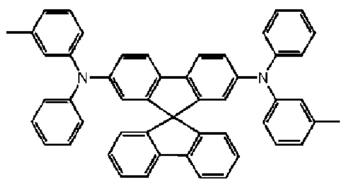

Spiro-TPD

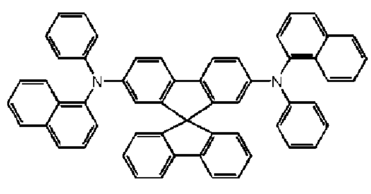

Spiro-NPB

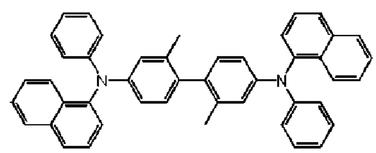

methylated NPB

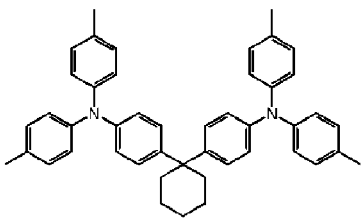

TAPC

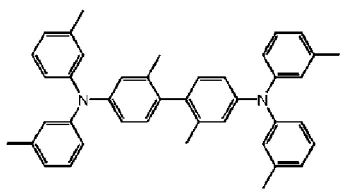

HMTPD

Formula 201

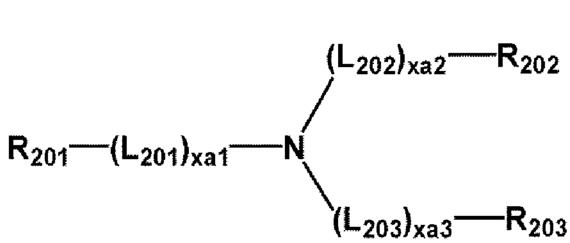

Formula 202

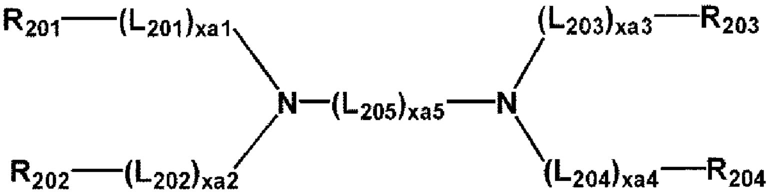

In Formulae 201 and 202,

$L_{201}$ to $L_{204}$ may each independently be selected from a substituted or unsubstituted $C_3$-$C_{10}$ cycloalkylene group, a substituted or unsubstituted $C_1$-$C_{10}$ heterocycloalkylene group, a substituted or unsubstituted $C_3$-$C_{10}$ cycloalkenylene group, a substituted or unsubstituted $C_1$-$C_{10}$ heterocycloalkenylene group, a substituted or unsubstituted $C_6$-$C_{60}$ (*e.g.* $C_6$-$C_{32}$) arylene group, a substituted or unsubstituted $C_1$-$C_{60}$ (*e.g.* $C_1$-$C_{20}$) heteroarylene group, a substituted or unsubstituted divalent non-aromatic condensed polycyclic group, and a substituted or unsubstituted divalent non-aromatic condensed heteropolycyclic group,

$L_{205}$ may be selected from *-O-*', *-S-*', *-N($Q_{201}$)-*', a substituted or unsubstituted $C_1$-$C_{20}$ alkylene group, a substituted or unsubstituted $C_2$-$C_{20}$ alkenylene group, a substituted or unsubstituted $C_3$-$C_{10}$ cycloalkylene group, a substituted or unsubstituted $C_1$-$C_{10}$ heterocycloalkylene group, a substituted or unsubstituted $C_3$-$C_{10}$ cycloalkenylene group, a substituted or unsubstituted $C_1$-$C_{10}$ heterocycloalkenylene group, a substituted or unsubstituted $C_6$-$C_{60}$ (*e.g.* $C_6$-$C_{32}$) arylene group, a substituted or unsubstituted $C_1$-$C_{60}$ (*e.g.* $C_1$-$C_{20}$) heteroarylene group, a substituted or unsubstituted divalent non-aromatic condensed polycyclic group, and a substituted or unsubstituted divalent non-aromatic condensed heteropolycyclic group,

xa1 to xa4 may each independently be an integer from 0 to 3,

xa5 may be an integer from 1 to 10, and

$R_{201}$ to $R_{204}$ and $Q_{201}$ may each independently be selected from a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ (*e.g.* $C_6$-$C_{32}$) aryl group, a substituted or unsubstituted $C_6$-$C_{60}$ (*e.g.* $C_6$-$C_{32}$) aryloxy group, a substituted or unsubstituted $C_6$-$C_{60}$ (*e.g.* $C_6$-$C_{32}$) arylthio group, a substituted or unsubstituted $C_1$-$C_{60}$ (*e.g.* $C_1$-$C_{20}$) heteroaryl group, a substituted or unsubstituted monovalent non-aromatic condensed polycyclic group, and a substituted or unsubstituted monovalent non-aromatic condensed heteropolycyclic group.

In one embodiment, in Formula 202, $R_{201}$ and $R_{202}$ may optionally be linked to each other via a single bond, a dimethyl-methylene group, or a diphenyl-methylene group, and $R_{203}$ and $R_{204}$ may optionally be linked to each other via a single bond, a dimethyl-methylene group, or a diphenyl-methylene group.

In one embodiment, in Formulae 201 and 202,

$L_{201}$ to $L_{205}$ may each independently be selected from:

a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group; and

a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group,

a benzocarbazolylene group, a dibenzocarbazolylene group, a dibenzosilolylene group, and a pyridinylene group, each substituted with at least one selected from deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a $C_1$-$C_{10}$ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, -Si($Q_{31}$)($Q_{32}$)($Q_{33}$), and -N($Q_{31}$)($Q_{32}$), and

$Q_{31}$ to $Q_{33}$ may each independently be selected from a $C_1$-$C_{10}$ alkyl group, a $C_1$-$C_{10}$ alkoxy group, a phenyl group, a biphenyl group, a terphenyl group, and a naphthyl group.

In one or more embodiments, xa1 to xa4 may each independently be 0, 1, or 2.

In one or more embodiments, xa5 may be 1, 2, 3, or 4.

In one or more embodiments, $R_{201}$ to $R_{204}$ and $Q_{201}$ may each independently be selected from:

a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group; and

a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group, each substituted with at least one selected from deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a $C_1$-$C_{10}$ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, -Si($Q_{31}$)($Q_{32}$)($Q_{33}$), and -N($Q_{31}$)($Q_{32}$), and

$Q_{31}$ to $Q_{33}$ are the same as described above.

In one or more embodiments, at least one selected from $R_{201}$ to $R_{203}$ in Formula 201 may each independently be selected from:

a fluorenyl group, a spiro-bifluorenyl group, a carbazolyl group, a dibenzofuranyl group, and a dibenzothiophenyl group; and

a fluorenyl group, a spiro-bifluorenyl group, a carbazolyl group, a dibenzofuranyl group, and a dibenzothiophenyl group, each substituted with at least one selected from deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group,

a cyclopentyl group, a cyclohexyl group, a cycloheptyl group, a cyclopentenyl group, a cyclohexenyl group, a phenyl group, a biphenyl group, a terphenyl group, a phenyl group substituted with a $C_1$-$C_{10}$ alkyl group, a phenyl group substituted with -F, a naphthyl group, a fluorenyl group, a spiro-bifluorenyl group, a carbazolyl group, a dibenzofuranyl group, and a dibenzothiophenyl group,

but embodiments of the present disclosure are not limited thereto.

In one or more embodiments, in Formula 202, i) $R_{201}$ and $R_{202}$ may be linked to each other via a single bond, and/or ii) $R_{203}$ and $R_{204}$ may be linked to each other via a single bond.

In one or more embodiments, $R_{201}$ to $R_{204}$ in Formula 202 may each independently be selected from:

a carbazolyl group; and

a carbazolyl group substituted with at least one selected from deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a $C_1$-$C_{10}$ alkyl group, a phenyl group substituted with -F, a naphthyl group, a fluorenyl group, a spiro-bifluorenyl group, a carbazolyl group, a dibenzofuranyl group, and a dibenzothiophenyl group,

but embodiments of the present disclosure are not limited thereto.

The compound represented by Formula 201 may be represented by Formula 201A below:

Formula 201A

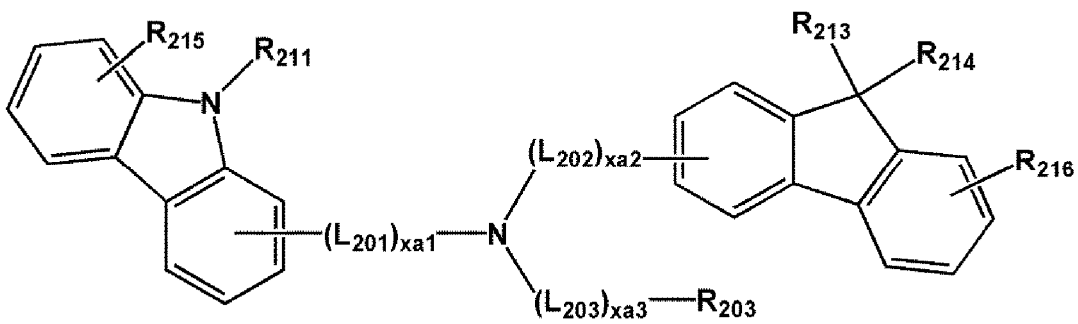

In one embodiment, the compound represented by Formula 201 may be represented by Formula 201A(1) below, but embodiments of the present disclosure are not limited thereto:

Formula 201A(1)

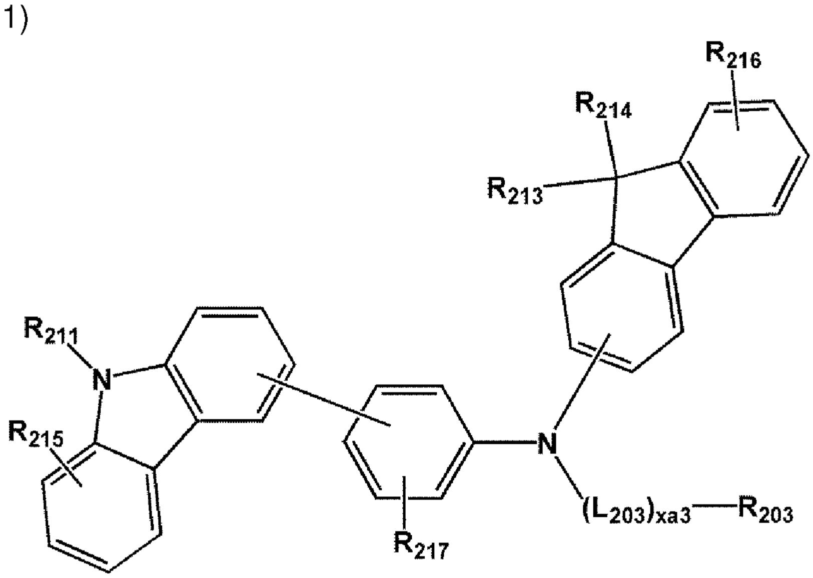

In one or more embodiments, the compound represented by Formula 201 may be represented by Formula 201A-1 below, but embodiments of the present disclosure are not limited thereto:

Formula 201A-1

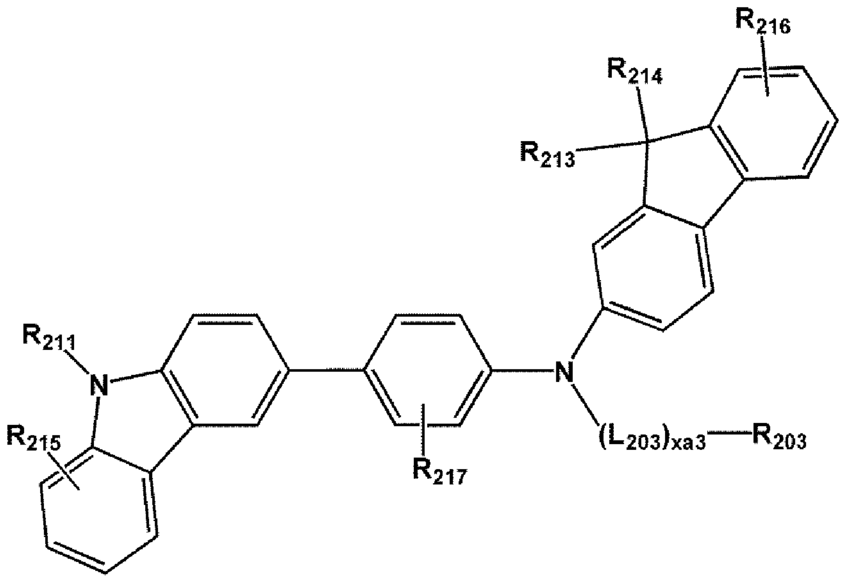

In one embodiment, the compound represented by Formula 202 may be represented by Formula 202A below:

Formula 202A

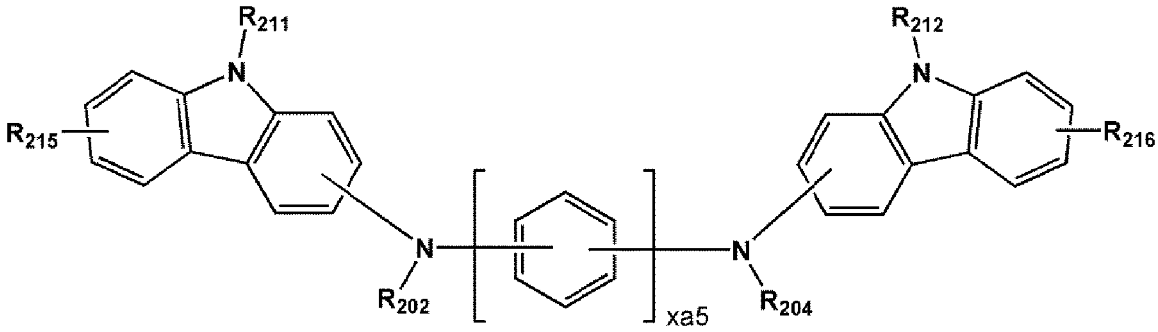

In one or more embodiments, the compound represented by Formula 202 may be represented by Formula 202A-1 below:

Formula 202A-1

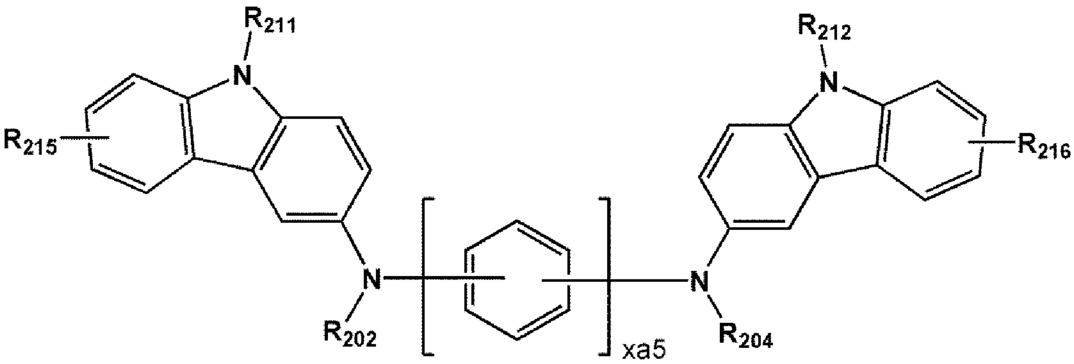

In Formulae 201A, 201A(1), 201A-1, 202A, and 202A-1,

$L_{201}$ to $L_{203}$, xa1 to xa3, xa5, and $R_{202}$ to $R_{204}$ may each be understood by referring to the corresponding descriptions thereof presented herein in connection with Formulae 201 and 202,

$R_{211}$ and $R_{212}$ may each be understood by referring to the descriptions provided in connection with $R_{203}$, and

$R_{213}$ to $R_{217}$ may each independently be selected from hydrogen, deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a $C_1$-$C_{10}$ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group.

The hole transport region may include at least one compound selected from Compounds HT1 to HT39 below, but embodiments of the present disclosure are not limited thereto:

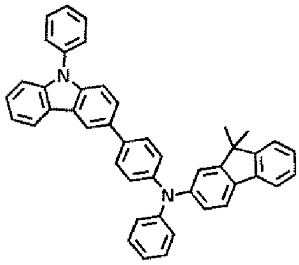

HT1

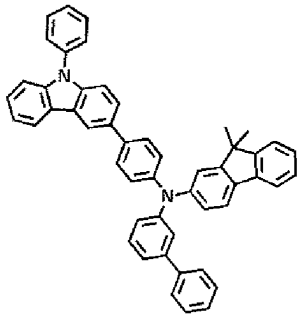

HT2

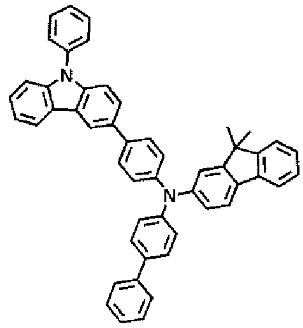

HT3

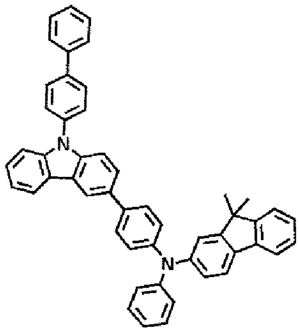

HT4

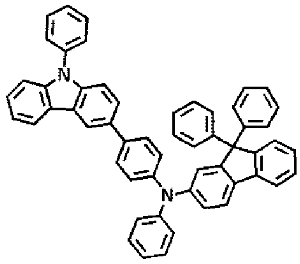

HT5

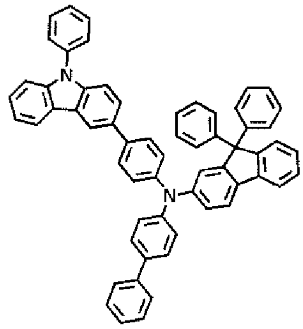

HT6

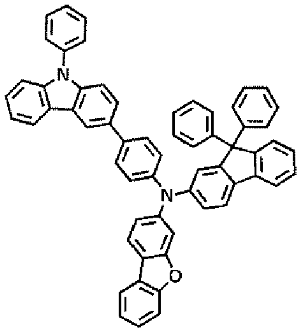

HT7

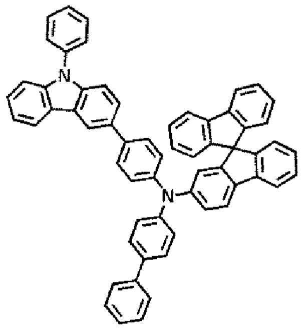

HT8

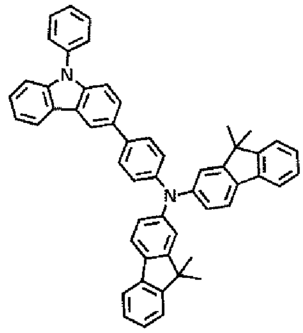

HT9

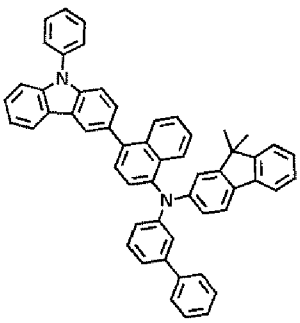

HT10

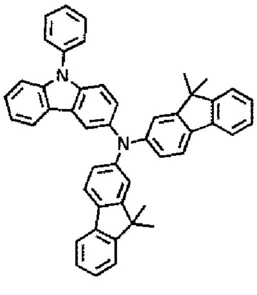

HT11

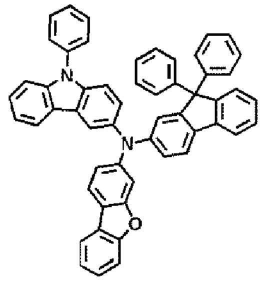

HT12

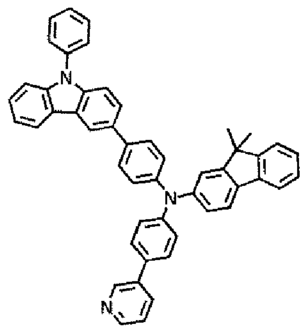

HT13

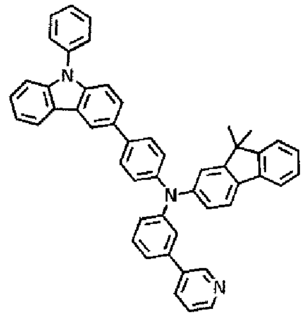

HT14

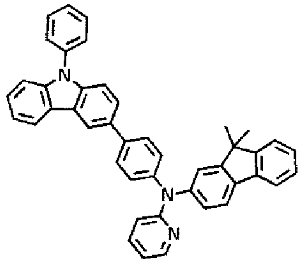

HT15

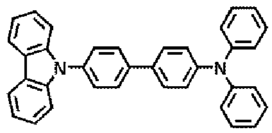

HT16

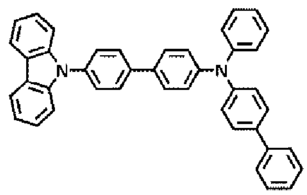

HT17

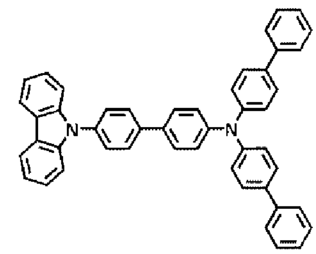

HT18

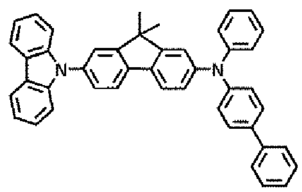

HT19

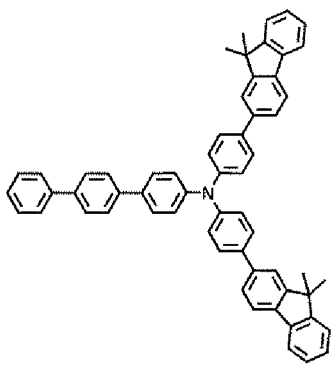

HT20

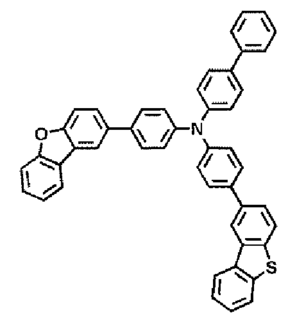

HT21

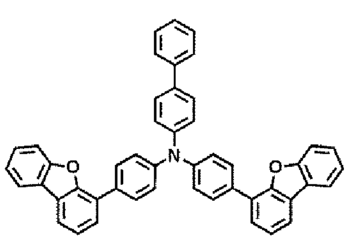

HT22

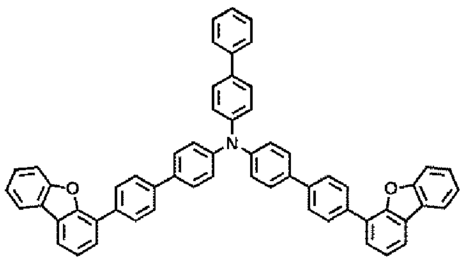

HT23

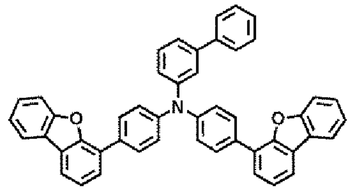

HT24

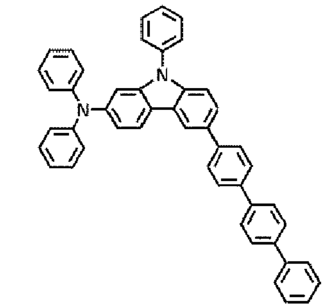

HT25

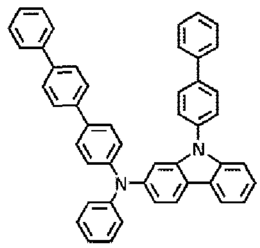

HT26

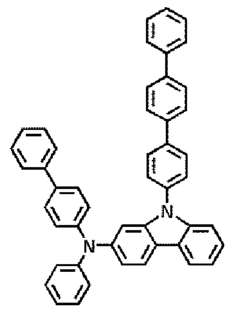

HT27

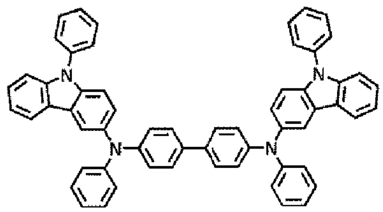

HT28

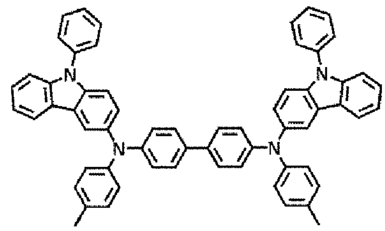

HT29

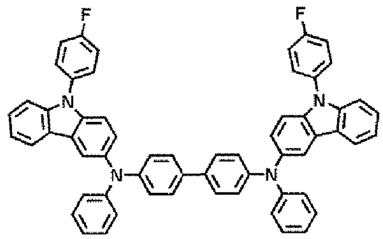

HT30

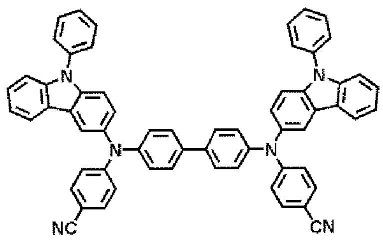

HT31

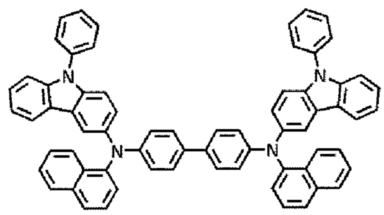

HT32

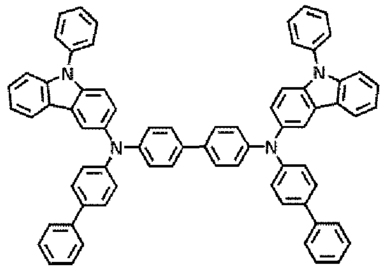

HT33

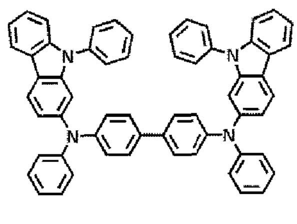

HT34

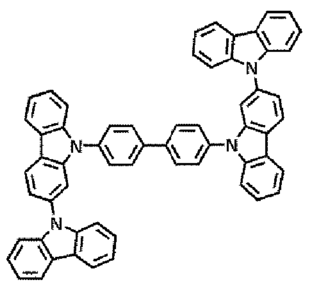

HT35

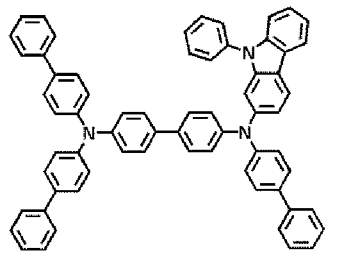

HT36

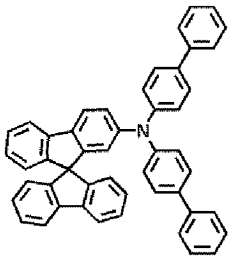

HT37

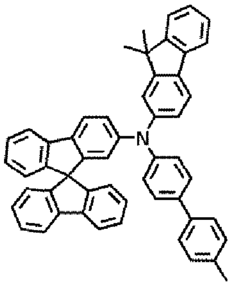

HT38

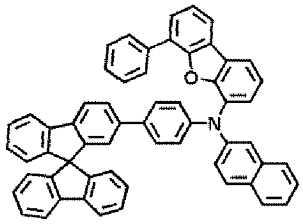

HT39

A thickness of the hole transport region may be from about 100 Å to about 10,000 Å, for example, about 100 Å to about 7,000 Å, about 100 Å to about 5,000 Å, or about 100 Å to about 3,000 Å. When the hole transport region includes at least one selected from a hole injection layer and a hole transport layer, a thickness of the hole injection layer may be in a range of about 100 Å to about 9,000 Å, for example, about 100 Å to about 7,000 Å, about 100 Å to about 5,000 Å, about 100 Å to about 3,000 Å, about 100 Å to about 2,000 Å, about 100 Å to about 1,000 Å or about 300 Å to about 500 Å, and a thickness of the hole transport layer may be in a range of about 50 Å to about 2,000 Å, for example, about 100 Å to about 1,500 Å, or about 100 Å to about 150 Å. When the thicknesses of the hole transport region, the hole injection layer, and the hole transport layer are within these ranges, satisfactory hole transporting characteristics may be obtained without a substantial increase in driving voltage.

The emission auxiliary layer may increase light-emission efficiency by compensating for an optical resonance distance according to the wavelength of light emitted by an emission layer, and the electron blocking layer may block the flow of electrons from an electron transport region. The emission auxiliary layer and the electron blocking layer may include the materials as described above.

**p-dopant**

The hole transport region may further include, in addition to these materials, a charge-generation material for the improvement of conductive properties. The charge-generation material may be homogeneously or non-homogeneously dispersed in the hole transport region.

The charge-generation material may be, for example, a p-dopant.

In one embodiment, the p-dopant may have a lowest unoccupied molecular orbital (LUMO) energy level of -3.5 eV or less.

The p-dopant may include at least one selected from a quinone derivative, a metal oxide, and a cyano group-containing compound, but embodiments of the present disclosure are not limited thereto.

For example, the p-dopant may include at least one selected from:

a quinone derivative, such as tetracyanoquinodimethane (TCNQ) and/or F4-2,3,5,6-tetrafluoro-7,7,8,8-tetracyanoquinodimethane (F4-TCNQ);
a metal oxide, such as tungsten oxide and/or molybdenum oxide;
1,4,5,8,9,12-hexaazatriphenylene-hexacarbonitrile (HAT-CN); and
a compound represented by Formula 221 below:
but embodiments of the present disclosure are not limited thereto:

HAT-CN

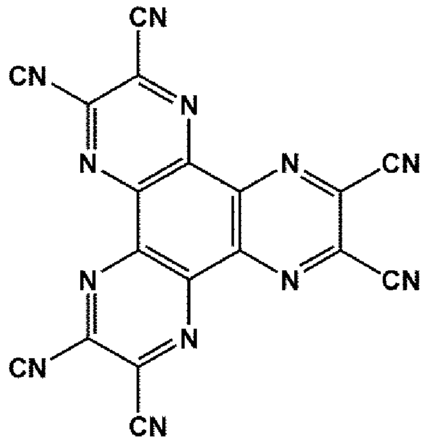

F4-TCNQ

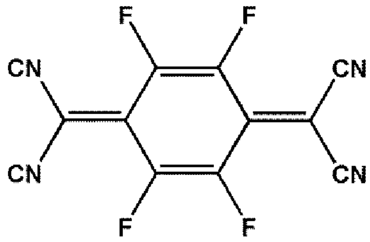

Formula 221

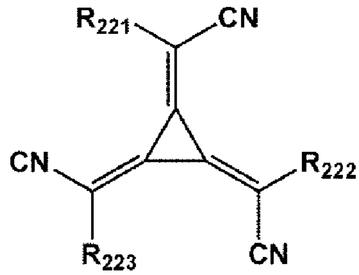

In Formula 221,

$R_{221}$ to $R_{223}$ may each independently be selected from a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ (*e.g.* $C_6$-$C_{32}$) aryl group, a substituted or unsubstituted $C_1$-$C_{60}$ (*e.g.* $C_1$-$C_{20}$) heteroaryl group, a substituted or unsubstituted monovalent non-aromatic condensed polycyclic group, and a substituted or unsubstituted monovalent non-aromatic condensed heteropolycyclic group, wherein at least one selected from $R_{221}$ to $R_{223}$ may have at least one substituent selected from a cyano group, -F, -Cl, -Br, -I, a $C_1$-$C_{20}$ alkyl group substituted with -F, a $C_1$-$C_{20}$ alkyl group substituted with -Cl, a $C_1$-$C_{20}$ alkyl group substituted with -Br, and a $C_1$-$C_{20}$ alkyl group substituted with -I.

**Emission layer in organic layer 150**

When the organic light-emitting device 10 is a full-color organic light-emitting device, the emission layer may be patterned into a red emission layer, a green emission layer, or a blue emission layer, according to a sub-pixel. In one or more embodiments, the emission layer may have a stacked structure of two or more layers selected from a red emission layer, a green emission layer, and a blue emission layer, in which the two or more layers contact each other or are separated from each other. In one or more embodiments, the emission layer may include two or more materials selected from a red light-emitting material, a green light-emitting material, and a blue light-emitting material, in which the two or more materials are mixed with each other in a single layer to emit white light.

A thickness of the emission layer may be in a range of about 100 Å to about 1,000 Å, for example, about 100 Å to about 800 Å, about 150 Å to about 800 Å, about 150 Å to about 700 Å, about 150 Å to about 650 Å, about 200 Å to about 600 Å or about 200 Å to about 250 Å. When the thickness of the emission layer is within these ranges, suitable (e.g., excellent) light-emission characteristics may be obtained without a substantial increase in driving voltage.

**Electron transport region in organic layer 150**

The electron transport region may have i) a single-layered structure including a single layer including a single material, ii) a single-layered structure including a single layer including a plurality of different materials, or iii) a multi-layered structure having a plurality of layers including a plurality of different materials.

The electron transport region may include at least one selected from a buffer layer, a hole blocking layer, an

electron control layer, an electron transport layer, and an electron injection layer, but embodiments of the present disclosure are not limited thereto.

For example, the electron transport region may have an electron transport layer/electron injection layer structure, a hole blocking layer/electron transport layer/electron injection layer structure, an electron control layer/electron transport layer/electron injection layer structure, or a buffer layer/electron transport layer/electron injection layer structure, wherein for each structure, constituting layers are sequentially stacked from the emission layer in the stated order. However, embodiments of the structure of the electron transport region are not limited thereto.

The electron transport region (for example, a buffer layer, a hole blocking layer, an electron control layer, or an electron transport layer in the electron transport region) may include a metal-free compound containing at least one $\pi$ electron-depleted nitrogen-containing ring.

The term "$\pi$ electron-depleted nitrogen-containing ring" refers to a $C_1$-$C_{60}$ (*e.g.* a $C_1$-$C_{30}$) heterocyclic group having at least one *-N=*' moiety as a ring-forming moiety.

For example, the "$\pi$ electron-depleted nitrogen-containing ring" may be i) a 5-membered to 7-membered heteromonocyclic group having at least one *-N=*' moiety, ii) a heteropolycyclic group in which two or more 5-membered to 7-membered heteromonocyclic groups each having at least one *-N=*' moiety are condensed with each other, or iii) a heteropolycyclic group in which at least one of 5-membered to 7-membered heteromonocyclic groups, each having at least one *-N=*' moiety, is condensed with at least one $C_5$-$C_{60}$ (*e.g.* a $C_5$-$C_{30}$) carbocyclic group.

Examples of the $\pi$ electron-depleted nitrogen-containing ring include an imidazole group, a pyrazole group, a thiazole group, an isothiazole group, an oxazole group, an isoxazole group, a pyridine group, a pyrazine group, a pyrimidine group, a pyridazine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, and an azacarbazole group, but embodiments of the present disclosure are not limited thereto.

For example, the electron transport region may include a compound represented by Formula 601 below:

Formula 601 $$[Ar_{601}]_{xe11}\text{-}[(L_{601})_{xe1}\text{-}R_{601}]_{xe21}$$

In Formula 601,

$Ar_{601}$ may be a substituted or unsubstituted $C_5$-$C_{60}$ carbocyclic group or a substituted or unsubstituted $C_1$-$C_{60}$ heterocyclic group,

xe11 may be 1, 2, or 3,

$L_{601}$ may be selected from a substituted or unsubstituted $C_3$-$C_{10}$ cycloalkylene group, a substituted or unsubstituted $C_1$-$C_{10}$ heterocycloalkylene group, a substituted or unsubstituted $C_3$-$C_{10}$ cycloalkenylene group, a substituted or unsubstituted $C_1$-$C_{10}$ heterocycloalkenylene group, a substituted or unsubstituted $C_6$-$C_{60}$ arylene group, a substituted or unsubstituted $C_1$-$C_{60}$ heteroarylene group, a substituted or unsubstituted divalent non-aromatic condensed polycyclic group, and a substituted or unsubstituted divalent non-aromatic condensed heteropolycyclic group,

xe1 may be an integer from 0 to 5,

$R_{601}$ may be selected from a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, - Si($Q_{601}$)($Q_{602}$)($Q_{603}$), - -C(=O)($Q_{601}$), -S(=O)$_2$($Q_{661}$), and -P(=O)($Q_{601}$)($Q_{602}$),

$Q_{601}$ to $Q_{603}$ may each independently be a $C_1$-$C_{10}$ alkyl group, a $C_1$-$C_{10}$ alkoxy group, a phenyl group, a biphenyl group, a terphenyl group, or a naphthyl group, and

xe21 may be an integer from 1 to 5.

In one embodiment, at least one of $Ar_{601}$(s) in the number of xe11 and $R_{661}$(s) in the number of xe21 may include the $\pi$ electron-depleted nitrogen-containing ring.

For example, $Ar_{601}$ may be a substituted or unsubstituted $C_5$-$C_{30}$ carbocyclic group or a substituted or unsubstituted $C_1$-$C_{20}$ heterocyclic group, but embodiments are not limited thereto.

In one embodiment, $Ar_{601}$ in Formula 601 may be selected from:

a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, a dibenzothiophene group, a carbazole group, an imidazole group, a pyrazole group, a thiazole group, an isothiazole group, an oxazole group, an isoxazole group, a pyridine group, a pyrazine group, a pyrimidine group, a pyridazine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, and an azacarbazole group; and

a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, a dibenzothiophene group, a carbazole group, an imidazole group, a pyrazole group, a thiazole group, an isothiazole group, an oxazole group, an isoxazole group, a pyridine group, a pyrazine group, a pyrimidine group, a pyridazine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, and an azacarbazole group, each substituted with at least one selected from deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a phenyl group, a biphenyl group, a terphenyl group, a naphthyl group, $-Si(Q_{31})(Q_{32})(Q_{33})$, $-S(=O)_2(Q_{31})$, and $-P(=O)(Q_{31})(Q_{32})$, and

$Q_{31}$ to $Q_{33}$ may each independently be selected from a $C_1$-$C_{10}$ alkyl group, a $C_1$-$C_{10}$ alkoxy group, a phenyl group, a biphenyl group, a terphenyl group, and a naphthyl group.

When xe11 in Formula 601 is 2 or more, two or more $Ar_{661}$(s) may be linked to each other via a single bond.

In one or more embodiments, $Ar_{601}$ in Formula 601 may be an anthracene group.

In one or more embodiments, a compound represented by Formula 601 may be represented by Formula 601-1 below:

Formula 601-1

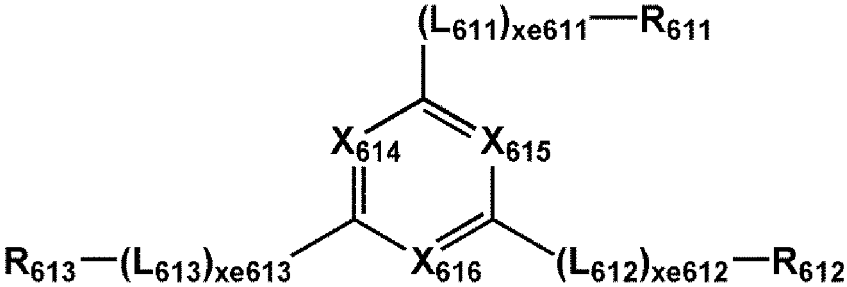

In Formula 601-1,

$X_{614}$ may be N or $C(R_{614})$, $X_{615}$ may be N or $C(R_{615})$, $X_{616}$ may be N or $C(R_{616})$, and at least one selected from $X_{614}$ to $X_{616}$ may be N,

$L_{611}$ to $L_{613}$ may each be understood by referring to the descriptions provided in connection with $L_{601}$,

xe611 to xe613 may each be understood by referring to the description presented in connection with xe1,

$R_{611}$ to $R_{613}$ may each be understood by referring to the descriptions provided in connection with $R_{601}$, and

$R_{614}$ to $R_{616}$ may each independently be selected from hydrogen, deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a phenyl group, a biphenyl group, a terphenyl group, and a naphthyl group.

For example, $L_{601}$ and $L_{611}$ to $L_{613}$ in Formulae 601 and 601-1 may each independently be selected from: a substituted or unsubstituted $C_3$-$C_{10}$ cycloalkylene group, a substituted or unsubstituted $C_1$-$C_{10}$ heterocycloalkylene group, a substituted or unsubstituted $C_3$-$C_{10}$ cycloalkenylene group, a substituted or unsubstituted $C_1$-$C_{10}$ heterocy-

cloalkenylene group, a substituted or unsubstituted $C_6$-$C_{30}$ arylene group, a substituted or unsubstituted $C_1$-$C_{20}$ heteroarylene group, a substituted or unsubstituted divalent non-aromatic condensed polycyclic group, and a substituted or unsubstituted divalent non-aromatic condensed heteropolycyclic group, but embodiments are not limited thereto.

In one embodiment, $L_{601}$ and $L_{611}$ to $L_{613}$ in Formulae 601 and 601-1 may each independently be selected from:

a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group; and

a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group, each substituted with at least one selected from deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group,

but embodiments of the present disclosure are not limited thereto.

In one or more embodiments, xe1 and xe611 to xe613 in Formulae 601 and 601-1 may each independently be 0, 1, or 2.

For example, $R_{601}$ and $R_{611}$ to $R_{613}$ in Formulae 601 and 601-1 may each independently be selected from: a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{30}$ aryl group, a substituted or unsubstituted $C_6$-$C_{30}$ aryloxy group, a substituted or unsubstituted $C_6$-$C_{30}$ arylthio group, a substituted or unsubstituted $C_1$-$C_{20}$ heteroaryl group, a substituted or unsubstituted monovalent non-aromatic condensed polycyclic group, a substituted or unsubstituted monovalent non-aromatic condensed heteropolycyclic group, - $Si(Q_{601})(Q_{602})(Q_{603})$, $-C(=O)(Q_{601})$, $-S(=O)_2(Q_{661})$, and $-P(=O)(Q_{601})(Q_{602})$.

In one or more embodiments, $R_{601}$ and $R_{611}$ to $R_{613}$ in Formulae 601 and 601-1 may each independently be selected from:

a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group;

a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group, each substituted with at least one selected from deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group; and

$-S(=O)_2(Q_{661})$, and $-P(=O)(Q_{601})(Q_{602})$, and

$Q_{601}$ and $Q_{602}$ are the same as described above.

The electron transport region may include at least one compound selected from Compounds ET1 to ET36 below, but embodiments of the present disclosure are not limited thereto:

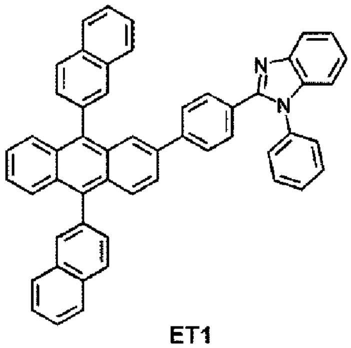

ET1

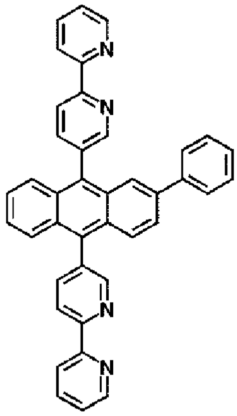

ET2

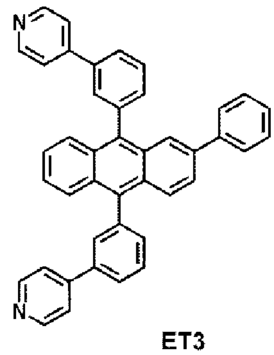

ET3

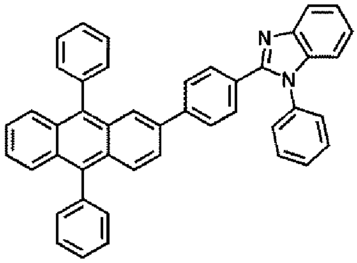

ET4

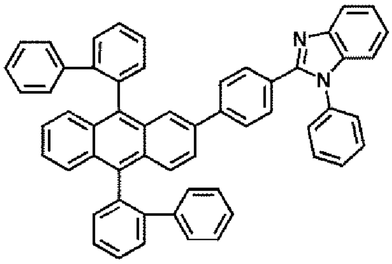

ET5

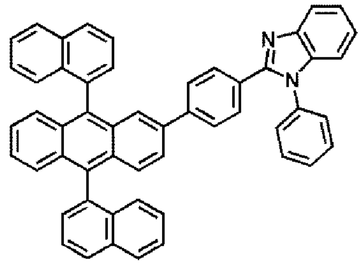

ET6

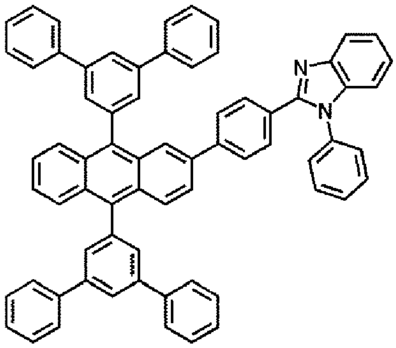

ET7

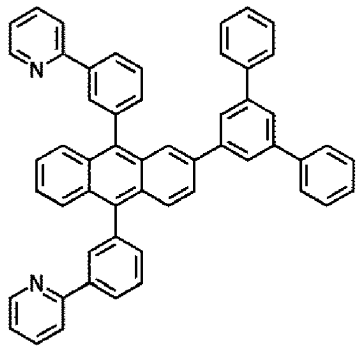

ET8

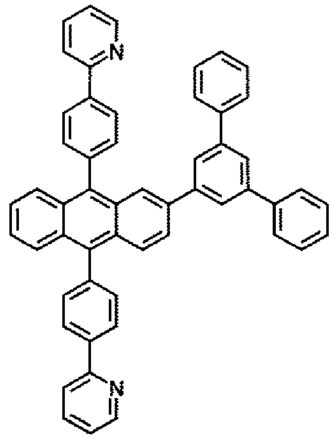

ET9

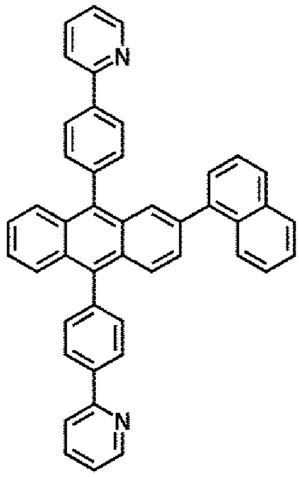

ET10

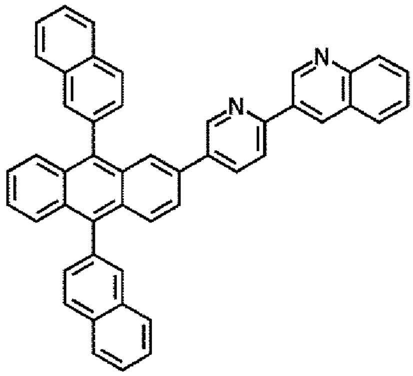

ET11

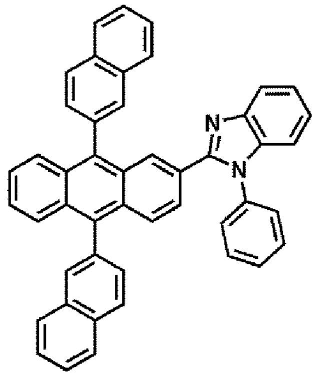

ET12

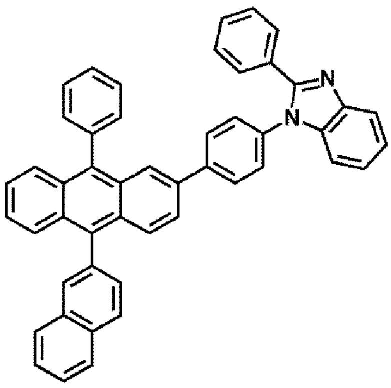

ET13

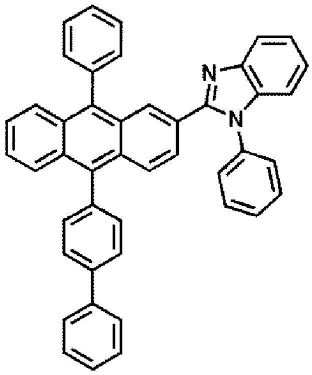

ET14

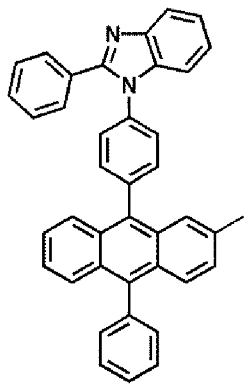

ET15

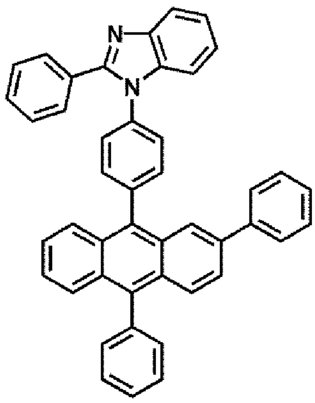

ET16

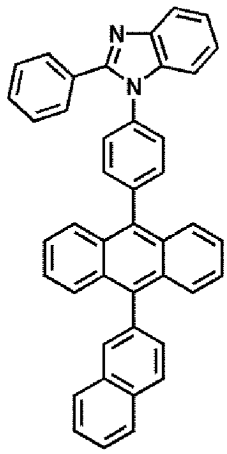

ET17

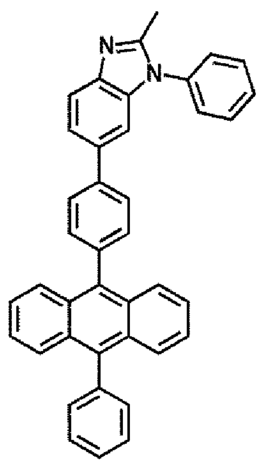

ET18

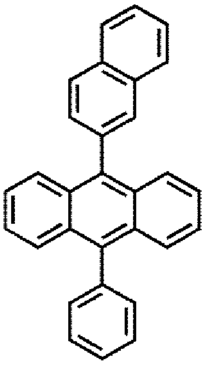

ET19

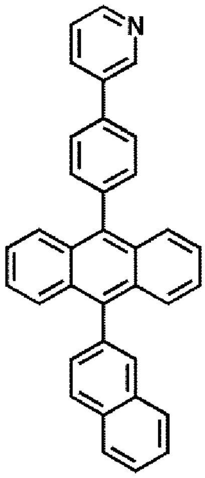

ET20

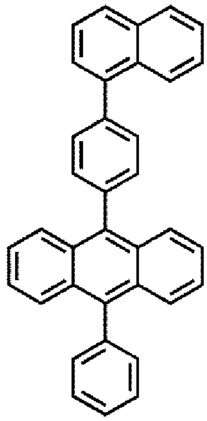

ET21

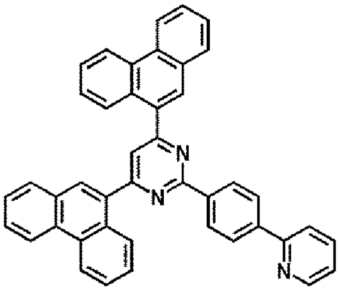

ET22

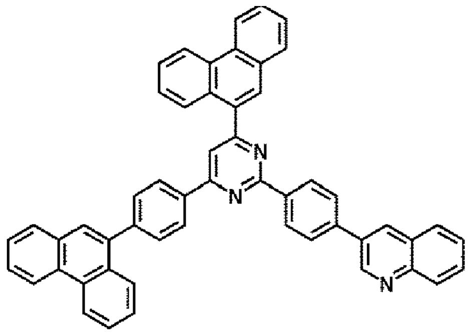

ET23

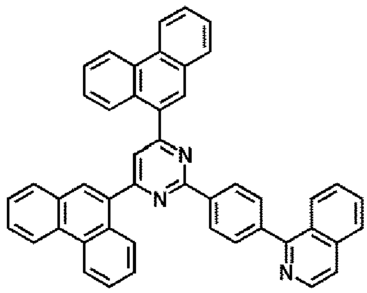

ET24

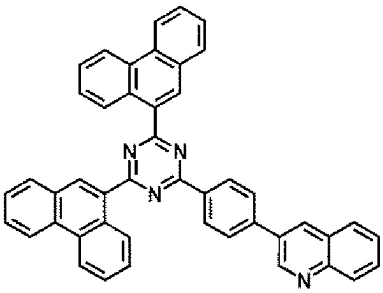

ET25

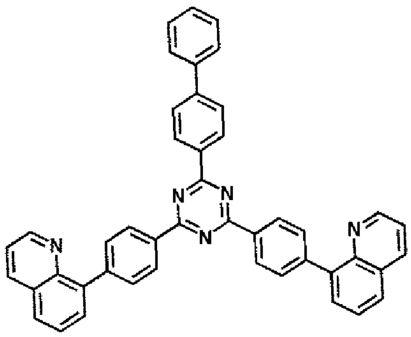

ET26

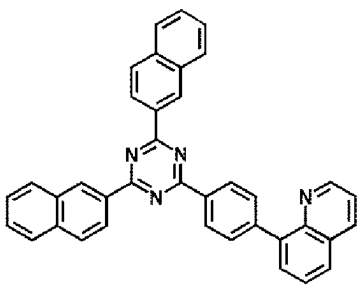

ET27

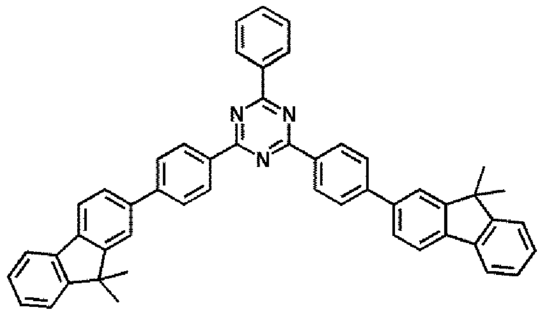

ET28

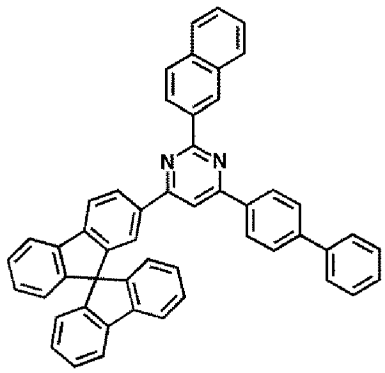

ET29

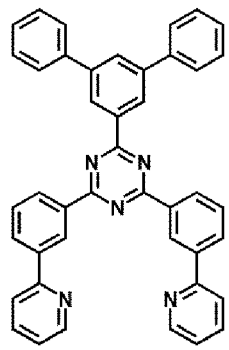

ET30

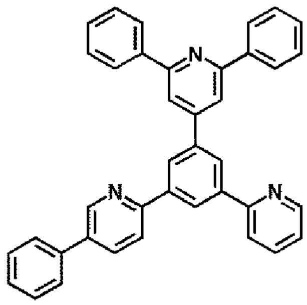

ET31

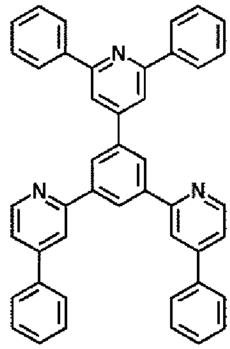

ET32

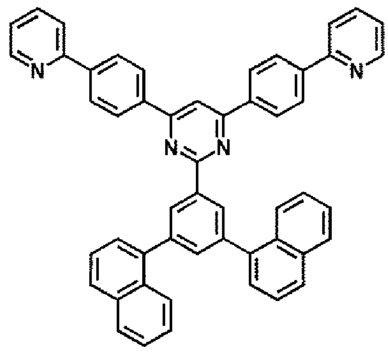

ET33

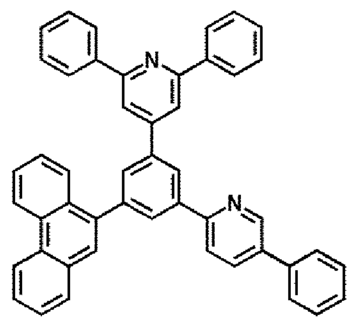

ET34

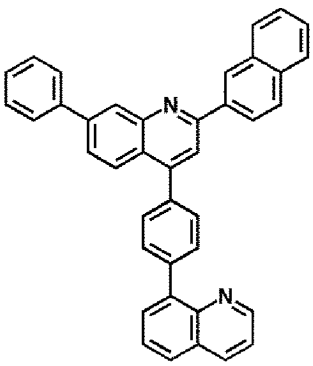

ET35

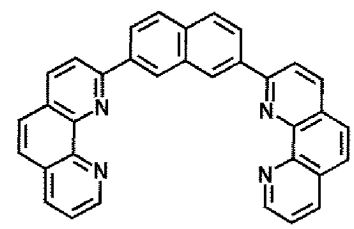

ET36

In one or more embodiments, the electron transport region may include at least one compound selected from 2,9-dimethyl-4,7-diphenyl-1,10-phenanthroline (BCP), 4,7-diphenyl-1,10-phenanthroline (Bphen), $Alq_3$, BAlq, 3-(biphenyl-4-yl)-5-(4-tert-butylphenyl)-4-phenyl-4H-1,2,4-triazole (TAZ), NTAZ, and diphenyl(4-(triphenylsilyl)phenyl)-phosphine oxide (TSPO1):

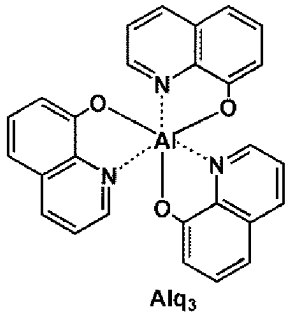

Alq$_3$

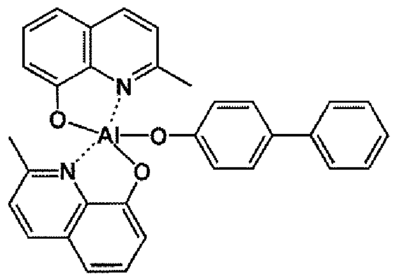

BAlq

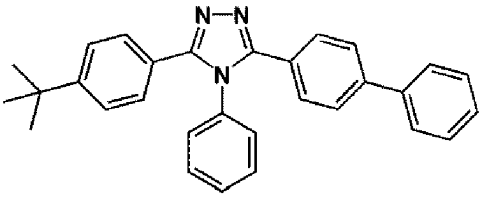

TAZ

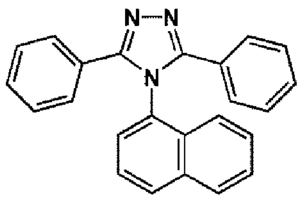

NTAZ

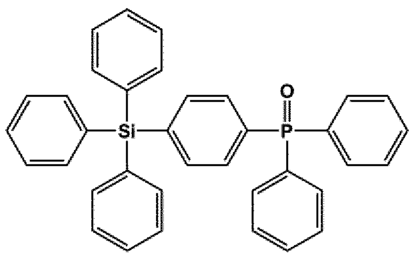

TSPO1

A thickness of the buffer layer, the hole blocking layer, or the electron control layer may be in a range of about 20 Å to about 1,000 Å, for example, about 20 Å to about 700 Å, about 20 Å to about 500 Å, about 20 Å to about 400 Å, about 30 Å to about 400 Å or about 30 Å to about 300 Å. When the thicknesses of the buffer layer, the hole blocking layer, and the electron control layer are within these ranges, the hole blocking layer may have suitable (e.g., excellent) hole blocking characteristics or electron control characteristics without a substantial increase in driving voltage.

A thickness of the electron transport layer may be from about 100 Å to about 1,000 Å, for example, about 100 Å to about 700 Å, about 100 Å to about 600 Å, about 150 Å to about 600 Å, about 150 Å to about 500 Å Å or about 200 Å to about 400 Å. When the thickness of the electron transport layer is within the ranges described above, the electron transport layer may have satisfactory electron transport characteristics without a substantial increase in driving voltage.

The electron transport region (for example, the electron transport layer in the electron transport region) may further include, in addition to the materials described above, a metal-containing material.

The metal-containing material may include at least one selected from alkali metal complex and alkaline earth-metal complex. The alkali metal complex may include a metal ion selected from a Li ion, a Na ion, a K ion, a Rb ion, and a Cs ion, and the alkaline earth-metal complex may include a metal ion selected from a Be ion, a Mg ion, a Ca ion, a Sr ion, and a Ba ion. A ligand coordinated with the metal ion of the alkali metal complex or the alkaline earth-metal complex may be selected from a hydroxy quinoline, a hydroxy isoquinoline, a hydroxy benzoquinoline, a hydroxy acridine, a hydroxy phenanthridine, a hydroxy phenyloxazole, a hydroxy phenylthiazole, a hydroxy diphenyloxadiazole, a hydroxy diphenylthiadiazole, a hydroxy phenylpyridine, a hydroxy phenylbenzimidazole, a hydroxy phenylbenzothiazole, a bipyridine, a phenanthroline, and a cyclopentadiene, but embodiments of the present disclosure are not limited thereto.

For example, the metal-containing material may include a Li complex. The Li complex may include, for example, Compound ET-D1 (lithium quinolate, LiQ) or ET-D2 below:

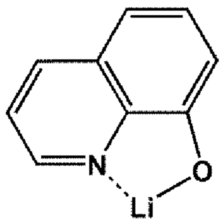

ET-D1

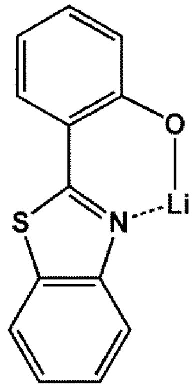

ET-D2

The electron transport region may include an electron injection layer that facilitates electron injection from the second electrode 190. The electron injection layer may be in direct contact with the second electrode 190.

The electron injection layer may have i) a single-layered structure including a single layer including a single material, ii) a single-layered structure including a single layer including a plurality of different materials, or iii) a multi-layered structure having a plurality of layers including a plurality of different materials.

The electron injection layer may include an alkali metal, an alkaline earth metal, a rare earth metal, an alkali metal compound, an alkaline earth-metal compound, a rare earth metal compound, an alkali metal complex, an alkaline earth-metal complex, a rare earth metal complex, or any combination thereof.

The alkali metal may be selected from Li, Na, K, Rb, and Cs. In one embodiment, the alkali metal may be Li, Na, and/or Cs. In one or more embodiments, the alkali metal may be Li and/or Cs, but embodiments of the present disclosure are not limited thereto.

The alkaline earth metal may be selected from Mg, Ca, Sr, and Ba.

The rare earth metal may be selected from Sc, Y, Ce, Tb, Yb, and Gd.

The alkali metal compound, the alkaline earth-metal compound, and the rare earth metal compound may be selected from oxides and halides (for example, fluorides, chlorides, bromides, and/or iodides) of the alkali metal, the alkaline earth-metal, and the rare earth metal.

The alkali metal compound may be selected from alkali metal oxides, such as $Li_2O$, $Cs_2O$, and/or $K_2O$, and alkali metal halides, such as LiF, NaF, CsF, KF, LiI, NaI, CsI, and/or KI. In one embodiment, the alkali metal compound may be selected from LiF, $Li_2O$, NaF, LiI, NaI, CsI, and KI, but embodiments of the present disclosure are not limited thereto.

The alkaline earth-metal compound may be selected from alkaline earth-metal oxides, such as BaO, SrO, CaO, $Ba_xSr_{1-x}O$ ($0<x<1$), and/or $Ba_xCa_{1-x}O$ ($0<x<1$). In one embodiment, the alkaline earth-metal compound may be selected from BaO, SrO, and CaO, but embodiments of the present disclosure are not limited thereto.

The rare earth metal compound may be selected from $YbF_3$, $ScF_3$, $Sc_2O_3$, $Y_2O_3$, $Ce_2O_3$, $GdF_3$ and $TbF_3$. In one embodiment, the rare earth metal compound may be selected from $YbF_3$, $ScF_3$, $TbF_3$, $YbI_3$, $ScI_3$, and $TbI_3$, but embodiments of the present disclosure are not limited thereto.

The alkali metal complex, the alkaline earth-metal complex, and the rare earth metal complex may include an ion of alkali metal, alkaline earth-metal, and rare earth metal as described above, and a ligand coordinated with a metal ion of the alkali metal complex, the alkaline earth-metal complex, or the rare earth metal complex may be selected from hydroxy quinoline, hydroxy isoquinoline, hydroxy benzoquinoline, hydroxy acridine, hydroxy phenanthridine, hydroxy phenyloxazole, hydroxy phenylthiazole, hydroxy diphenyloxadiazole, hydroxy diphenylthiadiazole, hydroxy phenylpyridine, hydroxy phenylbenzimidazole, hydroxy phenylbenzothiazole, bipyridine, phenanthroline, and cyclopentadiene, but embodiments of the present disclosure are not limited thereto.

The electron injection layer may include (e.g., consist of) an alkali metal, an alkaline earth metal, a rare earth metal, an alkali metal compound, an alkaline earth-metal compound, a rare earth metal compound, an alkali metal complex, an alkaline earth-metal complex, a rare earth metal complex, or any combination thereof, as described above. In one or more embodiments, the electron injection layer may further include an organic material. When the electron injection layer further includes the organic material, the alkali metal, the alkaline earth metal, the rare earth metal, the alkali metal compound, the alkaline earth-metal compound, the rare earth metal compound, the alkali metal complex, the alkaline earth-metal complex, the rare earth metal complex, or any combination thereof may be homogeneously or non-homogeneously dispersed in a matrix including the organic material.

A thickness of the electron injection layer may be in a range of about 1 Å to about 100 Å, for example, about 3 Å to about 90 Å or about 3 Å to about 20 Å. When the thickness of the electron injection layer is within these ranges, satisfactory electron injection characteristics may be obtained without substantial increase in driving voltage.

**Second electrode 190**

The second electrode 190 is disposed on the organic layer 150 having such a structure. The second electrode 190 may be a cathode which is an electron injection electrode, and in this regard, a material for forming the second electrode 190 may be selected from a metal, an alloy, an electrically conductive compound, and combinations thereof, which may have a relatively low work function.

The second electrode 190 may include at least one selected from lithium (Li), silver (Ag), magnesium (Mg), aluminium (Al), aluminium-lithium (Al-Li), calcium (Ca), magnesium-indium (Mg-In), magnesium-silver (Mg-Ag), ITO, and IZO, but embodiments of the present disclosure are not limited thereto. The second electrode 190 may be a transmissive electrode, a semi-transmissive electrode, or a reflective electrode.

The second electrode 190 may have a single-layered structure, or a multi-layered structure including two or more layers.

**Description of FIGS. 2 to 4**

An organic light-emitting device 20 of FIG. 2 has a structure in which a first capping layer 210, the first electrode 110, the organic layer 150, and the second electrode 190 are sequentially stacked in this stated order. An organic light-emitting device 30 of FIG. 3 has a structure in which the first electrode 110, the organic layer 150, the second electrode 190, and a second capping layer 220 are sequentially stacked in this stated order. An organic light-emitting device 40 of FIG. 4 has a structure in which the first capping layer 210, the first electrode 110, the organic layer 150, the second electrode 190, and the second capping layer 220 are sequentially stacked in this stated order.

Regarding FIGS. 2 to 4, the first electrode 110, the organic layer 150, and the second electrode 190 may be understood by referring to the corresponding descriptions provided in connection with FIG. 1.

In the organic layer 150 of each of the organic light-emitting devices 20 and 40, light generated in an emission layer may pass through the first electrode 110 and the first capping layer 210 toward the outside, wherein the first electrode 110 may be a semi-transmissive electrode or a transmissive electrode. In the organic layer 150 of each of the organic light-emitting devices 30 and 40, light generated in an emission layer may pass through the second electrode 190 and the second capping layer 220 toward the outside, wherein the second electrode 190 may be a semi-transmissive electrode or a transmissive electrode.

The first capping layer 210 and the second capping layer 220 may increase external luminescence efficiency according to the principle of constructive interference.

The first capping layer 210 and the second capping layer 220 may each independently be an organic capping layer including an organic material, an inorganic capping layer including an inorganic material, or a composite capping layer including an organic material and an inorganic material.

At least one selected from the first capping layer 210 and the second capping layer 220 may each independently include at least one material selected from carbocyclic compounds, heterocyclic compounds, amine-based compounds, porphyrine derivatives, phthalocyanine derivatives, naphthalocyanine derivatives, alkali metal complexes, and alkaline earth-based complexes. The carbocyclic compound, the heterocyclic compound, and the amine-based compound may be optionally substituted with a substituent containing at least one element selected from O, N, S, Se, Si, F, Cl, Br, and I. In one embodiment, at least one selected from the first capping layer 210 and the second capping layer 220 may each independently include an amine-based compound.

In one embodiment, at least one selected from the first capping layer 210 and the second capping layer 220 may each independently include the compound represented by Formula 201 or the compound represented by Formula 202.

In one or more embodiments, at least one selected from the first capping layer 210 and the second capping layer 220 may each independently include a compound selected from Compounds HT28 to HT33 and Compounds CP1 to CP5 below, but embodiments of the present disclosure are not limited thereto.

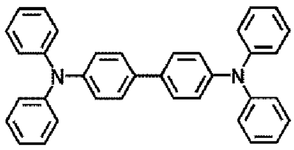

CP1

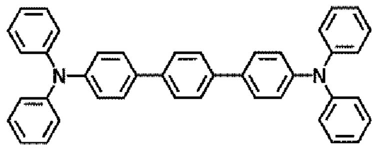

CP2

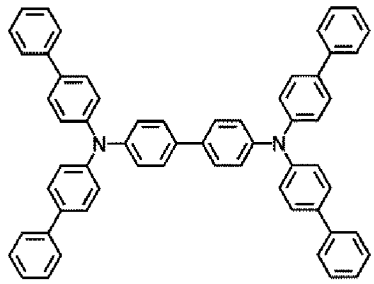

CP3

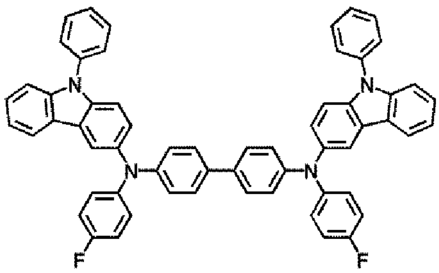

CP4

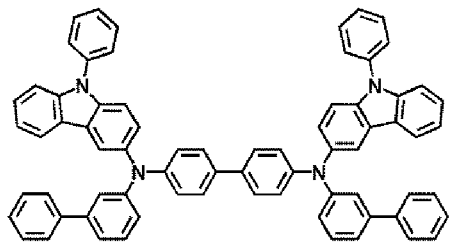

CP5

Hereinbefore, the organic light-emitting device according to an embodiment has been described in connection with FIGS. 1 to 4, but embodiments of the present disclosure are not limited thereto.

Layers constituting the hole transport region, the emission layer, and layers constituting the electron transport region may be formed in a certain region by utilizing one or more suitable methods selected from vacuum deposition, spin coating, casting, Langmuir-Blodgett (LB) deposition, ink-jet printing, laser-printing, and laser-induced thermal imaging (LITI).

When layers constituting the hole transport region, the emission layer, and layers constituting the electron transport region are formed by vacuum deposition, the deposition may be performed at a deposition temperature of about 100 °C to about 500 °C, a vacuum degree of about $10^{-8}$ torr to about $10^{-3}$ torr, and a deposition speed of about 0.01 Å/sec to about 100 Å/sec by taking into account a material to be included in a layer to be formed, and the structure of a layer to be formed.

When layers constituting the hole transport region, the emission layer, and layers constituting the electron transport region are formed by spin coating, the spin coating may be performed at a coating speed of about 2,000 rpm to about 5,000 rpm and at a heat treatment temperature of about 80 °C to 200 °C by taking into account a material to be included in a layer to be formed, and the structure of a layer to be formed.

**Apparatus**

The organic light-emitting device may be included in various suitable apparatuses.

In more detail, one example of such apparatuses may include: a thin-film transistor including a source electrode, a drain electrode, and an activation layer; and the organic light-emitting device. Here, the first electrode of the organic light-emitting device may be in electrical contact with the source electrode or the drain electrode of the thin-film transistor.

The thin-film transistor may further include a gate electrode, a gate insulation layer, and/or the like.

The active layer may include crystalline silicon, amorphous silicon, organic semiconductor, oxide semiconductor, and/or the like, but embodiments of the present disclosure are not limited thereto.

The apparatus may further include a sealing part for sealing the organic light-emitting device. The sealing part may allow an image from the organic light-emitting device to be displayed and may block outside air and moisture from penetrating into the organic light-emitting device. The sealing part may be a sealing substrate including a transparent glass or a plastic substrate. The sealing part may be a thin film encapsulation layer including a plurality of organic layers and/or a plurality of inorganic layers. When the sealing part is a thin film encapsulation layer, the entire apparatus may be flexible.

For example, the apparatus may be a light-emitting apparatus, an authentication apparatus, or an electronic apparatus.

The light-emitting apparatus may be utilized as various suitable displays, light sources, and/or the like.

The authentication apparatus may be, for example, a biometric authentication apparatus for authenticating an

individual by utilizing biometric information of a biometric body (for example, a finger tip, a pupil, and/or the like). The authentication apparatus may further include, in addition to the organic light-emitting device, a biometric information collector.

The electronic apparatus may be applied to personal computers (for example, a mobile personal computer), mobile phones, digital cameras, electronic organizers, electronic dictionaries, electronic game machines, medical instruments (for example, electronic thermometers, sphygmomanometers, blood glucose meters, pulse measurement devices, pulse wave measurement devices, electrocardiogram (ECG) displays, ultrasonic diagnostic devices, and/or endoscope displays), fish finders, various suitable measuring instruments, meters (for example, meters for a vehicle, an aircraft, and/or a vessel), projectors, and/or the like, but embodiments of the present disclosure are not limited thereto.

**General definition of substituents**

The term "$\pi$ electron-depleted nitrogen-containing cyclic group" as used herein refers to a cyclic group having at least one *-N=*' moiety, for example, an imidazole group, a pyrazole group, a thiazole group, an isothiazole group, an oxazole group, an isoxazole group, a pyridine group, a pyrazine group, a pyridazine group, a pyrimidine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, and/or an azacarbazole group.

The term "$\pi$ electron-depleted nitrogen-free cyclic group" as used herein refers to a cyclic group that does not have a *-N=*' moiety. The $\pi$ electron-depleted nitrogen-free cyclic group may be selected from a benzene group, a heptalene group, an indene group, a naphthalene group, an azulene group, a heptalene group, an indacene group, acenaphthylene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentacene group, a hexacene group, a pentacene group, a rubicene group, a coronene group, an ovalene group, a pyrrole group, an isoindole group, an indole group, a furan group, a thiophene group, a benzofuran group, a benzothiophene group, a benzocarbazole group, a dibenzocarbazole group, a dibenzofuran group, a dibenzothiophene group, a dibenzothiophene sulfone group, a carbazole group, a dibenzosilole group, an indenocarbazole group, an indolocarbazole group, a benzofurocarbazole group, a benzothienocarbazole group and a triindolobenzene group, but embodiments of the present disclosure are not limited thereto.

The term "transition metal of Period 4 of the Periodic Table of Elements" as used herein refers to an element of Period 4 and the d-block of the Periodic Table of Elements, and non-limiting examples thereof include scandium (Sc), titanium (Ti), vanadium (V), chromium (Cr), manganese (Mn), iron (Fe), cobalt (Co), nickel (Ni), copper (Cu), and zinc (Zn).

The term "transition metal of Period 5 of the Periodic Table of Elements" as used herein refers to an element of Period 5 and the d-block of the Periodic Table of Elements, and non-limiting examples thereof include yttrium (Y), zirconium (Zr), niobium (Nb), molybdenum (Mo), technetium (Tc), ruthenium (Ru), rhodium (Rh), palladium (Pd), silver (Ag), and cadmium (Cd).

The term "transition metal of Period 6 of the Periodic Table of Elements" as used herein refers to an element of Period 6 and the d-block and the f-block of the Periodic Table of Elements, and non-limiting examples thereof include lanthanum (La), samarium (Sm), europium (Eu), terbium (Tb), thulium (Tm), ytterbium (Yb), lutetium (Lu), hafnium (Hf), tantalum (Ta), tungsten (W), rhenium (Re), osmium (Os), iridium (Ir), platinum (Pr), gold (Au), and mercury (Hg).

The term "$C_1$-$C_{60}$ alkyl group" as used herein refers to a linear or branched aliphatic saturated hydrocarbon monovalent group having 1 to 60 carbon atoms, and non-limiting examples thereof include a methyl group, an ethyl group, a propyl group, an isobutyl group, a see-butyl group, a tert-butyl group, a pentyl group, an isoamyl group, and a hexyl group. The term "$C_1$-$C_{60}$ alkylene group" as used herein refers to a divalent group having the same structure as the $C_1$-$C_{60}$ alkyl group. Corresponding definitions apply to other ranges given for the number of carbon atoms in an alkyl/alkylene group.

The term "$C_2$-$C_{60}$ alkenyl group" as used herein refers to a hydrocarbon group having at least one carbon-carbon double bond in, for example, the middle and/or at the terminus of the $C_2$-$C_{60}$ alkyl group, and non-limiting examples thereof include an ethenyl group, a propenyl group, and a butenyl group. The term "$C_2$-$C_{60}$ alkenylene group" as used herein refers to a divalent group having the same structure as the $C_2$-$C_{60}$ alkenyl group. Corresponding definitions apply to other ranges given for the number of carbon atoms in an alkenyl/alkenylene group.

The term "$C_2$-$C_{60}$ alkynyl group" as used herein refers to a hydrocarbon group having at least one carbon-carbon triple bond in, for example, the middle and/or at the terminus of the $C_2$-$C_{60}$ alkyl group, and non-limiting examples thereof include an ethynyl group, and a propynyl group. The term "$C_2$-$C_{60}$ alkynylene group" as used herein refers to a divalent group having the same structure as the $C_2$-$C_{60}$ alkynyl group. Corresponding definitions apply to other ranges

given for the number of carbon atoms in an alkynyl/alkynylene group.

The term "$C_1$-$C_{60}$ alkoxy group" as used herein refers to a monovalent group represented by -$OA_{101}$ (wherein $A_{101}$ is the $C_1$-$C_{60}$ alkyl group), and non-limiting examples thereof include a methoxy group, an ethoxy group, and an isopropyloxy group. Corresponding definitions apply to other ranges given for the number of carbon atoms in an alkoxy group.

The term "$C_3$-$C_{10}$ cycloalkyl group" as used herein refers to a monovalent saturated hydrocarbon monocyclic group having 3 to 10 carbon atoms, and non-limiting examples thereof include a cyclopropyl group, a cyclobutyl group, a cyclopentyl group, a cyclohexyl group, and a cycloheptyl group. The term "$C_3$-$C_{10}$ cycloalkylene group" as used herein refers to a divalent group having the same structure as the $C_3$-$C_{10}$ cycloalkyl group.

The term "$C_1$-$C_{10}$ heterocycloalkyl group" as used herein refers to a monovalent monocyclic group having at least one heteroatom selected from N, O, Si, P, and S as a ring-forming atom, and 1 to 10 carbon atoms as the remaining ring-forming atoms, and non-limiting examples thereof include a 1,2,3,4-oxatriazolidinyl group, a tetrahydrofuranyl group, and a tetrahydrothiophenyl group. The term "$C_1$-$C_{10}$ heterocycloalkylene group" as used herein refers to a divalent group having the same structure as the $C_1$-$C_{10}$ heterocycloalkyl group.

The term $C_3$-$C_{10}$ cycloalkenyl group used herein refers to a monovalent monocyclic group that has 3 to 10 carbon atoms and at least one carbon-carbon double bond in the ring thereof and no aromaticity, and non-limiting examples thereof include a cyclopentenyl group, a cyclohexenyl group, and a cycloheptenyl group. The term "$C_3$-$C_{10}$ cycloalkenylene group" as used herein refers to a divalent group having the same structure as the $C_3$-$C_{10}$ cycloalkenyl group.

The term "$C_1$-$C_{10}$ heterocycloalkenyl group" as used herein refers to a monovalent monocyclic group that has at least one heteroatom selected from N, O, Si, P, and S as a ring-forming atom, 1 to 10 carbon atoms as the remaining ring-forming atoms, and at least one carbon-carbon double bond in its ring. Non-limiting examples of the $C_1$-$C_{10}$ heterocycloalkenyl group include a 4,5-dihydro-1 ,2,3,4-oxatriazolyl group, a 2,3-dihydrofuranyl group, and a 2,3-dihydrothiophenyl group. The term "$C_1$-$C_{10}$ heterocycloalkenylene group" as used herein refers to a divalent group having the same structure as the $C_1$-$C_{10}$ heterocycloalkenyl group.

The term "$C_6$-$C_{60}$ aryl group" as used herein refers to a monovalent group having a carbocyclic aromatic system having 6 to 60 carbon atoms. Non-limiting examples of the $C_6$-$C_{60}$ aryl group include a phenyl group, a naphthyl group, an anthracenyl group, a phenanthrenyl group, a pyrenyl group, and a chrysenyl group. The term "$C_6$-$C_{60}$ arylene group" used herein refers to a divalent group having the same structure as the $C_6$-$C_{60}$ aryl group. When the $C_6$-$C_{60}$ aryl group and the $C_6$-$C_{60}$ arylene group each independently include two or more rings, the respective rings may be fused to each other. Corresponding definitions apply to other ranges given for the number of carbon atoms in an aryl/arylene group.

The term "$C_1$-$C_{60}$ heteroaryl group" as used herein refers to a monovalent group having a carbocyclic aromatic system that has at least one heteroatom selected from N, O, Si, P, and S as a ring-forming atom, in addition to 1 to 60 carbon atoms as the remaining ring-forming atoms. Non-limiting examples of the $C_1$-$C_{60}$ heteroaryl group include a pyridinyl group, a pyrimidinyl group, a pyrazinyl group, a pyridazinyl group, a triazinyl group, a quinolinyl group, and an isoquinolinyl group. The term "$C_1$-$C_{60}$ heteroarylene group" as used herein refers to a divalent group having the same structure as the $C_1$-$C_{60}$ heteroaryl group. When the $C_1$-$C_{60}$ heteroaryl group and the $C_1$-$C_{60}$ heteroarylene group each independently include two or more rings, the respective rings may be condensed (fused) with each other. Corresponding definitions apply to other ranges given for the number of carbon atoms in an heteroaryl/heteroarylene group.

The term "$C_6$-$C_{60}$ aryloxy group" as used herein refers to a monovalent group represented by -$OA_{102}$ (wherein $A_{102}$ is the $C_6$-$C_{60}$ aryl group), and the term "$C_6$-$C_{60}$ arylthio group" as used herein refers to a monovalent group represented by -$SA_{103}$ (wherein $A_{103}$ is the $C_6$-$C_{60}$ aryl group). Corresponding definitions apply to other ranges given for the number of carbon atoms in an aryloxy group and an arylthio group.

The term "$C_1$-$C_{60}$ heteroaryloxy group" as used herein refers to a monovalent group represented by -$OA_{104}$ (wherein $A_{104}$ is the $C_1$-$C_{60}$ heteroaryl group), and the term "$C_1$-$C_{60}$ heteroarylthio group" as used herein refers to -$SA_{105}$ (wherein $A_{105}$ is the $C_1$-$C_{60}$ heteroaryl group). Corresponding definitions apply to other ranges given for the number of carbon atoms in a heteroaryloxy group and a heteroarylthio group.

The term "monovalent non-aromatic condensed polycyclic group" as used herein refers to a monovalent group having two or more rings condensed with each other, only carbon atoms as ring-forming atoms (for example, having 8 to 60 carbon atoms), and no aromaticity in its entire molecular structure (e.g., the molecular structure as a whole does not have aromaticity). A non-limiting example of the monovalent non-aromatic condensed polycyclic group is a fluorenyl group. The term "divalent non-aromatic condensed polycyclic group" as used herein refers to a divalent group having the same structure as that of the monovalent non-aromatic condensed polycyclic group.

The term "monovalent non-aromatic condensed heteropolycyclic group" as used herein refers to a monovalent group having two or more rings condensed to each other, at least one heteroatom selected from N, O, Si, P, and S, other than carbon atoms (for example, 1 to 60 carbon atoms), as a ring-forming atom, and no aromaticity in its entire molecular structure (e.g., the molecular structure as a whole does not have aromaticity). A non-limiting example of the monovalent non-aromatic condensed heteropolycyclic group is a carbazolyl group. The term "divalent non-aromatic

condensed heteropolycyclic group" as used herein refers to a divalent group having the same structure as that of the monovalent non-aromatic condensed heteropolycyclic group.

The term "$C_5$-$C_{60}$ carbocyclic group" as used herein refers to a monocyclic or polycyclic group having 5 to 60 carbon atoms in which ring-forming atoms are carbon atoms only. The term "$C_5$-$C_{60}$ carbocyclic group" as used herein refers to an aromatic carbocyclic group or a non-aromatic carbocyclic group. The $C_5$-$C_{60}$ carbocyclic group may be a ring (such as benzene), a monovalent group (such as a phenyl group), or a divalent group (such as a phenylene group). In one or more embodiments, depending on the number of substituents connected to the $C_5$-$C_{60}$ carbocyclic group, the $C_5$-$C_{60}$ carbocyclic group may be a trivalent group or a quadrivalent group. Corresponding definitions apply to other ranges given for the number of carbon atoms in a carbocyclic group.

The term "$C_1$-$C_{60}$ heterocyclic group" as used herein refers to a group having the same structure as the $C_5$-$C_{60}$ carbocyclic group, except that as a ring-forming atom, at least one heteroatom selected from N, O, Si, P, and S is used in addition to carbon atoms (the number of carbon atoms may be in a range of 1 to 60). Corresponding definitions apply to other ranges given for the number of carbon atoms in a heterocyclic group.

In the present specification, at least one substituent of the substituted $C_5$-$C_{60}$ (*e.g.* $C_5$-$C_{30}$) carbocyclic group, the substituted $C_1$-$C_{60}$ (*e.g.* $C_1$-$C_{20}$) heterocyclic group, the substituted $C_3$-$C_{10}$ cycloalkylene group, the substituted $C_1$-$C_{10}$ heterocycloalkylene group, the substituted $C_3$-$C_{10}$ cycloalkenylene group, the substituted $C_1$-$C_{10}$ heterocycloalkenylene group, the substituted $C_6$-$C_{60}$ (*e.g.* $C_6$-$C_{30}$) arylene group, the substituted $C_1$-$C_{60}$ (*e.g.* $C_1$-$C_{20}$) heteroarylene group, the substituted divalent non-aromatic condensed polycyclic group, the substituted divalent non-aromatic condensed heteropolycyclic group, the substituted $C_1$-$C_{60}$ (*e.g.* $C_1$-$C_{20}$) alkyl group, the substituted $C_2$-$C_{60}$ (*e.g.* $C_2$-$C_{20}$) alkenyl group, the substituted $C_2$-$C_{60}$ (*e.g.* $C_2$-$C_{20}$) alkynyl group, the substituted $C_1$-$C_{60}$ (*e.g.* $C_1$-$C_{20}$) alkoxy group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ (*e.g.* $C_6$-$C_{30}$) aryl group, the substituted $C_6$-$C_{60}$ (*e.g.* $C_6$-$C_{30}$) aryloxy group, the substituted $C_6$-$C_{60}$ *(e.g.* $C_6$-$C_{30}$) arylthio group, the substituted $C_1$-$C_{60}$ *(e.g.* $C_1$-$C_{20}$) heteroaryl group, the substituted $C_1$-$C_{60}$ (*e.g.* $C_1$-$C_{20}$) heteroaryloxy group, the substituted $C_1$-$C_{60}$ (*e.g.* $C_1$-$C_{20}$) heteroarylthio group, the substituted monovalent non-aromatic condensed polycyclic group, and the substituted monovalent non-aromatic condensed heteropolycyclic group may be selected from:

deuterium, -F, -Cl, -Br, -I, a hydroxyl group, a cyano group, a nitro group, an amidino group, a hydrazino group, a hydrazono group, a $C_1$-$C_{60}$ (*e.g.* $C_1$-$C_{20}$) alkyl group, a $C_2$-$C_{60}$ (*e.g.* $C_2$-$C_{20}$) alkenyl group, a $C_2$-$C_{60}$ (*e.g.* $C_2$-$C_{20}$) alkynyl group, and a $C_1$-$C_{60}$ (*e.g.* $C_1$-$C_{20}$) alkoxy group;

a $C_1$-$C_{60}$ (*e.g.* $C_1$-$C_{20}$) alkyl group, a $C_2$-$C_{60}$ (*e.g.* $C_2$-$C_{20}$) alkenyl group, a $C_2$-$C_{60}$ (*e.g.* $C_2$-$C_{20}$) alkynyl group, and a $C_1$-$C_{60}$ (*e.g.* $C_1$-$C_{20}$) alkoxy group, each substituted with at least one selected from deuterium, -F, -Cl, -Br, -I, a hydroxyl group, a cyano group, a nitro group, an amidino group, a hydrazino group, a hydrazono group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ (*e.g.* $C_6$-$C_{30}$) aryl group, a $C_6$-$C_{60}$ (*e.g.* $C_6$-$C_{30}$) aryloxy group, a $C_6$-$C_{60}$ (*e.g.* $C_6$-$C_{30}$) arylthio group, a $C_1$-$C_{60}$ (*e.g.* $C_1$-$C_{20}$) heteroaryl group, a $C_1$-$C_{60}$ (*e.g.* $C_1$-$C_{20}$) heteroaryloxy group, a $C_1$-$C_{60}$ (*e.g.* $C_1$-$C_{20}$) heteroarylthio group, a monovalent non-aromatic condensed polycyclic group, a monovalent non-aromatic condensed heteropolycyclic group, -Si($Q_{11}$)($Q_{12}$)($Q_{13}$), - N($Q_{11}$)($Q_{12}$), -B($Q_{11}$)($Q_{12}$), -C(=O)($Q_{11}$), -S(=O)$_2$($Q_{11}$), and -P(=O)($Q_{11}$)($Q_{12}$);

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ (*e.g.* $C_6$-$C_{30}$) aryl group, a $C_6$-$C_{60}$ (*e.g.* $C_6$-$C_{30}$) aryloxy group, a $C_6$-$C_{60}$ (*e.g.* $C_6$-$C_{30}$) arylthio group, a $C_1$-$C_{60}$ (*e.g.* $C_1$-$C_{20}$) heteroaryl group, a $C_1$-$C_{60}$ (*e.g.* $C_1$-$C_{20}$) heteroaryloxy group, a $C_1$-$C_{60}$ (*e.g.* $C_1$-$C_{20}$) heteroarylthio group, a monovalent non-aromatic condensed polycyclic group, and a monovalent non-aromatic condensed heteropolycyclic group;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ (*e.g.* $C_6$-$C_{30}$) aryl group, a $C_6$-$C_{60}$ (*e.g.* $C_6$-$C_{30}$) aryloxy group, a $C_6$-$C_{60}$ (*e.g.* $C_6$-$C_{30}$) arylthio group, a $C_1$-$C_{60}$ (*e.g.* $C_1$-$C_{20}$) heteroaryl group, a $C_1$-$C_{60}$ (*e.g.* $C_1$-$C_{20}$) heteroaryloxy group, a $C_1$-$C_{60}$ (*e.g.* $C_1$-$C_{20}$) heteroarylthio group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amidino group, a hydrazino group, a hydrazono group, a $C_1$-$C_{60}$ (*e.g.* $C_1$-$C_{20}$) alkyl group, a $C_2$-$C_{60}$ (*e.g.* $C_2$-$C_{20}$) alkenyl group, a $C_2$-$C_{60}$ (*e.g.* $C_2$-$C_{20}$) alkynyl group, a $C_1$-$C_{60}$ (*e.g.* $C_1$-$C_{20}$) alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ (*e.g.* $C_6$-$C_{30}$) aryl group, a $C_6$-$C_{60}$ (*e.g.* $C_6$-$C_{30}$) aryloxy group, a $C_6$-$C_{60}$ (*e.g.* $C_6$-$C_{30}$) arylthio group, a $C_1$-$C_{60}$ (*e.g.* $C_1$-$C_{20}$) heteroaryl group, a $C_1$-$C_{60}$ (*e.g.* $C_1$-$C_{20}$) heteroaryloxy group, a $C_1$-$C_{60}$ (*e.g.* $C_1$-$C_{20}$) heteroarylthio group, a monovalent non-aromatic condensed polycyclic group, a monovalent non-aromatic condensed heteropolycyclic group, -Si($Q_{21}$)($Q_{22}$)($Q_{23}$), -N($Q_{21}$)($Q_{22}$), - B($Q_{21}$)($Q_{22}$), -C(=O)($Q_{21}$), -S(=O)$_2$($Q_{21}$), and -P(=O)($Q_{21}$)($Q_{22}$); and

-Si($Q_{31}$)($Q_{32}$)($Q_{33}$), -N($Q_{31}$)($Q_{32}$), -B($Q_{31}$)($Q_{32}$), -C(=O)($O_{31}$), -S(=O)$_2$($Q_{31}$), and -P(=O)($Q_{31}$)($Q_{32}$), and

$Q_{11}$ to $Q_{13}$, $Q_{21}$ to $Q_{23}$, and $Q_{31}$ to $Q_{33}$ may each independently be selected from hydrogen, deuterium, -F, -Cl, -Br, -I, a hydroxyl group, a cyano group, a nitro group, an amidino group, a hydrazino group, a hydrazono group, a $C_1$-$C_{60}$ (*e.g.* $C_1$-$C_{20}$) alkyl group, a $C_2$-$C_{60}$ (*e.g.* $C_2$-$C_{20}$) alkenyl group, a $C_2$-$C_{60}$ (*e.g.* $C_2$-$C_{20}$) alkynyl group, a $C_1$-$C_{60}$ (*e.g.* $C_1$-$C_{20}$) alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ (*e.g.* $C_6$-$C_{30}$) aryl group, a $C_1$-$C_{60}$ (*e.g.* $C_1$-$C_{20}$) heteroaryl group, a $C_1$-$C_{60}$ (*e.g.* $C_1$-$C_{20}$) heteroaryloxy group, a $C_1$-$C_{60}$ (*e.g.* $C_1$-$C_{20}$) heteroarylthio group, a monovalent non-aromatic condensed polycyclic group, a monovalent non-aromatic condensed heteropolycyclic group, a $C_1$-$C_{60}$ (*e.g.* $C_1$-$C_{20}$) alkyl group substituted with at least one selected from deuterium, -F, and a cyano group, a $C_6$-$C_{60}$ (*e.g.* $C_6$-$C_{30}$) aryl group substituted with at least one selected from deuterium, -F, and a cyano group, a biphenyl group, and a terphenyl group.

The term "Ph" as used herein refers to a phenyl group, the term "Me" as used herein refers to a methyl group, the term "Et" as used herein refers to an ethyl group, the term "ter-Bu" or "$Bu^t$" as used herein refers to a tert-butyl group, the term "OMe" as used herein refers to a methoxy group, and "D" refers to deuterium.
The term "biphenyl group" as used herein refers to "a phenyl group substituted with a phenyl group". For example, the "biphenyl group" may be a substituted phenyl group having a $C_6$-$C_{60}$ aryl group as a substituent.
The term "terphenyl group" as used herein refers to "a phenyl group substituted with a biphenyl group". For example, the "terphenyl group" may be a phenyl group having, as a substituent, a $C_6$-$C_{60}$ aryl group substituted with a $C_6$-$C_{60}$ aryl group.

* and *' as used herein, unless defined otherwise, each refer to a binding site to a neighboring atom in a corresponding formula.

Hereinafter, a compound according to embodiments and an organic light-emitting device according to embodiments will be described in more detail with reference to Synthesis Examples and Examples. The expression "B was utilized instead of A" utilized in describing Synthesis Examples refers to that an identical molar equivalent of B was utilized in place of A.

## Examples

### Example 1-1

As an anode, a substrate with ITO deposited thereon was cut to a size of 50 mm x 50 mm x 0.5 mm, and sonicated utilizing isopropyl alcohol and pure water for 5 minutes each, and then irradiated with ultraviolet light for 30 minutes and exposed to ozon for cleaning. Then the resultant glass substrate was loaded onto a vacuum deposition apparatus.
m-MTDATA was deposited on the ITO substrate to form a hole injection layer having a thickness of 40 Å, NPB was vacuum deposited on the hole injection layer to form a hole transport layer having a thickness of 10 Å, and Compounds HT-01, ET-1, PD1, and DA-03 were co-deposited at a weight ratio of 70 : 30 : 10 : 1 on the hole transport layer to form an emission layer having a thickness of 200 Å. Compound ET-1 was deposited on the emission layer to form an electron transport layer having a thickness of 300 Å. Al was deposited on the electron transport layer to form a cathode having a thickenss of 1200 Å, and thereby, an organic light-emitting device was manufactured.

### Examples 1-2 to 1-5 and Comparative Examples 1-1 to 1-15

Organic light-emitting devices were manufactured in the same manner as in Example 1-1, except that emission layers were each formed utilizing compounds respectively shown in Table 1.

### Evaluation Example 1

The efficiency, emission wavelength and lifespan of the organic light-emitting devices manufactured according to Examples 1-1 to 1-5 and Comparative Examples 1-1 to 1-15 were measured utilizing a Keithley SMU 236 and luminance meter PR650 at a current density of 10 mA/cm$^2$. The results are shown in Table 1. The lifespan is a period of time that was taken until the brightness was reduced from an initial brightness to 90% of the initial brightness.

Table 1]

| | Emission layer | | | | Brightness (cd/m$^2$) | Efficiency (cd/A) | Emission wave length | Lifespan (hr) |
|---|---|---|---|---|---|---|---|---|
| | first compound | second compound | third compound | fourth compound | | | | |
| | | | | | | | | |
| | | | | | | | (nm) | |
| Example 1-1 | HT-01 | ET-1 | PD1 | DA-03 | 1000 | 131.28 | 456 | 28 |
| Example 1-2 | HT-02 | ET-3 | PD7 | DA-05 | 1000 | 148.79 | 458 | 43 |
| Example 1-3 | HT-07 | ET-5 | PD12 | DA-10 | 1000 | 189.61 | 456 | 35 |
| Example 1-4 | HT-12 | ET-8 | PD26 | DA-19 | 1000 | 219.14 | 457 | 40 |
| Example 1-5 | HT-16 | ET-11 | PD35 | DA-28 | 1000 | 238.58 | 458 | 51 |
| Comparative Example 1-1 | HT-01 | - | PD1 | DA-03 | 1000 | 50.53 | 459 | 0.2 |
| Comparative Example 1-2 | HT-02 | - | PD7 | DA-05 | 1000 | 21.46 | 457 | 6 |
| Comparative Example 1-3 | - | ET-5 | PD12 | DA-10 | 1000 | 13.74 | 486 | 3 |
| Comparative | - | ET-8 | PD26 | DA-19 | 1000 | 38.21 | 485 | 0.8 |
| Example 1-4 | | | | | | | | |
| Comparative Example 1-5 | CBP | | PD1 | DA-03 | 1000 | 27.13 | 461 | 1 |
| Comparative Example 1-6 | HT-01 | ET-1 | - | DA-03 | 1000 | 72.18 | 456 | 10 |
| Comparative Example 1-7 | HT-02 | ET-3 | - | DA-05 | 1000 | 75.77 | 458 | 12 |
| Comparative Example 1-8 | HT-07 | ET-5 | - | DA-10 | 1000 | 80.62 | 456 | 11 |
| Comparative Example 1-9 | HT-12 | ET-8 | - | DA-19 | 1000 | 95.24 | 457 | 15 |

(continued)

| | | | | | | | (nm) | |
|---|---|---|---|---|---|---|---|---|
| Comparative Example 1-10 | HT-16 | ET-11 | - | DA-28 | 1000 | 89.18 | 458 | 22 |
| Comparative Example 1-11 | HT-01 | ET-1 | PD1 | DCJTB | 1000 | 50.12 | 465 | 8 |
| Comparative Example 1-12 | HT-02 | ET-3 | PD7 | DCJTB | 1000 | 45.22 | 466 | 4 |
| Comparative Example 1-13 | HT-07 | ET-5 | PD12 | DCJTB | 1000 | 65.59 | 465 | 3 |
| Comparative Example 1-14 | HT-12 | ET-8 | PD26 | DCJTB | 1000 | 42.54 | 465 | 4 |
| Comparative Example 1-15 | HT-16 | ET-11 | PD35 | DCJTB | 1000 | 22.42 | 466 | 9 |

Table 1 shows that the organic light-emitting devices of Examples 1-1 to 1-5 have greater current efficiency and longer lifespan than the organic light-emitting devices of Comparative Examples 1-1 to 1-15.

**Example 2-1**

As an anode, an indium tin oxide (ITO)-deposited substrate was cut to a size of 50 mm x 50 mm x 0.5 mm, and sonicated utilizing isopropyl alcohol and pure water for 5 minutes each, and then irradiated with ultraviolet light for 30 minutes and exposed to ozon for cleaning. Then the resultant glass substrate was loaded onto a vacuum deposition apparatus.

m-MTDATA was deposited on the ITO substrate to form a hole injection layer having a thickness of 40 Å, NPB was vacuum deposited on the hole injection layer to form a hole transport layer having a thickness of 10 Å, and Compounds HT-01, ET-1, PD2, and DA-02 were co-deposited at a weight ratio of 70 : 30 : 10 : 3 on the hole transport layer to form an emission layer having a thickness of 200 Å. Compound ET2 was deposited on the emission layer to form a hole blocking layer having a thickness of 50 Å. Compound ET-1 was deposited on the hole blocking layer to form an electron transport layer having a thickness of 300Å. Al was deposited on the electron transport layer to form a cathode having a thickness of 1200 Å, and thereby, an organic light-emitting device was manufactured.

**Examples 2-2 to 2-10 and Comparative Examples 2-1 to 2-30**

Organic light-emitting devices were manufactured in the same manner as in Example 2-1, except that an emission layer and a hole blocking layer were each formed utilizing compounds respectively shown in Table 2.

**Evaluation Example 2**

The efficiency, emission wavelength and lifespan of the organic light-emitting devices manufactured according to Examples 2-1 to 2-10 and Comparative Examples 2-1 to 2-30) were measured utilizing a Keithley SMU 236 and luminance meter PR650 at a current density of 10 mA/$cm^2$. The results are shown in Table 2. The lifespan is a period of time that was taken until the brightness was reduced from an initial brightness to 90% of the initial brightness.

[Table 2]

| | Emission layer | | | | Hole blocking layer | Brightness (cd/m$^2$) | Efficiency (cd/A) | Emission wavelength (nm) | Life span (hr) |
|---|---|---|---|---|---|---|---|---|---|
| | first compound | second compound | third compound | fourth compound | | | | | |
| Example 2-1 | HT-01 | ET-1 | PD2 | DA-02 | ET-2 | 1000 | 147.45 | 456 | 33 |
| Example 2-2 | HT-04 | ET-2 | PD4 | DA-04 | ET-2 | 1000 | 198.56 | 458 | 32 |
| Example 2-3 | HT-06 | ET-3 | PD5 | DA-14 | ET-7 | 1000 | 207.45 | 457 | 51 |
| Example 2-4 | HT-08 | ET-7 | PD20 | DA-15 | ET-7 | 1000 | 210.15 | 457 | 15 |
| Example 2-5 | HT-12 | ET-9 | PD16 | DA-16 | ET-10 | 1000 | 224.31 | 458 | 55 |
| Example 2-6 | HT-02 | ET-4 | PD5 | DA-08 | ET-1 | 1000 | 136.87 | 456 | 23 |
| Example 2-7 | HT-02 | ET-4 | PD5 | DA-09 | ET-2 | 1000 | 134.12 | 458 | 37 |
| Example 2-8 | HT-09 | ET-5 | PD6 | DA-10 | ET-3 | 1000 | 109.45 | 457 | 38 |
| Example 2-9 | HT-09 | ET-9 | PD20 | DA-15 | ET-3 | 1000 | 210.15 | 457 | 29 |
| Example 2-10 | HT-12 | ET-9 | PD14 | DA-18 | ET-5 | 1062 | 254.31 | 458 | 56 |
| Comparative Example 2-1 | HT-01 | - | PD2 | DA-02 | ET-2 | 1000 | 8.15 | 456 | 0.1 |
| Comparative Example 2-2 | HT-04 | - | PD4 | DA-04 | ET-2 | 1000 | 11.45 | 458 | 0.8 |
| Comparative Example 2-3 | - | ET-3 | PD5 | DA-14 | ET-7 | 1000 | 16.14 | 457 | 0.9 |
| Comparative Example 2-4 | - | ET-7 | PD20 | DA-15 | ET-7 | 1000 | 8.36 | 457 | 1 |
| Comparative Example 2-5 | CBP | | PD16 | DA-16 | ET-10 | 1000 | 19.12 | 458 | 22 |
| Comparative Example 2-6 | HT-02 | - | PD5 | DA-08 | ET-1 | 1000 | 9.18 | 456 | 0.1 |
| Comparative | HT-02 | - | PD5 | DA-09 | ET-2 | 1000 | 8.45 | 458 | 0.1 |
| Example 2-7 | | | | | | | | | |
| Comparative Example 2-8 | - | ET-5 | PD6 | DA-10 | ET-3 | 1000 | 10.23 | 457 | 0.8 |

(continued)

| | Emission layer | | | | Hole blocking layer | Brightness (cd/m$^2$) | Efficiency (cd/A) | Emission wavelength (nm) | Life span (hr) |
|---|---|---|---|---|---|---|---|---|---|
| | first compound | second compound | third compound | fourth compound | | | | | |
| Comparative Example 2-9 | - | ET-9 | PD20 | DA-15 | ET-3 | 1000 | 5.11 | 457 | 1 |
| Comparative Example 2-10 | CBP | | PD14 | DA-18 | ET-5 | 1000 | 19.12 | 444 | 2 |
| Comparative Example 2-11 | HT-01 | ET-1 | - | DA-02 | ET-2 | 1000 | 56.45 | 456 | 12 |
| Comparative Example 2-12 | HT-04 | ET-2 | - | DA-04 | ET-2 | 1000 | 98.16 | 458 | 10 |
| Comparative Example 2-13 | HT-06 | ET-3 | - | DA-14 | ET-7 | 1000 | 56.55 | 457 | 9 |
| Comparative Example 2-14 | HT-08 | ET-7 | - | DA-15 | ET-7 | 1000 | 99.25 | 457 | 9 |
| Comparative Example 2-15 | HT-12 | ET-15 | - | DA-16 | ET-10 | 1000 | 98.31 | 458 | 10 |
| Comparative Example 2-16 | HT-02 | ET-4 | - | DA-08 | ET-1 | 1000 | 45.65 | 456 | 8 |
| Comparative Example 2-17 | HT-02 | ET-4 | - | DA-09 | ET-2 | 1000 | 65.13 | 458 | 4 |
| Comparative Example 2-18 | HT-09 | ET-5 | - | DA-10 | ET-3 | 1000 | 66.12 | 457 | 5 |
| Comparative Example 2-19 | HT-09 | ET-9 | - | DA-15 | ET-3 | 1000 | 64.12 | 457 | 6 |
| Comparative | HT-12 | ET-9 | - | DA-18 | ET-5 | 1000 | 95.13 | 458 | 4 |
| Example 2-20 | | | | | | | | | |
| Comparative Example 2-21 | HT-01 | ET-1 | PD2 | DCJTB | ET-2 | 1000 | 80.43 | 465 | 12 |

(continued)

| | Emission layer | | | | Hole blocking layer | Brightness (cd/m$^2$) | Efficiency (cd/A) | Emission wavelength (nm) | Life span (hr) |
|---|---|---|---|---|---|---|---|---|---|
| | first compound | second compound | third compound | fourth compound | | | | | |
| Comparative Example 2-22 | HT-04 | ET-2 | PD4 | DCJTB | ET-2 | 1000 | 76.12 | 466 | 11 |
| Comparative Example 2-23 | HT-06 | ET-3 | PD5 | DCJTB | ET-7 | 1000 | 76.33 | 465 | 12 |
| Comparative Example 2-24 | HT-08 | ET-7 | PD20 | DCJTB | ET-7 | 1000 | 95.12 | 465 | 10 |
| Comparative Example 2-25 | HT-12 | ET-9 | PD16 | DCJTB | ET-10 | 1000 | 105.13 | 466 | 21 |
| Comparative Example 2-26 | HT-02 | ET-4 | PD5 | DCJTB | ET-1 | 1000 | 111.13 | 466 | 20 |
| Comparative Example 2-27 | HT-02 | ET-4 | PD5 | DCJTB | ET-2 | 1000 | 90.0 | 466 | 5 |
| Comparative Example 2-28 | HT-09 | ET-5 | PD6 | DCJTB | ET-3 | 1000 | 110.13 | 465 | 12 |
| Comparative Example 2-29 | HT-09 | ET-9 | PD20 | DCJTB | ET-3 | 1000 | 88.13 | 465 | 21 |
| Comparative Example 2-30 | HT-12 | ET-9 | PD14 | DCJTB | ET-5 | 1000 | 89.13 | 465 | 13 |

From Table 2, it may be confirmed that the current efficiency and lifespan of the organic light-emitting devices of Examples 2-1 to 2-10 are better (e.g., superior) to the current efficiency and lifespan of the organic light-emitting device of Comparative Examples 2-1 to 2-30.

**Example 3-1**

As an anode, a substrate with ITO deposited thereon was cut to a size of 50 mm x 50 mm x 0.5 mm, and sonicated utilizing isopropyl alcohol and pure water for 5 minutes each, and then irradiated with ultraviolet light for 30 minutes and exposed to ozon for cleaning. Then the resultant glass substrate was loaded onto a vacuum deposition apparatus.

m-MTDATA was deposited on the ITO substrate to form a hole injection layer having a thickness of 40 Å, NPB was vacuum deposited on the hole injection layer to form a hole transport layer having a thickness of 10 Å, and Compounds HT-01, ET-1, 1, and DA-07 were co-deposited at a weight ratio of 70 : 30 : 10 : 1 on the hole transport layer to form an emission layer having a thickness of 200 Å. Compound ET-1 was deposited on the emission layer to form an electron transport layer having a thickness of 300 Å. Al was deposited on the electron transport layer to form a cathode having a thickenss of 1200 Å, and thereby, an organic light-emitting device was manufactured.

**Examples 3-2 to 3-5 and Comparative Examples 3-1 to 3-15**

Organic light-emitting devices were manufactured in the same manner as in Example 3-1, except that an emission layer is formed utilizing compounds respectively shown in Table 3.

**Evaluation Example 3**

The efficiency, emission wavelength, and lifespan of the organic light-emitting devices manufactured according to Examples 3-1 to 3-5 and Comparative Examples 3-1 to 3-15 were measured by utilizing Kethley SMU 236 and a luminance photometer PR650 at a current density of 10 mA/$cm^2$, and results thereof are shown in Table 3. The lifespan is a period of time that was taken until the brightness was reduced from an initial brightness to 90% of the initial brightness.

Table 3]

| | Emission layer | | | | Brightness ($cd/m^2$) | Efficiency (cd/A) | Emission wave length | Life span (hr) |
|---|---|---|---|---|---|---|---|---|
| | first compound | second compound | third compound | fourth compound | | | | |
| | | | | | | | | |
| | | | | | | | (nm) | |
| Example 3-1 | HT-01 | ET-1 | 1 | DA-07 | 1000 | 150.12 | 458 | 20 |
| Example 3-2 | HT-05 | ET-8 | 5 | DA-11 | 1000 | 145.11 | 457 | 17 |
| Example 3-3 | HT-11 | ET-9 | 7 | DA-04 | 1000 | 241.45 | 457 | 19 |
| Example 3-4 | HT-17 | ET-11 | 9 | DA-30 | 1000 | 222.13 | 457 | 44 |
| Example 3-5 | HT-15 | ET-9 | 8 | DA-21 | 1000 | 244.23 | 455 | 45 |
| Comparative Example 3-1 | HT-01 | - | 1 | DA-07 | 1000 | 10.21 | 459 | 0.1 |
| Comparative Example 3-2 | HT-05 | - | 5 | DA-11 | 1000 | 10.45 | 457 | 0.1 |
| Comparative Example 3-3 | - | ET-9 | 7 | DA-04 | 1000 | 14.12 | 457 | 0.5 |
| Comparative | - | ET-11 | 9 | DA-30 | 1000 | 17.25 | 457 | 0.7 |
| Example 3-4 | | | | | | | | |
| Comparative Example 3-5 | CBP | | 8 | DA-21 | 1000 | 5.14 | 455 | 2 |
| Comparative Example 3-6 | HT-01 | ET-1 | - | DA-07 | 1000 | 80.12 | 458 | 10 |
| Comparative Example 3-7 | HT-05 | ET-8 | - | DA-11 | 1000 | 65.11 | 457 | 5 |
| Comparative Example 3-8 | HT-11 | ET-9 | - | DA-04 | 1000 | 99.13 | 457 | 4 |
| Comparative Example 3-9 | HT-17 | ET-11 | - | DA-30 | 1000 | 100.13 | 457 | 10 |

(continued)

| | | | | | | | | |
|---|---|---|---|---|---|---|---|---|
| | | | | | | | (nm) | |
| Comparative Example 3-10 | HT-15 | ET-9 | - | DA-21 | 1000 | 100.23 | 455 | 18 |
| Comparative Example 3-11 | HT-01 | ET-1 | 1 | DCJTB | 1000 | 88.14 | 465 | 11 |
| Comparative Example 3-12 | HT-05 | ET-8 | 5 | DCJTB | 1000 | 81.12 | 466 | 8 |
| Comparative Example 3-13 | HT-11 | ET-9 | 7 | DCJTB | 1000 | 78.45 | 465 | 7 |
| Comparative Example 3-14 | HT-17 | ET-11 | 9 | DCJTB | 1000 | 65.15 | 465 | 8 |
| Comparative Example 3-15 | HT-15 | ET-9 | 8 | DCJTB | 1000 | 69.31 | 466 | 12 |

From Table 3, it may be confirmed that the current efficiency and lifespan of the organic light-emitting devices of Examples 3-1 to 3-5 are better (e.g., superior) to the current efficiency and lifespan of the organic light-emitting device of Comparative Examples 3-1 to 3-15.

The organic light-emitting device according to embodiments of the present disclosure may have high efficiency and long lifespan.

The terminology used herein is for the purpose of describing particular example embodiments only and is not intended to be limiting of the invention.

As used herein, the term "substantially," "about," and similar terms are used as terms of approximation and not as terms of degree, and are intended to account for the inherent deviations in measured or calculated values that would be recognized by those of ordinary skill in the art. Moreover, any numerical range recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein and any minimum numerical limitation recited in this specification is intended to include all higher numerical limitations subsumed therein.

The use of "may" when describing embodiments of the inventive concept refers to "one or more embodiments of the inventive concept."

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims, and equivalents thereof.

## Claims

1. An organic light-emitting device (10, 20, 30, 40) comprising:

   a first electrode (110);
   a second electrode (190); and
   an organic layer (150) between the first electrode (110) and the second electrode (190),
   wherein:

      the organic layer (150) comprises an emission layer,
      the emission layer comprises a first compound, a second compound, a third compound, and a fourth compound,
      the first compound is represented by Formula 1;
      the second compound is represented by Formula 2A or Formula 2B;
      the third compound is represented by Formula 3;
      the fourth compound is represented by any one of Formulae 4-1 to 4-3; and
      the first compound, the second compound, the third compound, and the fourth compound are different from each other:

<Formula 1>

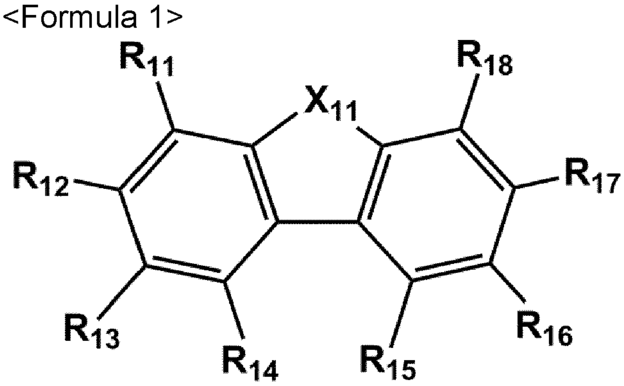

<Formula 2A>

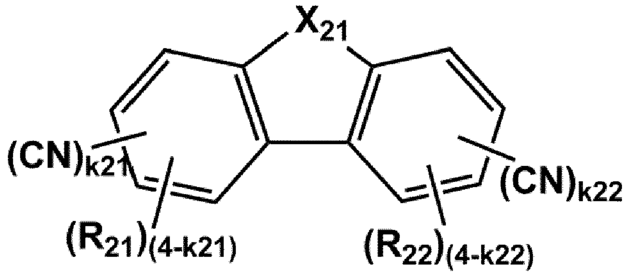

<Formula 2B>

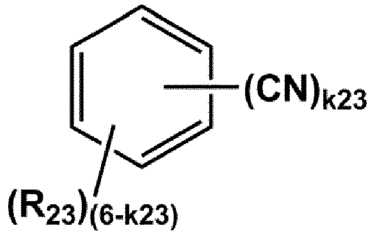

<Formula 3> $M_{31}(L_{31})_{n31}(L_{32})_{n32}$

<Formula 3A>

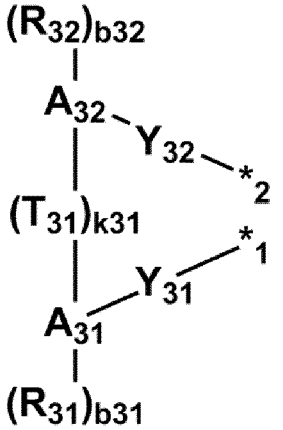

<Formula 3B>

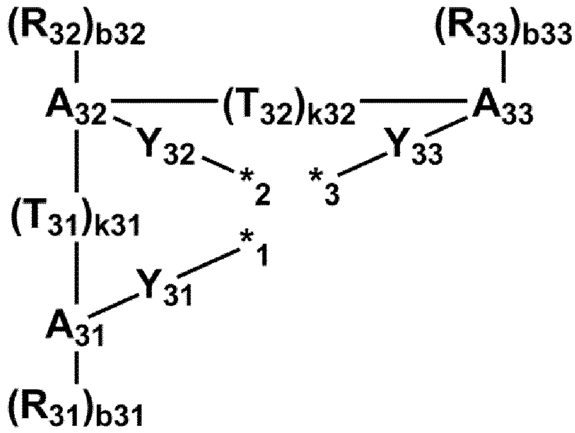

<Formula 3C>

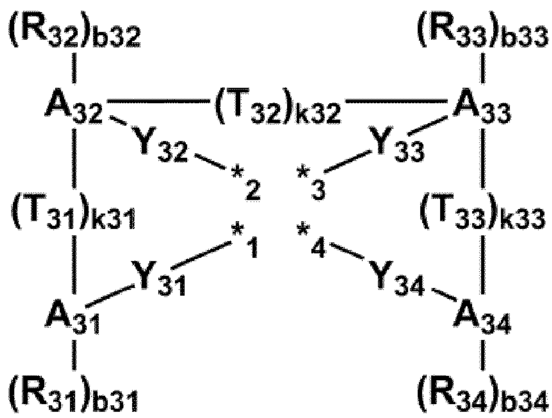

<Formula 3D>

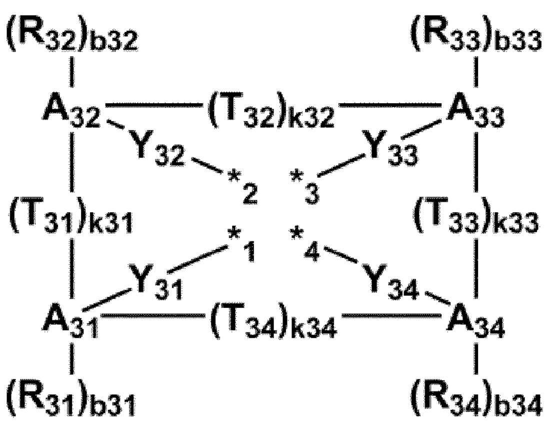

<Formula 4-1 > $(D_{41})_{n41}\text{-}(L_{41})_{a41}\text{-}(A_{41})_{m41}$

<Formula 4-2> $(D_{41})_{n41}\text{-}(L_{41})_{a41}\text{-}(A_{41})_{m41}\text{-}(L_{42})_{a42}\text{-}(D_{42})_{n42}$

<Formula 4-3> $(A_{41})_{m41}\text{-}(L_{41})_{a41}\text{-}(D_{41})_{n41}\text{-}(L_{42})_{a42}\text{-}(A_{42})_{m42}$

wherein in Formula 1, $X_{11}$ is selected from O, S, $N(R_{19})$, and $C(R_{19})(R_{20})$;
$R_{11}$ to $R_{20}$ are each independently selected from:

a group represented by $*\text{-}(L_{11})_{a11}\text{-}A_{11}$, hydrogen, deuterium, a $C_1$-$C_{60}$ alkyl group, a $\pi$ electron-depleted

nitrogen-free cyclic group, $-C(Q_1)(Q_2)(Q_3)$, - $Si(Q_1)(Q_2)(Q_3)$, $-B(Q_1)(Q_2)$, and $-N(Q_1)(Q_2)$;
a $\pi$ electron-depleted nitrogen-free cyclic group substituted with at least one selected from deuterium, a $C_1$-$C_{60}$ alkyl group, a $\pi$ electron-depleted nitrogen-free cyclic group, -C(Q31)(Q32)(Q33), $-Si(Q_{31})(Q_{32})(Q_{33})$, $-B(Q_{31})(Q_{32})$, and $-N(Q_{31})(Q_{32})$; and
a $\pi$ electron-depleted nitrogen-free cyclic group substituted with a $\pi$ electron-depleted nitrogen-free cyclic group substituted with at least one selected from deuterium, a $C_1$-$C_{60}$ alkyl group, a $\pi$ electron-depleted nitrogen-free cyclic group, $-C(Q_{21})(Q_{22})(Q_{23})$, $-Si(Q_{21})(Q_{22})(Q_{23})$, $-B(Q_{21})(Q_{22})$, and -N(Q21)(Q22),

$L_{11}$ is selected from:

a $\pi$ electron-depleted nitrogen-free cyclic group, $-C(Q_1)(Q_2)-$, $-Si(Q_1)(Q_2)-$, $-B(Q_1)-$, and $-N(Q_1)-$; and
a $\pi$ electron-depleted nitrogen-free cyclic group substituted with at least one selected from deuterium, a $C_1$-$C_{60}$ alkyl group, a $\pi$ electron-depleted nitrogen-free cyclic group, -C(Q31)(Q32)(Q33), -Si(Q31)(Q32)(Q33), $-B(Q_{31})(Q_{32})$, and $-N(Q_{31})(Q_{32})$,

a11 is selected from 1, 2, and 3, and
$A_{11}$ is selected from:

a $\pi$ electron-depleted nitrogen-free cyclic group;
a $\pi$ electron-depleted nitrogen-free cyclic group substituted with at least one selected from deuterium, a $C_1$-$C_{60}$ alkyl group, a $\pi$ electron-depleted nitrogen-free cyclic group, $-C(Q_{31})(Q_{32})(Q_{33})$, $-Si(Q_{31})(Q_{32})(Q_{33})$, $-B(Q_{31})(Q_{32})$, and $-N(Q_{31})(Q_{32})$; and
a $\pi$ electron-depleted nitrogen-free cyclic group substituted with a $\pi$ electron-depleted nitrogen-free cyclic group substituted with at least one selected from deuterium, a $C_1$-$C_{60}$ alkyl group, a $\pi$ electron-depleted nitrogen-free cyclic group, $-C(Q_{21})(Q_{22})(Q_{23})$, $-Si(Q_{21})(Q_{22})(Q_{23})$, $-B(Q_{21})(Q_{22})$, and -N(Q21)(Q22),

wherein in Formulae 2A and 2B,
$X_{21}$ is selected from O, S, $N(R_{24})$, and $C(R_{24})(R_{25})$,
k21 and k22 are each independently selected from 0, 1, 2, 3, and 4, wherein a sum of k21 and k22 is 1 or more,
k23 is selected from 1, 2, 3, 4, 5, and 6,
$R_{21}$ to $R_{25}$ are each independently selected from:

a group represented by $*-(L_{21})_{a21}-A_{21}$, hydrogen, deuterium, -F, a cyano group, a $C_1$-$C_{60}$ alkyl group, a $\pi$ electron-depleted nitrogen-containing cyclic group, a $\pi$ electron-depleted nitrogen-free cyclic group, $-C(Q_1)(Q_2)(Q_3)$, - $Si(Q_1)(Q_2)(Q_3)$, $-B(Q_1)(Q_2)$, $-N(Q_1)(Q_2)$, $-S(=O)(Q_1)$, $-S(=O)_2(Q_1)$, $-P(=O)(Q_1)(Q_2)$, and $-P(=S)(Q_1)(Q_2)$;
a $\pi$ electron-depleted nitrogen-containing cyclic group and a $\pi$ electron-depleted nitrogen-free cyclic group, each substituted with at least one selected from deuterium, -F, a cyano group, a $C_1$-$C_{60}$ alkyl group, a $\pi$ electron-depleted nitrogen-containing cyclic group, a $\pi$ electron-depleted nitrogen-free cyclic group, $-C(Q_{31})(Q_{32})(Q_{33})$, $-Si(Q_{31})(Q_{32})(Q_{33})$, $-B(Q_{31})(Q_{32})$, $-N(Q_{31})(Q_{32})$, - $S(=O)(Q_{31})$, $-S(=O)_2(Q_{31})$, $-P(=O)(Q_{31})(Q_{32})$, and $-P(=S)(Q_{31})(Q_{32})$; and
a $\pi$ electron-depleted nitrogen-containing cyclic group and a $\pi$ electron-depleted nitrogen-free cyclic group, each substituted with at least one selected from a $\pi$ electron-depleted nitrogen-containing cyclic group and a $\pi$ electron-depleted nitrogen-free cyclic group that are each independently substituted with at least one selected from deuterium, -F, a cyano group, a $C_1$-$C_{60}$ alkyl group, a $\pi$ electron-depleted nitrogen-containing cyclic group, a $\pi$ electron-depleted nitrogen-free cyclic group, $-C(Q_{21})(Q_{22})(Q_{23})$, $-Si(Q_{21})(Q_{22})(Q_{23})$, $-B(Q_{21})(Q_{22})$, - $N(Q_{21})(Q_{22})$, $-S(=O)(Q_{21})$, $-S(=O)_2(Q_{21})$, $-P(=O)(Q_{21})(Q_{22})$, and $-P(=S)(Q_{21})(Q_{22})$, $L_{21}$ is selected from:

a $\pi$ electron-depleted nitrogen-containing cyclic group, a $\pi$ electron-depleted nitrogen-free cyclic group, $-C(Q_1)(Q_2)-$, $-Si(Q_1)(Q_2)-$, $-B(Q_1)-$, $-N(Q_1)-$, - $S(=O)-$, $-S(=O)_2-$, $-P(=O)(Q_1)-$, and $-P(=S)(Q_1)-$; and
a $\pi$ electron-depleted nitrogen-containing cyclic group and a $\pi$ electron-depleted nitrogen-free cyclic group, each substituted with at least one selected from deuterium, -F, a cyano group, a $C_1$-$C_{60}$ alkyl group, a $\pi$ electron-depleted nitrogen-containing cyclic group, a $\pi$ electron-depleted nitrogen-free cyclic group, $-C(Q_{31})(Q_{32})(Q_{33})$, $-Si(Q_{31})(Q_{32})(Q_{33})$, $-B(Q_{31})(Q_{32})$, $-N(Q_{31})(Q_{32})$, -

$S(=O)(Q_{31})$, $-S(=O)_2(Q_{31})$, $-P(=O)(Q_{31})(Q_{32})$, and $-P(=S)$ $(Q_{31})(Q_{32})$;

a21 is selected from 1, 2, and 3, and
$A_{21}$ is selected from:

a π electron-depleted nitrogen-containing cyclic group and a π electron-depleted nitrogen-free cyclic group;
a π electron-depleted nitrogen-containing cyclic group and a π electron-depleted nitrogen-free cyclic group, each substituted with at least one selected from deuterium, -F, a cyano group, a $C_1$-$C_{60}$ alkyl group, a π electron-depleted nitrogen-containing cyclic group, a π electron-depleted nitrogen-free cyclic group, $-C(Q_{31})(Q_{32})(Q_{33})$, $-Si(Q_{31})(Q_{32})(Q_{33})$, $-B(Q_{31})(Q_{32})$, $-N(Q_{31})(Q_{32})$, $-S(=O)(Q_{31})$, $-S(=O)_2(Q_{31})$, $-P(=O)(Q_{31})(Q_{32})$, and $-P(=S)$ $(Q_{31})(Q_{32})$; and
a π electron-depleted nitrogen-containing cyclic group and a π electron-depleted nitrogen-free cyclic group, each substituted with at least one selected from a π electron-depleted nitrogen-containing cyclic group and a π electron-depleted nitrogen-free cyclic group that are each independently substituted with at least one selected from deuterium, -F, a cyano group, a $C_1$-$C_{60}$ alkyl group, a π electron-depleted nitrogen-containing cyclic group, a π electron-depleted nitrogen-free cyclic group, $-C(Q_{21})(Q_{22})(Q_{23})$, $-Si(Q_{21})(Q_{22})(Q_{23})$, $-B(Q_{21})(Q_{22})$, $-N(Q_{21})(Q_{22})$, $-S(=O)(Q_{21})$, $-S(=O)_2(Q_{21})$, $-P(=O)(Q_{21})(Q_{22})$, and $-P(=S)$ $(Q_{21})(Q_{22})$, wherein in Formula 3,

$M_{31}$ is selected from transition metals of Period 4, Period 5, and Period 6 of the Periodic Table of Elements,
$L_{31}$ is a ligand represented by one selected from Formulae 3A to 3D,
$L_{32}$ is selected from a monodentate ligand, a bidentate ligand, and a tridentate ligand,
n31 is 1 or 2, and
n32 is selected from 0, 1, 2, 3, and 4,
wherein in Formulae 3A to 3D,
$A_{31}$ to $A_{34}$ are each independently selected from a $C_5$-$C_{30}$ carbocyclic group and a $C_1$-$C_{30}$ heterocyclic group,
$T_{31}$ to $T_{34}$ are each independently selected from a single bond, a double bond, *-O-*', *-S-*', *-C(=O)-*', *-S(=O)-*', $*-C(R_{35})(R_{36})-*'$, $*-C(R_{35})=C(R_{36})-*'$, $*-C(R_{35})=*'$, $*-Si(R_{35})(R_{36})-*'$, $*-B(R_{35})-*'$, $*-N(R_{35})-*'$, and $*-P(R_{35})-*''$,
k31 to k34 are each independently selected from 1, 2, and 3,
$Y_{31}$ to $Y_{34}$ are each independently selected from a single bond, *-O-*', *-S-*', $*-C(R_{37})(R_{38})-*'$, $*-Si(R_{37})(R_{38})-*'$, $*-B(R_{37})-*'$, $*-N(R_{37})-*'$, and $*-P(R_{37})-*'$,
$*_1$, $*_2$, $*_3$, and $*_4$ each indicate a binding site to $M_{31}$,
$R_{31}$ to $R_{38}$ are each independently selected from hydrogen, deuterium, -F, -Cl, - Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, $-C(Q_1)(Q_2)(Q_3)$, $-Si(Q_1)(Q_2)(Q_3)$, $-B(Q_1)(Q_2)$, $-N(Q_1)(Q_2)$, $-P(Q_1)(Q_2)$, $-C(=O)(Q_1)$, $-S(=O)(Q_1)$, $-S(=O)_2(Q_1)$, $-P(=O)(Q_1)(Q_2)$, and $-P(=S)(Q_1)(Q_2)$, wherein $R_{31}$ to $R_{38}$ are optionally linked to each other to form a substituted or unsubstituted $C_5$-$C_{60}$ carbocyclic group or a substituted or unsubstituted $C_1$-$C_{60}$ heterocyclic group, and
b31 to b34 are each independently an integer from 0 to 10,
wherein in Formulae 4-1 to 4-3,
$A_{41}$ and $A_{42}$ are each independently selected from a group represented by Formula 12, $-Si(Q_1)(Q_2)(Q_3)$, $-B(Q_1)(Q_2)$, and $-N(Q_1)(Q_2)$:

<Formula 12>

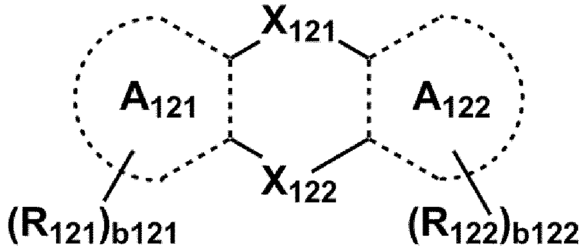

wherein, in Formula 12,
$X_{121}$ is selected from O, S, N($R_{123}$), and C($R_{123}$)($R_{124}$),
$X_{122}$ is selected from a single bond, O, S, N($R_{125}$), and C($R_{125}$)($R_{126}$),
$A_{121}$ and $A_{122}$ are each independently selected from a benzene group, a naphthalene group, a phenalene group, an anthracene group, a fluoranthene group, a triphenylene group, a phenanthrene group, a pyrene group, a chrysene group, a perylene group, a fluorene group, a carbazole group, a dibenzofuran group, and a dibenzothiophene group,
$R_{121}$ to $R_{126}$ are each independently selected from:

a binding site, hydrogen, deuterium, a $C_1$-$C_{20}$ alkyl group, a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a benzofluorenyl group, a benzocarbazolyl group, a benzonaphthofuranyl group, a benzonaphthothiophenyl group, a dibenzofluorenyl group, a dibenzocarbazolyl group, a dinaphthofuranyl group, a dinaphthothiophenyl group, - Si($Q_{31}$)($Q_{32}$)($Q_{33}$), -B($Q_{31}$)($Q_{32}$), and -N($Q_{31}$)($Q_{32}$); and
a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a benzofluorenyl group, a benzocarbazolyl group, a benzonaphthofuranyl group, a benzonaphthothiophenyl group, a dibenzofluorenyl group, a dibenzocarbazolyl group, a dinaphthofuranyl group, and a dinaphthothiophenyl group, each substituted with at least one selected from deuterium, a $C_1$-$C_{20}$ alkyl group, a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a benzofluorenyl group, a benzocarbazolyl group, a benzonaphthofuranyl group, a benzonaphthothiophenyl group, a dibenzofluorenyl group, a dibenzocarbazolyl group, a dinaphthofuranyl group, a dinaphthothiophenyl group, - Si(Q21)(Q22)(Q23), -B($Q_{21}$)($Q_{22}$), and -N($Q_{21}$)($Q_{22}$), wherein $R_{123}$ and $R_{124}$ are optionally linked to each other to form a $\pi$ electron-depleted nitrogen-free cyclic group, $R_{125}$ and $R_{126}$ are optionally linked to each other to form a $\pi$ electron-depleted nitrogen-free cyclic group, and at least one selected from $R_{121}$ to $R_{126}$ is the binding site, and

b121 and b122 are each independently selected from 1, 2, 3, 4, 5, and 6,
m41 and m42 are each independently selected from 1, 2, and 3,

$D_{41}$ and $D_{42}$ are each independently selected from:

-F, a cyano group, a pyrazole group, an imidazole group, a triazole group, an oxazole group, an isoxazole group, an oxadiazole group, an isozadiazole group, a thiazole group, an isothiazole group, a thiadiazole group, isothiadiazole group, a pyridine group, a pyrazine group, a pyridazine group, a pyrimidine group, a triazine group, a quinoline group, an isoquinoline group, a naphthyridine group, a quinoxaline group, a quinazoline group, and a group represented by Formulae 13-1 to 13-3;
a pyrazole group, an imidazole group, a triazole group, an oxazole group, an isoxazole group, an oxadiazole group, an isozadiazole group, a thiazole group, an isothiazole group, a thiadiazole group, an isothiadiazole group, a pyridine group, a pyrazine group, a pyridazine group, a pyrimidine group, a triazine group, a quinoline group, an isoquinoline group, a naphthyridine group, a quinoxaline group, and a quinazoline group, each substituted with at least one selected from deuterium, -F, a cyano group, a $C_1$-$C_{20}$ alkyl group, a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl

group, a benzofluorenyl group, a benzocarbazolyl group, a benzonaphthofuranyl group, a benzonaphthothiophenyl group, a dibenzofluorenyl group, a dibenzocarbazolyl group, a dinaphthofuranyl group, a dinaphthothiophenyl group, a pyrazolyl group, an imidazolyl group, a triazolyl group, an oxazolyl group, an isoxazolyl group, an oxadiazolyl group, an isoxadiazolyl group, a thiazolyl group, an isothiazolyl group, a thiadiazolyl group, an isothiadiazolyl group, a pyridinyl group, a pyrazinyl group, a pyridazinyl group, a pyrimidinyl group, a triazinyl group, a quinolinyl group, an isoquinolinyl group, a naphthyridinyl group, a quinoxalinyl group, and a quinazolinyl group;

a pyrazole group, an imidazole group, a triazole group, an oxazole group, an isoxazole group, an oxadiazole group, an isozadiazole group, a thiazole group, an isothiazole group, a thiadiazole group, an isothiadiazole group, a pyridine group, a pyrazine group, a pyridazine group, a pyrimidine group, a triazine group, a quinoline group, an isoquinoline group, a naphthyridine group, a quinoxaline group, and a quinazoline group, each substituted with at least one selected from a $C_1$-$C_{20}$ alkyl group, a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a benzofluorenyl group, a benzocarbazolyl group, a benzonaphthofuranyl group, a benzonaphthothiophenyl group, a dibenzofluorenyl group, a dibenzocarbazolyl group, a dinaphthofuranyl group, a dinaphthothiophenyl group, a pyrazolyl group, an imidazolyl group, a triazolyl group, an oxazolyl group, an isoxazolyl group, an oxadiazolyl group, an isoxadiazolyl group, a thiazolyl group, an isothiazolyl group, a thiadiazolyl group, an isothiadiazolyl group, a pyridinyl group, a pyrazinyl group, a pyridazinyl group, a pyrimidinyl group, a triazinyl group, a quinolinyl group, an isoquinolinyl group, a naphthyridinyl group, a quinoxalinyl group, and a quinazolinyl group that are each independently substituted with at least one selected from deuterium, -F, a cyano group, a $C_1$-$C_{20}$ alkyl group, a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a benzofluorenyl group, a benzocarbazolyl group, a benzonaphthofuranyl group, a benzonaphthothiophenyl group, a dibenzofluorenyl group, a dibenzocarbazolyl group, a dinaphthofuranyl group, a dinaphthothiophenyl group, a pyrazolyl group, an imidazolyl group, a triazolyl group, an oxazolyl group, an isoxazolyl group, an oxadiazolyl group, an isoxadiazolyl group, a thiazolyl group, an isothiazolyl group, a thiadiazolyl group, an isothiadiazolyl group, a pyridinyl group, a pyrazinyl group, a pyridazinyl group, a pyrimidinyl group, a triazinyl group, a quinolinyl group, an isoquinolinyl group, a naphthyridinyl group, a quinoxalinyl group, and a quinazolinyl group;

a $C_1$-$C_{20}$ alkyl group, a benzene group, a biphenyl group, a terphenyl group, a naphthalene group, a phenanthrene group, a triphenylene group, a chrysene group, a fluoranthene group, a fluorene group, a carbazole group, a dibenzofuran group, a dibenzothiophene group, a benzofluorene group, a benzocarbazole group, a benzonaphthofuran group, a benzonaphthothiophene group, a dibenzofluorene group, a dibenzocarbazole group, a dinaphthofuran group, and a dinaphthothiophene group, each substituted with at least one selected from -F, a cyano group, a pyrazolyl group, an imidazolyl group, a triazolyl group, an oxazolyl group, an isoxazolyl group, an oxadiazolyl group, an isoxadiazolyl group, a thiazolyl group, an isothiazolyl group, a thiadiazolyl group, an isothiadiazolyl group, a pyridinyl group, a pyrazinyl group, a pyridazinyl group, a pyrimidinyl group, a triazinyl group, a quinolinyl group, an isoquinolinyl group, a naphthyridinyl group, a quinoxalinyl group, and a quinazolinyl group;

a $C_1$-$C_{20}$ alkyl group, a benzene group, a biphenyl group, a terphenyl group, a naphthalene group, a phenanthrene group, a triphenylene group, a chrysene group, a fluoranthene group, a fluorene group, a carbazole group, a dibenzofuran group, a dibenzothiophene group, a benzofluorene group, a benzocarbazole group, a benzonaphthofuran group, a benzonaphthothiophene group, a dibenzofluorene group, a dibenzocarbazole group, a dinaphthofuran group, and a dinaphthothiophene group, each substituted with at least one selected from a pyrazolyl group, an imidazolyl group, a triazolyl group, an oxazolyl group, an isoxazolyl group, an oxadiazolyl group, an isoxadiazolyl group, a thiazolyl group, an isothiazolyl group, a thiadiazolyl group, an isothiadiazolyl group, a pyridinyl group, a pyrazinyl group, a pyridazinyl group, a pyrimidinyl group, a triazinyl group, a quinolinyl group, an isoquinolinyl group, a naphthyridinyl group, a quinoxalinyl group, and a quinazolinyl group that are each independently substituted with at least one selected from deuterium, -F, a cyano group, a $C_1$-$C_{20}$ alkyl group, a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a benzofluorenyl group, a benzocarbazolyl group, a benzonaphthofuranyl group, a benzonaphthothiophenyl group, a dibenzofluorenyl group, a dibenzocarbazolyl group, a dinaphthofuranyl group, a dinaphthothiophenyl group, a pyrazolyl group, an imidazolyl group, a triazolyl group, an oxazolyl group, an isoxazolyl group, an oxadiazolyl group, an isoxadiazolyl group, a thiazolyl group, an isothiazolyl group, a thiadiazolyl group, an isothiadiazolyl group, a pyridinyl group, a pyrazinyl group, a pyridazinyl group, a pyrimidinyl group, a triazinyl group, a quinolinyl group, an isoquinolinyl group, a naphthyridinyl group,

a quinoxalinyl group, and a quinazolinyl group; and

a $C_1$-$C_{20}$ alkyl group, a benzene group, a biphenyl group, a terphenyl group, a naphthalene group, a phenanthrene group, a triphenylene group, a chrysene group, a fluoranthene group, a fluorene group, a carbazole group, a dibenzofuran group, a dibenzothiophene group, a benzofluorene group, a benzocarbazole group, a benzonaphthofuran group, a benzonaphthothiophene group, a dibenzofluorene group, a dibenzocarbazole group, a dinaphthofuran group, and a dinaphthothiophene group, each substituted with at least one selected from a $C_1$-$C_{20}$ alkyl group, a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a benzofluorenyl group, a benzocarbazolyl group, a benzonaphthofuranyl group, a benzonaphthothiophenyl group, a dibenzofluorenyl group, a dibenzocarbazolyl group, a dinaphthofuranyl group, and a dinaphthothiophenyl group that are each independently substituted with at least one selected from -F, a cyano group, a pyrazolyl group, an imidazolyl group, a triazolyl group, an oxazolyl group, an isoxazolyl group, an oxadiazolyl group, an isoxadiazolyl group, a thiazolyl group, an isothiazolyl group, a thiadiazolyl group, an isothiadiazolyl group, a pyridinyl group, a pyrazinyl group, a pyridazinyl group, a pyrimidinyl group, a triazinyl group, a quinolinyl group, an isoquinolinyl group, a naphthyridinyl group, a quinoxalinyl group, and a quinazolinyl group:

<Formula 13-1>

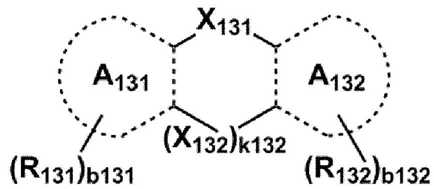

<Formula 13-2>

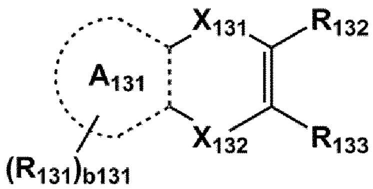

<Formula 13-3>

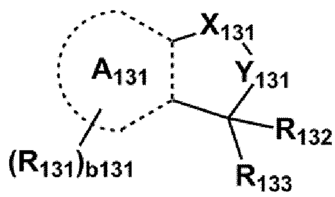

wherein, in Formulae 13-1 to 13-3,

$X_{131}$ is selected from C(=O), S(=O), $S(=O)_2$, $P(=O)(R_{134})$, and $P(=S)(R_{134})$,

$X_{132}$ is selected from O, S, C(=O), S(=O), $S(=O)_2$, $P(=O)(R_{135})$, and $P(=S)(R_{135})$,

k132 is 0 or 1,

$Y_{131}$ is selected from O and S,

$A_{131}$ and $A_{132}$ are each independently selected from a benzene group, a naphthalene group, a phenalene group, an anthracene group, a fluoranthene group, a triphenylene group, a phenanthrene group, a pyrene group, a chrysene group, a perylene group, a fluorene group, a carbazole group, a dibenzofuran group, and a dibenzothiophene group,

$R_{131}$ to $R_{135}$ are each independently selected from:

a binding site, hydrogen, deuterium, -F, a cyano group, a $C_1$-$C_{20}$ alkyl group, a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a benzofluorenyl group, a benzocarbazolyl group, a benzonaphthofuranyl group, a benzonaphthothiophenyl group, a dibenzofluorenyl group, a dibenzocarbazolyl group, a dinaphthofuranyl group, a dinaphthothiophenyl group, a pyrazolyl group, an imidazolyl group, a triazolyl group, an oxazolyl group, an isoxazolyl group, an oxadiazolyl group, an isoxadiazolyl group, a thiazolyl group, an isothiazolyl group, a thiadiazolyl group, an isothiadiazolyl group, a pyridinyl group, a pyrazinyl group, a pyridazinyl group, a pyrimidinyl group, a triazinyl group, a quinolinyl group, an isoquinolinyl group, a naphthyridinyl group, a quinoxalinyl group, and a quinazolinyl group; and

a $C_1$-$C_{20}$ alkyl group, a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a benzofluorenyl group, a benzocarbazolyl group, a benzonaphthofuranyl group, a benzonaphthothiophenyl group, a dibenzofluorenyl group, a dibenzocarbazolyl group, a dinaphthofuranyl group, a dinaphthothiophenyl group, a pyrazolyl group, an imidazolyl group, a triazolyl group, an oxazolyl group, an isoxazolyl group, an oxadiazolyl group, an isoxadiazolyl group, a thiazolyl group, an isothiazolyl group, a thiadiazolyl group, an isothiadiazolyl group, a pyridinyl group, a pyrazinyl group, a pyridazinyl group, a pyrimidinyl group, a triazinyl group, a quinolinyl group, an isoquinolinyl group, a naphthyridinyl group, a quinoxalinyl group, and a quinazolinyl group, each substituted with at least one selected from deuterium, -F, a cyano group, a $C_1$-$C_{20}$ alkyl group, a phenyl group, a biphenyl group, a terphenyl group, a naphthyl group, a phenanthrenyl group, a triphenylenyl group, a chrysenyl group, a

fluoranthenyl group, a fluorenyl group, a carbazolyl group, a dibenzofuranyl group, a dibenzothiophenyl group, a benzofluorenyl group, a benzocarbazolyl group, a benzonaphthofuranyl group, a benzonaphthothiophenyl group, a dibenzofluorenyl group, a dibenzocarbazolyl group, a dinaphthofuranyl group, a dinaphthothiophenyl group, a pyrazolyl group, an imidazolyl group, a triazolyl group, an oxazolyl group, an isoxazolyl group, an oxadiazolyl group, an isoxadiazolyl group, a thiazolyl group, an isothiazolyl group, a thiadiazolyl group, an isothiadiazolyl group, a pyridinyl group, a pyrazinyl group, a pyridazinyl group, a pyrimidinyl group, a triazinyl group, a quinolinyl group, an isoquinolinyl group, a naphthyridinyl group, a quinoxalinyl group, and a quinazolinyl group, wherein at least one selected from $R_{131}$ to $R_{135}$ is the binding site, and
b131 and b132 are each independently selected from 1, 2, 3, 4, 5, and 6,
n41 and n42 are each independently selected from 1, 2, and 3,

$L_{41}$ and $L_{42}$ are each independently selected from:

a benzene group, a naphthalene group, a phenalene group, an anthracene group, a fluoranthene group, a triphenylene group, a phenanthrene group, a pyrene group, a chrysene group, a perylene group, a fluorene group, a carbazole group, a dibenzofuran group, a dibenzothiophene group, $-C(Q_1)(Q_2)-$, and $-Si(Q_1)(Q_2)-$; and
a benzene group, a naphthalene group, a phenalene group, an anthracene group, a fluoranthene group, a triphenylene group, a phenanthrene group, a pyrene group, a chrysene group, a perylene group, a fluorene group, a carbazole group, a dibenzofuran group, and a dibenzothiophene group, each substituted with at least one selected from deuterium, a $C_1$-$C_{20}$ alkyl group, a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a benzofluorenyl group, a benzocarbazolyl group, a benzonaphthofuranyl group, a benzonaphthothiophenyl group, a dibenzofluorenyl group, a dibenzocarbazolyl group, a dinaphthofuranyl group, a dinaphthothiophenyl group, $-C(Q_{31})(Q_{32})(Q_{33})$, and $-Si(Q_{31})(Q_{32})(Q_{33})$,
a41 and a42 are each independently selected from 0, 1, 2, and 3, and
wherein, in Formulae 1, 2A, 2B, 3, and 4-1 to 4-3,
$Q_1$ to $Q_3$, $Q_{21}$ to $Q_{23}$, and $Q_{31}$ to $Q_{33}$ are each independently selected from hydrogen, deuterium, -F, -Cl, -Br, -I, a hydroxyl group, a cyano group, a nitro group, an amidino group, a hydrazino group, a hydrazono group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, a biphenyl group, and a terphenyl group.

**2.** An organic light-emitting device (10, 20, 30, 40) according to claim 1, wherein:

(i) the first compound, the second compound, and the third compound are substantially not to emit light; and/or
(ii) the fourth compound is to emit light; and/or
(iii) a ratio of a light emitted from the fourth compound to a total light emitted from the emission layer is 80% or more; and/or
(iv) at least one of $R_{11}$ to $R_{19}$ is the group represented by $*-(L_{11})_{a11}-A_{11}$; and/or
(v) $X_{11}$ is $N(R_{19})$.

**3.** An organic light-emitting device (10, 20, 30, 40) according to claim 1 or claim 2, wherein $A_{11}$ is selected from:

a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a benzofluorenyl group, a benzocarbazolyl group, a benzonaphthofuranyl group, a benzonaphthothiophenyl group, a dibenzofluorenyl group, a dibenzocarbazolyl group, a dinaphthofuranyl group and dinaphthothiophenyl group;
a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a benzofluorenyl group, a benzocarbazolyl group, a benzonaphthofuranyl group, a benzonaphthothiophenyl group, a dibenzofluorenyl group, a dibenzocarbazolyl group, a dinaphthofuranyl group, and a dinaphthothiophenyl group, each substituted with at least one selected from deuterium, a $C_1$-$C_{20}$ alkyl

group, a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a benzofluorenyl group, a benzocarbazolyl group, a benzonaphthofuranyl group, a benzonaphthothiophenyl group, a dibenzofluorenyl group, a dibenzocarbazolyl group, a dinaphthofuranyl group, a dinaphthothiophenyl group, - $C(Q_{31})(Q_{32})(Q_{33})$, $-Si(Q_{31})(Q_{32})(Q_{33})$, $-B(Q_{31})(Q_{32})$, and $-N(Q_{31})(Q_{32})$; and

a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a benzofluorenyl group, a benzocarbazolyl group, a benzonaphthofuranyl group, a benzonaphthothiophenyl group, a dibenzofluorenyl group, a dibenzocarbazolyl group, a dinaphthofuranyl group, and a dinaphthothiophenyl group, each substituted with at least one selected from a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a benzofluorenyl group, a benzocarbazolyl group, a benzonaphthofuranyl group, a benzonaphthothiophenyl group, a dibenzofluorenyl group, a dibenzocarbazolyl group, a dinaphthofuranyl group, and a dinaphthothiophenyl group that are each independently substituted with at least one selected from deuterium, a $C_1$-$C_{20}$ alkyl group, a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a benzofluorenyl group, a benzocarbazolyl group, a benzonaphthofuranyl group, a benzonaphthothiophenyl group, a dibenzofluorenyl group, a dibenzocarbazolyl group, a dinaphthofuranyl group, a dinaphthothiophenyl group, - $C(Q_{21})(Q_{22})(Q_{23})$, $-Si(Q_{21})(Q_{22})(Q_{23})$, $-B(Q_{21})(Q_{22})$, and $-N(Q_{21})(Q_{22})$.

**4.** An organic light-emitting device (10, 20, 30, 40) according to any one of claims 1 to 3, wherein $A_{11}$ is represented by any one of Formulae 8-1 to 8-5:

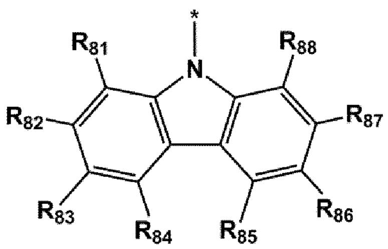

8-1

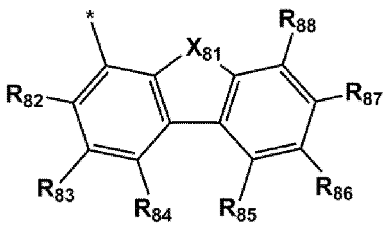

8-2

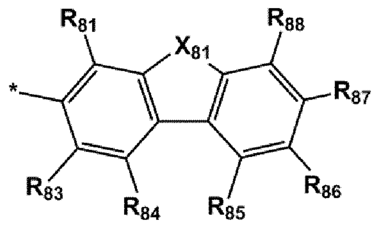

8-3

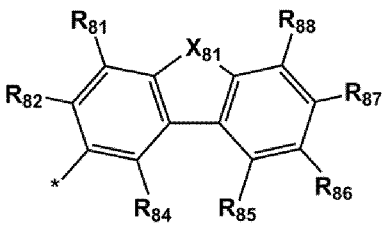

8-4

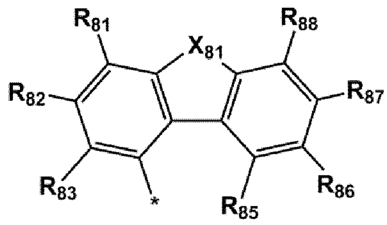

8-5

wherein, in Formulae 8-1 to 8-5,

$X_{81}$ is selected from O, S, $N(R_{89})$, and $C(R_{89})(R_{90})$,

$R_{81}$ to $R_{90}$ are each independently selected from hydrogen, deuterium, a $C_1$-$C_{20}$ alkyl group, a phenyl group, a biphenyl group, a terphenyl group, a fluorenyl group, a carbazolyl group, a dibenzofuranyl group, and a dibenzothiophenyl group, and

* indicates a binding site to a neighboring atom.

**5.** An organic light-emitting device (10, 20, 30, 40) according to any one of claims 1 to 4, wherein the first compound is represented by any one of Formulae 1-1 to 1-5:

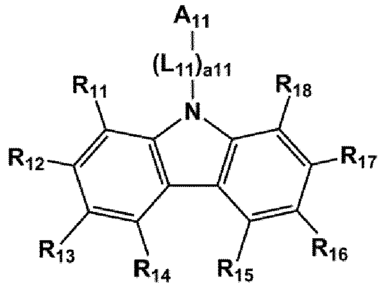

1-1

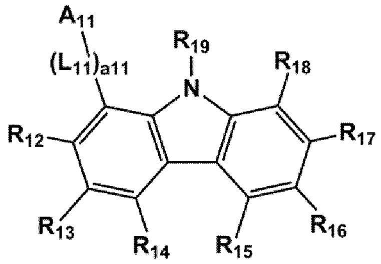

1-2

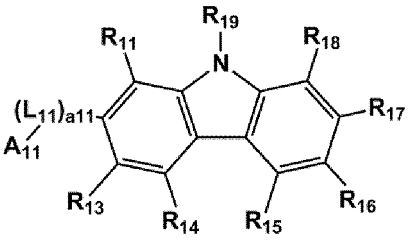

1-3

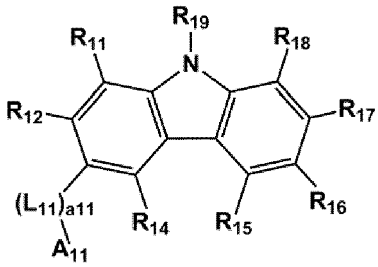

1-4

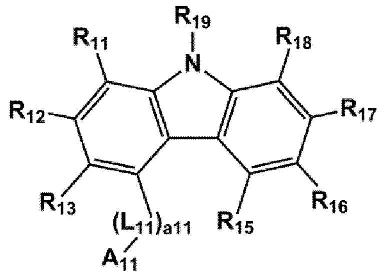

1-5

wherein, in Formulae 1-1 to 1-5,
$L_{11}$, a11, $A_{11}$, and $R_{11}$ to $R_{19}$ are each the same as respectively defined in connection with Formula 1.

**6.** An organic light-emitting device (10, 20, 30, 40) according to any one of claims 1 to 5, wherein:

at least one of $R_{21}$, $R_{22}$, $R_{24}$, and $R_{25}$ in Formula 2A is the group represented by *-$(L_{21})_{a21}$-$A_{21}$, and
at least one $R_{23}$ out of a number (6-k23) in Formula 2B is the group represented by *-$(L_{21})_{a21}$-$A_{21}$.

**7.** An organic light-emitting device (10, 20, 30, 40) according to any one of claims 1 to 6, wherein $A_{21}$ is selected from:

a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a pyridinyl group, a pyrazinyl group, a pyridazinyl group, a pyrimidinyl group, a triazinyl group, a quinolinyl group, an isoquinolinyl group, a naphthyridinyl group, a quinoxalinyl group, and a quinazolinyl group;
a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a pyridinyl group, a pyrazinyl group, a pyridazinyl group, a pyrimidinyl group, a triazinyl group, a quinolinyl group, an isoquinolinyl group, a naphthyridinyl group, a quinoxalinyl group, and a quinazolinyl group, each substituted with at least one selected from deuterium, -F, a cyano group, a $C_1$-$C_{20}$ alkyl group, a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a pyridinyl group, a pyrazinyl group, a pyridazinyl group, a pyrimidinyl group, a triazinyl group, a quinolinyl group, an isoquinolinyl group, a naphthyridinyl group, a quinoxalinyl group, a quinazolinyl group, -C(Q31)(Q32)(Q33), -Si($Q_{31}$)($Q_{32}$)($Q_{33}$), -B(Q31)(Q32), -N(Q31)(Q32), - S(=O)($Q_{31}$), -S$(=O)_2$($Q_{31}$), -P(=O)($Q_{31}$)($Q_{32}$), and -P(=S) ($Q_{31}$)($Q_{32}$); and
a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a pyridinyl group, a pyrazinyl group, a pyridazinyl group, a pyrimidinyl group, a triazinyl group, a quinolinyl group, an isoquinolinyl group, a naphthyridinyl group, a quinoxalinyl group, and a quinazolinyl group, each substituted with at least one selected from a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a pyridinyl group, a pyrazinyl group, a pyridazinyl group, a pyrimidinyl group, a triazinyl group, a quinolinyl group, an isoquinolinyl group, a naphthyridinyl group, a quinoxalinyl group, and a quinazolinyl group that are each independently

substituted with at least one selected from deuterium, -F, a cyano group, a $C_1$-$C_{20}$ alkyl group, a phenyl group, a biphenyl group, a terphenyl group, a naphthyl group, a phenanthrenyl group, a triphenylenyl group, a chrysenyl group, a fluoranthenyl group, a fluorenyl group, a carbazolyl group, a dibenzofuranyl group, a dibenzothiophenyl group, a pyridinyl group, a pyrazinyl group, a pyridazinyl group, a pyrimidinyl group, a triazinyl group, a quinolinyl group, an isoquinolinyl group, a naphthyridinyl group, a quinoxalinyl group, a quinazolinyl group, $-C(Q_{21})(Q_{22})(Q_{23})$, $-Si(Q_{21})(Q_{22})(Q_{23})$, $-B(Q_{21})(Q_{22})$, - $N(Q_{21})(Q_{22})$, $-S(=O)(Q_{21})$, $-S(=O)_2(Q_{21})$, $-P(=O)(Q_{21})(Q_{22})$, and -P(=S) $(Q_{21})(Q_{22})$.

**8.** An organic light-emitting device (10, 20, 30, 40) according to any one of claims 1 to 7, wherein the second compound is represented by Formula 2-1 or Formula 2-2:

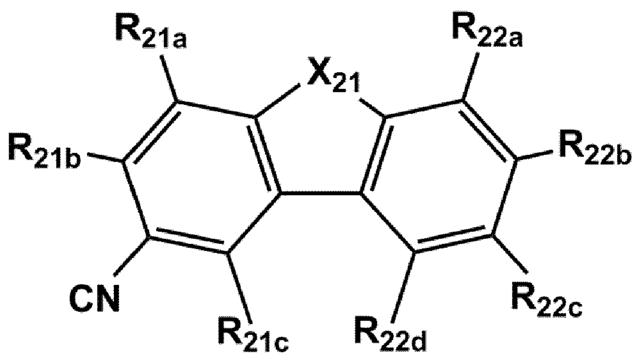

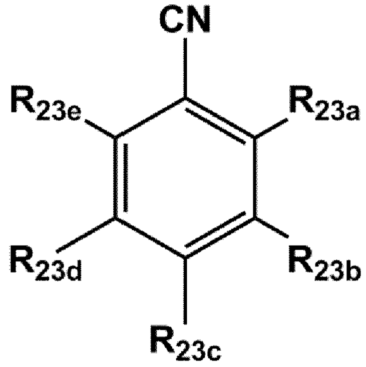

2-1 2-2

wherein, in Formulae 2-1 and 2-2,
$X_{21}$ is selected from O, S, $N(R_{24})$, and $C(R_{24})(R_{25})$,
$R_{21a}$ to $R_{21c}$, $R_{22a}$ to $R_{22d}$, $R_{23a}$ to $R_{23e}$, $R_{24}$, and $R_{25}$ are each independently selected from:

a group represented by $*-(L_{21})_{a21}-A_{21}$, hydrogen, deuterium, -F, a cyano group, a $C_1$-$C_{60}$ alkyl group, a $\pi$ electron-depleted nitrogen-containing cyclic group, a $\pi$ electron-depleted nitrogen-free cyclic group, $-C(Q_1)(Q_2)(Q_3)$, - $Si(Q_1)(Q_2)(Q_3)$, $-B(Q_1)(Q_2)$, $-N(Q_1)(Q_2)$, $-S(=O)(Q_1)$, $-S(=O)_2(Q_1)$, $-P(=O)(Q_1)(Q_2)$, and $-P(=S)(Q_1)(Q_2)$;
a $\pi$ electron-depleted nitrogen-containing cyclic group and a $\pi$ electron-depleted nitrogen-free cyclic group, each substituted with at least one selected from deuterium, -F, a cyano group, a $C_1$-$C_{60}$ alkyl group, a $\pi$ electron-depleted nitrogen-containing cyclic group, a $\pi$ electron-depleted nitrogen-free cyclic group, $-C(Q_{31})(Q_{32})(Q_{33})$, $-Si(Q_{31})(Q_{32})(Q_{33})$, $-B(Q_{31})(Q_{32})$, $-N(Q_{31})(Q_{32})$, - $S(=O)(Q_{31})$, $-S(=O)_2(Q_{31})$, $-P(=O)(Q_{31})(Q_{32})$, and $-P(=S)(Q_{31})(Q_{32})$; and
a $\pi$ electron-depleted nitrogen-containing cyclic group and a $\pi$ electron-depleted nitrogen-free cyclic group, each substituted with at least one selected from a $\pi$ electron-depleted nitrogen-containing cyclic group and a $\pi$ electron-depleted nitrogen-free cyclic group that are each independently substituted with at least one selected from deuterium, -F, a cyano group, a $C_1$-$C_{60}$ alkyl group, a $\pi$ electron-depleted nitrogen-containing cyclic group, a $\pi$ electron-depleted nitrogen-free cyclic group, $-C(Q_{21})(Q_{22})(Q_{23})$, $-Si(Q_{21})(Q_{22})(Q_{23})$, $-B(Q_{21})(Q_{22})$, - $N(Q_{21})(Q_{22})$, $-S(=O)(Q_{21})$, $-S(=O)_2(Q_{21})$, $-P(=O)(Q_{21})(Q_{22})$, and $-P(=S)(Q_{21})(Q_{22})$,

at least one of $R_{21a}$ to $R_{21c}$, $R_{22a}$ to $R_{22d}$, $R_{24}$ and $R_{25}$ in Formula 2-1 is the group represented by $*-(L_{21})_{a21}-A_{21}$,
at least one selected from $R_{23a}$ to $R_{23e}$ in Formula 2-2 is the group represented by $*-(L_{21})_{a21}-A_{21}$,
b41 to b43 are each independently an integer from 0 to 10, and
$Q_1$ to $Q_3$, $Q_{21}$ to $Q_{23}$, and $Q_{31}$ to $Q_{33}$ are each independently selected from hydrogen, deuterium, -F, -Cl, -Br, -I, a hydroxyl group, a cyano group, a nitro group, an amidino group, a hydrazino group, a hydrazono group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, a biphenyl group, and a terphenyl group.

**9.** An organic light-emitting device (10, 20, 30, 40) according to any one of claims 1 to 8, wherein the third compound is represented by Formula 3-1 or Formula 3-2:

<Formula 3-1>

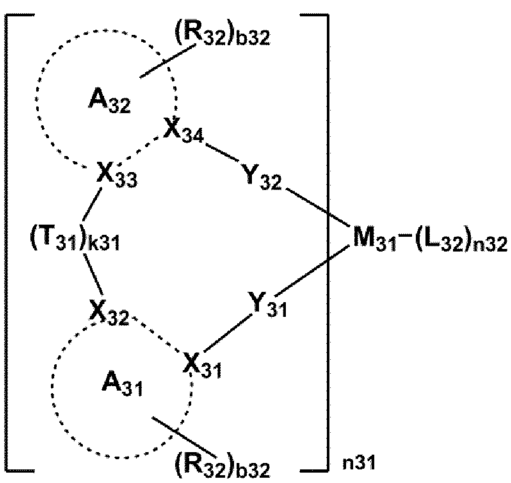

<Formula 3-2>

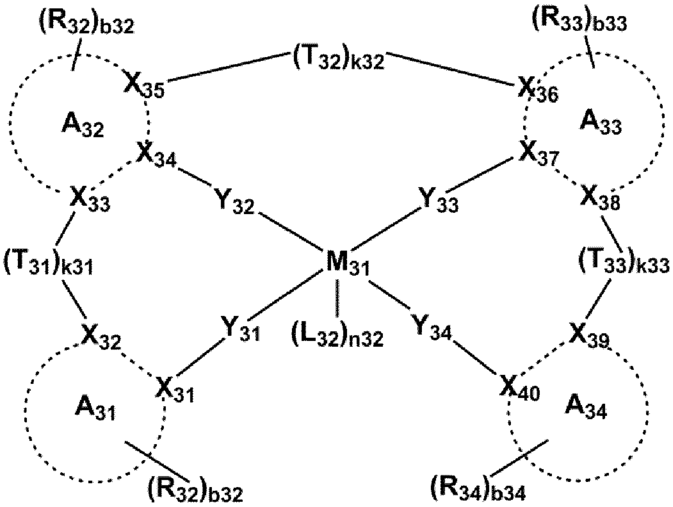

wherein, in Formulae 3-1 and 3-2,
$X_{31}$ to $X_{40}$ are each independently selected from N and C, and
$M_{31}$, $A_{31}$ to $A_{34}$, $R_{32}$ to $R_{34}$, b32 to b34, $Y_{31}$ to $Y_{34}$, $T_{31}$ to $T_{33}$, k31 to k33, $L_{32}$, n31 and n32 are each the same as respectively defined in connection with Formula 3.

**10.** An organic light-emitting device (10, 20, 30, 40), wherein:

the first compound is selected from compounds of Group I,
the second compound is selected from compounds of Group II,
the third compound is selected from compounds of Group III-I and Group III-II, and
the fourth compound is selected from compounds of Group IV:

<Group I>

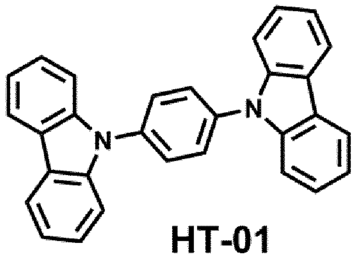

HT-01

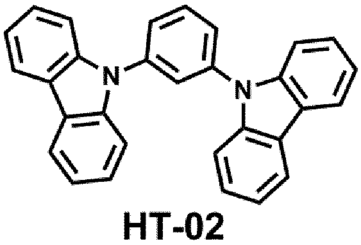

HT-02

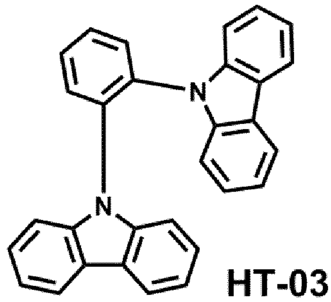

HT-03

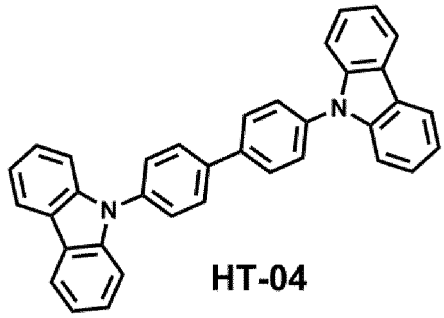

HT-04

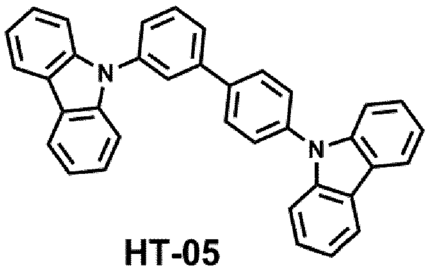

HT-05

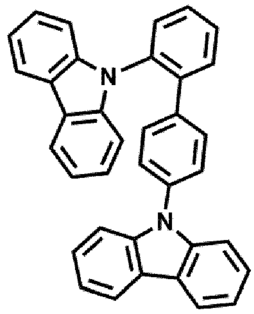

HT-06

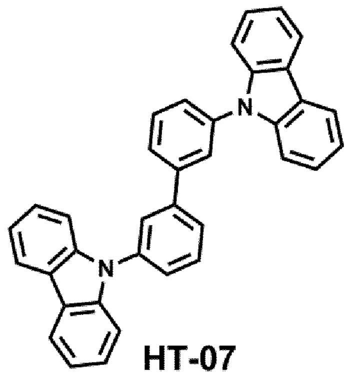

HT-07

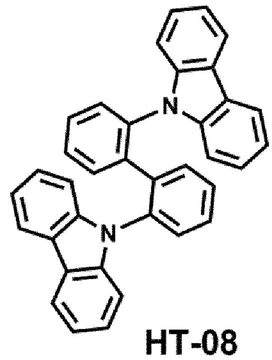

HT-08

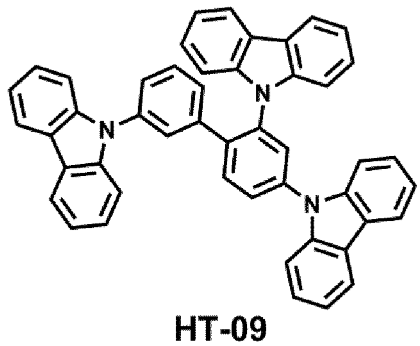

HT-09

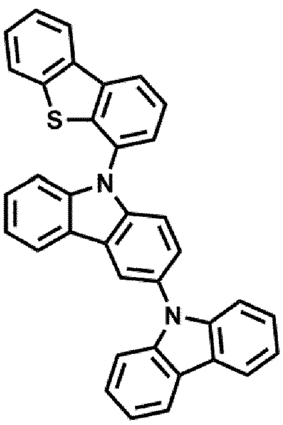

HT-10

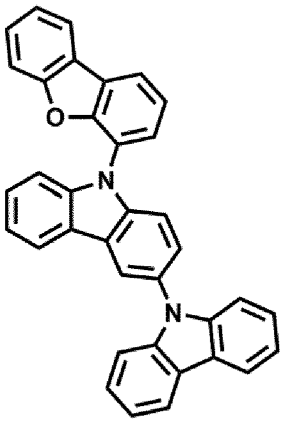

HT-11

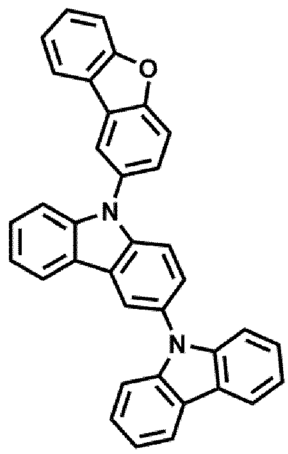

HT-12

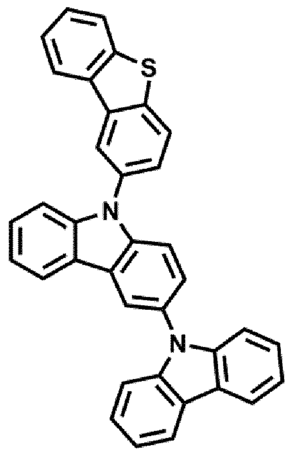

HT-13

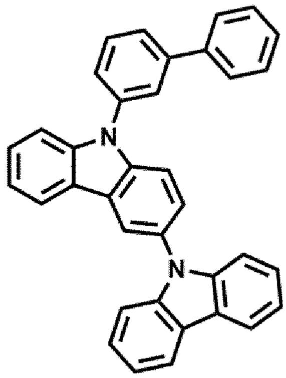

HT-14

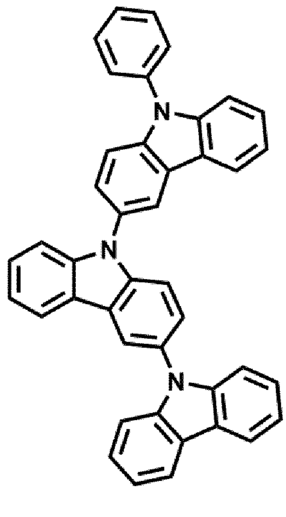

HT-15

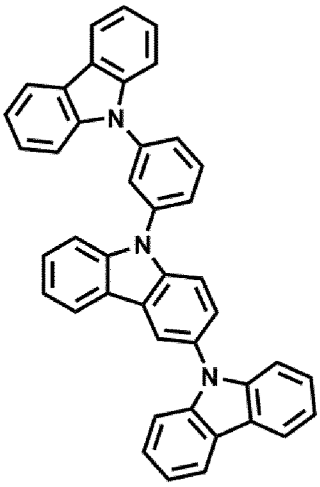

HT-16

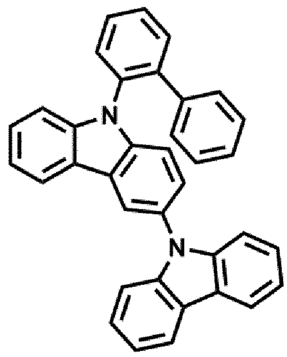

HT-17

<Group II>

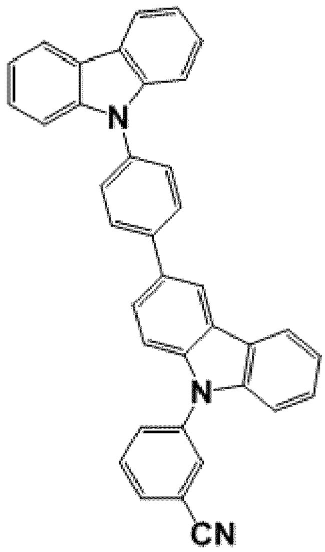

ET-1

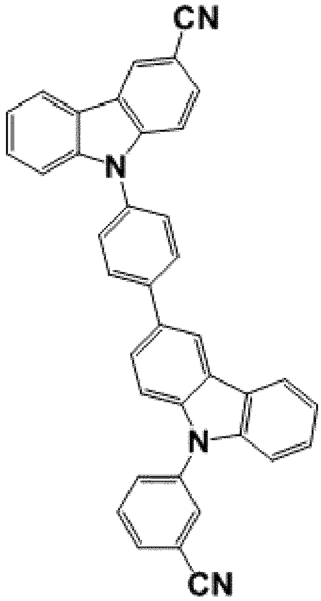

ET-2

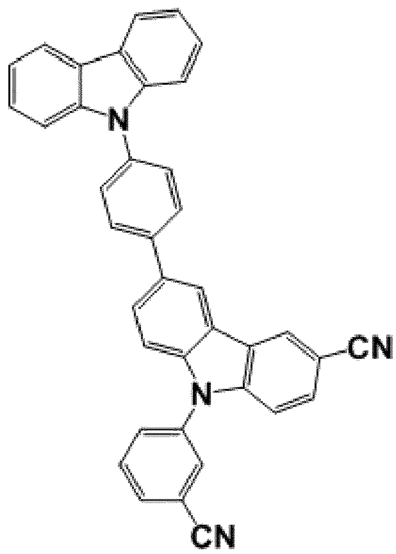

ET-3

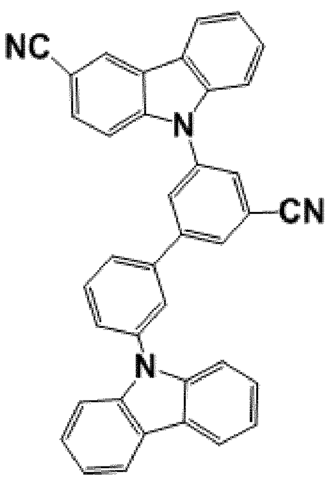

ET-4

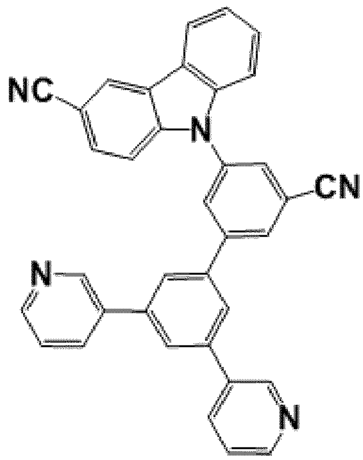

ET-5

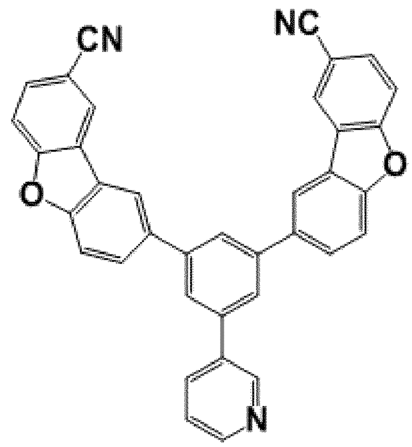

ET-6

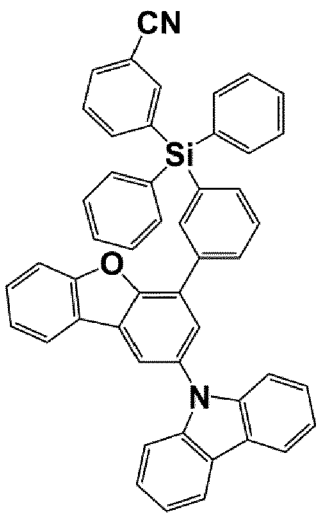

ET-7

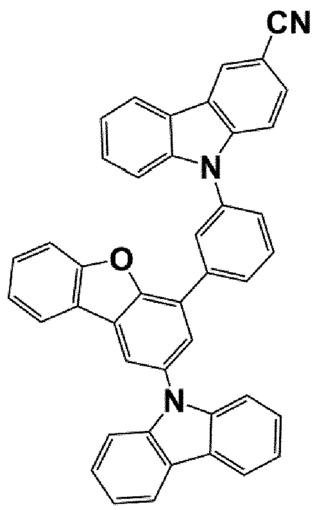

ET-8

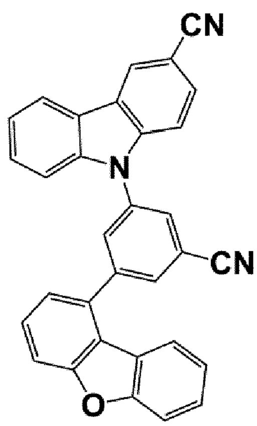

ET-9

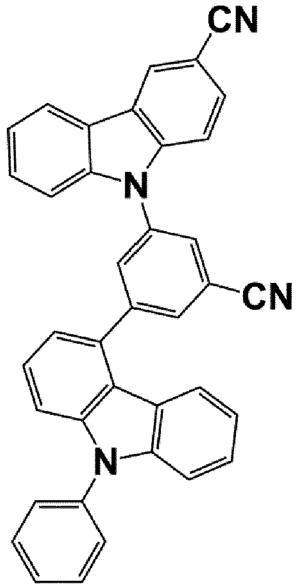

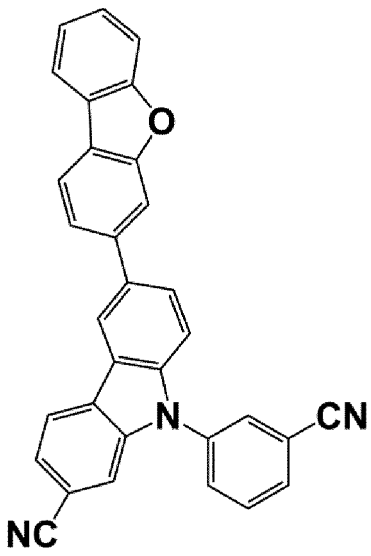

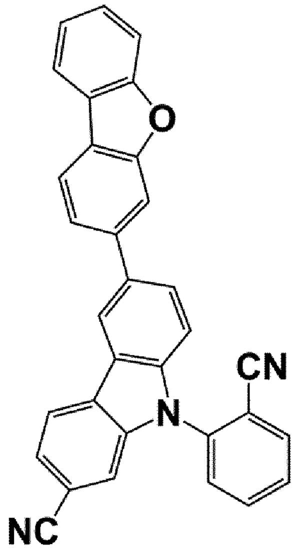

ET-10

ET-11

ET-12

<Group III-I>

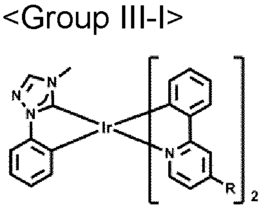

1 (R = H)
2 (R = Me)
3 (R = *iso*-Pr)
4 (R = *tert*-Bu)
5 (R = $NMe_2$)

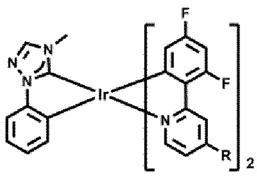

6 (R = H)
7 (R = Me)
8 (R = *iso*-Pr)
9 (R = *tert*-Bu)
10 (R = $NMe_2$)

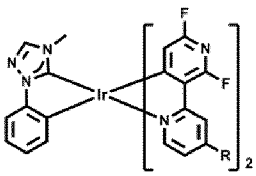

11 (R = H)
12 (R = Me)
13 (R = *iso*-Pr)
14 (R = *tert*-Bu)
15 (R = $NMe_2$)

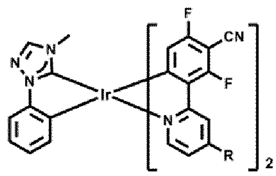

16 (R = H)
17 (R = Me)
18 (R = *iso*-Pr)
19 (R = *tert*-Bu)
20 (R = $NMe_2$)

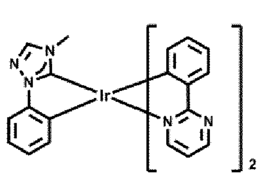

21

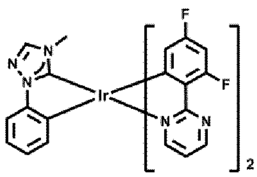

22

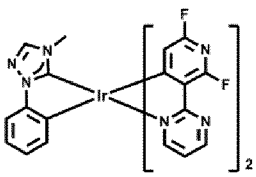

23

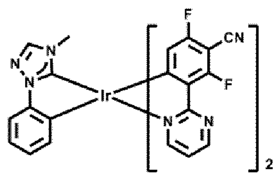

24

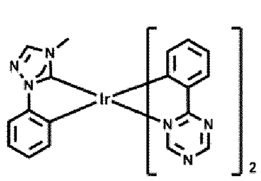

25

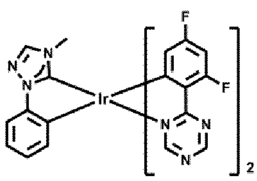

26

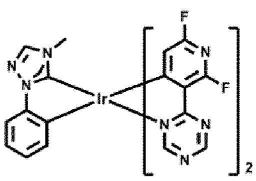

27

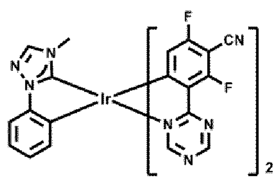

28

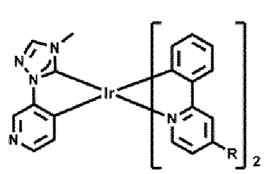

29 (R = H)
30 (R = Me)
31 (R = *iso*-Pr)
32 (R = *tert*-Bu)
33 (R = $NMe_2$)

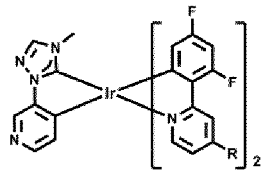

34 (R = H)
35 (R = Me)
36 (R = *iso*-Pr)
37 (R = *tert*-Bu)
38 (R = $NMe_2$)

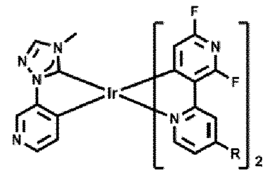

39 (R = H)
40 (R = Me)
41 (R = *iso*-Pr)
42 (R = *tert*-Bu)
43 (R = $NMe_2$)

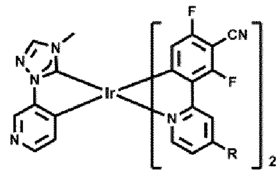

44 (R = H)
45 (R = Me)
46 (R = *iso*-Pr)
47 (R = *tert*-Bu)
48 (R = $NMe_2$)

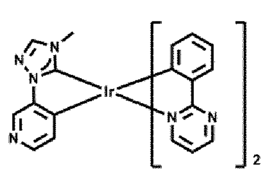

49

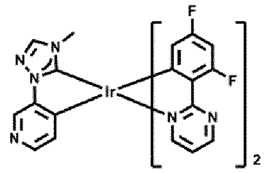

50

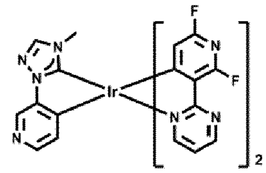

51

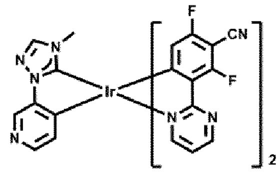

52

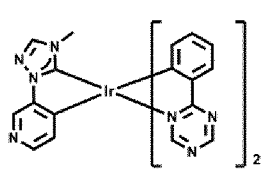

53

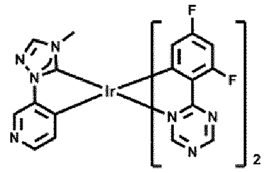

54

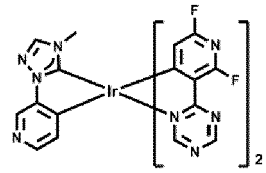

55

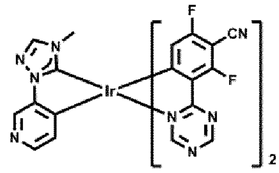

56

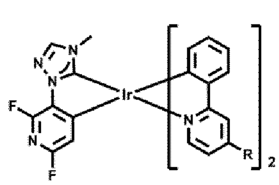

57 (R = H)
58 (R = Me)
59 (R = *iso*-Pr)
60 (R = *tert*-Bu)
61 (R = $NMe_2$)

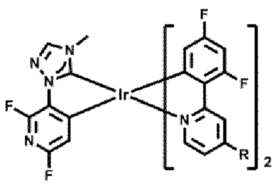

62 (R = H)
63 (R = Me)
64 (R = *iso*-Pr)
65 (R = *tert*-Bu)
66 (R = $NMe_2$)

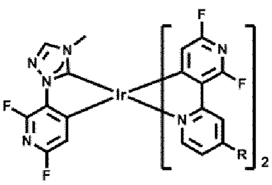

67 (R = H)
68 (R = Me)
69 (R = *iso*-Pr)
70 (R = *tert*-Bu)
71 (R = $NMe_2$)

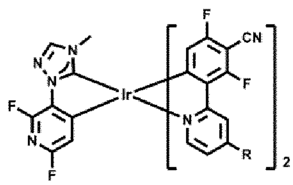

72 (R = H)
73 (R = Me)
74 (R = *iso*-Pr)
75 (R = *tert*-Bu)
76 (R = $NMe_2$)

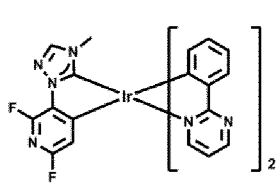

77

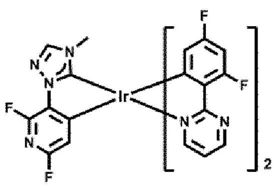

78

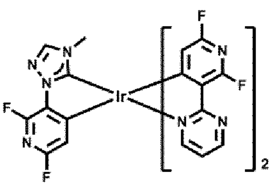

79

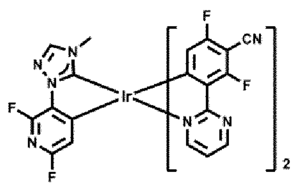

80

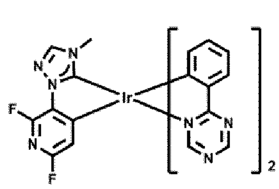

81

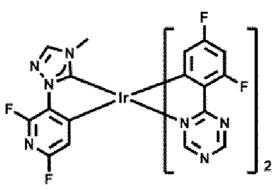

82

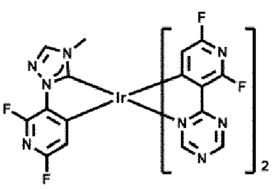

83

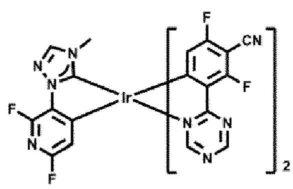

84

<Group III-2>

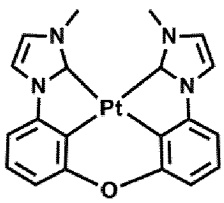

**PD1**

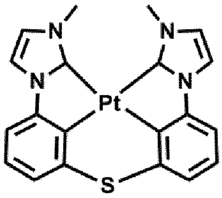

**PD2**

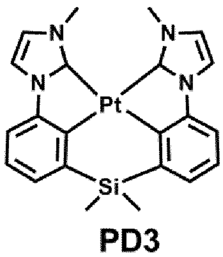

**PD3**

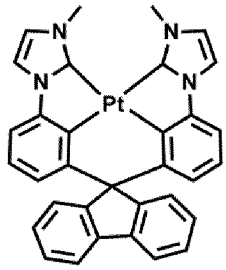

**PD4**

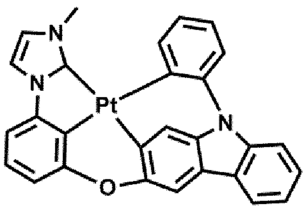

**PD5**

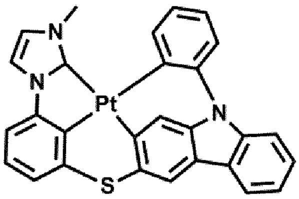

**PD6**

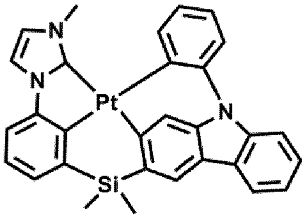

**PD7**

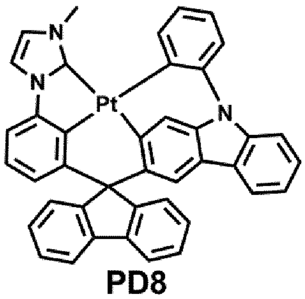

**PD8**

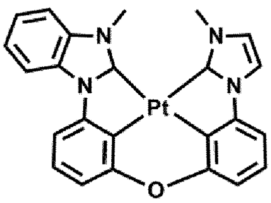

**PD9**

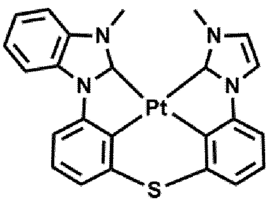

**PD10**

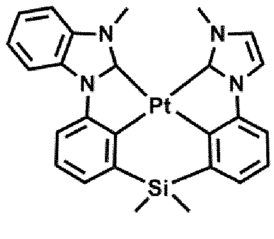

**PD11**

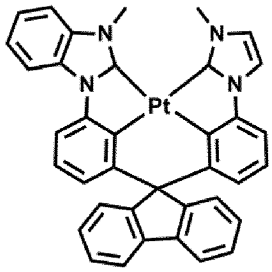

**PD12**

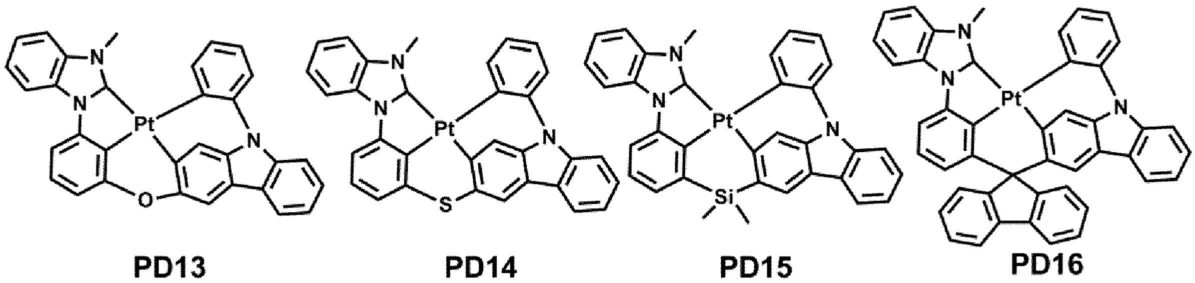

PD13 PD14 PD15 PD16

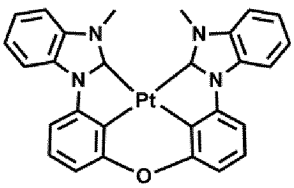

PD17

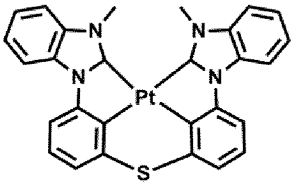

PD18

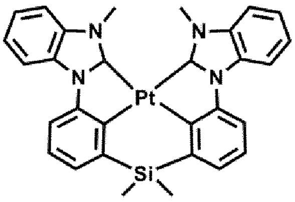

PD19

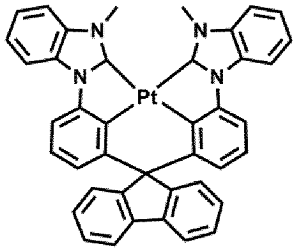

PD20

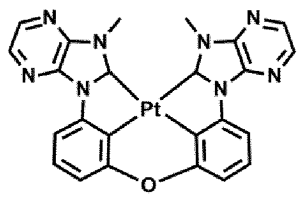

PD21

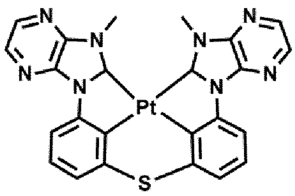

PD22

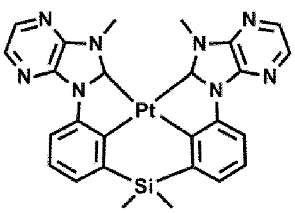

PD23

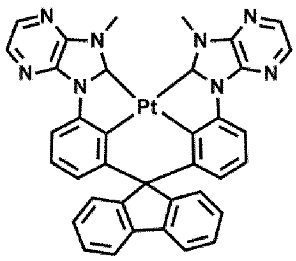

PD24

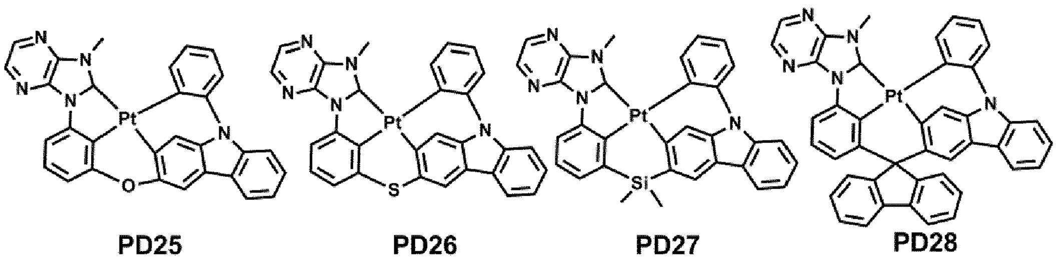

PD25 PD26 PD27 PD28

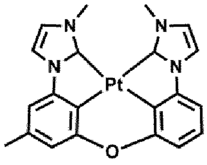

PD29

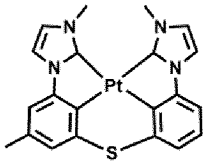

PD30

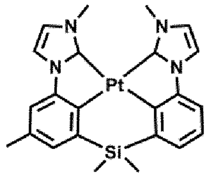

PD31

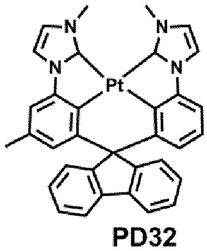

PD32

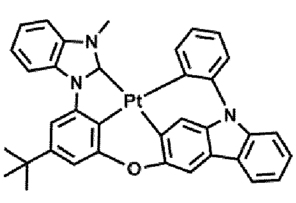

PD33

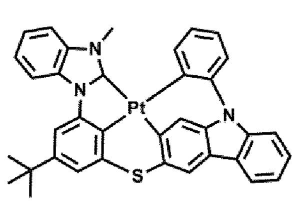

PD34

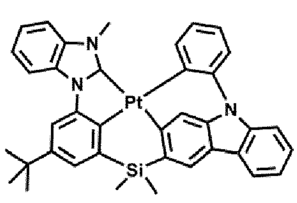

PD35

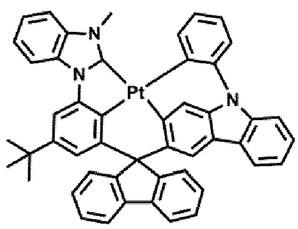

PD36

<Group IV>

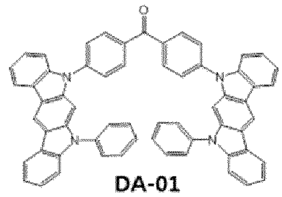
DA-01

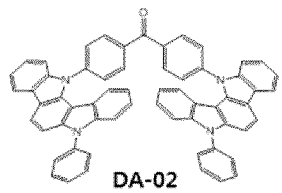
DA-02

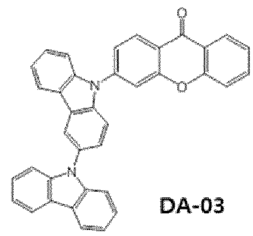
DA-03

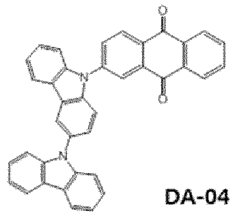
DA-04

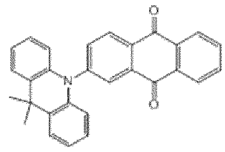
DA-05

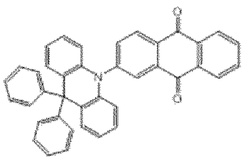
DA-06

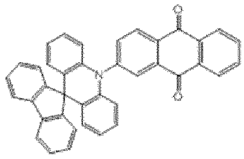
DA-07

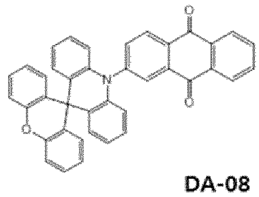
DA-08

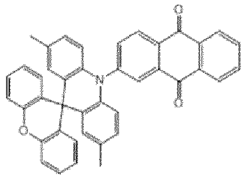
DA-09

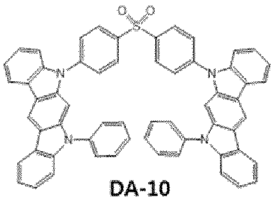
DA-10

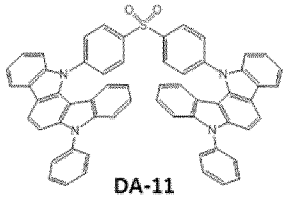
DA-11

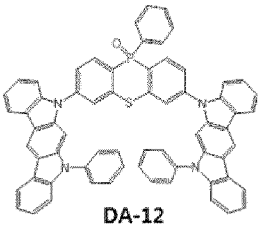
DA-12

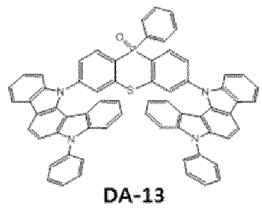
DA-13

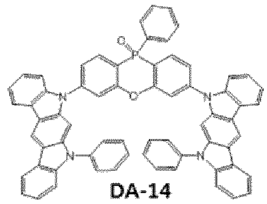
DA-14

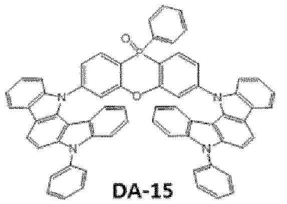
DA-15

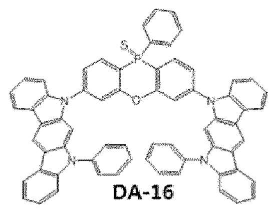
DA-16

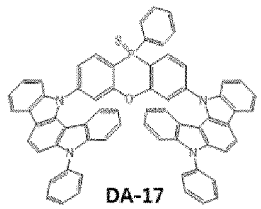
DA-17

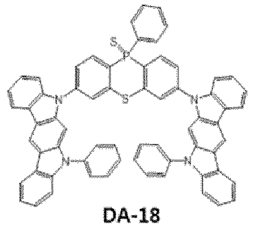
DA-18

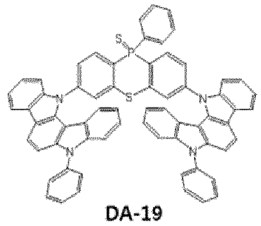
DA-19

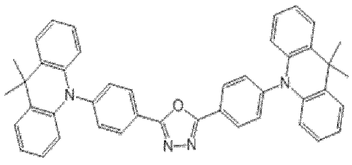
DA-20

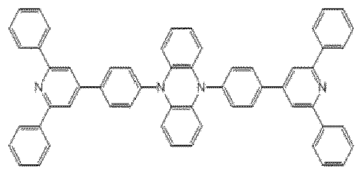
DA-21

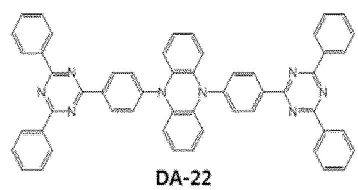
DA-22

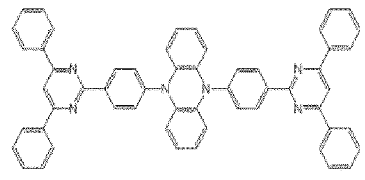
DA-23

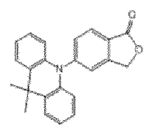
DA-24

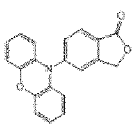
DA-25

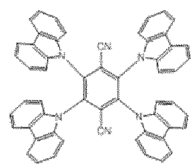
DA-26

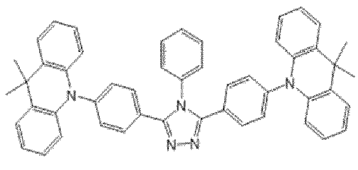
DA-27

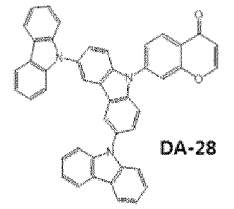
DA-28

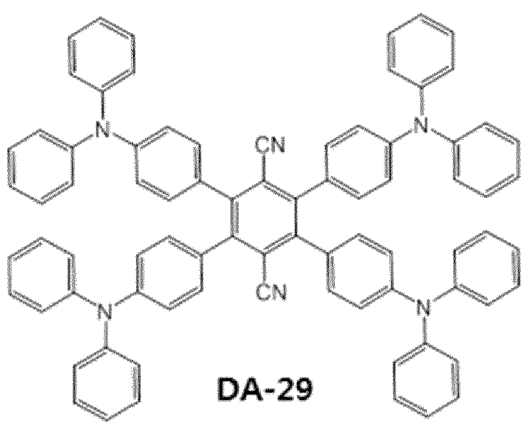
DA-29

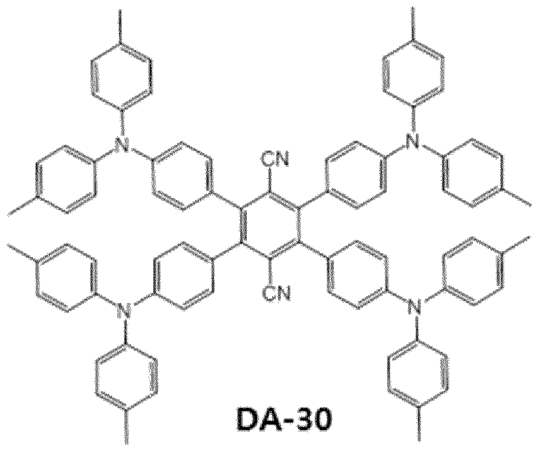
DA-30

.

**11.** An organic light-emitting device (10, 20, 30, 40) according to any one of claims 1 to 10, wherein:

the first electrode (110) is an anode,
the second electrode (190) is a cathode,
the organic layer (150) further comprises a hole transport region between the first electrode (110) and the emission layer and/or an electron transport region between the emission layer and the second electrode (190),
the hole transport region comprises a hole injection layer, a hole transport layer, an emission auxiliary layer, and/or an electron blocking layer, and
the electron transport region comprises a hole blocking layer, an electron transport layer, and/or an electron injection layer, optionally wherein the hole blocking layer comprises a hole blocking material represented by Formula 2A or Formula 2B:

<Formula 2A>

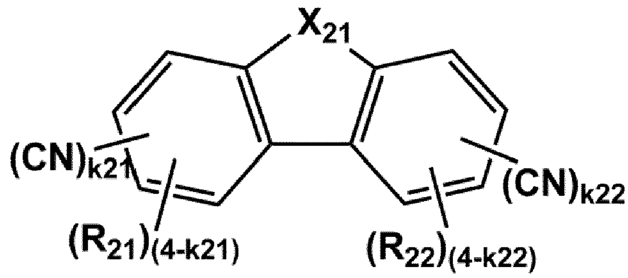

<Formula 2B>

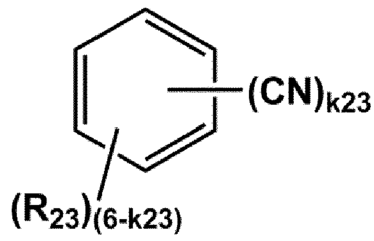

wherein, in Formulae 2A and 2B,
$X_{21}$ is selected from O, S, $N(R_{24})$, and $C(R_{24})(R_{25})$,
k21 and k22 are each independently selected from 0, 1, 2, 3, and 4, wherein the sum of k21 and k22 is 1 or more,
k23 is selected from 1, 2, 3, 4, 5, and 6,
$R_{21}$ to $R_{25}$ are each independently selected from:

a group represented by $*-(L_{21})_{a21}-A_{21}$, hydrogen, deuterium, -F, a cyano group, a $C_1$-$C_{60}$ alkyl group, a π electron-depleted nitrogen-containing cyclic group, a π electron-depleted nitrogen-free cyclic group, $-C(Q_1)(Q_2)(Q_3)$, - $Si(Q_1)(Q_2)(Q_3)$, $-B(Q_1)(Q_2)$, $-N(Q_1)(Q_2)$, $-S(=O)(Q_1)$, $-S(=O)_2(Q_1)$, $-P(=O)(Q_1)(Q_2)$, and $-P(=S)(Q_1)(Q_2)$;
a π electron-depleted nitrogen-containing cyclic group and a π electron-depleted nitrogen-free cyclic group, each substituted with at least one selected from deuterium, -F, a cyano group, a $C_1$-$C_{60}$ alkyl group, a π electron-depleted nitrogen-containing cyclic group, a π electron-depleted nitrogen-free cyclic group, $-C(Q_{31})(Q_{32})(Q_{33})$, $-si(Q_{31})(Q_{32})(Q_{33})$, $-B(Q_{31})(Q_{32})$, $-N(Q_{31})(Q_{32})$, - $S(=O)(Q_{31})$, $-S(=O)_2(Q_{31})$, $-P(=O)(Q_{31})(Q_{32})$, and $-P(=S)(Q_{31})(Q_{32})$; and
a π electron-depleted nitrogen-containing cyclic group and a π electron-depleted nitrogen-free cyclic group, each substituted with at least one selected from a π electron-depleted nitrogen-containing cyclic group and a π electron-depleted nitrogen-free cyclic group that are each substituted with at least one selected from deuterium, -F, a cyano group, a $C_1$-$C_{60}$ alkyl group, a π electron-depleted nitrogen-containing cyclic group, a π electron-depleted nitrogen-free cyclic group, $-C(Q_{21})(Q_{22})(Q_{23})$, $-Si(Q_{21})(Q_{22})(Q_{23})$, $-B(Q_{21})(Q_{22})$, $-N(Q_{21})(Q_{22})$, - $S(=O)(Q_{21})$, $-S(=O)_2(Q_{21})$, $-P(=O)(Q_{21})(Q_{22})$, and $-P(=S)(Q_{21})(Q_{22})$,

$L_{21}$ is selected from:

a π electron-depleted nitrogen-containing cyclic group, a π electron-depleted nitrogen-free cyclic group, $-C(Q_1)(Q_2)-$, $-Si(Q_1)(Q_2)-$, $-B(Q_1)-$, $-N(Q_1)-$, - $S(=O)-$, $-S(=O)_2-$, $-P(=O)(Q_1)-$, and $-P(=S)(Q_1)-$; and
a π electron-depleted nitrogen-containing cyclic group and a π electron-depleted nitrogen-free cyclic group, each substituted with at least one selected from deuterium, -F, a cyano group, a $C_1$-$C_{60}$ alkyl group, a π electron-depleted nitrogen-containing cyclic group, a π electron-depleted nitrogen-free cyclic group, $-C(Q_{31})(Q_{32})(Q_{33})$, $-si(Q_{31})(Q_{32})(Q_{33})$, $-B(Q_{31})(Q_{32})$, $-N(Q_{31})(Q_{32})$, - $S(=O)(Q_{31})$, $-S(=O)_2(Q_{31})$, $-P(=O)(Q_{31})(Q_{32})$, and $-P(=S)$ $(Q_{31})(Q_{32})$,

a21 is selected from 1, 2, and 3,
$A_{21}$ is selected from:

a π electron-depleted nitrogen-containing cyclic group and a π electron-depleted nitrogen-free cyclic group;
a π electron-depleted nitrogen-containing cyclic group and a π electron-depleted nitrogen-free cyclic group, each substituted with at least one selected from deuterium, -F, a cyano group, a $C_1$-$C_{60}$ alkyl group, a π electron-depleted nitrogen-containing cyclic group, a π electron-depleted nitrogen-free cyclic group, $-C(Q_{31})(Q_{32})(Q_{33})$, $-si(Q_{31})(Q_{32})(Q_{33})$, $-B(Q_{31})(Q_{32})$, $-N(Q_{31})(Q_{32})$, - $S(=O)(Q_{31})$, $-S(=O)_2(Q_{31})$, $-P(=O)(Q_{31})(Q_{32})$, and $-P(=S)$ $(Q_{31})(Q_{32})$; and
a π electron-depleted nitrogen-containing cyclic group and a π electron-depleted nitrogen-free cyclic group, each substituted with at least one selected from a π electron-depleted nitrogen-containing cyclic group and a π electron-depleted nitrogen-free cyclic group that are each substituted with at least one selected from deuterium, -F, a cyano group, a $C_1$-$C_{60}$ alkyl group, a π electron-depleted nitrogen-containing cyclic group, a π electron-depleted nitrogen-free cyclic group, $-C(Q_{21})(Q_{22})(Q_{23})$, $-si(Q_{21})(Q_{22})(Q_{23})$, $-B(Q_{21})(Q_{22})$, $-N(Q_{21})(Q_{22})$, - $S(=O)(Q_{21})$, $-S(=O)_2(Q_{21})$, $-P(=O)(Q_{21})(Q_{22})$, and $-P(=S)$ $(Q_{21})(Q_{22})$, and

$Q_1$ to $Q_3$, $Q_{21}$ to $Q_{23}$, and $Q_{31}$ to $Q_{33}$ are each independently selected from hydrogen, deuterium, -F, -Cl, -Br, -I, a hydroxyl group, a cyano group, a nitro group, an amidino group, a hydrazino group, a hydrazono group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, a biphenyl group, and a terphenyl group.

**12.** An apparatus comprising:

a thin-film transistor comprising a source electrode, a drain electrode, and an activation layer;
a sealing part; and
the organic light-emitting device (10, 20, 30, 40) according to any one of claims 1 to 11,
wherein the first electrode (110) of the organic light-emitting device (10, 20, 30, 40) is electrically connected to the source electrode or the drain electrode of the thin-film transistor.

**Patentansprüche**

**1.** Organische lichtemittierende Vorrichtung (10, 20, 30, 40), umfassend:

eine erste Elektrode (110);
eine zweite Elektrode (190); und
eine organische Schicht (150) zwischen der ersten Elektrode (110) und der zweiten Elektrode (190), wobei:

die organische Schicht (150) eine Emissionsschicht umfasst,
die Emissionsschicht eine erste Verbindung, eine zweite Verbindung, eine dritte Verbindung und eine vierte Verbindung umfasst,
die erste Verbindung durch die Formel 1 dargestellt wird;
die zweite Verbindung durch die Formel 2A oder die Formel 2B dargestellt wird;
die dritte Verbindung durch die Formel 3 dargestellt wird;
die vierte Verbindung durch eine der Formeln 4-1 bis 4-3 dargestellt wird; und
die erste Verbindung, die zweite Verbindung, die dritte Verbindung und die vierte Verbindung voneinander verschieden sind:

<Formel 1>

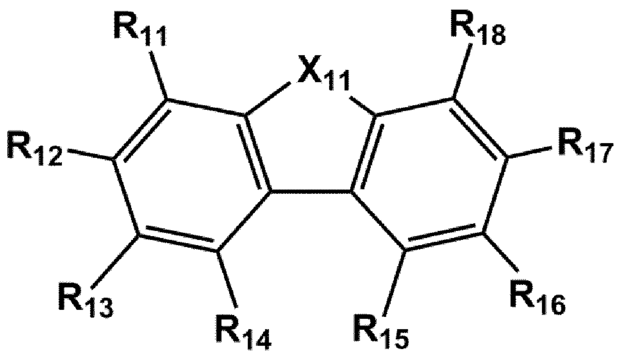

<Formel 2A>

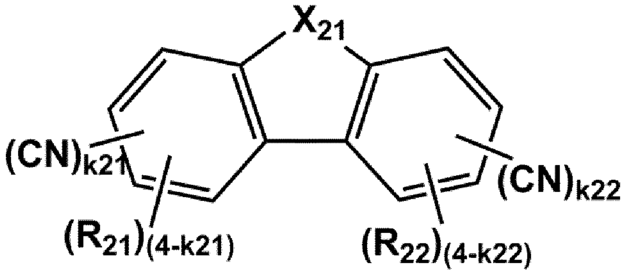

<Formel 2B>

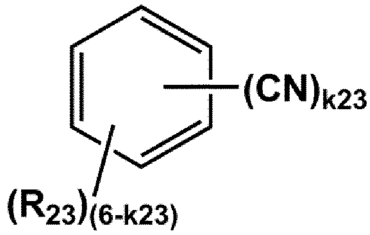

<Formel 3> $M_{31}\ (L_{31})_{n31}(L_{32})_{n32}$

<Formel 3A>

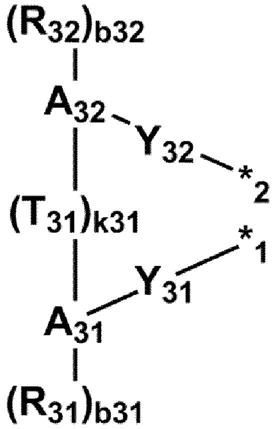

<Formel 3B>

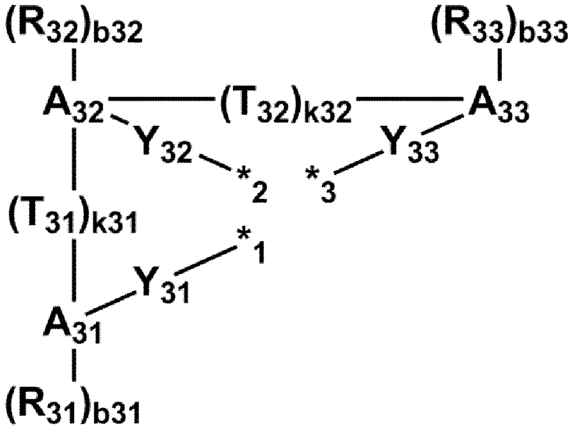

<Formel 3C>

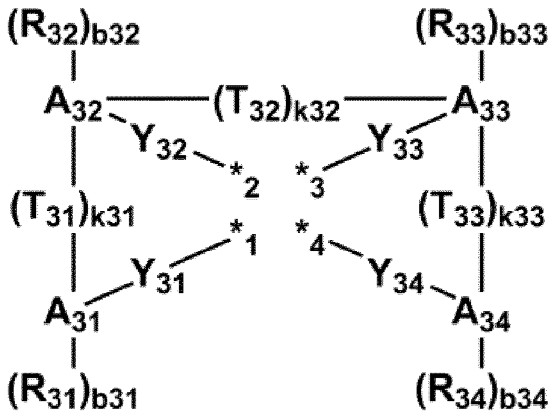

<Formel 3D>

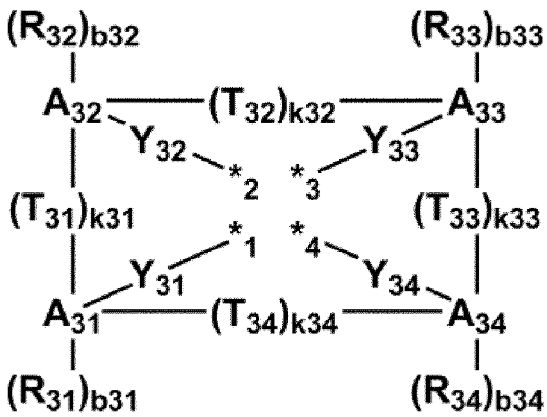

<Formel 4-1> $(D_{41})_{n41}\text{-}(L_{41})_{a41}\text{-}(A_{41})\ m41$

<Formel 4-2> $(D_{41})_{n41}\text{-}(L_{41})_{a41}\text{-}(A_{41})_{m41}\text{-}(L_{42})_{a42}\text{-}(D_{42})_{n42}$

<Formel 4-3> $(A_{41})_{m41}\text{-}(L_{41})_{a41}\text{-}(D_{41})_{n41}\text{-}(L_{42})_{a42}\text{-}(A_{42})_{m42}$

wobei in Formel 1 $X_{11}$ ausgewählt ist aus O, S, $N(R_{19})$ und $C(R_{19})(R_{20})$;
$R_{11}$ bis $R_{20}$ jeweils unabhängig ausgewählt sind aus:

einer Gruppe, dargestellt durch *-$(L_{11})_{a11}$-$A_{11}$, Wasserstoff, Deuterium, einer $C_1$-$C_{60}$-Alkylgruppe, einer $\pi$-elektronenverarmten stickstofffreien cyclischen Gruppe, -$C(Q_1)(Q_2)(Q_3)$, -$Si(Q_1)(Q_2)(Q_3)$, -$B(Q_1)(Q_2)$ und -$N(Q_1)(Q_2)$;

einer $\pi$-elektronenverarmten stickstofffreien cyclischen Gruppe, substituiert mit mindestens einer, ausgewählt aus Deuterium, einer $C_1$-$C_{60}$-Alkylgruppe, einer $\pi$-elektronenverarmten stickstofffreien cyclischen Gruppe, -$C(Q_{31})(Q_{32})(Q_{33})$, -$Si(Q_{31})(Q_{32})(Q_{33})$, -$B(Q_{31})(Q_{32})$ und -$N(Q_{31})(Q_{32})$; und

einer $\pi$-elektronenverarmten stickstofffreien cyclischen Gruppe, substituiert mit einer $\pi$-elektronenverarmten stickstofffreien cyclischen Gruppe, substituiert mit mindestens einer, ausgewählt aus Deuterium, einer $C_1$-$C_{60}$-Alkylgruppe, einer $\pi$-elektronenverarmten stickstofffreien cyclischen Gruppe, -$C(Q_{21})(Q_{22})(Q_{23})$, -$Si(Q_{21})(Q_{22})(Q_{23})$, -$B(Q_{21})(Q_{22})$ und -$N(Q_{21})(Q_{22})$,

$L_{11}$ ausgewählt ist aus:

einer $\pi$-elektronenverarmten stickstofffreien cyclischen Gruppe, -$C(Q_1)(Q_2)$-, -$Si(Q_1)(Q_2)$-, -$B(Q_1)$- und -$N(Q_1)$-; und

einer $\pi$-elektronenverarmten stickstofffreien cyclischen Gruppe, substituiert mit mindestens einer, ausgewählt aus: Deuterium, einer $C_1$-$C_{60}$-Alkylgruppe, einer $\pi$-elektronenverarmten stickstofffreien cyclischen Gruppe, -$C(Q_{31})(Q_{32})(Q_{33})$, -$Si(Q_{31})(Q_{32})(Q_{33})$, -$B(Q_{31})(Q_{32})$ und -$N(Q_{31})(Q_{32})$,

a11 ausgewählt ist aus 1, 2 und 3 und

$A_{11}$ ausgewählt ist aus:

einer $\pi$-elektronenverarmten stickstofffreien cyclischen Gruppe;

einer $\pi$-elektronenverarmten stickstofffreien cyclischen Gruppe, substituiert mit mindestens einer, ausgewählt aus Deuterium, einer $C_1$-$C_{60}$-Alkylgruppe, einer $\pi$-elektronenverarmten stickstofffreien cyclischen Gruppe, -$C(Q_{31})(Q_{32})(Q_{33})$, -$Si(Q_{31})(Q_{32})(Q_{33})$, -$B(Q_{31})(Q_{32})$ und -$N(Q_{31})(Q_{32})$, und

einer $\pi$-elektronenverarmten stickstofffreien cyclischen Gruppe, substituiert mit einer $\pi$-elektronenverarmten stickstofffreien cyclischen Gruppe, substituiert mit mindestens einer, ausgewählt aus Deuterium, einer $C_1$-$C_{60}$-Alkylgruppe, einer $\pi$-elektronenverarmten stickstofffreien cyclischen Gruppe, -$C(Q_{21})(Q_{22})(Q_{23})$, -$Si(Q_{21})(Q_{22})(Q_{23})$, -$B(Q_{21})(Q_{22})$ und -$N(Q_{21})(Q_{22})$,

wobei in den Formeln 2A und 2B,

$X_{21}$ ausgewählt ist aus O, S, $N(R_{24})$ und $C(R_{24})(R_{25})$,

k21 und k22 jeweils unabhängig ausgewählt sind aus 0, 1, 2, 3 und 4, wobei die Summe von k21 und k22 1 oder mehr beträgt,

k23 ausgewählt ist aus 1, 2, 3, 4, 5 und 6,

$R_{21}$ bis $R_{25}$ jeweils unabhängig ausgewählt sind aus:

einer Gruppe, dargestellt durch *-$(L_{21})_{a21}$-$A_{21}$, Wasserstoff, Deuterium, -F, einer Cyanogruppe, einer $C_1$-$C_{60}$-Alkylgruppe, einer $\pi$-elektronenverarmten stickstoffhaltigen cyclischen Gruppe, einer $\pi$-elektronenverarmten stickstofffreien cyclischen Gruppe, -$C(Q_1)(Q_2)(Q_3)$, -$Si(Q_1)(Q_2)(Q_3)$, -$B(Q_1)(Q_2)$, -$N(Q_1)(Q_2)$, -$S(=O)(Q_1)$, -$S(=O)_2(Q_1)$, -$P(=O)(Q_1)(Q_2)$ und -$P(=S)(Q_1)(Q_2)$;

einer $\pi$-elektronenverarmten stickstoffhaltigen cyclischen Gruppe und einer $\pi$-elektronenverarmten stickstofffreien cyclischen Gruppe, jeweils substituiert mit mindestens einer, ausgewählt aus Deuterium, -F, einer Cyanogruppe, einer $C_1$-$C_{60}$-Alkylgruppe, einer $\pi$-elektronenverarmten stickstoffhaltigen cyclischen Gruppe, einer $\pi$-elektronenverarmten stickstofffreien cyclischen Gruppe, -$C(Q_{31})(Q_{32})(Q_{33})$, -$Si(Q_{31})(Q_{32})(Q_{33})$, -$B(Q_{31})(Q_{32})$, -$N(Q_{31})(Q_{32})$, -$S(=O)(Q_{31})$, -$S(=O)_2(Q_{31})$, -$P(=O)(Q_{31})(Q_{32})$ und -$P(=S)(Q_{31})(Q_{32})$; und

einer $\pi$-elektronenverarmten stickstoffhaltigen cyclischen Gruppe und einer $\pi$-elektronenverarmten stickstofffreien cyclischen Gruppe, jeweils substituiert mit mindestens einer, ausgewählt aus einer $\pi$-elektronenverarmten stickstoffhaltigen cyclischen Gruppe und einer $\pi$-elektronenverarmten stickstofffreien cyclischen Gruppe, die jeweils unabhängig substituiert sind mit mindestens einer, ausgewählt aus Deuterium, -F, einer Cyanogruppe, einer $C_1$-$C_{60}$-Alkylgruppe, einer $\pi$-elektronenverarmten stickstoffhaltigen cyclischen Gruppe, einer $\pi$-elektronenverarmten stickstofffreien cyclischen Gruppe, -$C(Q_{21})(Q_{22})(Q_{23})$, -$Si(Q_{21})(Q_{22})(Q_{23})$, -$B(Q_{21})(Q_{22})$, -$N(Q_{21})(Q_{22})$, -$S(=O)(Q_{21})$, -$S(=O)_2(Q_{21})$, -$P(=O)(Q_{21})(Q_{22})$ und -$P(=S)(Q_{21})(Q_{22})$,

$L_{21}$ ausgewählt ist aus:

einer π-elektronenverarmten stickstoffhaltigen cyclischen Gruppe, einer π-elektronenverarmten stickstofffreien cyclischen Gruppe, $-C(Q_1)(Q_2)-$, $-Si(Q_1)(Q_2)-$, $-B(Q_1)-$, $-N(Q_1)-$, $-S(=O)-$, $-S(=O)_2-$, $-P(=O)(Q_1)-$ und $-P(=S)(Q_1)-$; und

einer π-elektronenverarmten stickstoffhaltigen cyclischen Gruppe und einer π-elektronenverarmten stickstofffreien cyclischen Gruppe, jeweils substituiert mit mindestens einer, ausgewählt aus Deuterium, -F, einer Cyanogruppe, einer $C_1$-$C_{60}$-Alkylgruppe, einer π-elektronenverarmten stickstoffhaltigen cyclischen Gruppe, einer π-elektronenverarmten stickstofffreien cyclischen Gruppe, $-C(Q_{31})(Q_{32})(Q_{33})$, $-Si(Q_{31})(Q_{32})(Q_{33})$, $-B(Q_{31})(Q_{32})$, $-N(Q_{31})(Q_{32})$, $-S(=O)(Q_{31})$, $-S(=O)_2(Q_{31})$, $-P(=O)(Q_{31})(Q_{32})$ und $-P(=S)(Q_{31})(Q_{32})$;

a21 ausgewählt ist aus 1, 2 und 3 und

$A_{21}$ ausgewählt ist aus:

einer π-elektronenverarmten stickstoffhaltigen cyclischen Gruppe und einer π-elektronenverarmten stickstofffreien cyclischen Gruppe;

einer π-elektronenverarmten stickstoffhaltigen cyclischen Gruppe und einer π-elektronenverarmten stickstofffreien cyclischen Gruppe, jeweils substituiert mit mindestens einer, ausgewählt aus Deuterium, -F, einer Cyanogruppe, einer $C_1$-$C_{60}$-Alkylgruppe, einer π-elektronenverarmten stickstoffhaltigen cyclischen Gruppe, einer π-elektronenverarmten stickstofffreien cyclischen Gruppe, $-C(Q_{31})(Q_{32})(Q_{33})$, $-Si(Q_{31})(Q_{32})(Q_{33})$, $-B(Q_{31})(Q_{32})$, $-N(Q_{31})(Q_{32})$, $-S(=O)(Q_{31})$, $-S(=O)_2(Q_{31})$, $-P(=O)(Q_{31})(Q_{32})$ und $-P(=S)(Q_{31})(Q_{32})$; und

einer π-elektronenverarmten stickstoffhaltigen cyclischen Gruppe und einer π-elektronenverarmten stickstofffreien cyclischen Gruppe, jeweils substituiert mit mindestens einer, ausgewählt aus einer π-elektronenverarmten stickstoffhaltigen cyclischen Gruppe und einer π-elektronenverarmten stickstofffreien cyclischen Gruppe, jeweils unabhängig substituiert mit mindestens einer, ausgewählt aus Deuterium, -F, einer Cyanogruppe, einer $C_1$-$C_{60}$-Alkylgruppe, einer π-elektronenverarmten stickstoffhaltigen cyclischen Gruppe, einer π-elektronenverarmten stickstofffreien cyclischen Gruppe, $-C(Q_{21})(Q_{22})(Q_{23})$, $-Si(Q_{21})(Q_{22})(Q_{23})$, $-B(Q_{21})(Q_{22})$, $-N(Q_{21})(Q_{22})$, $-S(=O)(Q_{21})$, $-S(=O)_2(Q_{21})$, $-P(=O)(Q_{21})(Q_{22})$ und $-P(=S)(Q_{21})(Q_{22})$,

wobei in Formel 3,

$M_{31}$ ausgewählt ist aus den Übergangsmetallen der Periode 4, der Periode 5 und der Periode 6 des Periodensystems der Elemente,

$L_{31}$ ein Ligand ist, dargestellt durch einem, ausgewählt aus den Formeln 3A bis 3D,

$L_{32}$ ausgewählt ist aus einem einzähnigen Liganden, einem zweizähnigen Liganden und einem dreizähnigen Liganden,

n31 1 oder 2 ist, und

n32 ausgewählt ist aus 0, 1, 2, 3 und 4,

wobei in den Formeln 3A bis 3D,

$A_{31}$ bis $A_{34}$ jeweils unabhängig ausgewählt sind aus einer carbocyclischen $C_5$-$C_{30}$-Gruppe und einer heterocyclischen $C_1$-$C_{30}$-Gruppe,

$T_{31}$ bis $T_{34}$ jeweils unabhängig ausgewählt sind aus einer Einfachbindung, einer Doppelbindung, *-O-*', *-S-*', *-C(=O)-*', *-S(=O)-*', $*-C(R_{35})(R_{36})-*'$, $*-C(R_{35})=C(R_{36})-*'$, $*-C(R_{35})=*'$, $*-Si(R_{35})(R_{36})-*'$, $*-B(R_{35})-*'$, $*-N(R_{35})-*'$ und $*-P(R_{35})-*'$,

k31 bis k34 jeweils unabhängig ausgewählt sind aus 1, 2 und 3,

$Y_{31}$ bis $Y_{34}$ jeweils unabhängig ausgewählt sind aus einer Einfachbindung, *-O-*', *-S-*', $*-C(R_{37})(R_{38})-*'$, $*-Si(R_{37})(R_{38})-*'$, $*-B(R_{37})-*'$, $*-N(R_{37})-*'$ und $*-P(R_{37})-*'$,

$*_1$, $*_2$, $*_3$ und $*_4$ jeweils eine Bindungsstelle zu $M_{31}$ anzeigen,

$R_{31}$ bis $R_{38}$ jeweils unabhängig ausgewählt sind aus Wasserstoff, Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer substituierten oder unsubstituierten $C_1$-$C_{60}$-Alkylgruppe, einer substituierten oder unsubstituierten $C_2$-$C_{60}$-Alkenylgruppe, einer substituierten oder unsubstituierten $C_2$-$C_{60}$-Alkinylgruppe, einer substituierten oder unsubstituierten $C_1$-$C_{60}$-Alkoxygruppe, einer substituierten oder unsubstituierten $C_3$-$C_{10}$-Cycloalkylgruppe, einer substituierten oder unsubstituierten $C_1$-$C_{10}$-Heterocycloalkylgruppe, einer substituierten oder unsubstituierten $C_3$-$C_{10}$-Cycloalkenylgruppe, einer substituierten oder unsubstituierten $C_1$-$C_{10}$-Heterocycloalkenylgruppe, einer substituierten oder unsubstituierten $C_6$-$C_{60}$-Arylgruppe, einer substituierten oder unsubstituierten $C_6$-$C_{60}$-Aryloxygruppe, einer substituierten oder un-

substituierten $C_6$-$C_{60}$-Arylthiogruppe, einer substituierten oder unsubstituierten $C_1$-$C_{60}$-Heteroarylgruppe, einer substituierten oder unsubstituierten einwertigen nichtaromatischen kondensierten polycyclischen Gruppe, einer substituierten oder unsubstituierten einwertigen nichtaromatischen kondensierten heteropolycyclischen Gruppe, $-C(Q_1)(Q_2)(Q_3)$, $-Si(Q_1)(Q_2)(Q_3)$, $-B(Q_1)(Q_2)$, $-N(Q_1)(Q_2)$, $-P(Q_1)(Q_2)$, $-C(=O)(Q_1)$, $-S(=O)(Q_1)$, $-S(=O)_2(Q_1)$, $-P(=O)(Q_1)(Q_2)$ und $-P(=S)(Q_1)(Q_2)$, wobei $R_{31}$ bis $R_{38}$ optional miteinander verbunden sind, um eine substituierte oder unsubstituierte carbocyclische $C_5$-$C_{60}$-Gruppe oder eine substituierte oder unsubstituierte heterocyclische $C_1$-$C_{60}$-Gruppe zu bilden, und

b31 bis b34 jeweils unabhängig eine ganze Zahl von 0 bis 10 sind,

wobei in den Formeln 4-1 bis 4-3,

$A_{41}$ und $A_{42}$ jeweils unabhängig ausgewählt sind aus einer Gruppe, dargestellt durch Formel 12, $-Si(Q_1)(Q_2)(Q_3)$, $-B(Q_1)(Q_2)$ und $-N(Q_1)(Q_2)$:

<Formel 12>

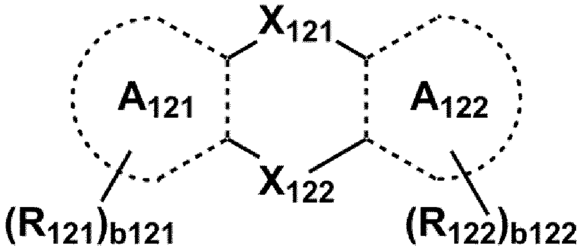

wobei in Formel 12,

$X_{121}$ ausgewählt ist aus O, S, $N(R_{123})$ und $C(R_{123})(R_{124})$,

$X_{122}$ ausgewählt ist aus einer Einfachbindung, O, S, $N(R_{125})$ und $C(R_{125})(R_{126})$,

$A_{121}$ und $A_{122}$ jeweils unabhängig ausgewählt sind aus einer Benzolgruppe, einer Naphthalingruppe, einer Phenalengruppe, einer Anthracengruppe, einer Fluoranthengruppe, einer Triphenylengruppe, einer Phenanthrengruppe, einer Pyrengruppe, einer Chrysengruppe, einer Perylengruppe, einer Fluorengruppe, einer Carbazolgruppe, einer Dibenzofurangruppe und einer Dibenzothiophengruppe,

$R_{121}$ bis $R_{126}$ jeweils unabhängig ausgewählt sind aus:

einer Bindungsstelle, Wasserstoff, Deuterium, einer $C_1$-$C_{20}$-Alkylgruppe, einer Phenylgruppe, einer Biphenylgruppe, einer Terphenylgruppe, einer Naphthylgruppe, einer Phenanthrenylgruppe, einer Triphenylenylgruppe, einer Chrysenylgruppe, einer Fluoranthenylgruppe, einer Fluorenylgruppe, einer Carbazolylgruppe, einer Dibenzofuranylgruppe, einer Dibenzothiophenylgruppe, einer Benzofluorenylgruppe, einer Benzocarbazolylgruppe, einer Benzonaphthofuranylgruppe, einer Benzonaphthothiophenylgruppe, einer Dibenzofluorenylgruppe, einer Dibenzocarbazolylgruppe, einer Dinaphthofuranylgruppe, einer Dinaphthothiophenylgruppe, $-Si(Q_{31})(Q_{32})(Q_{33})$, $-B(Q_{31})(Q_{32})$ und $-N(Q_{31})(Q_{32})$; und

einer Phenylgruppe, einer Biphenylgruppe, einer Terphenylgruppe, einer Naphthylgruppe, einer Phenanthrenylgruppe, einer Triphenylenylgruppe, einer Chrysenylgruppe, einer Fluoranthenylgruppe, einer Fluorenylgruppe, einer Carbazolylgruppe, einer Dibenzofuranylgruppe, einer Dibenzothiophenylgruppe, einer Benzofluorenylgruppe, einer Benzocarbazolylgruppe, einer Benzonaphthofuranylgruppe, einer Benzonaphthothiophenylgruppe, einer Dibenzofluorenylgruppe, einer Dibenzocarbazolylgruppe, einer Dinaphthofuranylgruppe und einer Dinaphthothiophenylgruppe, jeweils substituiert mit mindestens einer, ausgewählt aus Deuterium, einer $C_1$-$C_{20}$-Alkylgruppe, einer Phenylgruppe, einer Biphenylgruppe, einer Terphenylgruppe, einer Naphthylgruppe, einer Phenanthrenylgruppe, einer Triphenylenylgruppe, einer Chrysenylgruppe, einer Fluoranthenylgruppe, einer Fluorenylgruppe, einer Carbazolylgruppe, einer Dibenzofuranylgruppe, einer Dibenzothiophenylgruppe, einer Benzofluorenylgruppe, einer Benzocarbazolylgruppe, einer Benzonaphthofuranylgruppe, einer Benzonaphthothiophenylgruppe, einer Dibenzofluorenylgruppe, einer Dibenzocarbazolylgruppe, einer Dinaphthofuranylgruppe, einer Dinaphthothiophenylgruppe, $-Si(Q_{21})(Q_{22})(Q_{23})$, $-B(Q_{21})(Q_{22})$ und $-N(Q_{21})(Q_{22})$, wobei $R_{123}$ und $R_{124}$ optional miteinander verbunden sind, um eine $\pi$-elektronenverarmte stickstofffreie cyclische Gruppe zu bilden, $R_{125}$ und $R_{126}$ optional miteinander verbunden sind, um eine $\pi$-elektronenverarmte, stickstofffreie cyclische Gruppe zu bilden, und mindestens einer, ausgewählt aus $R_{121}$ bis $R_{126}$, die Bindungsstelle ist, und

b121 und b122 jeweils unabhängig ausgewählt sind aus 1, 2, 3, 4, 5 und 6,
m41 und m42 jeweils unabhängig ausgewählt sind aus 1, 2 und 3,

$D_{41}$ und $D_{42}$ jeweils unabhängig ausgewählt sind aus:

-F, einer Cyanogruppe, einer Pyrazolgruppe, einer Imidazolgruppe, einer Triazolgruppe, einer Oxazolgruppe, einer Isoxazolgruppe, einer Oxadiazolgruppe, einer Isozadiazolgruppe, einer Thiazolgruppe, einer Isothiazolgruppe, einer Thiadiazolgruppe, einer Isothiadiazolgruppe, einer Pyridingruppe, einer Pyrazingruppe, einer Pyridazingruppe, einer Pyrimidingruppe, einer Triazingruppe, einer Chinolingruppe, einer Isochinolingruppe, einer Naphthyridingruppe, einer Chinoxalingruppe, einer Chinazolingruppe und einer Gruppe, dargestellt durch Formeln 13-1 bis 13-3;
einer Pyrazolgruppe, einer Imidazolgruppe, einer Triazolgruppe, einer Oxazolgruppe, einer Isoxazolgruppe, einer Oxadiazolgruppe, einer Isozadiazolgruppe, einer Thiazolgruppe, einer Isothiazolgruppe, einer Thiadiazolgruppe, einer Isothiadiazolgruppe, einer Pyridingruppe, einer Pyrazingruppe, einer Pyridazingruppe, einer Pyrimidingruppe, einer Triazingruppe, einer Chinolingruppe, einer Isochinolingruppe, einer Naphthyridingruppe, einer Chinoxalingruppe und einer Chinazolingruppe, jeweils substituiert mit mindestens einer, ausgewählt aus Deuterium, -F, einer Cyanogruppe, einer $C_1$-$C_{20}$-Alkylgruppe, einer Phenylgruppe, einer Biphenylgruppe, einer Terphenylgruppe, einer Naphthylgruppe, einer Phenanthrenylgruppe, einer Triphenylenylgruppe, einer Chrysenylgruppe, einer Fluoranthenylgruppe, einer Fluorenylgruppe, einer Carbazolylgruppe, einer Dibenzofuranylgruppe, einer Dibenzothiophenylgruppe, einer Benzofluorenylgruppe, einer Benzocarbazolylgruppe, einer Benzonaphthofuranylgruppe, einer Benzonaphthothiophenylgruppe, einer Dibenzofluorenylgruppe, einer Dibenzocarbazolylgruppe, einer Dinaphthofuranylgruppe, einer Dinaphthothiophenylgruppe, einer Pyrazolylgruppe, einer Imidazolylgruppe, einer Triazolylgruppe, einer Oxazolylgruppe, einer Isoxazolylgruppe, einer Oxadiazolylgruppe, einer Isoxadiazolylgruppe, einer Thiazolylgruppe, einer Isothiazolylgruppe, einer Thiadiazolylgruppe, einer Isothiadiazolylgruppe, einer Pyridinylgruppe, einer Pyrazinylgruppe, einer Pyridazinylgruppe, einer Pyrimidinylgruppe, einer Triazinylgruppe, einer Chinolinylgruppe, einer Isochinolinylgruppe, einer Naphthyridinylgruppe, einer Chinoxalinylgruppe und einer Chinazolinylgruppe;
einer Pyrazolgruppe, einer Imidazolgruppe, einer Triazolgruppe, einer Oxazolgruppe, einer Isoxazolgruppe, einer Oxadiazolgruppe, einer Isozadiazolgruppe, einer Thiazolgruppe, einer Isothiazolgruppe, einer Thiadiazolgruppe, einer Isothiadiazolgruppe, einer Pyridingruppe, einer Pyrazingruppe, einer Pyridazingruppe, einer Pyrimidingruppe, einer Triazingruppe, einer Chinolingruppe, einer Isochinolingruppe, einer Naphthyridingruppe, einer Chinoxalingruppe und einer Chinazolingruppe, jeweils substituiert mit mindestens einer, ausgewählt aus einer $C_1$-$C_{20}$-Alkylgruppe, einer Phenylgruppe, einer Biphenylgruppe, einer Terphenylgruppe, einer Naphthylgruppe, einer Phenanthrenylgruppe, einer Triphenylenylgruppe, einer Chrysenylgruppe, einer Fluoranthenylgruppe, einer Fluorenylgruppe, einer Carbazolylgruppe, einer Dibenzofuranylgruppe, einer Dibenzothiophenylgruppe, einer Benzofluorenylgruppe, einer Benzocarbazolylgruppe, einer Benzonaphthofuranylgruppe, einer Benzonaphthothiophenylgruppe, einer Dibenzofluorenylgruppe, einer Dibenzocarbazolylgruppe, einer Dinaphthofuranylgruppe, einer Dinaphthothiophenylgruppe, einer Pyrazolylgruppe, einer Imidazolylgruppe, einer Triazolylgruppe, einer Oxazolylgruppe, einer Isoxazolylgruppe, einer Oxadiazolylgruppe, einer Isoxadiazolylgruppe, einer Thiazolylgruppe, einer Isothiazolylgruppe, einer Thiadiazolylgruppe, einer Isothiadiazolylgruppe, einer Pyridinylgruppe, einer Pyrazinylgruppe, einer Pyridazinylgruppe, einer Pyrimidinylgruppe, einer Triazinylgruppe, einer Chinolinylgruppe, einer Isochinolinylgruppe, einer Naphthyridinylgruppe, einer Chinoxalinylgruppe und einer Chinazolinylgruppe, die jeweils unabhängig substituiert sind mit mindestens einer, ausgewählt aus Deuterium, -F, einer Cyanogruppe, einer $C_1$-$C_{20}$-Alkylgruppe, einer Phenylgruppe, einer Biphenylgruppe, einer Terphenylgruppe, einer Naphthylgruppe, einer Phenanthrenylgruppe, einer Triphenylenylgruppe, einer Chrysenylgruppe, einer Fluoranthenylgruppe, einer Fluorenylgruppe, einer Carbazolylgruppe, einer Dibenzofuranylgruppe, einer Dibenzothiophenylgruppe, einer Benzofluorenylgruppe, einer Benzocarbazolylgruppe, einer Benzonaphthofuranylgruppe, einer Benzonaphthothiophenylgruppe, einer Dibenzofluorenylgruppe, einer Dibenzocarbazolylgruppe, einer Dinaphthofuranylgruppe, einer Dinaphthothiophenylgruppe, einer Pyrazolylgruppe, einer Imidazolylgruppe, einer Triazolylgruppe, einer Oxazolylgruppe, einer Isoxazolylgruppe, einer Oxadiazolylgruppe, einer Isoxadiazolylgruppe, einer Thiazolylgruppe, einer Isothiazolylgruppe, einer Thiadiazolylgruppe, einer Isothiadiazolylgruppe, einer Pyridinylgruppe, einer Pyrazinylgruppe, einer Pyridazinylgruppe, einer Pyrimidinylgruppe, einer Triazinylgruppe, einer Chinolinylgruppe, einer Isochinolinylgruppe, einer Naphthyridinylgruppe, einer Chinoxalinylgruppe und einer Chinazolinylgruppe;
einer $C_1$-$C_{20}$-Alkylgruppe, einer Benzolgruppe, einer Biphenylgruppe, einer Terphenylgruppe, einer

Naphthalingruppe, einer Phenanthrengruppe, einer Triphenylengruppe, einer Chrysengruppe, einer Fluoranthengruppe, einer Fluorengruppe, einer Carbazolgruppe, einer Dibenzofurangruppe, einer Dibenzothiophengruppe, einer Benzofluorengruppe, einer Benzocarbazolgruppe, einer Benzonaphthofurangruppe, einer Benzonaphthothiophengruppe, einer Dibenzofluorengruppe, einer Dibenzocarbazolgruppe, einer Dinaphthofurangruppe und einer Dinaphthothiophengruppe, jeweils substituiert mit mindestens einer, ausgewählt aus -F, einer Cyanogruppe, einer Pyrazolylgruppe, einer Imidazolylgruppe, einer Triazolylgruppe, einer Oxazolylgruppe, einer Isoxazolylgruppe, einer Oxadiazolylgruppe, einer Isoxadiazolylgruppe, einer Thiazolylgruppe, einer Isothiazolylgruppe, einer Thiadiazolylgruppe, einer Isothiadiazolylgruppe, einer Pyridinylgruppe, einer Pyrazinylgruppe, einer Pyridazinylgruppe, einer Pyrimidinylgruppe, einer Triazinylgruppe, einer Chinolinylgruppe, einer Isochinolinylgruppe, einer Naphthyridinylgruppe, einer Chinoxalinylgruppe und einer Chinazolinylgruppe;

einer $C_1$-$C_{20}$-Alkylgruppe, einer Benzolgruppe, einer Biphenylgruppe, einer Terphenylgruppe, einer Naphthalingruppe, einer Phenanthrengruppe, einer Triphenylengruppe, einer Chrysengruppe, einer Fluoranthengruppe, einer Fluorengruppe, einer Carbazolgruppe, einer Dibenzofurangruppe, einer Dibenzothiophengruppe, einer Benzofluorengruppe, einer Benzocarbazolgruppe, einer Benzonaphthofurangruppe, einer Benzonaphthothiophengruppe, einer Dibenzofluorengruppe, einer Dibenzocarbazolgruppe, einer Dinaphthofurangruppe und einer Dinaphthothiophengruppe, jeweils substituiert mit mindestens einer, ausgewählt aus einer Pyrazolylgruppe, einer Imidazolylgruppe, einer Triazolylgruppe, einer Oxazolylgruppe, einer Isoxazolylgruppe, einer Oxadiazolylgruppe, einer Isoxadiazolylgruppe, einer Thiazolylgruppe, einer Isothiazolylgruppe, einer Thiadiazolylgruppe, einer Isothiadiazolylgruppe, einer Pyridinylgruppe, einer Pyrazinylgruppe, einer Pyridazinylgruppe, einer Pyrimidinylgruppe, einer Triazinylgruppe, einer Chinolinylgruppe, einer Isochinolinylgruppe, einer Naphthyridinylgruppe, einer Chinoxalinylgruppe und einer Chinazolinylgruppe, die jeweils unabhängig substituiert sind mit mindestens einer, ausgewählt aus Deuterium, -F, einer Cyanogruppe, einer $C_1$-$C_{20}$-Alkylgruppe, einer Phenylgruppe, einer Biphenylgruppe, einer Terphenylgruppe, einer Naphthylgruppe, einer Phenanthrenylgruppe, einer Triphenylenylgruppe, einer Chrysenylgruppe, einer Fluoranthenylgruppe, einer Fluorenylgruppe, einer Carbazolylgruppe, einer Dibenzofuranylgruppe, einer Dibenzothiophenylgruppe, einer Benzofluorenylgruppe, einer Benzocarbazolylgruppe, einer Benzonaphthofuranylgruppe, einer Benzonaphthothiophenylgruppe, einer Dibenzofluorenylgruppe, einer Dibenzocarbazolylgruppe, einer Dinaphthofuranylgruppe, einer Dinaphthothiophenylgruppe, einer Pyrazolylgruppe, einer Imidazolylgruppe, einer Triazolylgruppe, einer Oxazolylgruppe, einer Isoxazolylgruppe, einer Oxadiazolylgruppe, einer Isoxadiazolylgruppe, einer Thiazolylgruppe, einer Isothiazolylgruppe, einer Thiadiazolylgruppe, einer Isothiadiazolylgruppe, einer Pyridinylgruppe, einer Pyrazinylgruppe, einer Pyridazinylgruppe, einer Pyrimidinylgruppe, einer Triazinylgruppe, einer Chinolinylgruppe, einer Isochinolinylgruppe, einer Naphthyridinylgruppe, einer Chinoxalinylgruppe und einer Chinazolinylgruppe; und

einer $C_1$-$C_{20}$-Alkylgruppe, einer Benzolgruppe, einer Biphenylgruppe, einer Terphenylgruppe, einer Naphthalingruppe, einer Phenanthrengruppe, einer Triphenylengruppe, einer Chrysengruppe, einer Fluoranthengruppe, einer Fluorengruppe, einer Carbazolgruppe, einer Dibenzofurangruppe, einer Dibenzothiophengruppe, einer Benzofluorengruppe, einer Benzocarbazolgruppe, einer Benzonaphthofurangruppe, einer Benzonaphthothiophengruppe, einer Dibenzofluorengruppe, einer Dibenzocarbazolgruppe, einer Dinaphthofurangruppe und einer Dinaphthothiophengruppe, jeweils substituiert mit mindestens einer, ausgewählt aus einer $C_1$-$C_{20}$-Alkylgruppe, einer Phenylgruppe, einer Biphenylgruppe, einer Terphenylgruppe, einer Naphthylgruppe, einer Phenanthrenylgruppe, einer Triphenylenylgruppe, einer Chrysenylgruppe, einer Fluoranthenylgruppe, einer Fluorenylgruppe, einer Carbazolylgruppe, einer Dibenzofuranylgruppe, einer Dibenzothiophenylgruppe, einer Benzofluorenylgruppe, einer Benzocarbazolylgruppe, einer Benzonaphthofuranylgruppe, einer Benzonaphthothiophenylgruppe, einer Dibenzofluorenylgruppe, einer Dibenzocarbazolylgruppe, einer Dinaphthofuranylgruppe und einer Dinaphthothiophenylgruppe, die jeweils unabhängig substituiert sind mit mindestens einer, ausgewählt aus -F, einer Cyanogruppe, einer Pyrazolylgruppe, einer Imidazolylgruppe, einer Triazolylgruppe, einer Oxazolylgruppe, einer Isoxazolylgruppe, einer Oxadiazolylgruppe, einer Isoxadiazolylgruppe, einer Thiazolylgruppe, einer Isothiazolylgruppe, einer Thiadiazolylgruppe, einer Isothiadiazolylgruppe, einer Pyridinylgruppe, einer Pyrazinylgruppe, einer Pyridazinylgruppe, einer Pyrimidinylgruppe, einer Triazinylgruppe, einer Chinolinylgruppe, einer Isochinolinylgruppe, einer Naphthyridinylgruppe, einer Chinoxalinylgruppe und einer Chinazolinylgruppe:

<Formel 13-1> <Formel 13-2> <Formel 13-3>

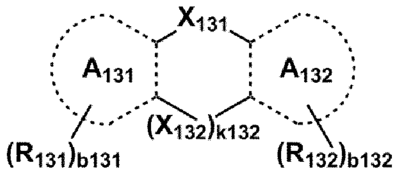

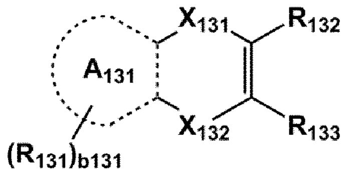

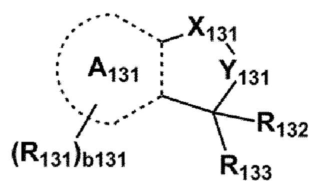

wobei in den Formeln 13-1 bis 13-3,
$X_{131}$ ausgewählt ist aus C(=O), S(=O), $S(=O)_2$, P(=O)($R_{134}$) und P(=S)($R_{134}$),
$X_{132}$ ausgewählt ist aus O, S, C(=O), S(=O), $S(=O)_2$, P(=O)($R_{135}$) und P(=S)($R_{135}$),
k132 0 oder 1 ist,
$Y_{131}$ ausgewählt ist aus O und S,
$A_{131}$ und $A_{132}$ jeweils unabhängig ausgewählt sind aus einer Benzolgruppe, einer Naphthalingruppe, einer Phenalengruppe, einer Anthracengruppe, einer Fluoranthengruppe, einer Triphenylengruppe, einer Phenanthrengruppe, einer Pyrengruppe, einer Chrysengruppe, einer Perylengruppe, einer Fluorengruppe, einer Carbazolgruppe, einer Dibenzofurangruppe und einer Dibenzothiophengruppe,

$R_{131}$ bis $R_{135}$ jeweils unabhängig ausgewählt sind aus:

einer Bindungsstelle, Wasserstoff, Deuterium, -F, einer Cyanogruppe, einer $C_1$-$C_{20}$-Alkylgruppe, einer Phenylgruppe, einer Biphenylgruppe, einer Terphenylgruppe, einer Naphthylgruppe, einer Phenanthrenylgruppe, einer Triphenylenylgruppe, einer Chrysenylgruppe, einer Fluoranthenylgruppe, einer Fluorenylgruppe, einer Carbazolylgruppe, einer Dibenzofuranylgruppe, einer Dibenzothiophenylgruppe, einer Benzofluorenylgruppe, einer Benzocarbazolylgruppe, einer Benzonaphthofuranylgruppe, einer Benzonaphthothiophenylgruppe, einer Dibenzofluorenylgruppe, einer Dibenzocarbazolylgruppe, einer Dinaphthofuranylgruppe, einer Dinaphthothiophenylgruppe, einer Pyrazolylgruppe, einer Imidazolylgruppe, einer Triazolylgruppe, einer Oxazolylgruppe, einer Isoxazolylgruppe, einer Oxadiazolylgruppe, einer Isoxadiazolylgruppe, einer Thiazolylgruppe, einer Isothiazolylgruppe, einer Thiadiazolylgruppe, einer Isothiadiazolylgruppe, einer Pyridinylgruppe, einer Pyrazinylgruppe, einer Pyridazinylgruppe, einer Pyrimidinylgruppe, einer Triazinylgruppe, einer Chinolinylgruppe, einer Isochinolinylgruppe, einer Naphthyridinylgruppe, einer Chinoxalinylgruppe und einer Chinazolinylgruppe; und
einer $C_1$-$C_{20}$-Alkylgruppe, einer Phenylgruppe, einer Biphenylgruppe, einer Terphenylgruppe, einer Naphthylgruppe, einer Phenanthrenylgruppe, einer Triphenylenylgruppe, einer Chrysenylgruppe, einer Fluoranthenylgruppe, einer Fluorenylgruppe, einer Carbazolylgruppe, einer Dibenzofuranylgruppe, einer Dibenzothiophenylgruppe, einer Benzofluorenylgruppe, einer Benzocarbazolylgruppe, einer Benzonaphthofuranylgruppe, einer Benzonaphthothiophenylgruppe, einer Dibenzofluorenylgruppe, einer Dibenzocarbazolylgruppe, einer Dinaphthofuranylgruppe, einer Dinaphthothiophenylgruppe, einer Pyrazolylgruppe, einer Imidazolylgruppe, einer Triazolylgruppe, einer Oxazolylgruppe, einer Isoxazolylgruppe, einer Oxadiazolylgruppe, einer Isoxadiazolylgruppe, einer Thiazolylgruppe, einer Isothiazolylgruppe, einer Thiadiazolylgruppe, einer Isothiadiazolylgruppe, einer Pyridinylgruppe, einer Pyrazinylgruppe, einer Pyridazinylgruppe, einer Pyrimidinylgruppe, einer Triazinylgruppe, einer Chinolinylgruppe, einer Isochinolinylgruppe, einer Naphthyridinylgruppe, einer Chinoxalinylgruppe und einer Chinazolinylgruppe, jeweils substituiert mit mindestens einer, ausgewählt aus Deuterium, -F, einer Cyanogruppe, einer $C_1$-$C_{20}$-Alkylgruppe, einer Phenylgruppe, einer Biphenylgruppe, einer Terphenylgruppe, einer Naphthylgruppe, einer Phenanthrenylgruppe, einer Triphenylenylgruppe, einer Chrysenylgruppe, einer Fluoranthenylgruppe, einer Fluorenylgruppe, einer Carbazolylgruppe, einer Dibenzofuranylgruppe, einer Dibenzothiophenylgruppe, einer Benzofluorenylgruppe, einer Benzocarbazolylgruppe, einer Benzonaphthofuranylgruppe, einer Benzonaphthothiophenylgruppe, einer Dibenzofluorenylgruppe, einer Dibenzocarbazolylgruppe, einer Dinaphthofuranylgruppe, einer Dinaphthothiophenylgruppe, einer Pyrazolylgruppe, einer Imidazolylgruppe, einer Triazolylgruppe, einer Oxazolylgruppe, einer Isoxazolylgruppe, einer Oxadiazolylgruppe, einer Isoxadiazolylgruppe, einer Thiazolylgruppe, einer Isothiazolylgruppe, einer Thiadiazolylgruppe, einer Isothiadiazolylgruppe, einer Pyridinylgruppe, einer Pyrazinylgruppe, einer Pyridazinylgruppe, einer Pyrimidinylgruppe, einer Triazinylgruppe, einer Chinolinylgruppe, einer Isochinolinylgruppe, einer Naphthyridinylgruppe, einer Chinoxalinylgruppe und einer Chinazolinylgruppe, wobei mindestens einer, ausgewählt aus $R_{131}$ bis $R_{135}$, die Bindungsstelle ist, und
b131 und b132 jeweils unabhängig ausgewählt sind aus 1, 2, 3, 4, 5 und 6,
n41 und n42 jeweils unabhängig ausgewählt sind aus 1, 2 und 3,

$L_{41}$ und $L_{42}$ jeweils unabhängig ausgewählt sind aus:

einer Benzolgruppe, einer Naphthalingruppe, einer Phenalengruppe, einer Anthracengruppe, einer Fluoranthengruppe, einer Triphenylengruppe, einer Phenanthrengruppe, einer Pyrengruppe, einer Chrysengruppe, einer Perylengruppe, einer Fluorengruppe, einer Carbazolgruppe, einer Dibenzofurangruppe, einer Dibenzothiophengruppe, $-C(Q_1)(Q_2)-$ und $-Si(Q_1)(Q_2)-$; und
einer Benzolgruppe, einer Naphthalingruppe, einer Phenalengruppe, einer Anthracengruppe, einer Fluoranthengruppe, einer Triphenylengruppe, einer Phenanthrengruppe, einer Pyrengruppe, einer Chrysengruppe, einer Perylengruppe, einer Fluorengruppe, einer Carbazolgruppe, einer Dibenzofurangruppe und einer Dibenzothiophengruppe, jeweils substituiert mit mindestens einer, ausgewählt aus Deuterium, einer $C_1$-$C_{20}$-Alkylgruppe, einer Phenylgruppe, einer Biphenylgruppe, einer Terphenylgruppe, einer Naphthylgruppe, einer Phenanthrenylgruppe, einer Triphenylenylgruppe, einer Chrysenylgruppe, einer Fluoranthenylgruppe, einer Fluorenylgruppe, einer Carbazolylgruppe, einer Dibenzofuranylgruppe, einer Dibenzothiophenylgruppe, einer Benzofluorenylgruppe, einer Benzocarbazolylgruppe, einer Benzonaphthofuranylgruppe, einer Benzonaphthothiophenylgruppe, einer Dibenzofluorenylgruppe, einer Dibenzocarbazolylgruppe, einer Dinaphthofuranylgruppe, einer Dinaphthothiophenylgruppe, $-C(Q_{31})(Q_{32})(Q_{33})$ und $-Si(Q_{31})(Q_{32})(Q_{33})$,
a41 und a42 jeweils unabhängig ausgewählt sind aus 0, 1, 2 und 3, und
wobei in den Formeln 1, 2A, 2B, 3 und 4-1 bis 4-3,
$Q_1$ bis $Q_3$, $Q_{21}$ bis $Q_{23}$ und $Q_{31}$ bis $Q_{33}$ jeweils unabhängig ausgewählt sind aus Wasserstoff, Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer $C_1$-$C_{60}$-Alkylgruppe, einer $C_2$-$C_{60}$-Alkenylgruppe, einer $C_2$-$C_{60}$-Alkinylgruppe, einer $C_1$-$C_{60}$-Alkoxygruppe, einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_6$-$C_{60}$-Aryloxygruppe, einer $C_6$-$C_{60}$-Arylthiogruppe, einer $C_1$-$C_{60}$-Heteroarylgruppe, einer $C_1$-$C_{60}$-Heteroaryloxygruppe, einer $C_1$-$C_{60}$-Heteroarylthiogruppe, einer einwertigen nichtaromatischen kondensierten polycyclischen Gruppe, einer einwertigen nichtaromatischen kondensierten heteropolycyclischen Gruppe, einer Biphenylgruppe und einer Terphenylgruppe.

**2.** Organische lichtemittierende Vorrichtung (10, 20, 30, 40) nach Anspruch 1, wobei:

(i) die erste Verbindung, die zweite Verbindung und die dritte Verbindung im Wesentlichen kein Licht emittieren; und/oder
(ii) die vierte Verbindung Licht emittieren soll; und/oder
(iii) das Verhältnis eines von der vierten Verbindung emittierten Lichts zu einem gesamten von der Emissionsschicht emittierten Licht 80 % oder mehr beträgt; und/oder
(iv) mindestens einer von $R_{11}$ bis $R_{19}$ die durch $*-(L_{11})_{a11}-A_{11}$ dargestellte Gruppe ist; und/oder
(v) $X_{11}$ $N(R_{19})$ ist.

**3.** Organische lichtemittierende Vorrichtung (10, 20, 30, 40) nach Anspruch 1 oder Anspruch 2, wobei $A_{11}$ ausgewählt ist aus:

einer Phenylgruppe, einer Biphenylgruppe, einer Terphenylgruppe, einer Naphthylgruppe, einer Phenanthrenylgruppe, einer Triphenylenylgruppe, einer Chrysenylgruppe, einer Fluoranthenylgruppe, einer Fluorenylgruppe, einer Carbazolylgruppe, einer Dibenzofuranylgruppe, einer Dibenzothiophenylgruppe, einer Benzofluorenylgruppe, einer Benzocarbazolylgruppe, einer Benzonaphthofuranylgruppe, einer Benzonaphthothiophenylgruppe, einer Dibenzofluorenylgruppe, einer Dibenzocarbazolylgruppe, einer Dinaphthofuranylgruppe und einer Dinaphthothiophenylgruppe,
einer Phenylgruppe, einer Biphenylgruppe, einer Terphenylgruppe, einer Naphthylgruppe, einer Phenanthrenylgruppe, einer Triphenylenylgruppe, einer Chrysenylgruppe, einer Fluoranthenylgruppe, einer Fluorenylgruppe, einer Carbazolylgruppe, einer Dibenzofuranylgruppe, einer Dibenzothiophenylgruppe, einer Benzofluorenylgruppe, einer Benzocarbazolylgruppe, einer Benzonaphthofuranylgruppe, einer Benzonaphthothiophenylgruppe, einer Dibenzofluorenylgruppe, einer Dibenzocarbazolylgruppe, einer Dinaphthofuranylgruppe und einer Dinaphthothiophenylgruppe, jeweils substituiert mit mindestens einer, ausgewählt aus Deuterium, einer $C_1$-$C_{20}$-Alkylgruppe, einer Phenylgruppe, einer Biphenylgruppe, einer Terphenylgruppe, einer Naphthylgruppe, einer Phenanthrenylgruppe, einer Triphenylenylgruppe, einer Chrysenylgruppe, einer Fluoranthenylgruppe, einer Fluorenylgruppe, einer Carbazolylgruppe, einer Dibenzofuranylgruppe, einer Dibenzothiophenylgruppe,

einer Benzofluorenylgruppe, einer Benzocarbazolylgruppe, einer Benzonaphthofuranylgruppe, einer Benzonaphthothiophenylgruppe, einer Dibenzofluorenylgruppe, einer Dibenzocarbazolylgruppe, einer Dinaphthofuranylgruppe, einer Dinaphthothiophenylgruppe, $-C(Q_{31})(Q_{32})(Q_{33})$, $-Si(Q_{31})(Q_{32})(Q_{33})$, $-B(Q_{31})(Q_{32})$ und $-N(Q_{31})(Q_{32})$; und

einer Phenylgruppe, einer Biphenylgruppe, einer Terphenylgruppe, einer Naphthylgruppe, einer Phenanthrenylgruppe, einer Triphenylenylgruppe, einer Chrysenylgruppe, einer Fluoranthenylgruppe, einer Fluorenylgruppe, einer Carbazolylgruppe, einer Dibenzofuranylgruppe, einer Dibenzothiophenylgruppe, einer Benzofluorenylgruppe, einer Benzocarbazolylgruppe, einer Benzonaphthofuranylgruppe, einer Benzonaphthothiophenylgruppe, einer Dibenzofluorenylgruppe, einer Dibenzocarbazolylgruppe, einer Dinaphthofuranylgruppe und einer Dinaphthothiophenylgruppe, jeweils substituiert mit mindestens einer, ausgewählt aus einer Phenylgruppe, einer Biphenylgruppe, einer Terphenylgruppe, einer Naphthylgruppe, einer Phenanthrenylgruppe, einer Triphenylenylgruppe, einer Chrysenylgruppe, einer Fluoranthenylgruppe, einer Fluorenylgruppe, einer Carbazolylgruppe, einer Dibenzofuranylgruppe, einer Dibenzothiophenylgruppe, einer Benzofluorenylgruppe, einer Benzocarbazolylgruppe, einer Benzonaphthofuranylgruppe, einer Benzonaphthothiophenylgruppe, einer Dibenzofluorenylgruppe, einer Dibenzocarbazolylgruppe, einer Dinaphthofuranylgruppe und einer Dinaphthothiophenylgruppe, die jeweils unabhängig substituiert sind mit mindestens einer, ausgewählt aus Deuterium, einer $C_1$-$C_{20}$-Alkylgruppe, einer Phenylgruppe, einer Biphenylgruppe, einer Terphenylgruppe, einer Naphthylgruppe, einer Phenanthrenylgruppe, einer Triphenylenylgruppe, einer Chrysenylgruppe, einer Fluoranthenylgruppe, einer Fluorenylgruppe, einer Carbazolylgruppe, einer Dibenzofuranylgruppe, einer Dibenzothiophenylgruppe, einer Benzofluorenylgruppe, einer Benzocarbazolylgruppe, einer Benzonaphthofuranylgruppe, einer Benzonaphthothiophenylgruppe, einer Dibenzofluorenylgruppe, einer Dibenzocarbazolylgruppe, einer Dinaphthofuranylgruppe, einer Dinaphthothiophenylgruppe, $-C(Q_{21})(Q_{22})(Q_{23})$, $-Si(Q_{21})(Q_{22})(Q_{23})$, $-B(Q_{21})(Q_{22})$ und $-N(Q_{21})(Q_{22})$.

**4.** Organische lichtemittierende Vorrichtung (10, 20, 30, 40) nach einem der Ansprüche 1 bis 3, wobei $A_{11}$ durch eine der Formeln 8-1 bis 8-5 dargestellt ist:

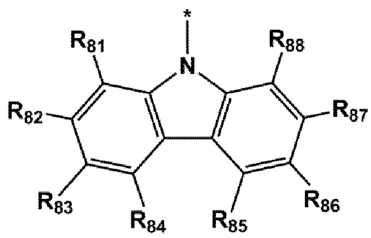

8-1

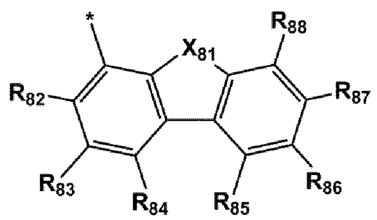

8-2

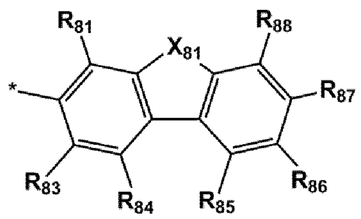

8-3

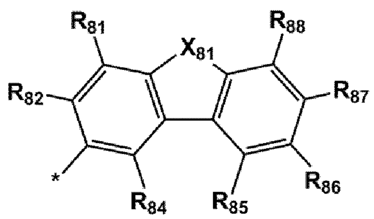

8-4

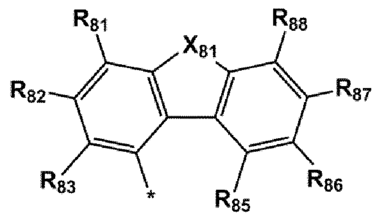

8-5

wobei in den Formeln 8-1 bis 8-5,

$X_{81}$ ausgewählt ist aus O, S, $N(R_{89})$ und $C(R_{89})(R_{90})$,

$R_{81}$ bis $R_{90}$ jeweils unabhängig ausgewählt sind aus Wasserstoff, Deuterium, einer $C_1$-$C_{20}$-Alkylgruppe, einer Phenylgruppe, einer Biphenylgruppe, einer Terphenylgruppe, einer Fluorenylgruppe, einer Carbazolylgruppe, einer Dibenzofuranylgruppe und einer Dibenzothiophenylgruppe, und

* eine Bindungsstelle zu einem benachbarten Atom anzeigt.

**5.** Organische lichtemittierende Vorrichtung (10, 20, 30, 40) nach einem der Ansprüche 1 bis 4, wobei die erste Verbindung durch eine der Formeln 1-1 bis 1-5 dargestellt ist:

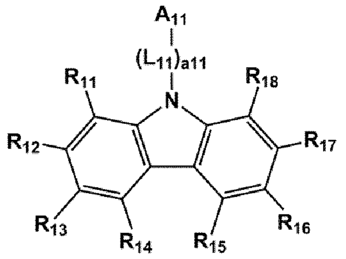

1-1

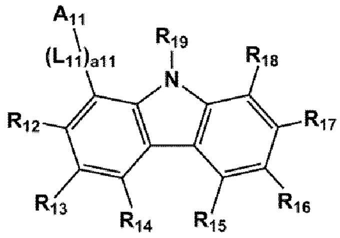

1-2

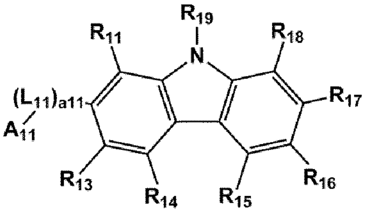

1-3

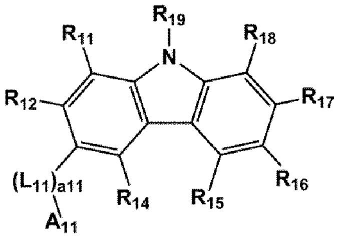

1-4

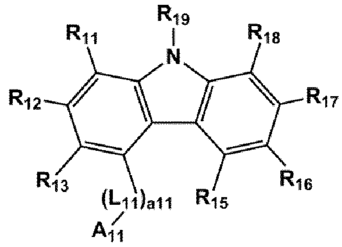

1-5

wobei in den Formeln 1-1 bis 1-5,
$L_{11}$, a11, $A_{11}$ und $R_{11}$ bis $R_{19}$ jeweils wie in Verbindung mit Formel 1 definiert sind.

**6.** Organische lichtemittierende Vorrichtung (10, 20, 30, 40) nach einem der Ansprüche 1 bis 5, wobei:

mindestens einer von $R_{21}$, $R_{22}$, $R_{24}$ und $R_{25}$ in Formel 2A die durch *-$(L_{21})_{a21}$-$A_{21}$ dargestellte Gruppe ist und mindestens ein $R_{23}$ aus einer Anzahl von (6-k23) in Formel 2B die durch *-$(L_{21})_{a21}$-$A_{21}$ dargestellte Gruppe ist.

**7.** Organische lichtemittierende Vorrichtung (10, 20, 30, 40) nach einem der Ansprüche 1 bis 6, wobei $A_{21}$ ausgewählt ist aus:

einer Phenylgruppe, einer Biphenylgruppe, einer Terphenylgruppe, einer Naphthylgruppe, einer Phenanthrenylgruppe, einer Triphenylenylgruppe, einer Chrysenylgruppe, einer Fluoranthenylgruppe, einer Fluorenylgruppe, einer Carbazolylgruppe, einer Dibenzofuranylgruppe, einer Dibenzothiophenylgruppe, einer Pyridinylgruppe, einer Pyrazinylgruppe, einer Pyridazinylgruppe, einer Pyrimidinylgruppe, einer Triazinylgruppe, einer Chinolinylgruppe, einer Isochinolinylgruppe, einer Naphthyridinylgruppe, einer Chinoxalinylgruppe und einer Chinazolinylgruppe;
einer Phenylgruppe, einer Biphenylgruppe, einer Terphenylgruppe, einer Naphthylgruppe, einer Phenanthrenylgruppe, einer Triphenylenylgruppe, einer Chrysenylgruppe, einer Fluoranthenylgruppe, einer Fluorenylgruppe, einer Carbazolylgruppe, einer Dibenzofuranylgruppe, einer Dibenzothiophenylgruppe, einer Pyridinylgruppe, einer Pyrazinylgruppe, einer Pyridazinylgruppe, einer Pyrimidinylgruppe, einer Triazinylgruppe, einer Chinolinylgruppe, einer Isochinolinylgruppe, einer Naphthyridinylgruppe, einer Chinoxalinylgruppe und einer Chinazolinylgruppe, jeweils substituiert mit mindestens einer, ausgewählt aus Deuterium, -F, einer Cyanogruppe, einer $C_1$-$C_{20}$-Alkylgruppe, einer Phenylgruppe, einer Biphenylgruppe, einer Terphenylgruppe, einer Naphthylgruppe, einer Phenanthrenylgruppe, einer Triphenylenylgruppe, einer Chrysenylgruppe, einer Fluoranthenylgruppe, einer Fluorenylgruppe, einer Carbazolylgruppe, einer Dibenzofuranylgruppe, einer Dibenzothiophenylgruppe, einer Pyridinylgruppe, einer Pyrazinylgruppe, einer Pyridazinylgruppe, einer Pyrimidinylgruppe, einer Triazinylgruppe, einer Chinolinylgruppe, einer Isochinolinylgruppe, einer Naphthyridinylgruppe, einer Chinoxalinylgruppe, einer Chinazolinylgruppe, $-C(Q_{31})(Q_{32})(Q_{33})$, $-Si(Q_{31})(Q_{32})(Q_{33})$, $-B(Q_{31})(Q_{32})$, $-N(Q_{31})(Q_{32})$, $-S(=O)(Q_{31})$, $-S(=O)_2(Q_{31})$, $-P(=O)(Q_{31})(Q_{32})$ und $-P(=S)(Q_{31})(Q_{32})$; und
einer Phenylgruppe, einer Biphenylgruppe, einer Terphenylgruppe, einer Naphthylgruppe, einer Phenanthrenylgruppe, einer Triphenylenylgruppe, einer Chrysenylgruppe, einer Fluoranthenylgruppe, einer Fluorenylgruppe, einer Carbazolylgruppe, einer Dibenzofuranylgruppe, einer Dibenzothiophenylgruppe, einer Pyridinylgruppe, einer Pyrazinylgruppe, einer Pyridazinylgruppe, einer Pyrimidinylgruppe, einer Triazinylgruppe, einer Chinolinylgruppe, einer Isochinolinylgruppe, einer Naphthyridinylgruppe, einer Chinoxalinylgruppe und einer Chinazolinylgruppe, jeweils substituiert mit mindestens einer, ausgewählt aus einer Phenylgruppe, einer Biphenylgruppe, einer Terphenylgruppe, einer Naphthylgruppe, einer Phenanthrenylgruppe, einer Triphenylenylgruppe,

einer Chrysenylgruppe, einer Fluoranthenylgruppe, einer Fluorenylgruppe, einer Carbazolylgruppe, einer Dibenzofuranylgruppe, einer Dibenzothiophenylgruppe, einer Pyridinylgruppe, einer Pyrazinylgruppe, einer Pyridazinylgruppe, einer Pyrimidinylgruppe, einer Triazinylgruppe, einer Chinolinylgruppe, einer Isochinolinylgruppe, einer Naphthyridinylgruppe, einer Chinoxalinylgruppe und einer Chinazolinylgruppe, die jeweils unabhängig substituiert sind mit mindestens einer, ausgewählt aus Deuterium, -F, einer Cyanogruppe, einer $C_1$-$C_{20}$-Alkylgruppe, einer Phenylgruppe, einer Biphenylgruppe, einer Terphenylgruppe, einer Naphthylgruppe, einer Phenanthrenylgruppe, einer Triphenylenylgruppe, einer Chrysenylgruppe, einer Fluoranthenylgruppe, einer Fluorenylgruppe, einer Carbazolylgruppe, einer Dibenzofuranylgruppe, einer Dibenzothiophenylgruppe, einer Pyridinylgruppe, einer Pyrazinylgruppe, einer Pyridazinylgruppe, einer Pyrimidinylgruppe, einer Triazinylgruppe, einer Chinolinylgruppe, einer Isochinolinylgruppe, einer Naphthyridinylgruppe, einer Chinoxalinylgruppe, einer Chinazolinylgruppe, $-C(Q_{21})(Q_{22})(Q_{23})$, $-Si(Q_{21})(Q_{22})(Q_{23})$, $-B(Q_{21})(Q_{22})$, $-N(Q_{21})(Q_{22})$, $-S(=O)(Q_{21})$, $-S(=O)_2(Q_{21})$, $-P(=O)(Q_{21})(Q_{22})$ und $-P(=S)(Q_{21})(Q_{22})$.

**8.** Organische lichtemittierende Vorrichtung (10, 20, 30, 40) nach einem der Ansprüche 1 bis 7, wobei die zweite Verbindung durch Formel 2-1 oder Formel 2-2 dargestellt ist:

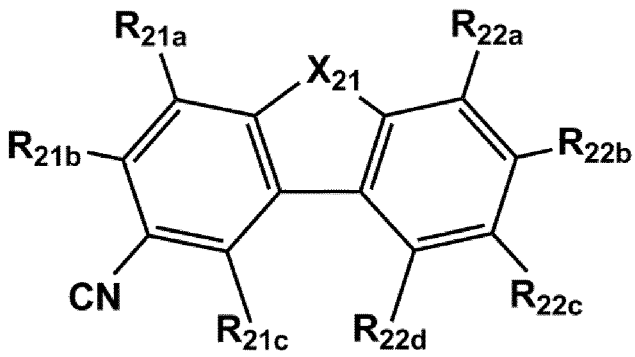

2-1

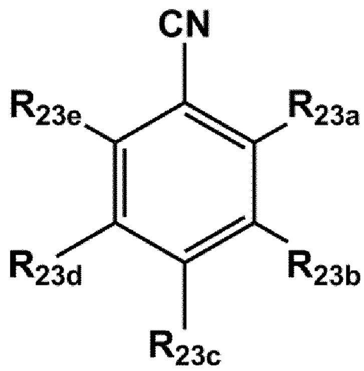

2-2

wobei in den Formeln 2-1 und 2-2,
$X_{21}$ ausgewählt ist aus O, S, $N(R_{24})$ und $C(R_{24})(R_{25})$,
$R_{21a}$ bis $R_{21c}$, $R_{22a}$ bis $R_{22d}$, $R_{23a}$ bis $R_{23e}$, $R_{24}$ und $R_{25}$ jeweils unabhängig ausgewählt sind aus:

einer Gruppe, dargestellt durch $*-(L_{21})_{a21}-A_{21}$, Wasserstoff, Deuterium, -F, einer Cyanogruppe, einer $C_1$-$C_{60}$-Alkylgruppe, einer $\pi$-elektronenverarmten stickstoffhaltigen cyclischen Gruppe, einer $\pi$-elektronenverarmten stickstofffreien cyclischen Gruppe, $-C(Q_1)(Q_2)(Q_3)$, $-Si(Q_1)(Q_2)(Q_3)$, $-B(Q_1)(Q_2)$, $-N(Q_1)(Q_2)$, $-S(=O)(Q_1)$, $-S(=O)_2(Q_1)$, $-P(=O)(Q_1)(Q_2)$ und $-P(=S)(Q_1)(Q_2)$;
einer $\pi$-elektronenverarmten stickstoffhaltigen cyclischen Gruppe und einer $\pi$-elektronenverarmten stickstofffreien cyclischen Gruppe, jeweils substituiert mit mindestens einer, ausgewählt aus Deuterium, -F, einer Cyanogruppe, einer $C_1$-$C_{60}$-Alkylgruppe, einer $\pi$-elektronenverarmten stickstoffhaltigen cyclischen Gruppe, einer $\pi$-elektronenverarmten stickstofffreien cyclischen Gruppe, $-C(Q_{31})(Q_{32})(Q_{33})$, $-Si(Q_{31})(Q_{32})(Q_{33})$, $-B(Q_{31})(Q_{32})$, $-N(Q_{31})(Q_{32})$, $-S(=O)(Q_{31})$, $-S(=O)_2(Q_{31})$, $-P(=O)(Q_{31})(Q_{32})$ und $-P(=S)(Q_{31})(Q_{32})$; und
einer $\pi$-elektronenverarmten stickstoffhaltigen cyclischen Gruppe und einer $\pi$-elektronenverarmten stickstofffreien cyclischen Gruppe, jeweils substituiert mit mindestens einer, ausgewählt aus einer $\pi$-elektronenverarmten stickstoffhaltigen cyclischen Gruppe und einer $\pi$-elektronenverarmten stickstofffreien cyclischen Gruppe, die jeweils unabhängig substituiert sind mit mindestens einer, ausgewählt aus Deuterium, -F, einer Cyanogruppe, einer $C_1$-$C_{60}$-Alkylgruppe, einer $\pi$-elektronenverarmten stickstoffhaltigen cyclischen Gruppe, einer $\pi$-elektronenverarmten stickstofffreien cyclischen Gruppe, $-C(Q_{21})(Q_{22})(Q_{23})$, $-Si(Q_{21})(Q_{22})(Q_{23})$, $-B(Q_{21})(Q_{22})$, $-N(Q_{21})(Q_{22})$, $-S(=O)(Q_{21})$, $-S(=O)_2(Q_{21})$, $-P(=O)(Q_{21})(Q_{22})$ und $-P(=S)(Q_{21})(Q_{22})$,
mindestens einer von $R_{21a}$ bis $R_{21c}$, $R_{22a}$ bis $R_{22d}$, $R_{24}$ und $R_{25}$ in Formel 2-1 die durch $*-(L_{21})_{a21}-A_{21}$ dargestellte Gruppe ist,
mindestens einer, ausgewählt aus $R_{23a}$ bis $R_{23e}$ in Formel 2-2 die durch $*-(L_{21})_{a21}-A_{21}$ dargestellte Gruppe ist,

b41 bis b43 jeweils unabhängig eine ganze Zahl von 0 bis 10 sind, und
$Q_1$ bis $Q_3$, $Q_{21}$ bis $Q_{23}$ und $Q_{31}$ bis $Q_{33}$ jeweils unabhängig ausgewählt sind aus Wasserstoff, Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer $C_1$-$C_{60}$-Alkylgruppe, einer $C_2$-$C_{60}$-Alkenylgruppe, einer $C_2$-$C_{60}$-Alkinylgruppe, einer $C_1$-$C_{60}$-Alkoxygruppe, einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_6$-$C_{60}$-Aryloxygruppe, einer $C_6$-$C_{60}$-Arylthiogruppe, einer $C_1$-$C_{60}$-Heteroarylgruppe, einer $C_1$-$C_{60}$-Heteroaryloxygruppe, einer $C_1$-$C_{60}$-Heteroarylthiogruppe, einer einwertigen nichtaromatischen kondensierten polycyclischen Gruppe, einer einwertigen nichtaromatischen kondensierten heteropolycyclischen Gruppe, einer Biphenylgruppe und einer Terphenylgruppe.

**9.** Organische lichtemittierende Vorrichtung (10, 20, 30, 40) nach einem der Ansprüche 1 bis 8, wobei die dritte Verbindung durch Formel 3-1 oder Formel 3-2 dargestellt ist:

<Formel 3-1>

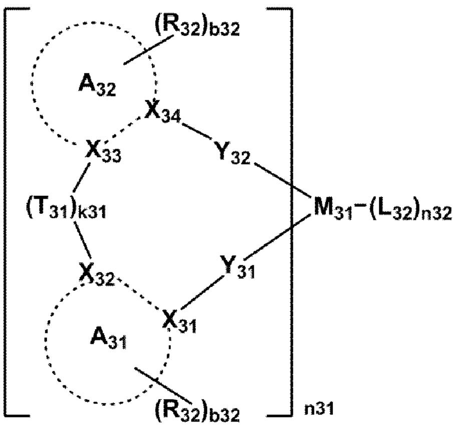

<Formel 3-2>

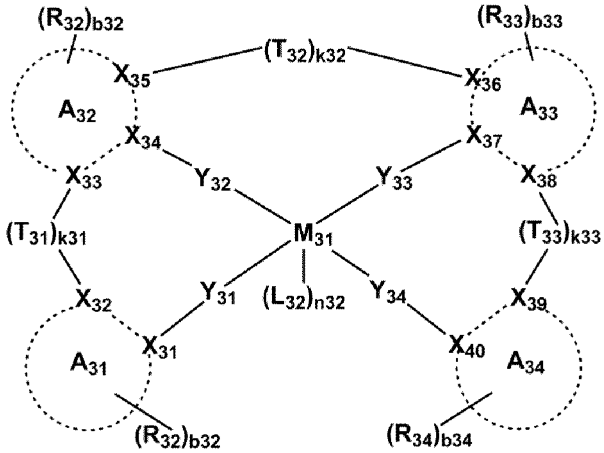

wobei in den Formeln 3-1 und 3-2,
$X_{31}$ bis $X_{40}$ jeweils unabhängig ausgewählt sind aus N und C, und
$M_{31}$, $A_{31}$ bis $A_{34}$, $R_{32}$ bis $R_{34}$, b32 bis b34, $Y_{31}$ bis $Y_{34}$, $T_{31}$ bis $T_{33}$, k31 bis k33, $L_{32}$, n31 und n32 jeweils die gleichen wie in Verbindung mit Formel 3 definiert sind.

**10.** Organische lichtemittierende Vorrichtung (10, 20, 30, 40), wobei:

die erste Verbindung ausgewählt ist aus den Verbindungen der Gruppe I,
die zweite Verbindung ausgewählt ist aus den Verbindungen der Gruppe II,
die dritte Verbindung ausgewählt ist aus den Verbindungen der Gruppe III-I und der Gruppe III-II, und
die vierte Verbindung ausgewählt ist aus den Verbindungen der Gruppe IV:

<Gruppe I>

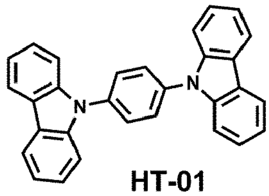
HT-01

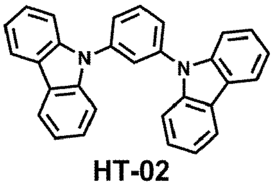
HT-02

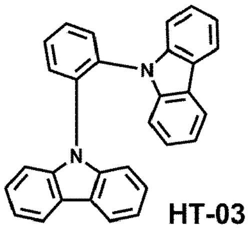
HT-03

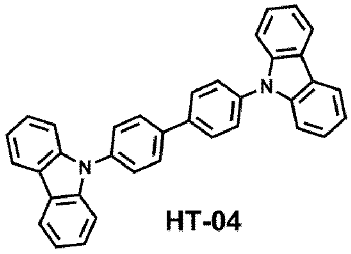
HT-04

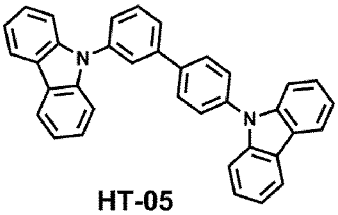
HT-05

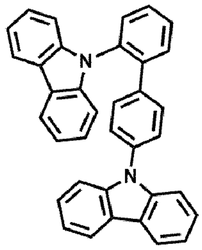
HT-06

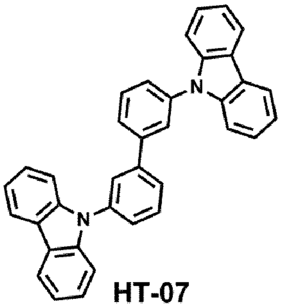
HT-07

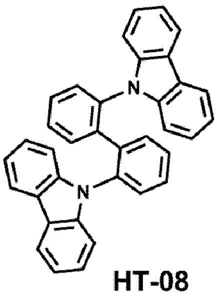
HT-08

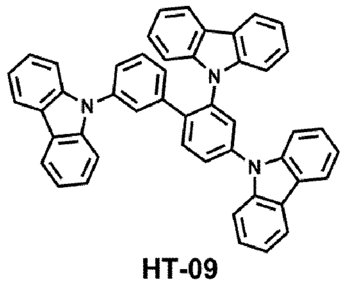
HT-09

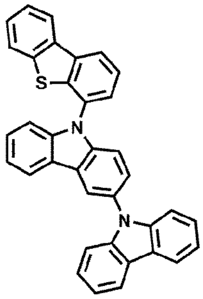
HT-10

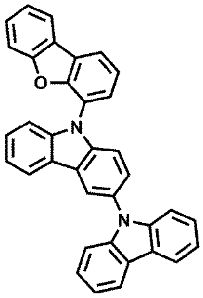
HT-11

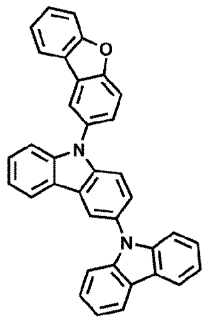
HT-12

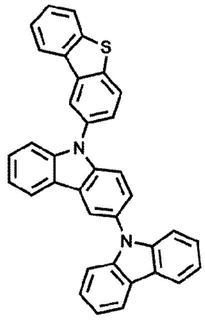
HT-13

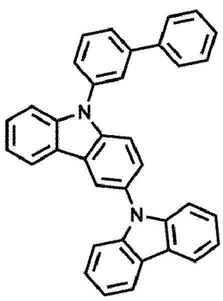
HT-14

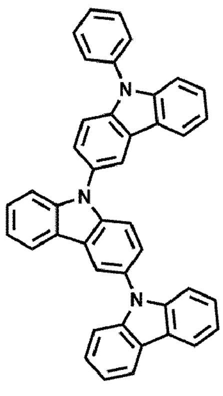
HT-15

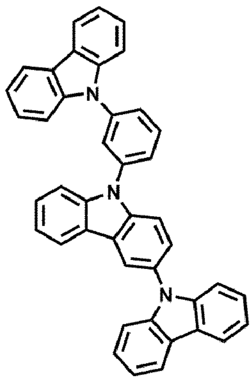
HT-16

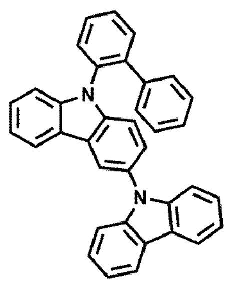
HT-17

<Gruppe II>

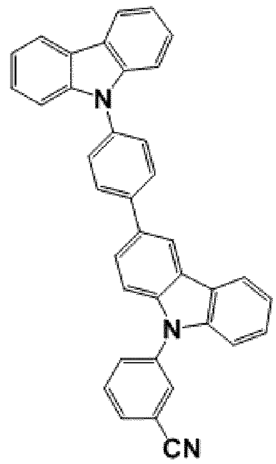

ET-1

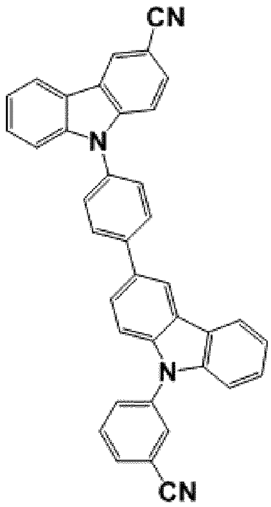

ET-2

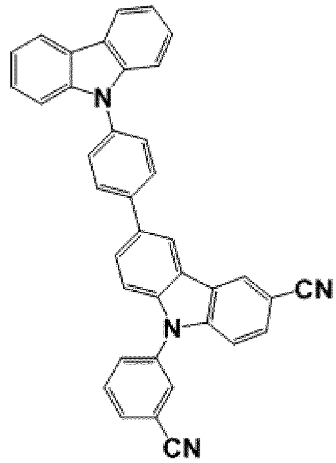

ET-3

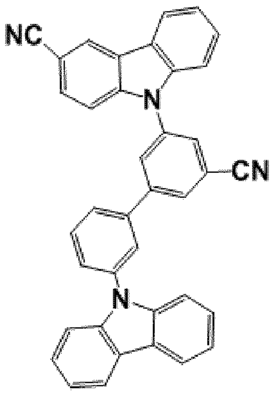

ET-4

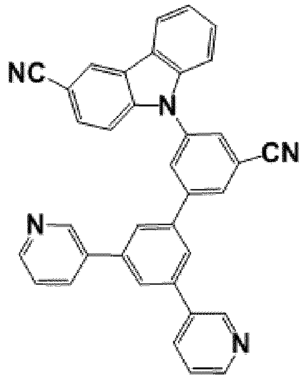

ET-5

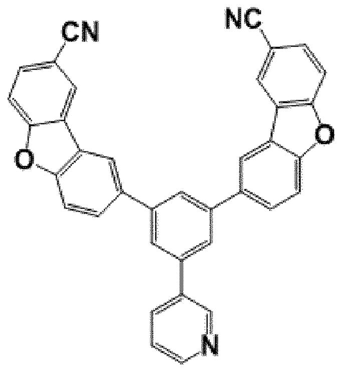

ET-6

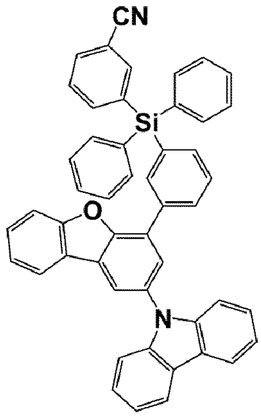

ET-7

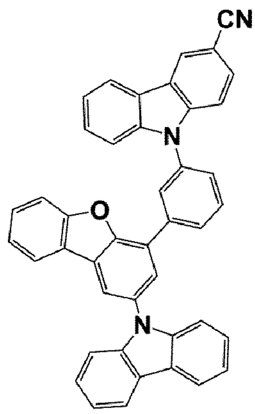

ET-8

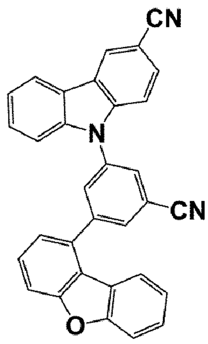

ET-9

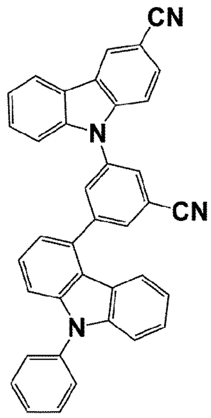

ET-10

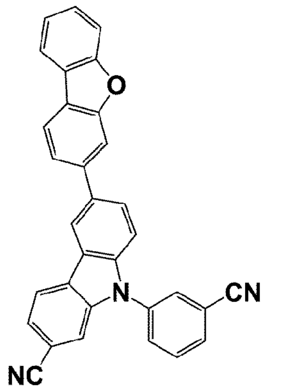

ET-11

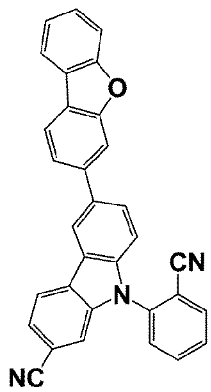

ET-12

<Gruppe III-I>

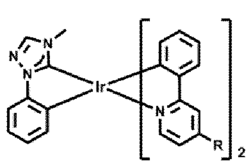

1 (R = H)
2 (R = Me)
3 (R = *iso*-Pr)
4 (R = *tert*-Bu)
5 (R = $NMe_2$)

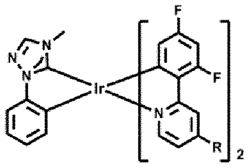

6 (R = H)
7 (R = Me)
8 (R = *iso*-Pr)
9 (R = *tert*-Bu)
10 (R = $NMe_2$)

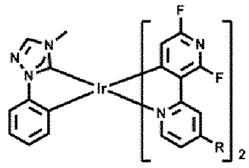

11 (R = H)
12 (R = Me)
13 (R = *iso*-Pr)
14 (R = *tert*-Bu)
15 (R = $NMe_2$)

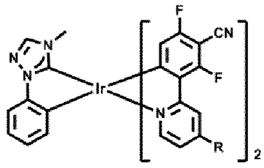

16 (R = H)
17 (R = Me)
18 (R = *iso*-Pr)
19 (R = *tert*-Bu)
20 (R = $NMe_2$)

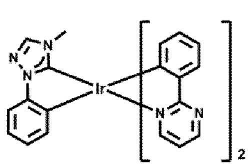

21

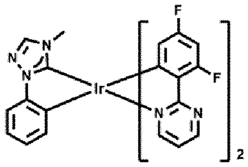

22

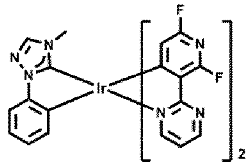

23

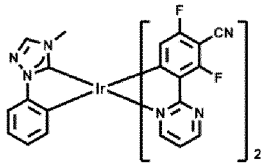

24

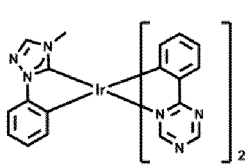

25

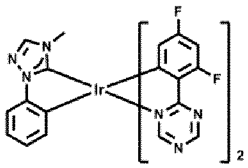

26

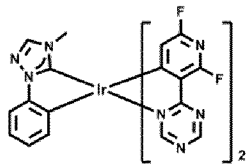

27

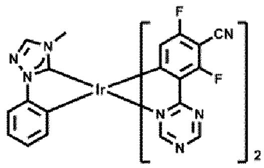

28

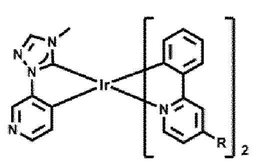

29 (R = H)
30 (R = Me)
31 (R = *iso*-Pr)
32 (R = *tert*-Bu)
33 (R = $NMe_2$)

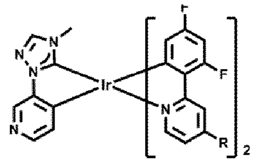

34 (R = H)
35 (R = Me)
36 (R = *iso*-Pr)
37 (R = *tert*-Bu)
38 (R = $NMe_2$)

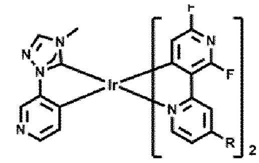

39 (R = H)
40 (R = Me)
41 (R = *iso*-Pr)
42 (R = *tert*-Bu)
43 (R = $NMe_2$)

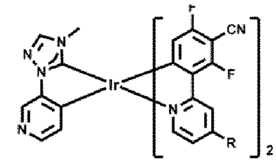

44 (R = H)
45 (R = Me)
46 (R = *iso*-Pr)
47 (R = *tert*-Bu)
48 (R = $NMe_2$)

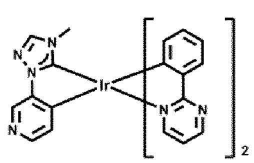

49

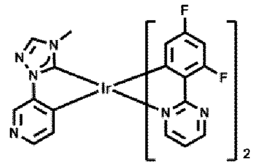

50

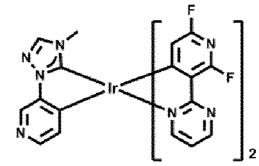

51

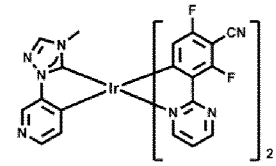

52

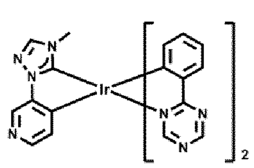

53

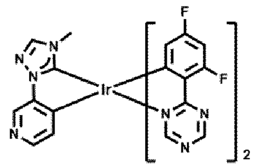

54

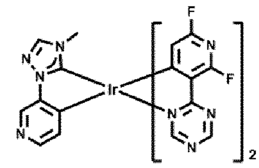

55

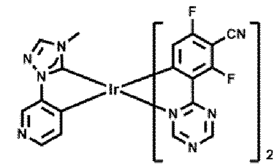

56

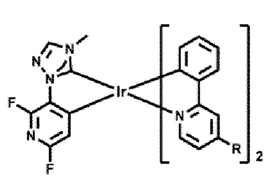

57 (R = H)
58 (R = Me)
59 (R = *iso*-Pr)
60 (R = *tert*-Bu)
61 (R = $NMe_2$)

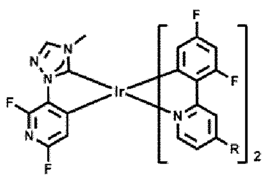

62 (R = H)
63 (R = Me)
64 (R = *iso*-Pr)
65 (R = *tert*-Bu)
66 (R = $NMe_2$)

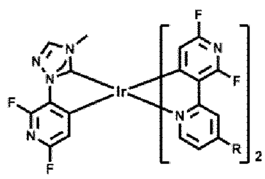

67 (R = H)
68 (R = Me)
69 (R = *iso*-Pr)
70 (R = *tert*-Bu)
71 (R = $NMe_2$)

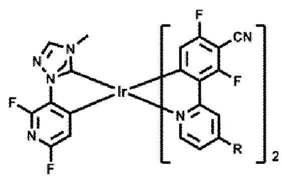

72 (R = H)
73 (R = Me)
74 (R = *iso*-Pr)
75 (R = *tert*-Bu)
76 (R = $NMe_2$)

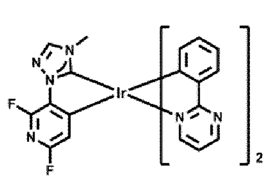

77

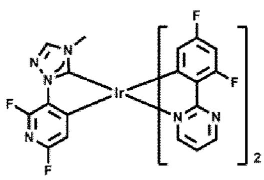

78

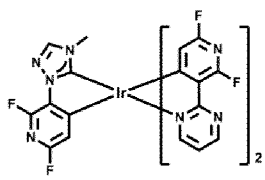

79

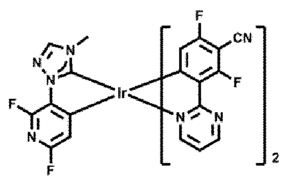

80

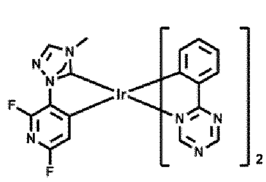

81

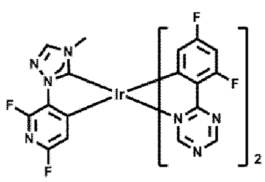

82

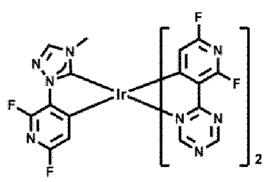

83

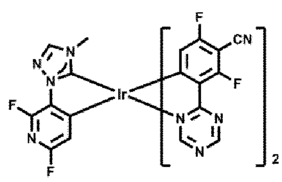

84

<Gruppe III-2>

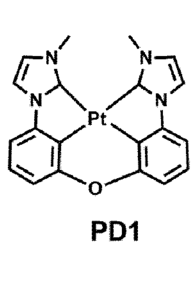

**PD1**

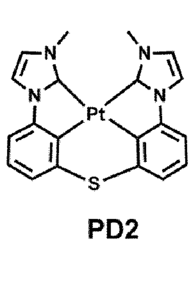

**PD2**

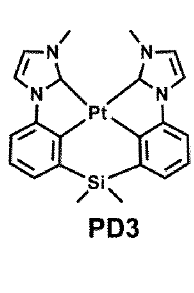

**PD3**

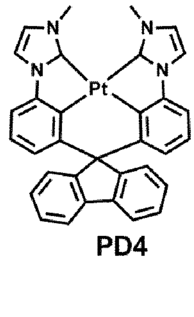

**PD4**

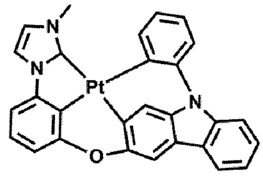 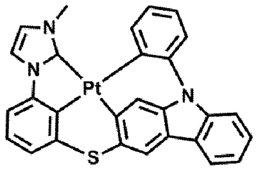 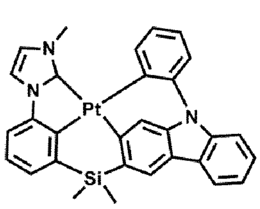 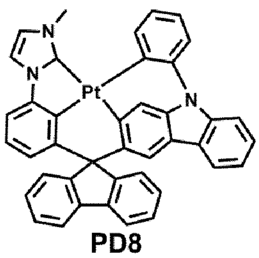

PD5 PD6 PD7 PD8

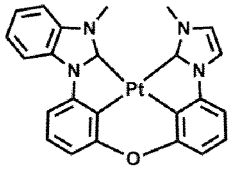 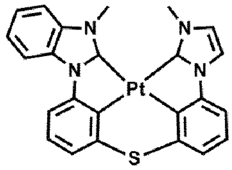 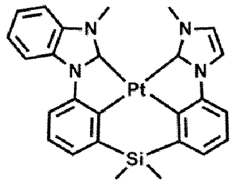 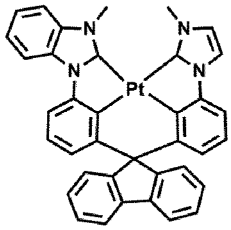

PD9 PD10 PD11 PD12

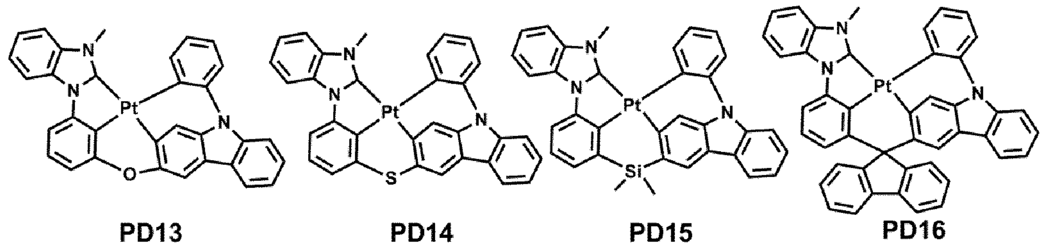

PD13 PD14 PD15 PD16

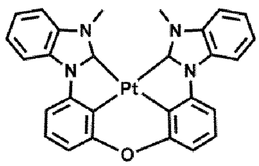 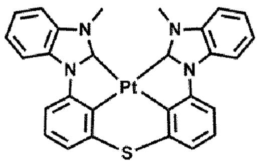 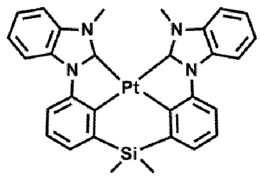 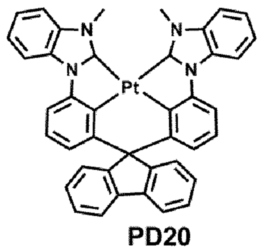

PD17 PD18 PD19 PD20

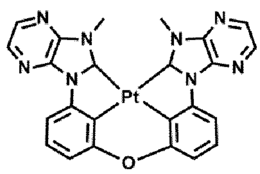 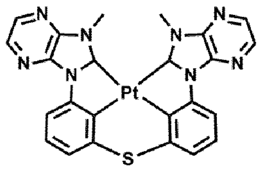 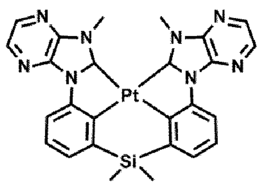 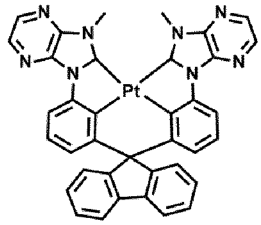

PD21 PD22 PD23 PD24

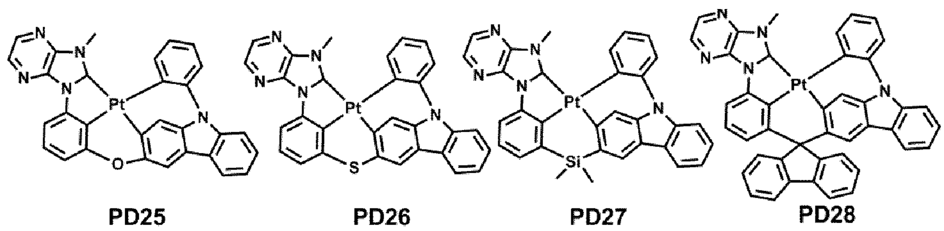

PD25 PD26 PD27 PD28

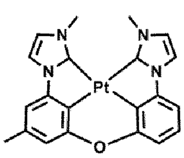

PD29

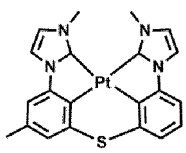

PD30

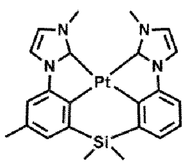

PD31

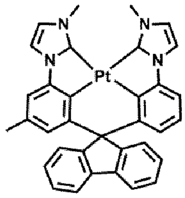

PD32

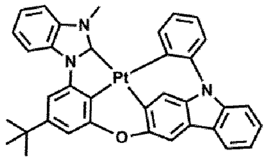

PD33

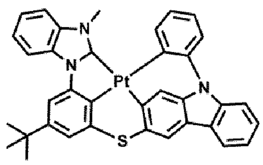

PD34

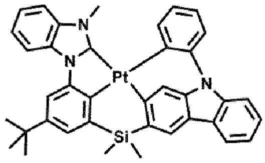

PD35

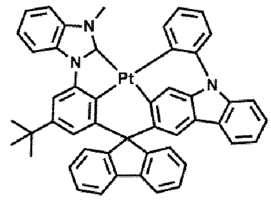

PD36

<Gruppe IV>

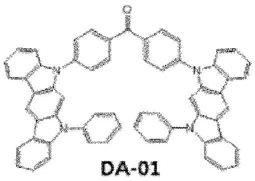

DA-01

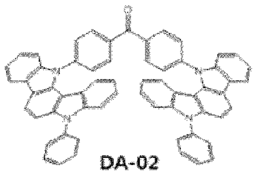

DA-02

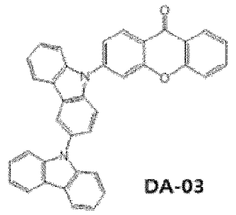

DA-03

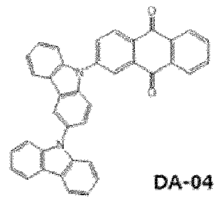

DA-04

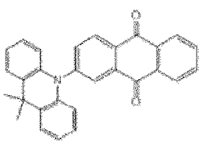

DA-05

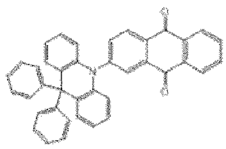

DA-06

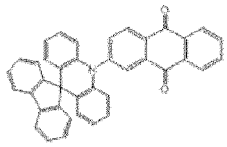

DA-07

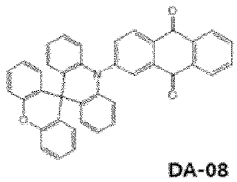

DA-08

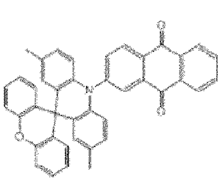

DA-09

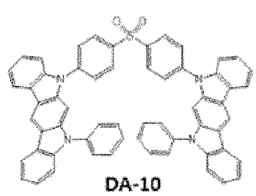

DA-10

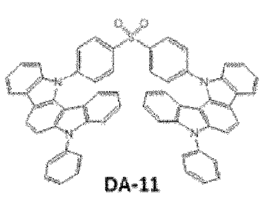

DA-11

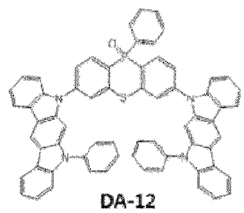

DA-12

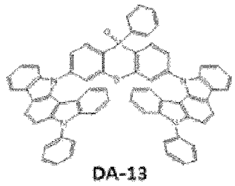
DA-13
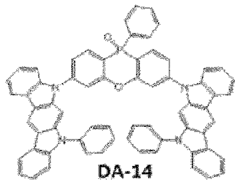
DA-14
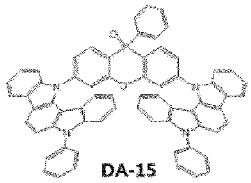
DA-15
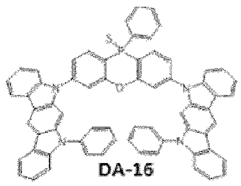
DA-16

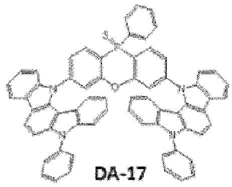
DA-17
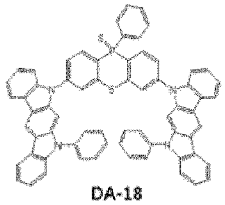
DA-18
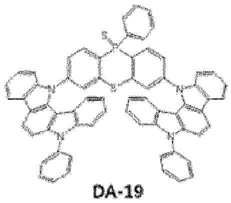
DA-19
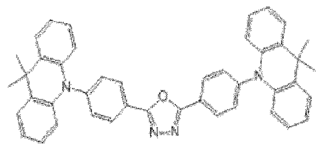
DA-20

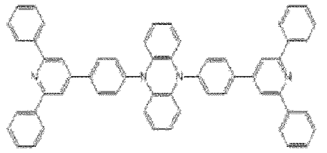
DA-21
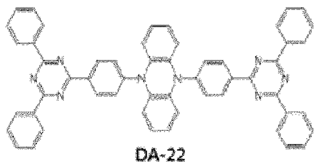
DA-22
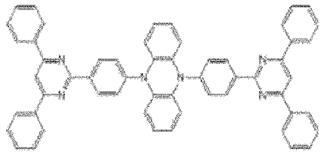
DA-23

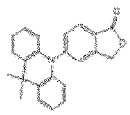
DA-24
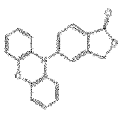
DA-25
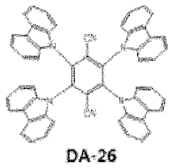
DA-26
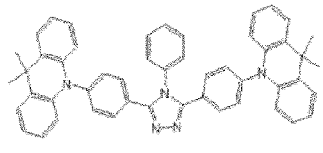
DA-27
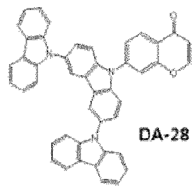
DA-28

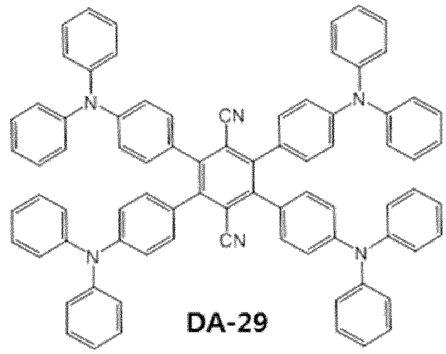
DA-29
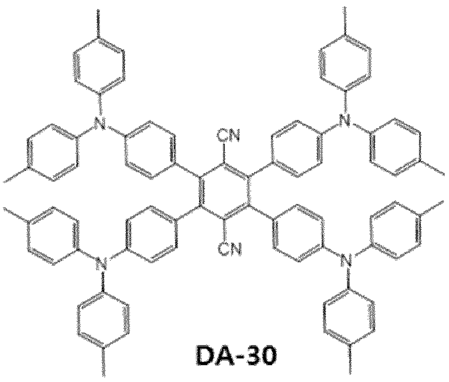
DA-30

**11.** Organische lichtemittierende Vorrichtung (10, 20, 30, 40) nach einem der Ansprüche 1 bis 10, wobei:

die erste Elektrode (110) eine Anode ist,
die zweite Elektrode (190) eine Kathode ist,
die organische Schicht (150) ferner eine Lochtransportregion zwischen der ersten Elektrode (110) und der Emissionsschicht und/oder einer Elektronentransportregion zwischen der Emissionsschicht und der zweiten Elektrode (190) umfasst,
die Lochtransportregion eine Lochinjektionsschicht, eine Lochtransportschicht, eine Emissionshilfsschicht und/oder eine Elektronensperrschicht umfasst, und
die Elektronentransportregion eine Lochsperrschicht, eine Elektronentransportschicht und/oder eine Elektroneninjektionsschicht umfasst, wobei die Lochsperrschicht optional ein Lochsperrmaterial, dargestellt durch die Formel 2A oder Formel 2B, umfasst:

<Formel 2A>

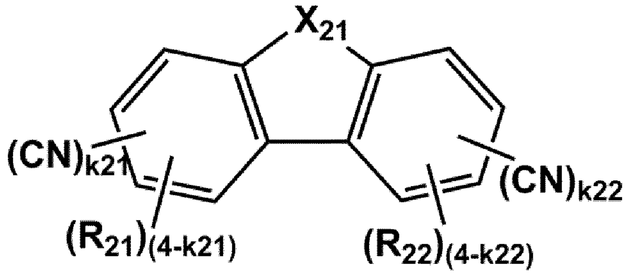

<Formel 2B>

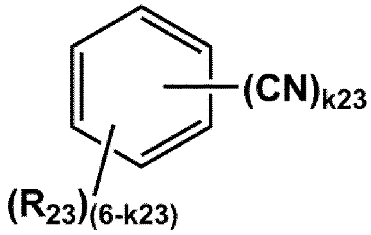

wobei in den Formeln 2A und 2B,
$X_{21}$ ausgewählt ist aus O, S, $N(R_{24})$ und $C(R_{24})(R_{25})$,
k21 und k22 jeweils unabhängig ausgewählt sind aus 0, 1, 2, 3 und 4, wobei die Summe von k21 und k22 1 oder mehr ist,
k23 ausgewählt ist aus 1, 2, 3, 4, 5 und 6,
$R_{21}$ bis $R_{25}$ jeweils unabhängig ausgewählt sind aus:

einer Gruppe, dargestellt durch $*-(L_{21})_{a21}-A_{21}$, Wasserstoff, Deuterium, -F, einer Cyanogruppe, einer $C_1$-$C_{60}$-Alkylgruppe, einer $\pi$-elektronenverarmten stickstoffhaltigen cyclischen Gruppe, einer $\pi$-elektronenverarmten stickstofffreien cyclischen Gruppe, $-C(Q_1)(Q_2)(Q_3)$, $-Si(Q_1)(Q_2)(Q_3)$, $-B(Q_1)(Q_2)$, $-N(Q_1)(Q_2)$, $-S(=O)(Q_1)$, $-S(=O)_2(Q_1)$, $-P(=O)(Q_1)(Q_2)$ und $-P(=S)(Q_1)(Q_2)$;
einer $\pi$-elektronenverarmten stickstoffhaltigen cyclischen Gruppe und einer $\pi$-elektronenverarmten stickstofffreien cyclischen Gruppe, jeweils substituiert mit mindestens einer, ausgewählt aus Deuterium, -F, einer Cyanogruppe, einer $C_1$-$C_{60}$-Alkylgruppe, einer $\pi$-elektronenverarmten stickstoffhaltigen cyclischen Gruppe, einer $\pi$-elektronenverarmten stickstofffreien cyclischen Gruppe, $-C(Q_{31})(Q_{32})(Q_{33})$, $-Si(Q_{31})(Q_{32})(Q_{33})$, $-B(Q_{31})(Q_{32})$, $-N(Q_{31})(Q_{32})$, $-S(=O)(Q_{31})$, $-S(=O)_2(Q_{31})$, $-P(=O)(Q_{31})(Q_{32})$ und $-P(=S)(Q_{31})(Q_{32})$; und
einer $\pi$-elektronenverarmten stickstoffhaltigen cyclischen Gruppe und einer $\pi$-elektronenverarmten stickstofffreien cyclischen Gruppe, jeweils substituiert mit mindestens einer, ausgewählt aus einer $\pi$-elektronenverarmten stickstoffhaltigen cyclischen Gruppe und einer $\pi$-elektronenverarmten stickstofffreien cyclischen Gruppe, die jeweils substituiert sind mit mindestens einer, ausgewählt aus Deuterium, -F, einer Cyanogruppe, einer $C_1$-$C_{60}$-Alkylgruppe, einer $\pi$-elektronenverarmten stickstoffhaltigen cyclischen Gruppe, einer $\pi$-elektronenverarmten stickstofffreien cyclischen Gruppe, $-C(Q_{21})(Q_{22})(Q_{23})$, $-Si(Q_{21})(Q_{22})(Q_{23})$, $-B(Q_{21})(Q_{22})$, $-N(Q_{21})(Q_{22})$, $-S(=O)(Q_{21})$, $-S(=O)_2(Q_{21})$, $-P(=O)(Q_{21})(Q_{22})$ und $-P(=S)(Q_{21})(Q_{22})$,

$L_{21}$ ausgewählt ist aus:

einer $\pi$-elektronenverarmten stickstoffhaltigen cyclischen Gruppe, einer $\pi$-elektronenverarmten stickstofffreien cyclischen Gruppe, $-C(Q_1)(Q_2)-$, $-Si(Q_1)(Q_2)-$, $-B(Q_1)-$, $-N(Q_1)-$, $-S(=O)-$, $-S(=O)_2-$, $-P(=O)(Q_1)-$ und $-P(=S)(Q_1)-$; und
einer $\pi$-elektronenverarmten stickstoffhaltigen cyclischen Gruppe und einer $\pi$-elektronenverarmten stickstofffreien cyclischen Gruppe, jeweils substituiert mit mindestens einer, ausgewählt aus Deuterium, -F, einer Cyanogruppe, einer $C_1$-$C_{60}$-Alkylgruppe, einer $\pi$-elektronenverarmten stickstoffhaltigen cyclischen Gruppe, einer $\pi$-elektronenverarmten stickstofffreien cyclischen Gruppe, $-C(Q_{31})(Q_{32})(Q_{33})$, $-Si(Q_{31})(Q_{32})(Q_{33})$, $-B(Q_{31})(Q_{32})$, $-N(Q_{31})(Q_{32})$, $-S(=O)(Q_{31})$, $-S(=O)_2(Q_{31})$, $-P(=O)(Q_{31})(Q_{32})$ und $-P(=S)(Q_{31})(Q_{32})$,
a21 ausgewählt ist aus 1, 2 und 3,

$A_{21}$ ausgewählt ist aus:

einer $\pi$-elektronenverarmten stickstoffhaltigen cyclischen Gruppe und einer $\pi$-elektronenverarmten stickstofffreien cyclischen Gruppe;
einer $\pi$-elektronenverarmten stickstoffhaltigen cyclischen Gruppe und einer $\pi$-elektronenverarmten stickstofffreien cyclischen Gruppe, jeweils substituiert mit mindestens einer, ausgewählt aus Deuterium, -F, einer Cyanogruppe, einer $C_1$-$C_{60}$-Alkylgruppe, einer $\pi$-elektronenverarmten stickstoffhaltigen cyclischen Gruppe, einer $\pi$-elektronenverarmten stickstofffreien cyclischen Gruppe, $-C(Q_{31})(Q_{32})(Q_{33})$,

$-Si(Q_{31})(Q_{32})(Q_{33})$, $-B(Q_{31})(Q_{32})$, $-N(Q_{31})(Q_{32})$, $-S(=O)(Q_{31})$, $-S(=O)_2(Q_{31})$, $-P(=O)(Q_{31})(Q_{32})$ und $-P(=S)(Q_{31})(Q_{32})$; und

einer $\pi$-elektronenverarmten stickstoffhaltigen cyclischen Gruppe und einer $\pi$-elektronenverarmten stickstofffreien cyclischen Gruppe, jeweils substituiert mit mindestens einer, ausgewählt aus einer $\pi$-elektronenverarmten stickstoffhaltigen cyclischen Gruppe und einer $\pi$-elektronenverarmten stickstofffreien cyclischen Gruppe, die jeweils substituiert sind mit mindestens einer, ausgewählt aus Deuterium, -F, einer Cyanogruppe, einer $C_1$-$C_{60}$-Alkylgruppe, einer $\pi$-elektronenverarmten stickstoffhaltigen cyclischen Gruppe, einer $\pi$-elektronenverarmten stickstofffreien cyclischen Gruppe, $-C(Q_{21})(Q_{22})(Q_{23})$, $-Si(Q_{21})(Q_{22})(Q_{23})$, $-B(Q_{21})(Q_{22})$, $-N(Q_{21})(Q_{22})$, $-S(=O)(Q_{21})$, $-S(=O)_2(Q_{21})$, $-P(=O)(Q_{21})(Q_{22})$ und $-P(=S)(Q_{21})(Q_{22})$, und

$Q_1$ bis $Q_3$, $Q_{21}$ bis $Q_{23}$ und $Q_{31}$ bis $Q_{33}$ jeweils unabhängig ausgewählt sind aus Wasserstoff, Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer $C_1$-$C_{60}$-Alkylgruppe, einer $C_2$-$C_{60}$-Alkenylgruppe, einer $C_2$-$C_{60}$-Alkinylgruppe, einer $C_1$-$C_{60}$-Alkoxygruppe, einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_6$-$C_{60}$-Aryloxygruppe, einer $C_6$-$C_{60}$-Arylthiogruppe, einer $C_1$-$C_{60}$-Heteroarylgruppe, einer $C_1$-$C_{60}$-Heteroaryloxygruppe, einer $C_1$-$C_{60}$-Heteroarylthiogruppe, einer einwertigen nichtaromatischen kondensierten polycyclischen Gruppe, einer einwertigen nichtaromatischen kondensierten heteropolycyclischen Gruppe, einer Biphenylgruppe und einer Terphenylgruppe.

**12.** Einrichtung, umfassend:

einen Dünnschichttransistor, umfassend eine Source-Elektrode, eine Drain-Elektrode und eine Aktivierungsschicht;
ein Dichtungsteil; und
die organische lichtemittierende Vorrichtung (10, 20, 30, 40) nach einem der Ansprüche 1 bis 11,
wobei die erste Elektrode (110) der organischen lichtemittierenden Vorrichtung (10, 20, 30, 40) elektrisch mit der Source-Elektrode oder der Drain-Elektrode des Dünnschichttransistors verbunden ist.

## Revendications

**1.** Dispositif organique d’émission de lumière (10, 20, 30, 40) comprenant :

une première électrode (110) ;
une seconde électrode (190) ; et
une couche organique (150) entre la première électrode (110) et la seconde électrode (190) ;
dans lequel :

la couche organique (150) comprend une couche d’émission,
la couche d’émission comprend un premier composé, un deuxième composé, un troisième composé et un quatrième composé,
le premier composé est représenté par la formule 1 ;
le deuxième composé est représenté par la formule 2A ou la formule 2B ;
le troisième composé est représenté par la formule 3 ;
le quatrième composé est représenté par l’une quelconque des formules 4-1 à 4-3 ; et
le premier composé, le deuxième composé, le troisième composé et le quatrième composé sont différents les uns des autres :

<Formule 1>

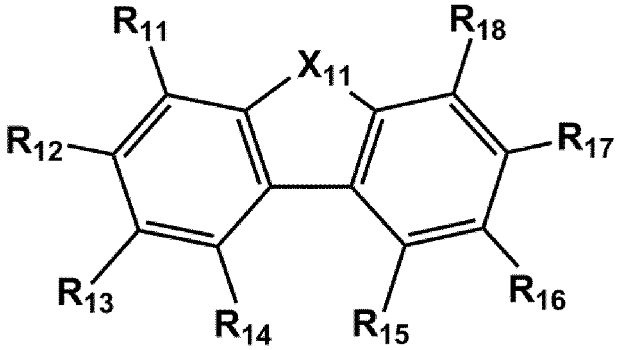

<Formule 2A>

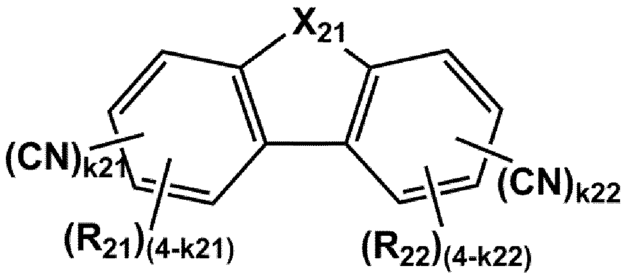

<Formule 2B>

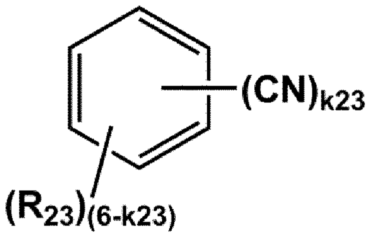

<Formule 3> $M_{31}(L_{31})_{n31}(L_{32})_{n32}$

<Formule 3A>

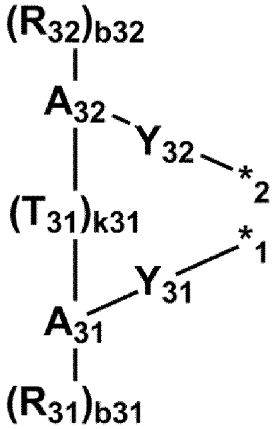

<Formule 3B>

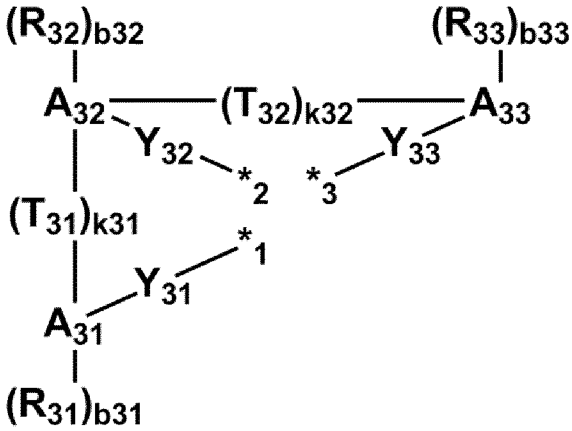

<Formule 3C>

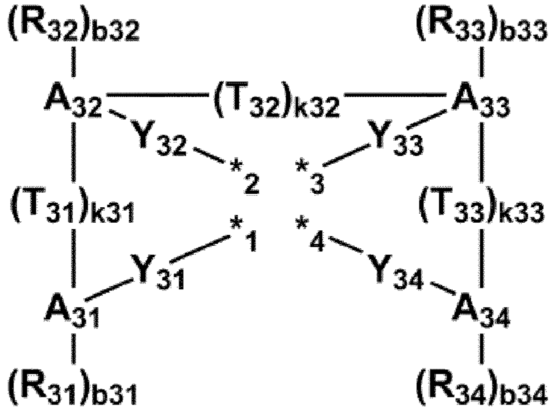

<Formule 3D>

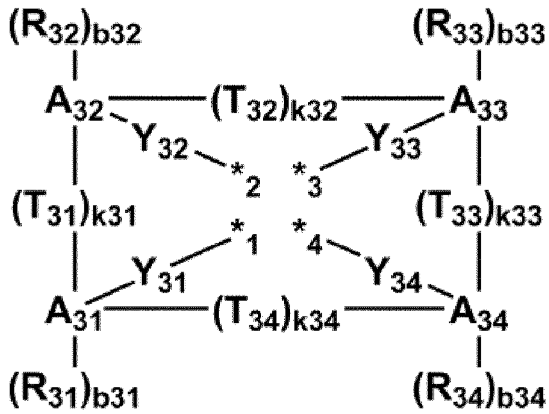

<Formule 4-1> $(D_{41})_{n41}$-$(L_{41})_{a41}$-$(A_{41})_{m41}$

<Formule 4-2> $(D_{41})_{n41}$-$(L_{41})_{a41}$-$(A_{41})_{m41}$-$(L_{42})_{a42}$-$(D_{42})_{n42}$

<Formule 4-3> $(A_{41})_{m41}$-$(L_{41})_{a41}$-$(D_{41})_{n41}$-$(L_{42})_{a42}$-$(A_{42})_{m42}$

dans lequel, dans la formule 1, $X_{11}$ est choisi parmi O, S, N($R_{19}$) et C($R_{19}$)($R_{20}$) ;
$R_{11}$ à $R_{20}$ sont chacun indépendamment choisis parmi :

un groupe représenté par *-$(L_{11})_{a11}$-$A_{11}$, un hydrogène, un deutérium, un groupe alkyle en $C_1$-$C_{60}$, un groupe cyclique sans azote appauvri en électrons $\pi$, -C($Q_1$)($Q_2$)($Q_3$), -Si($Q_1$)($Q_2$)($Q_3$), -B($Q_1$)($Q_2$) et -N($Q_1$)($Q_2$) ;
un groupe cyclique sans azote appauvri en électrons $\pi$ substitué par au moins l'un choisi parmi un deutérium, un groupe alkyle en $C_1$-$C_{60}$, un groupe cyclique sans azote appauvri en électrons $\pi$, -C($Q_{31}$)($Q_{32}$)($Q_{33}$), -Si($Q_{31}$)($Q_{32}$)($Q_{33}$), -B($Q_{31}$)($Q_{32}$) et -N($Q_{31}$)($Q_{32}$) ; et
un groupe cyclique sans azote appauvri en électrons $\pi$ substitué par un groupe cyclique sans azote appauvri en électrons $\pi$ substitué par au moins l'un choisi parmi un deutérium, un groupe alkyle en $C_1$-$C_{60}$, un groupe cyclique sans azote appauvri en électrons $\pi$, -C($Q_{21}$)($Q_{22}$)($Q_{23}$), -Si($Q_{21}$)($Q_{22}$)($Q_{23}$), -B($Q_{21}$)($Q_{22}$) et -N($Q_{21}$)($Q_{22}$),

$L_{11}$ est choisi parmi :

un groupe cyclique sans azote appauvri en électrons $\pi$, -C($Q_1$)($Q_2$)-, -Si($Q_1$)($Q_2$)-, -B($Q_1$)- et -N($Q_1$)- ; et
un groupe cyclique sans azote appauvri en électrons $\pi$ substitué par au moins l'un choisi parmi un deutérium, un groupe alkyle en $C_1$-$C_{60}$, un groupe cyclique sans azote appauvri en électrons $\pi$, -C($Q_{31}$)($Q_{32}$)($Q_{33}$), -Si($Q_{31}$)($Q_{32}$)($Q_{33}$), -B($Q_{31}$)($Q_{32}$) et -N($Q_{31}$)($Q_{32}$),
a11 est choisi parmi 1, 2 et 3, et

$A_{11}$ est choisi parmi :

un groupe cyclique sans azote appauvri en électrons $\pi$,
un groupe cyclique sans azote appauvri en électrons $\pi$ substitué par au moins l'un choisi parmi un deutérium, un groupe alkyle en $C_1$-$C_{60}$, un groupe cyclique sans azote appauvri en électrons $\pi$, -C($Q_{31}$)($Q_{32}$)($Q_{33}$), -Si($Q_{31}$)($Q_{32}$)($Q_{33}$), -B($Q_{31}$)($Q_{32}$) et -N($Q_{31}$)($Q_{32}$) ; et
un groupe cyclique sans azote appauvri en électrons $\pi$ substitué par un groupe cyclique sans azote appauvri en électrons $\pi$ substitué par au moins l'un choisi parmi un deutérium, un groupe alkyle en $C_1$-$C_{60}$, un groupe cyclique sans azote appauvri en électrons $\pi$, -C($Q_{21}$)($Q_{22}$)($Q_{23}$), -Si($Q_{21}$)($Q_{22}$)($Q_{23}$), -B($Q_{21}$)($Q_{22}$) et -N($Q_{21}$)($Q_{22}$),
dans lequel, dans les formules 2A et 2B,
$X_{21}$ est choisi parmi O, S, N($R_{24}$) et C($R_{24}$)($R_{25}$),
k21 et k22 sont chacun indépendamment choisis parmi 0, 1, 2, 3 et 4, où la somme de k21 et k22 vaut 1 ou plus,

k23 est choisi parmi 1, 2, 3, 4, 5 et 6,

$R_{21}$ à $R_{25}$ sont chacun indépendamment choisis parmi :

un groupe représenté par *-$(L_{21})_{a21}$-$A_{21}$, un hydrogène, un deutérium, -F, un groupe cyano, un groupe alkyle en $C_1$-$C_{60}$, un groupe cyclique contenant de l'azote appauvri en électrons $\pi$, un groupe cyclique sans azote appauvri en électrons $\pi$, -C($Q_1$)($Q_2$)($Q_3$), -Si($Q_1$)($Q_2$)($Q_3$), -B($Q_1$)($Q_2$), -N($Q_1$)($Q_2$), -S(=O)($Q_1$), -S(=O)$_2$($Q_1$), -P(=O)($Q_1$)($Q_2$) et -P(=S)($Q_1$)($Q_2$) ;
un groupe cyclique contenant de l'azote appauvri en électrons $\pi$ et un groupe cyclique sans azote appauvri en électrons $\pi$, chacun substitué par au moins l'un choisi parmi un deutérium, -F, un groupe cyano, un groupe alkyle en $C_1$-$C_{60}$, un groupe cyclique contenant de l'azote appauvri en électrons $\pi$, un groupe cyclique sans azote appauvri en électrons $\pi$, -C($Q_{31}$)($Q_{32}$)($Q_{33}$), -Si($Q_{31}$)($Q_{32}$)($Q_{33}$), -B($Q_{31}$)($Q_{32}$), -N($Q_{31}$)($Q_{32}$), -S(=O)($Q_{31}$), -S(=O)$_2$($Q_{31}$), -P(=O)($Q_{31}$)($Q_{32}$) et -P(=S)($Q_{31}$)($Q_{32}$) ; et
un groupe cyclique contenant de l'azote appauvri en électrons $\pi$ et un groupe cyclique sans azote appauvri en électrons $\pi$, chacun substitué par au moins l'un choisi parmi un groupe cyclique contenant de l'azote appauvri en électrons $\pi$ et un groupe cyclique sans azote appauvri en électrons $\pi$ qui sont chacun indépendamment substitués par au moins l'un choisi parmi un deutérium, -F, un groupe cyano, un groupe alkyle en $C_1$-$C_{60}$, un groupe cyclique contenant de l'azote appauvri en électrons $\pi$, un groupe cyclique sans azote appauvri en électrons $\pi$, -C($Q_{21}$)($Q_{22}$)($Q_{23}$), -Si($Q_{21}$)($Q_{22}$)($Q_{23}$), -B($Q_{21}$)($Q_{22}$), -N($Q_{21}$)($Q_{22}$), -S(=O)($Q_{21}$), -S(=O)$_2$($Q_{21}$), -P(=O)($Q_{21}$)($Q_{22}$) et -P(=S)($Q_{21}$)($Q_{22}$),

$L_{21}$ est choisi parmi :

un groupe cyclique contenant de l'azote appauvri en électrons $\pi$, un groupe cyclique sans azote appauvri en électrons $\pi$, -C($Q_1$)($Q_2$)-, -Si($Q_1$)($Q_2$)-, -B($Q_1$)-, -N($Q_1$)-, -S(=O)-, -S(=O)$_2$-, -P(=O)($Q_1$)- et -P(=S)($Q_1$)- ; et
un groupe cyclique contenant de l'azote appauvri en électrons $\pi$ et un groupe cyclique sans azote appauvri en électrons $\pi$, chacun substitué par au moins l'un choisi parmi un deutérium, -F, un groupe cyano, un groupe alkyle en $C_1$-$C_{60}$, un groupe cyclique contenant de l'azote appauvri en électrons $\pi$, un groupe cyclique sans azote appauvri en électrons $\pi$, -C($Q_{31}$)($Q_{32}$)($Q_{33}$), -Si($Q_{31}$)($Q_{32}$)($Q_{33}$), -B($Q_{31}$)($Q_{32}$), -N($Q_{31}$)($Q_{32}$), -S(=O)($Q_{31}$), -S(=O)$_2$($Q_{31}$), -P(=O)($Q_{31}$)($Q_{32}$) et -P(=S)($Q_{31}$)($Q_{32}$) ;
a21 est choisi parmi 1, 2 et 3, et

$A_{21}$ est choisi parmi :

un groupe cyclique contenant de l'azote appauvri en électrons $\pi$ et un groupe cyclique sans azote appauvri en électrons $\pi$,
un groupe cyclique contenant de l'azote appauvri en électrons $\pi$ et un groupe cyclique sans azote appauvri en électrons $\pi$, chacun substitué par au moins l'un choisi parmi un deutérium, -F, un groupe cyano, un groupe alkyle en $C_1$-$C_{60}$, un groupe cyclique contenant de l'azote appauvri en électrons $\pi$, un groupe cyclique sans azote appauvri en électrons $\pi$, -C($Q_{31}$)($Q_{32}$)($Q_{33}$), -Si($Q_{31}$)($Q_{32}$)($Q_{33}$), -B($Q_{31}$)($Q_{32}$), -N($Q_{31}$)($Q_{32}$), -S(=O)($Q_{31}$), -S(=O)$_2$($Q_{31}$), -P(=O)($Q_{31}$)($Q_{32}$) et -P(=S)($Q_{31}$)($Q_{32}$) ; et
un groupe cyclique contenant de l'azote appauvri en électrons $\pi$ et un groupe cyclique sans azote appauvri en électrons $\pi$, chacun substitué par au moins l'un choisi parmi un groupe cyclique contenant de l'azote appauvri en électrons $\pi$ et un groupe cyclique sans azote appauvri en électrons $\pi$ qui sont chacun indépendamment substitués par au moins l'un choisi parmi un deutérium, -F, un groupe cyano, un groupe alkyle en $C_1$-$C_{60}$, un groupe cyclique contenant de l'azote appauvri en électrons $\pi$, un groupe cyclique sans azote appauvri en électrons $\pi$, -C($Q_{21}$)($Q_{22}$)($Q_{23}$), -Si($Q_{21}$)($Q_{22}$)($Q_{23}$), -B($Q_{21}$)($Q_{22}$), -N($Q_{21}$)($Q_{22}$), -S(=O)($Q_{21}$), -S(=O)$_2$($Q_{21}$), -P(=O)($Q_{21}$)($Q_{22}$) et -P(=S)($Q_{21}$)($Q_{22}$),
dans lequel, dans la formule 3,
$M_{31}$ est choisi parmi les métaux de transition de la période 4, de la période 5 et de la période 6 du tableau périodique des éléments,
$L_{31}$ est un ligand représenté par l'un choisi parmi les formules 3A à 3D,
$L_{32}$ est choisi parmi un ligand monodentate, un ligand bidentate et un ligand tridentate,
n31 est 1 ou 2, et
n32 est choisi parmi 0, 1, 2, 3 et 4,
dans lequel, dans les formules 3A à 3D,
$A_{31}$ à $A_{34}$ sont chacun indépendamment choisis parmi un groupe carbocyclique en $C_5$-$C_{30}$ et un groupe

hétérocyclique en $C_1$-$C_{30}$,

$T_{31}$ à $T_{34}$ sont chacun indépendamment choisis parmi une liaison simple, une liaison double, *-O-*', *-S-*', *-C(=O)-*', *-S(=O)-*', *-C($R_{35}$)($R_{36}$)-*', *-C($R_{35}$)=C($R_{36}$)-*', *-C(R3$_{51}$)-*', *-Si($R_{35}$)($R_{36}$)-*', *-B($R_{35}$)-*', *-N($R_{35}$)-*' et *-P($R_{35}$)-*',

k31 à k34 sont chacun indépendamment choisis parmi 1, 2 et 3,

$Y_{31}$ à $Y_{34}$ sont chacun indépendamment choisis parmi une liaison simple, *-O-*', *-S-*', *-C($R_{37}$)($R_{38}$)-*', *-Si($R_{37}$)($R_{38}$)-*', *-B($R_{37}$)-*', *-N($R_{37}$)-*' et *-P($R_{37}$)-*',

$*_1$, $*_2$, $*_3$ et $*_4$ indiquent chacun un site de liaison à $M_{31}$,

$R_{31}$ à $R_{38}$ sont chacun indépendamment choisis parmi un hydrogène, un deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en $C_1$-$C_{60}$ substitué ou non substitué, un groupe alcényle en $C_2$-$C_{60}$ substitué ou non substitué, un groupe alcynyle en $C_2$-$C_{60}$ substitué ou non substitué, un groupe alkoxy en $C_1$-$C_{60}$ substitué ou non substitué, un groupe cycloalkyle en $C_3$-$C_{10}$ substitué ou non substitué, un groupe hétérocycloalkyle en $C_1$-$C_{10}$ substitué ou non substitué, un groupe cycloalcényle en $C_3$-$C_{10}$ substitué ou non substitué, un groupe hétérocycloalcényle en $C_1$-$C_{10}$ substitué ou non substitué, un groupe aryle en $C_6$-$C_{60}$ substitué ou non substitué, un groupe aryloxy en $C_6$-$C_{60}$ substitué ou non substitué, un groupe arylthio en $C_6$-$C_{60}$ substitué ou non substitué, un groupe hétéroaryle en $C_1$-$C_{60}$ substitué ou non substitué, un groupe polycyclique condensé non aromatique monovalent substitué ou non substitué, un groupe hétéropolycyclique condensé non aromatique monovalent substitué ou non substitué, -C($Q_1$)($Q_2$)($Q_3$), -Si($Q_1$)($Q_2$)($Q_3$), -B($Q_1$)($Q_2$), -N($Q_1$)($Q_2$), -P($Q_1$)($Q_2$), -C(=O)($Q_1$), -S(=O)($Q_1$), -S(=O)$_2$($Q_1$), -P(=O)($Q_1$)($Q_2$) et -P(=S)($Q_1$)($Q_2$), où $R_{31}$ à $R_{38}$ sont facultativement liés les uns aux autres pour former un groupe carbocyclique en $C_5$-$C_{60}$ substitué ou non substitué ou un groupe hétérocyclique en $C_1$-$C_{60}$ substitué ou non substitué, et

b31 à b34 sont chacun indépendamment un entier de 0 à 10,

dans lequel, dans les formules 4-1 à 4-3,

$A_{41}$ et $A_{42}$ sont chacun indépendamment choisis dans un groupe représenté par la formule 12, -Si($Q_1$)($Q_2$)($Q_3$), -B($Q_1$)($Q_2$) et -N($Q_1$)($Q_2$) :

<Formule 12>

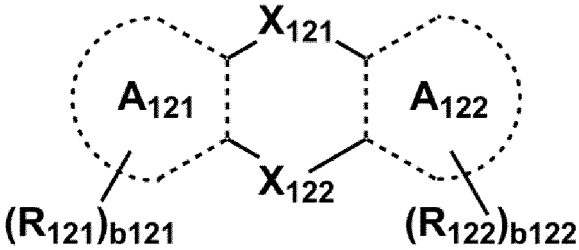

où, dans la formule 12,

$X_{121}$ est choisi parmi O, S, N($R_{123}$) et C($R_{123}$)($R_{124}$),

$X_{122}$ est choisi parmi une liaison simple, O, S, N($R_{125}$) et C($R_{125}$)($R_{126}$),

$A_{121}$ et $A_{122}$ sont chacun indépendamment choisis parmi un groupe benzène, un groupe naphtalène, un groupe phénalène, un groupe anthracène, un groupe fluoranthène, un groupe triphénylène, un groupe phénanthrène, un groupe pyrène, un groupe chrysène, un groupe pérylène, un groupe fluorène, un groupe carbazole, un groupe dibenzofurane et un groupe dibenzothiophène,

$R_{121}$ à $R_{126}$ sont chacun indépendamment choisis parmi :

un site de liaison, un hydrogène, un deutérium, un groupe alkyle en $C_1$-$C_{20}$, un groupe phényle, un groupe biphényle, un groupe terphényle, un groupe naphthyle, un groupe phénanthrényle, un groupe triphénylényle, un groupe chrysényle, un groupe fluoranthényle, un groupe fluorényle, un groupe carbazolyle, un groupe dibenzofuranyle, un groupe dibenzothiophényle, un groupe benzofluorényle, un groupe benzocarbazolyle, un groupe benzonaphthofuranyle, un groupe benzonaphthothiophényle, un groupe dibenzofluorényle, un groupe dibenzocarbazolyle, un groupe dinaphthofuranyle, un groupe dinaphthothiophényle, -Si($Q_{31}$)($Q_{32}$)($Q_{33}$), -B($Q_{31}$)($Q_{32}$) et -N($Q_{31}$)($Q_{32}$); et

un groupe phényle, un groupe biphényle, un groupe terphényle, un groupe naphthyle, un groupe phénanthrényle, un groupe triphénylényle, un groupe chrysényle, un groupe fluoranthényle, un groupe fluorényle, un groupe carbazolyle, un groupe dibenzofuranyle, un groupe dibenzothiophényle, un groupe benzofluorényle, un groupe benzocarbazolyle, un groupe benzonaphthofuranyle, un groupe benzonaphthothiophényle, un groupe dibenzofluorényle, un groupe dibenzocarbazolyle, un groupe dinaphthofuranyle et un groupe dinaphthothiophényle, chacun substitué par au moins l'un parmi un deutérium, un groupe alkyle en $C_1$-$C_{20}$, un groupe phényle, un groupe biphényle, un groupe terphényle, un groupe naphthyle, un groupe phénanthrényle, un groupe triphénylényle, un groupe chrysényle, un groupe fluoranthényle, un groupe fluorényle, un groupe carbazolyle, un groupe dibenzofuranyle, un groupe dibenzothiophényle, un groupe benzofluorényle, un groupe benzocarbazolyle, un groupe benzonaphthofuranyle, un groupe benzonaphthothiophényle, un groupe dibenzofluorényle, un groupe dibenzocarbazolyle, un groupe dinaphthofuranyle, un groupe dinaphthothiophényle, -Si($Q_{21}$)($Q_{22}$)($Q_{23}$), -B($Q_{21}$)($Q_{22}$) et -N($Q_{21}$)($Q_{22}$), où $R_{123}$ et $R_{124}$ sont facultativement liés l'un à l'autre pour former un groupe cyclique sans azote appauvri en électrons $\pi$, $R_{125}$ et $R_{126}$ sont facultativement liés l'un à l'autre pour former un groupe cyclique sans azote appauvri en électrons $\pi$, et au moins l'un choisi parmi $R_{121}$ à $R_{126}$ est le site de liaison, et

b121 et b122 sont chacun indépendamment choisis parmi 1, 2, 3, 4, 5 et 6,

m41 et m42 sont chacun indépendamment choisis parmi 1, 2 et 3,

$D_{41}$ et $D_{42}$ sont chacun indépendamment choisis parmi :

-F, un groupe cyano, un groupe pyrazole, un groupe imidazole, un groupe triazole, un groupe oxazole, un groupe isoxazole, un groupe oxadiazole, un groupe isozadiazole, un groupe thiazole, un groupe isothiazole, un groupe thiadiazole, un groupe isothiadiazole, un groupe pyridine, un groupe pyrazine, un groupe pyridazine, un groupe pyrimidine, un groupe triazine, un groupe quinoléine, un groupe isoquinoléine, un groupe naphthyridine, un groupe quinoxaline, un groupe quinazoline et un groupe représenté par les formules 13-1 à 13-3 ;

un groupe pyrazole, un groupe imidazole, un groupe triazole, un groupe oxazole, un groupe isoxazole, un groupe oxadiazole, un groupe isozadiazole, un groupe thiazole, un groupe isothiazole, un groupe thiadiazole, un groupe isothiadiazole, un groupe pyridine, un groupe pyrazine, un groupe pyridazine, un groupe pyrimidine, un groupe triazine, un groupe quinoléine, un groupe isoquinoléine, un groupe naphthyridine, un groupe quinoxaline et un groupe quinazoline, chacun substitué par au moins l'un choisi parmi un deutérium, -F, un groupe cyano, un groupe alkyle en $C_1$-$C_{20}$, un groupe phényle, un groupe biphényle, un groupe terphényle, un groupe naphthyle, un groupe phénanthrényle, un groupe triphénylényle, un groupe chrysényle, un groupe fluoranthényle, un groupe fluorényle, un groupe carbazolyle, un groupe dibenzofuranyle, un groupe dibenzothiophényle, un groupe benzofluorényle, un groupe benzocarbazolyle, un groupe benzonaphthofuranyle, un groupe benzonaphthothiophényle, un groupe dibenzofluorényle, un groupe dibenzocarbazolyle, un groupe dinaphthofuranyle, un groupe dinaphthothiophényle, un groupe pyrazolyle, un groupe imidazolyle, un groupe triazolyle, un groupe oxazolyle, un groupe isoxazolyle, un groupe oxadiazolyle, un groupe isoxadiazolyle, un groupe thiazolyle, un groupe isothiazolyle, un groupe thiadiazolyle, un groupe isothiadiazolyle, un groupe pyridinyle, un groupe pyrazinyle, un groupe pyridazinyle, un groupe pyrimidinyle, un groupe triazinyle, un groupe quinolinyle, un groupe isoquinolinyle, un groupe naphthyridinyle, un groupe quinoxalinyle et un groupe quinazolinyle ;

un groupe pyrazole, un groupe imidazole, un groupe triazole, un groupe oxazole, un groupe isoxazole, un groupe oxadiazole, un groupe isozadiazole, un groupe thiazole, un groupe isothiazole, un groupe thiadiazole, un groupe isothiadiazole, un groupe pyridine, un groupe pyrazine, un groupe pyridazine, un groupe pyrimidine, un groupe triazine, un groupe quinoléine, un groupe isoquinoléine, un groupe naphthyridine, un groupe quinoxaline et un groupe quinazoline, chacun substitué par au moins l'un choisi parmi un groupe alkyle en $C_1$-$C_{20}$, un groupe phényle, un groupe biphényle, un groupe terphényle, un groupe naphthyle, un groupe phénanthrényle, un groupe triphénylényle, un groupe chrysényle, un groupe fluoranthényle, un groupe fluorényle, un groupe carbazolyle, un groupe dibenzofuranyle, un groupe dibenzothiophényle, un groupe benzofluorényle, un groupe benzocarbazolyle, un groupe benzonaphthofuranyle, un groupe benzonaphthothiophényle, un groupe dibenzofluorényle, un groupe dibenzocarbazolyle, un groupe dinaphthofuranyle, un groupe dinaphthothiophényle, un groupe pyrazolyle, un groupe imidazolyle, un groupe triazolyle, un groupe oxazolyle, un groupe isoxazolyle, un groupe oxadiazolyle, un groupe isoxadiazolyle, un groupe thiazolyle, un groupe isothiazolyle, un groupe thiadiazolyle, un groupe isothiadiazolyle, un groupe pyridinyle, un groupe pyrazinyle, un groupe pyridazinyle, un groupe pyrimidinyle, un groupe triazinyle, un groupe quinolinyle, un groupe isoquinolinyle, un groupe naphthyridinyle, un groupe quinoxalinyle et un groupe quinazolinyle qui sont chacun indépendamment substitués par au moins l'un choisi parmi un deutérium, -F, un groupe cyano, un groupe alkyle en $C_1$-$C_{20}$, un groupe phényle, un groupe biphényle, un groupe terphényle, un groupe naphthyle, un groupe phénanthrényle, un groupe triphénylényle, un groupe chrysényle, un groupe fluoranthényle, un groupe fluorényle, un groupe carbazolyle, un groupe dibenzofuranyle, un groupe dibenzothiophényle, un groupe benzofluorényle, un groupe benzocarbazolyle, un groupe benzonaphthofuranyle, un groupe benzonaphthothiophényle, un groupe dibenzofluorényle, un groupe dibenzocarbazolyle, un groupe dinaphthofuranyle, un groupe dinaphthothiophényle, un groupe pyrazolyle, un groupe imidazolyle, un groupe triazolyle, un groupe oxazolyle, un groupe isoxazolyle, un groupe oxadiazolyle, un groupe isoxadiazolyle, un groupe thiazolyle, un groupe isothiazolyle, un groupe thiadiazolyle, un groupe isothiadiazolyle, un groupe pyridinyle, un groupe pyrazinyle, un groupe pyridazinyle, un groupe pyrimidinyle, un groupe triazinyle, un groupe quinolinyle, un groupe isoquinolinyle, un groupe naphthyridinyle, un groupe quinoxalinyle et un groupe quinazolinyle ;

un groupe alkyle en $C_1$-$C_{20}$, un groupe benzène, un groupe biphényle, un groupe terphényle, un groupe naphtalène, un groupe phénanthrène, un groupe triphénylène, un groupe chrysène, un groupe fluoranthène, un groupe fluorène, un groupe carbazole, un groupe dibenzofurane, un groupe dibenzothiophène, un groupe benzofluorène, un groupe benzocarbazole, un groupe benzonaphthofurane, un groupe benzonaphthothiophène, un groupe dibenzofluorène, un groupe dibenzocarbazole, un groupe dinaphthofurane et un groupe dinaphthothiophène, chacun substitué par au moins l'un choisi parmi -F, un groupe cyano, un groupe pyrazolyle, un groupe imidazolyle, un groupe triazolyle, un groupe oxazolyle, un groupe isoxazolyle, un groupe oxadiazolyle, un groupe isoxadiazolyle, un groupe thiazolyle, un groupe isothiazolyle, un groupe thiadiazolyle, un groupe isothiadiazolyle, un groupe pyridinyle, un groupe pyrazinyle, un groupe pyridazinyle, un groupe pyrimidinyle, un groupe triazinyle, un groupe quinolinyle, un groupe isoquinolinyle, un groupe naphthyridinyle, un groupe quinoxalinyle et un groupe quinazolinyle ;

un groupe alkyle en $C_1$-$C_{20}$, un groupe benzène, un groupe biphényle, un groupe terphényle, un groupe naphtalène, un groupe phénanthrène, un groupe triphénylène, un groupe chrysène, un groupe fluoranthène, un groupe fluorène, un groupe carbazole, un groupe dibenzofurane, un groupe dibenzothiophène, un groupe benzofluorène, un groupe benzocarbazole, un groupe benzonaphthofurane, un groupe benzonaphthothiophène, un groupe dibenzofluorène, un groupe dibenzocarbazole, un groupe dinaphthofurane et un groupe dinaphthothiophène, chacun substitué par au moins l'un choisi parmi un groupe pyrazolyle, un groupe imidazolyle, un groupe triazolyle, un groupe oxazolyle, un groupe isoxazolyle, un groupe oxadiazolyle, un groupe isoxadiazolyle, un groupe thiazolyle, un groupe isothiazolyle, un groupe thiadiazolyle, un groupe isothiadiazolyle, un groupe pyridinyle, un groupe pyrazinyle, un groupe pyridazinyle, un groupe pyrimidinyle, un groupe triazinyle, un groupe quinolinyle, un groupe isoquinolinyle, un groupe naphthyridinyle, un groupe quinoxalinyle et un groupe quinazolinyle qui sont chacun indépendamment substitués par au moins l'un choisi parmi un deutérium, -F, un groupe cyano, un groupe alkyle en $C_1$-$C_{20}$, un groupe phényle, un groupe biphényle, un groupe terphényle, un groupe naphthyle, un groupe phénanthrényle, un groupe triphénylényle, un groupe chrysényle, un groupe fluoranthényle, un groupe fluorényle, un groupe carbazolyle, un groupe dibenzofuranyle, un groupe dibenzothiophényle, un groupe benzofluorényle, un groupe benzocarbazolyle, un groupe benzonaphthofuranyle, un groupe benzonaphthothiophényle, un groupe dibenzofluorényle, un groupe dibenzocarbazolyle, un groupe dinaphthofuranyle, un groupe dinaphthothiophényle, un groupe pyrazolyle, un groupe imidazolyle, un groupe triazolyle, un groupe oxazolyle, un groupe isoxazolyle, un groupe oxadiazolyle, un groupe isoxadiazolyle, un groupe thiazolyle, un groupe isothiazolyle, un groupe thiadiazolyle, un groupe isothiadiazolyle, un groupe pyridinyle, un groupe pyrazinyle, un groupe pyridazinyle, un groupe pyrimidinyle, un groupe triazinyle, un groupe quinolinyle, un groupe isoquinolinyle, un groupe naphthyridinyle, un groupe quinoxalinyle et un groupe quinazolinyle ; et

un groupe alkyle en $C_1$-$C_{20}$, un groupe benzène, un groupe biphényle, un groupe terphényle, un groupe naphtalène, un groupe phénanthrène, un groupe triphénylène, un groupe chrysène, un groupe fluoranthène, un groupe fluorène, un groupe carbazole, un groupe dibenzofurane, un groupe dibenzothiophène, un groupe benzofluorène, un groupe benzocarbazole, un groupe benzonaphthofurane, un groupe benzonaphthothiophène, un groupe dibenzofluorène, un groupe dibenzocarbazole, un groupe dinaphthofurane et un groupe dinaphthothiophène, chacun substitué par au moins l'un choisi parmi un groupe alkyle en $C_1$-$C_{20}$, un groupe phényle, un groupe biphényle, un groupe terphényle, un groupe naphthyle, un groupe phénanthrényle, un groupe triphénylényle, un groupe chrysényle, un groupe fluoranthényle, un groupe fluorényle, un groupe carbazolyle, un groupe dibenzofuranyle, un groupe

dibenzothiophényle, un groupe benzofluorényle, un groupe benzocarbazolyle, un groupe benzonaphthofuranyle, un groupe benzonaphthothiophényle, un groupe dibenzofluorényle, un groupe dibenzocarbazolyle, un groupe dinaphthofuranyle et un groupe dinaphthothiophényle qui sont chacun indépendamment substitués par au moins l'un choisi parmi -F, un groupe cyano, un groupe pyrazolyle, un groupe imidazolyle, un groupe triazolyle, un groupe oxazolyle, un groupe isoxazolyle, un groupe oxadiazolyle, un groupe isoxadiazolyle, un groupe thiazolyle, un groupe isothiazolyle, un groupe thiadiazolyle, un groupe isothiadiazolyle, un groupe pyridinyle, un groupe pyrazinyle, un groupe pyridazinyle, un groupe pyrimidinyle, un groupe triazinyle, un groupe quinolinyle, un groupe isoquinolinyle, un groupe naphthyridinyle, un groupe quinoxalinyle et un groupe quinazolinyle :

<Formule 13-1>

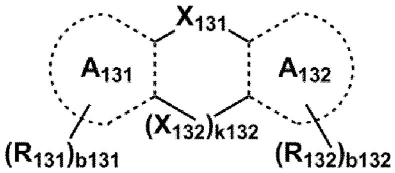

<Formule 13-2>

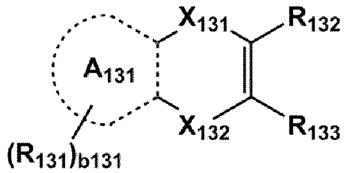

<Formule 13-3>

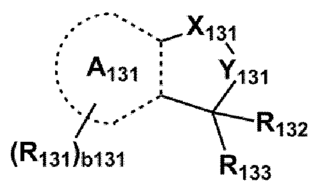

où, dans les formules 13-1 à 13-3,
$X_{131}$ est choisi parmi C(=O), S(=O), $S(=O)_2$, $P(=O)(R_{134})$ et $P(=S)(R_{134})$,
$X_{132}$ est choisi parmi O, S, C(=O), S(=O), $S(=O)_2$, $P(=O)(R_{135})$ et $P(=S)(R_{135})$,
k132 est 0 ou 1,
$Y_{131}$ est choisi parmi O et S,
$A_{131}$ et $A_{132}$ sont chacun indépendamment choisis parmi un groupe benzène, un groupe naphtalène, un groupe phénalène, un groupe anthracène, un groupe fluoranthène, un groupe triphénylène, un groupe phénanthrène, un groupe pyrène, un groupe chrysène, un groupe pérylène, un groupe fluorène, un groupe carbazole, un groupe dibenzofurane et un groupe dibenzothiophène,

$R_{131}$ à $R_{135}$ sont chacun indépendamment choisis parmi :

un site de liaison, un hydrogène, un deutérium, -F, un groupe cyano, un groupe alkyle en $C_1$-$C_{20}$, un groupe phényle, un groupe biphényle, un groupe terphényle, un groupe naphthyle, un groupe phénanthrényle, un groupe triphénylényle, un groupe chrysényle, un groupe fluoranthényle, un groupe fluorényle, un groupe carbazolyle, un groupe dibenzofuranyle, un groupe dibenzothiophényle, un groupe benzofluorényle, un groupe benzocarbazolyle, un groupe benzonaphthofuranyle, un groupe benzonaphthothiophényle, un groupe dibenzofluorényle, un groupe dibenzocarbazolyle, un groupe dinaphthofuranyle, un groupe dinaphthothiophényle, un groupe pyrazolyle, un groupe imidazolyle, un groupe triazolyle, un groupe oxazolyle, un groupe isoxazolyle, un groupe oxadiazolyle, un groupe isoxadiazolyle, un groupe thiazolyle, un groupe isothiazolyle, un groupe thiadiazolyle, un groupe isothiadiazolyle, un groupe pyridinyle, un groupe pyrazinyle, un groupe pyridazinyle, un groupe pyrimidinyle, un groupe triazinyle, un groupe quinolinyle, un groupe isoquinolinyle, un groupe naphthyridinyle, un groupe quinoxalinyle et un groupe quinazolinyle ; et
un groupe alkyle en $C_1$-$C_{20}$, un groupe phényle, un groupe biphényle, un groupe terphényle, un groupe naphthyle, un groupe phénanthrényle, un groupe triphénylényle, un groupe chrysényle, un groupe fluoranthényle, un groupe fluorényle, un groupe carbazolyle, un groupe dibenzofuranyle, un groupe dibenzothiophényle, un groupe benzofluorényle, un groupe benzocarbazolyle, un groupe benzonaphthofuranyle, un groupe benzonaphthothiophényle, un groupe dibenzofluorényle, un groupe dibenzocarbazolyle, un groupe dinaphthofuranyle, un groupe dinaphthothiophényle, un groupe pyrazolyle, un groupe imidazolyle, un groupe triazolyle, un groupe oxazolyle, un groupe isoxazolyle, un groupe oxadiazolyle, un groupe isoxadiazolyle, un groupe thiazolyle, un groupe isothiazolyle, un groupe thiadiazolyle, un groupe isothiadiazolyle, un groupe pyridinyle, un groupe pyrazinyle, un groupe pyridazinyle, un groupe pyrimidinyle, un groupe triazinyle, un groupe quinolinyle, un groupe isoquinolinyle, un groupe naphthyridinyle, un groupe quinoxalinyle et un groupe quinazolinyle, chacun substitué par au moins l'un choisi parmi un deutérium, -F, un groupe cyano, un groupe alkyle en $C_1$-$C_{20}$, un groupe phényle, un groupe biphényle, un groupe terphényle, un groupe naphthyle, un groupe phénanthrényle, un groupe triphénylényle, un groupe chrysényle, un groupe fluoranthényle, un groupe fluorényle, un groupe carbazolyle, un groupe dibenzofuranyle, un groupe dibenzothiophényle, un groupe benzofluorényle, un groupe benzocarbazolyle, un groupe benzonaphthofuranyle, un groupe benzonaphthothiophényle, un groupe dibenzofluorényle, un groupe dibenzocarbazolyle, un groupe dinaphthofuranyle, un groupe dinaphthothiophényle, un groupe pyrazolyle, un groupe imidazolyle, un groupe triazolyle, un groupe oxazolyle, un groupe isoxazolyle, un groupe oxadiazolyle, un groupe isoxadiazolyle, un groupe thiazolyle, un groupe isothiazolyle, un groupe thiadiazolyle, un groupe isothiadiazolyle, un groupe pyridinyle, un groupe pyrazinyle, un groupe pyridazinyle, un groupe pyrimidinyle, un groupe triazinyle, un groupe quinolinyle, un groupe isoquinolinyle, un groupe naphthyridinyle, un groupe quinoxalinyle et un groupe quinazolinyle, dans lequel au moins l'un choisi parmi $R_{131}$ à $R_{135}$ est le site de liaison, et

b131 et b132 sont chacun indépendamment choisis parmi 1, 2, 3, 4, 5 et 6,

n41 et n42 sont chacun indépendamment choisis parmi 1, 2 et 3,

$L_{41}$ et $L_{42}$ sont chacun indépendamment choisis parmi :

un groupe benzène, un groupe naphtalène, un groupe phénalène, un groupe anthracène, un groupe fluoranthène, un groupe triphénylène, un groupe phénanthrène, un groupe pyrène, un groupe chrysène, un groupe pérylène, un groupe fluorène, un groupe carbazole, un groupe dibenzofurane, un groupe dibenzothiophène, $-C(Q_1)(Q_2)-$ et $-Si(Q_1)(Q_2)-$ ; et

un groupe benzène, un groupe naphtalène, un groupe phénalène, un groupe anthracène, un groupe fluoranthène, un groupe triphénylène, un groupe phénanthrène, un groupe pyrène, un groupe chrysène, un groupe pérylène, un groupe fluorène, un groupe carbazole, un groupe dibenzofurane et un groupe dibenzothiophène, chacun substitué par au moins l'un choisi parmi un deutérium, un groupe alkyle en $C_1$-$C_{20}$, un groupe phényle, un groupe biphényle, un groupe terphényle, un groupe naphthyle, un groupe phénanthrényle, un groupe triphénylényle, un groupe chrysényle, un groupe fluoranthényle, un groupe fluorényle, un groupe carbazolyle, un groupe dibenzofuranyle, un groupe dibenzothiophényle, un groupe benzofluorényle, un groupe benzocarbazolyle, un groupe benzonaphthofuranyle, un groupe benzonaphthothiophényle, un groupe dibenzofluorényle, un groupe dibenzocarbazolyle, un groupe dinaphthofuranyle, un groupe dinaphthothiophényle, $-C(Q_{31})(Q_{32})(Q_{33})$ et $-Si(Q_{31})(Q_{32})(Q_{33})$,

a41 et a42 sont chacun indépendamment choisis parmi 0, 1, 2 et 3, et

dans lequel, dans les formules 1, 2A, 2B, 3 et 4-1 à 4-3,

$Q_1$ à $Q_3$, $Q_{21}$ à $Q_{23}$ et $Q_{31}$ à $Q_{33}$ sont chacun indépendamment choisis parmi un hydrogène, un deutérium, -F, -Cl, -Br, -I, un groupe hydroxyle, un groupe cyano, un groupe nitro, un groupe amidino, un groupe hydrazino, un groupe hydrazono, un groupe alkyle en $C_1$-$C_{60}$, un groupe alcényle en $C_2$-$C_{60}$, un groupe alcynyle en $C_2$-$C_{60}$, un groupe alkoxy en $C_1$-$C_{60}$, un groupe cycloalkyle en $C_3$-$C_{10}$, un groupe hétérocycloalkyle en $C_1$-$C_{10}$, un groupe cycloalcényle en $C_3$-$C_{10}$, un groupe hétérocycloalcényle en $C_1$-$C_{10}$, un groupe aryle en $C_6$-$C_{60}$, un groupe aryloxy en $C_6$-$C_{60}$, un groupe arylthio en $C_6$-$C_{60}$, un groupe hétéroaryle en $C_1$-$C_{60}$, un groupe hétéroaryloxy en $C_1$-$C_{60}$, un groupe hétéroarylthio en $C_1$-$C_{60}$, un groupe polycyclique condensé non aromatique monovalent, un groupe hétéropolycyclique condensé non aromatique monovalent, un groupe biphényle et un groupe terphényle.

**2.** Dispositif organique d'émission de lumière (10, 20, 30, 40) selon la revendication 1, dans lequel :

(i) le premier composé, le deuxième composé et le troisième composé ne doivent sensiblement pas émettre de lumière ; et/ou
(ii) le quatrième composé doit émettre de la lumière ; et/ou
(iii) le rapport entre une lumière émise par le quatrième composé et une lumière totale émise par la couche d'émission est de 80 % ou plus ; et/ou
(iv) au moins l'un parmi $R_{11}$ à $R_{19}$ est le groupe représenté par $*-(L_{11})_{a11}-A_{11}$ ; et/ou
(v) $X_{11}$ est $N(R_{19})$.

**3.** Dispositif organique d'émission de lumière (10, 20, 30, 40) selon la revendication 1 ou la revendication 2, dans lequel $A_{11}$ est choisi parmi :

un groupe phényle, un groupe biphényle, un groupe terphényle, un groupe naphthyle, un groupe phénanthrényle, un groupe triphénylényle, un groupe chrysényle, un groupe fluoranthényle, un groupe fluorényle, un groupe carbazolyle, un groupe dibenzofuranyle, un groupe dibenzothiophényle, un groupe benzofluorényle, un groupe benzocarbazolyle, un groupe benzonaphthofuranyle, un groupe benzonaphthothiophényle, un groupe dibenzofluorényle, un groupe dibenzocarbazolyle, un groupe dinaphthofuranyle et un groupe dinaphthothiophényle ;

un groupe phényle, un groupe biphényle, un groupe terphényle, un groupe naphthyle, un groupe phénanthrényle, un groupe triphénylényle, un groupe chrysényle, un groupe fluoranthényle, un groupe fluorényle, un groupe carbazolyle, un groupe dibenzofuranyle, un groupe dibenzothiophényle, un groupe benzofluorényle, un groupe benzocarbazolyle, un groupe benzonaphthofuranyle, un groupe benzonaphthothiophényle, un groupe dibenzofluorényle, un groupe dibenzocarbazolyle, un groupe dinaphthofuranyle et un groupe dinaphthothiophényle, chacun substitué par au moins l'un choisi parmi un deutérium, un groupe alkyle en $C_1$-$C_{20}$, un groupe phényle, un groupe biphényle, un groupe terphényle, un groupe naphthyle, un groupe phénanthrényle, un groupe triphénylényle, un groupe chrysényle, un groupe fluoranthényle, un groupe fluorényle, un groupe carbazolyle, un groupe dibenzofuranyle, un groupe dibenzothiophényle, un groupe benzofluorényle, un groupe benzocarbazolyle, un groupe benzonaphthofuranyle, un groupe benzonaphthothiophényle, un groupe dibenzofluorényle, un groupe dibenzocarbazolyle, un groupe dinaphthofuranyle, un groupe dinaphthothiophényle, $-C(Q_{31})(Q_{32})(Q_{33})$, $-Si(Q_{31})(Q_{32})(Q_{33})$, $-B(Q_{31})(Q_{32})$ et $-N(Q_{31})(Q_{32})$ ; et

un groupe phényle, un groupe biphényle, un groupe terphényle, un groupe naphthyle, un groupe phénanthrényle, un groupe triphénylényle, un groupe chrysényle, un groupe fluoranthényle, un groupe fluorényle, un groupe carbazolyle, un groupe dibenzofuranyle, un groupe dibenzothiophényle, un groupe benzofluorényle, un groupe benzocarbazolyle, un groupe benzonaphthofuranyle, un groupe benzonaphthothiophényle, un groupe dibenzofluorényle, un groupe dibenzocarbazolyle, un groupe dinaphthofuranyle et un groupe dinaphthothiophényle, chacun substitué par au moins l'un choisi parmi un groupe phényle, un groupe biphényle, un groupe terphényle, un groupe naphthyle, un groupe phénanthrényle, un groupe triphénylényle, un groupe chrysényle, un groupe fluoranthényle, un groupe fluorényle, un groupe carbazolyle, un groupe dibenzofuranyle, un groupe dibenzothiophényle, un groupe benzofluorényle, un groupe benzocarbazolyle, un groupe benzonaphthofuranyle, un groupe benzonaphthothiophényle, un groupe dibenzofluorényle, un groupe dibenzocarbazolyle, un groupe dinaphthofuranyle et un groupe dinaphthothiophényle qui sont chacun indépendamment substitués par au moins l'un choisi parmi un deutérium, un groupe alkyle en $C_1$-$C_{20}$, un groupe phényle, un groupe biphényle, un groupe terphényle, un groupe naphthyle, un groupe phénanthrényle, un groupe triphénylényle, un groupe chrysényle, un groupe fluoranthényle, un groupe fluorényle, un groupe carbazolyle, un groupe dibenzofuranyle, un groupe dibenzothiophényle, un groupe benzofluorényle, un groupe benzocarbazolyle, un groupe benzonaphthofuranyle, un groupe benzonaphthothiophényle, un groupe dibenzofluorényle, un groupe dibenzocarbazolyle, un groupe dinaphthofuranyle, un groupe dinaphthothiophényle, $-C(Q_{21})(Q_{22})(Q_{23})$, $-Si(Q_{21})(Q_{22})(Q_{23})$, $-B(Q_{21})(Q_{22})$ et $-N(Q_{21})(Q_{22})$.

**4.** Dispositif organique d'émission de lumière (10, 20, 30, 40) selon l'une quelconque des revendications 1 à 3, dans lequel $A_{11}$ est représenté par l'une quelconque des formules 8-1 à 8-5 :

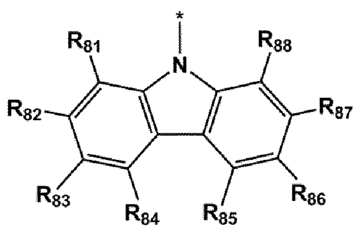

8-1

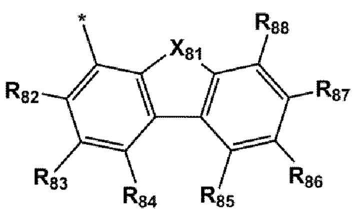

8-2

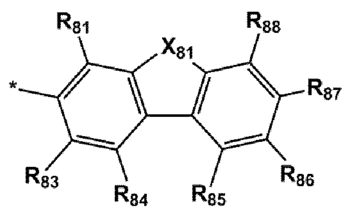

8-3

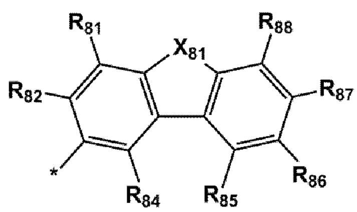

8-4

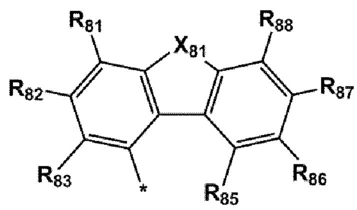

8-5

où, dans les formules 8-1 à 8-5,

$X_{81}$ est choisi parmi O, S, $N(R_{89})$ et $C(R_{89})(R_{90})$,

$R_{81}$ à $R_{90}$ sont chacun indépendamment choisis parmi un hydrogène, un deutérium, un groupe alkyle en $C_1$-$C_{20}$, un groupe phényle, un groupe biphényle, un groupe terphényle, un groupe fluorényle, un groupe carbazolyle,

un groupe dibenzofuranyle et un groupe dibenzothiophényle, et
* indique un site de liaison à un atome voisin.

**5.** Dispositif organique d'émission de lumière (10, 20, 30, 40) selon l'une quelconque des revendications 1 à 4, dans lequel le premier composé est représenté par l'une quelconque des formules 1-1 à 1-5 :

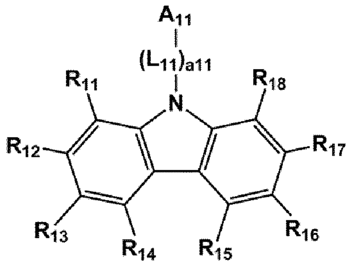

**1-1**

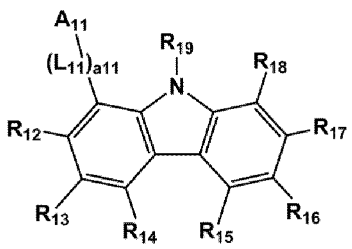

**1-2**

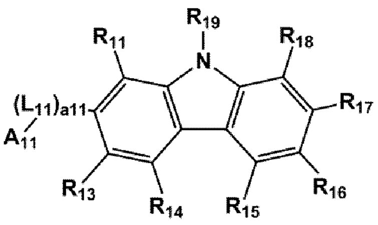

**1-3**

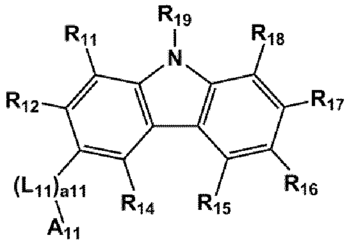

**1-4**

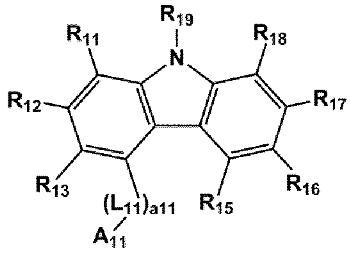

**1-5**

où, dans les formules 1-1 à 1-5,
$L_{11}$, a11, $A_{11}$ et $R_{11}$ à $R_{19}$ sont chacun identiques à ceux respectivement définis en rapport avec la formule 1.

**6.** Dispositif organique d'émission de lumière (10, 20, 30, 40) selon l'une quelconque des revendications 1 à 5, dans lequel :

au moins l'un parmi $R_{21}$, $R_{22}$, $R_{24}$ et $R_{25}$ dans la formule 2A est le groupe représenté par $*\text{-}(L_{21})_{a21}\text{-}A_{21}$, et au moins un $R_{23}$ parmi un nombre (6-k23) dans la formule 2B est le groupe représenté par $*\text{-}(L_{21})_{a21}\text{-}A_{21}$.

**7.** Dispositif organique d'émission de lumière (10, 20, 30, 40) selon l'une quelconque des revendications 1 à 6, dans lequel $A_{21}$ est choisi parmi :

un groupe phényle, un groupe biphényle, un groupe terphényle, un groupe naphthyle, un groupe phénanthrényle, un groupe triphénylényle, un groupe chrysényle, un groupe fluoranthényle, un groupe fluorényle, un groupe carbazolyle, un groupe dibenzofuranyle, un groupe dibenzothiophényle, un groupe pyridinyle, un groupe pyrazinyle, un groupe pyridazinyle, un groupe pyrimidinyle, un groupe triazinyle, un groupe quinolinyle, un groupe isoquinolinyle, un groupe naphthyridinyle, un groupe quinoxalinyle et un groupe quinazolinyle ;
un groupe phényle, un groupe biphényle, un groupe terphényle, un groupe naphthyle, un groupe phénanthrényle, un groupe triphénylényle, un groupe chrysényle, un groupe fluoranthényle, un groupe fluorényle, un groupe carbazolyle, un groupe dibenzofuranyle, un groupe dibenzothiophényle, un groupe pyridinyle, un groupe pyrazinyle, un groupe pyridazinyle, un groupe pyrimidinyle, un groupe triazinyle, un groupe quinolinyle, un groupe isoquinolinyle, un groupe naphthyridinyle, un groupe quinoxalinyle et un groupe quinazolinyle, chacun substitué par au moins l'un choisi parmi un deutérium, -F, un groupe cyano, un groupe alkyle en $C_1$-$C_{20}$, un groupe phényle, un groupe biphényle, un groupe terphényle, un groupe naphthyle, un groupe phénanthrényle, un groupe triphénylényle, un groupe chrysényle, un groupe fluoranthényle, un groupe fluorényle, un groupe carbazolyle, un groupe dibenzofuranyle, un groupe dibenzothiophényle, un groupe pyridinyle, un groupe pyrazinyle, un groupe pyridazinyle, un groupe pyrimidinyle, un groupe triazinyle, un groupe quinolinyle, un groupe isoquinolinyle, un groupe naphthyridinyle, un groupe quinoxalinyle, un groupe quinazolinyle, $-C(Q_{31})(Q_{32})(Q_{33})$, $-Si(Q_{31})(Q_{32})(Q_{33})$, $-B(Q_{31})(Q_{32})$, $-N(Q_{31})(Q_{32})$, $-S(=O)(Q_{31})$, $-S(=O)_2(Q_{31})$, $-P(=O)(Q_{31})(Q_{32})$ et $-P(=S)(Q_{31})(Q_{32})$ ; et

un groupe phényle, un groupe biphényle, un groupe terphényle, un groupe naphthyle, un groupe phénanthrényle, un groupe triphénylényle, un groupe chrysényle, un groupe fluoranthényle, un groupe fluorényle, un groupe carbazolyle, un groupe dibenzofuranyle, un groupe dibenzothiophényle, un groupe pyridinyle, un groupe pyrazinyle, un groupe pyridazinyle, un groupe pyrimidinyle, un groupe triazinyle, un groupe quinolinyle, un groupe isoquinolinyle, un groupe naphthyridinyle, un groupe quinoxalinyle et un groupe quinazolinyle, chacun substitué par au moins l'un choisi parmi un groupe phényle, un groupe biphényle, un groupe terphényle, un groupe naphthyle, un groupe phénanthrényle, un groupe triphénylényle, un groupe chrysényle, un groupe fluoranthényle, un groupe fluorényle, un groupe carbazolyle, un groupe dibenzofuranyle, un groupe dibenzothiophényle, un groupe pyridinyle, un groupe pyrazinyle, un groupe pyridazinyle, un groupe pyrimidinyle, un groupe triazinyle, un groupe quinolinyle, un groupe isoquinolinyle, un groupe naphthyridinyle, un groupe quinoxalinyle et un groupe quinazolinyle qui sont chacun indépendamment substitués par au moins l'un choisi parmi un deutérium, -F, un groupe cyano, un groupe alkyle en $C_1$-$C_{20}$, un groupe phényle, un groupe biphényle, un groupe terphényle, un groupe naphthyle, un groupe phénanthrényle, un groupe triphénylényle, un groupe chrysényle, un groupe fluoranthényle, un groupe fluorényle, un groupe carbazolyle, un groupe dibenzofuranyle, un groupe dibenzothiophényle, un groupe pyridinyle, un groupe pyrazinyle, un groupe pyridazinyle, un groupe pyrimidinyle, un groupe triazinyle, un groupe quinolinyle, un groupe isoquinolinyle, un groupe naphthyridinyle, un groupe quinoxalinyle, un groupe quinazolinyle, $-C(Q_{21})(Q_{22})(Q_{23})$, $-Si(Q_{21})(Q_{22})(Q_{23})$, $-B(Q_{21})(Q_{22})$, $-N(Q_{21})(Q_{22})$, $-S(=O)(Q_{21})$, $-S(=O)_2(Q_{21})$, $-P(=O)(Q_{21})(Q_{22})$ et $-P(=S)(Q_{21})(Q_{22})$.

**8.** Dispositif organique d'émission de lumière (10, 20, 30, 40) selon l'une quelconque des revendications 1 à 7, dans lequel le deuxième composé est représenté par la formule 2-1 ou la formule 2-2 :

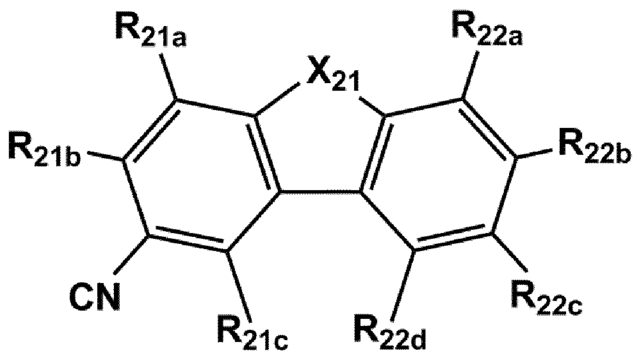

**2-1**

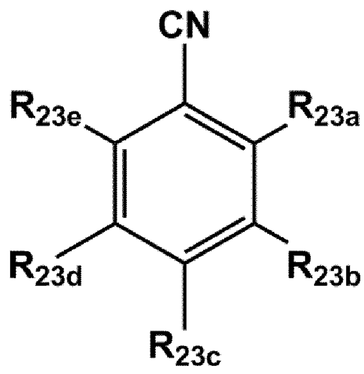

**2-2**

où, dans les formules 2-1 et 2-2,
$X_{21}$ est choisi parmi O, S, $N(R_{24})$ et $C(R_{24})(R_{25})$,
$R_{21a}$ à $R_{21c}$, $R_{22a}$ à $R_{22d}$, $R_{23a}$ à $R_{23e}$, $R_{24}$ et $R_{25}$ sont chacun indépendamment choisis parmi :

un groupe représenté par $*-(L_{21})_{a21}-A_{21}$, un hydrogène, un deutérium, -F, un groupe cyano, un groupe alkyle en $C_1$-$C_{60}$, un groupe cyclique contenant de l'azote appauvri en électrons $\pi$, un groupe cyclique sans azote appauvri en électrons $\pi$, $-C(Q_1)(Q_2)(Q_3)$, $-Si(Q_1)(Q_2)(Q_3)$, $-B(Q_1)(Q_2)$, $-N(Q_1)(Q_2)$, $-S(=O)(Q_1)$, $-S(=O)_2(Q_1)$, $-P(=O)(Q_1)(Q_2)$ et $-P(=S)(Q_1)(Q_2)$ ;
un groupe cyclique contenant de l'azote appauvri en électrons $\pi$ et un groupe cyclique sans azote appauvri en électrons $\pi$, chacun substitué par au moins l'un choisi parmi un deutérium, -F, un groupe cyano, un groupe alkyle en $C_1$-$C_{60}$, un groupe cyclique contenant de l'azote appauvri en électrons $\pi$, un groupe cyclique sans azote appauvri en électrons $\pi$, $-C(Q_{31})(Q_{32})(Q_{33})$, $-Si(Q_{31})(Q_{32})(Q_{33})$, $-B(Q_{31})(Q_{32})$, $-N(Q_{31})(Q_{32})$, $-S(=O)(Q_{31})$, $-S(=O)_2(Q_{31})$, $-P(=O)(Q_{31})(Q_{32})$ et $-P(=S)(Q_{31})(Q_{32})$ ; et
un groupe cyclique contenant de l'azote appauvri en électrons $\pi$ et un groupe cyclique sans azote appauvri en électrons $\pi$, chacun substitué par au moins l'un choisi parmi un groupe cyclique contenant de l'azote appauvri en électrons $\pi$ et un groupe cyclique sans azote appauvri en électrons $\pi$ qui sont chacun indépendamment substitués par au moins l'un choisi parmi un deutérium, -F, un groupe cyano, un groupe alkyle en $C_1$-$C_{60}$, un groupe cyclique contenant de l'azote appauvri en électrons $\pi$, un groupe cyclique sans azote appauvri en électrons $\pi$, $-C(Q_{21})(Q_{22})(Q_{23})$, $-Si(Q_{21})(Q_{22})(Q_{23})$, $-B(Q_{21})(Q_{22})$, $-N(Q_{21})(Q_{22})$, $-S(=O)(Q_{21})$, $-S(=O)_2(Q_{21})$, $-P(=O)(Q_{21})(Q_{22})$ et $-P(=S)(Q_{21})(Q_{22})$,

au moins l'un parmi $R_{21a}$ à $R_{21c}$, $R_{22a}$ à $R_{22d}$, $R_{24}$ et $R_{25}$ dans la formule 2-1 est le groupe représenté par $*-(L_{21})_{a21}-A_{21}$,

au moins l'un choisi parmi $R_{23a}$ à $R_{23e}$ dans la formule 2-2 est le groupe représenté par $*-(L_{21})_{a21}-A_{21}$,

b41 à b43 sont chacun indépendamment un entier de 0 à 10, et

$Q_1$ à $Q_3$, $Q_{21}$ à $Q_{23}$ et $Q_{31}$ à $Q_{33}$ sont chacun indépendamment choisis parmi un hydrogène, un deutérium, -F, -Cl, -Br, -I, un groupe hydroxyle, un groupe cyano, un groupe nitro, un groupe amidino, un groupe hydrazino, un groupe hydrazono, un groupe alkyle en $C_1$-$C_{60}$, un groupe alcényle en $C_2$-$C_{60}$, un groupe alcynyle en $C_2$-$C_{60}$, un groupe alkoxy en $C_1$-$C_{60}$, un groupe cycloalkyle en $C_3$-$C_{10}$, un groupe hétérocycloalkyle en $C_1$-$C_{10}$, un groupe cycloalcényle en $C_3$-$C_{10}$, un groupe hétérocycloalcényle en $C_1$-$C_{10}$, un groupe aryle en $C_6$-$C_{60}$, un groupe aryloxy en $C_6$-$C_{60}$, un groupe arylthio en $C_6$-$C_{60}$, un groupe hétéroaryle en $C_1$-$C_{60}$, un groupe hétéroaryloxy en $C_1$-$C_{60}$, un groupe hétéroarylthio en $C_1$-$C_{60}$, un groupe polycyclique condensé non aromatique monovalent, un groupe hétéropolycyclique condensé non aromatique monovalent, un groupe biphényle et un groupe terphényle.

**9.** Dispositif organique d'émission de lumière (10, 20, 30, 40) selon l'une quelconque des revendications 1 à 8, dans lequel le troisième composé est représenté par la formule 3-1 ou la formule 3-2 :

<Formule 3-1>

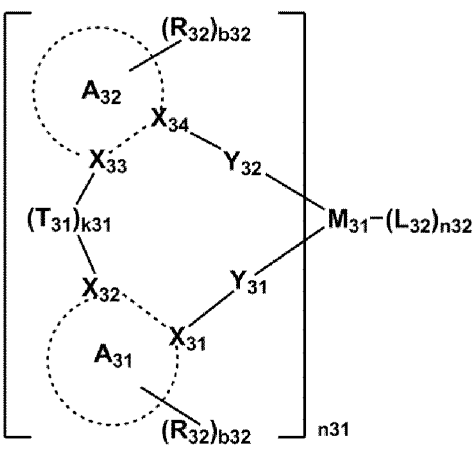

<Formule 3-2>

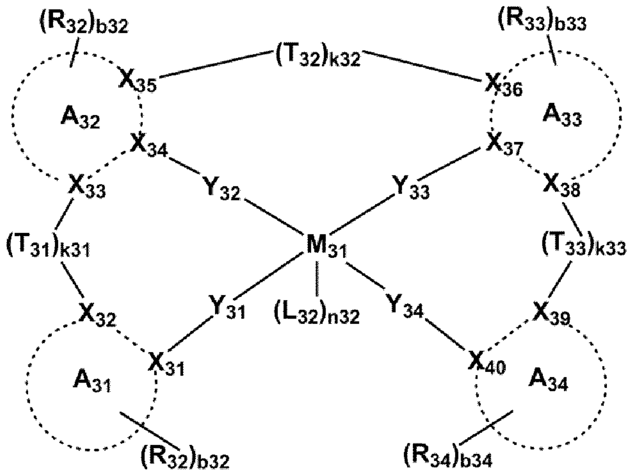

où, dans les formules 3-1 et 3-2,

$X_{31}$ à $X_{40}$ sont chacun indépendamment choisis parmi N et C, et

$M_{31}$, $A_{31}$ à $A_{34}$, $R_{32}$ à $R_{34}$, b32 à b34, $Y_{31}$ à $Y_{34}$, $T_{31}$ à $T_{33}$, k31 à k33, $L_{32}$, n31 et n32 sont chacun identiques à ceux respectivement définis en rapport avec la formule 3.

**10.** Dispositif organique d'émission de lumière (10, 20, 30, 40), dans lequel :

le premier composé est choisi parmi les composés du groupe I,

le deuxième composé est choisi parmi les composés du groupe II,

le troisième composé est choisi parmi les composés du groupe III-I et du groupe III-II, et

le quatrième composé est choisi parmi les composés du groupe IV :

<Groupe I>

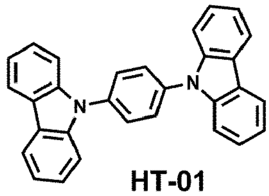
HT-01

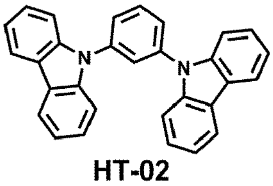
HT-02

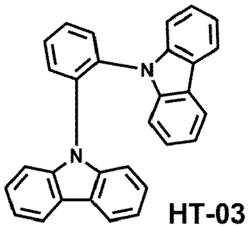
HT-03

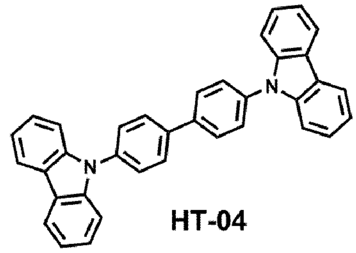
HT-04

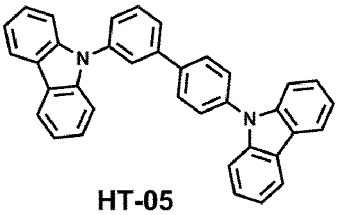
HT-05

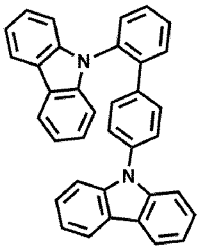
HT-06

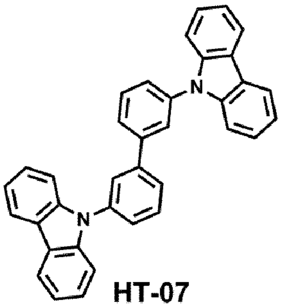
HT-07

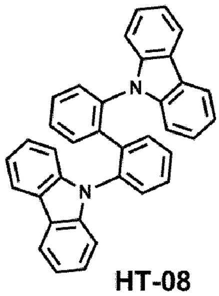
HT-08

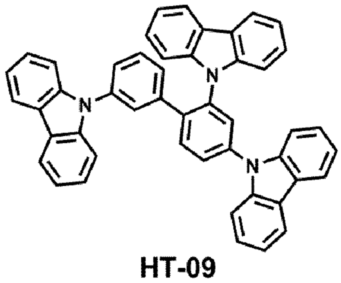
HT-09

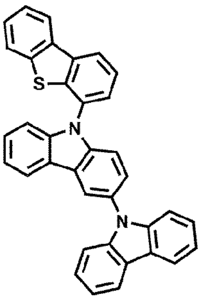
HT-10

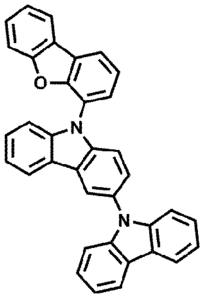
HT-11

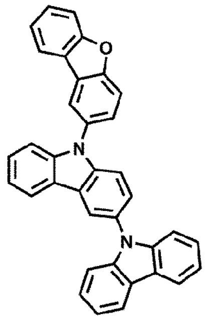
HT-12

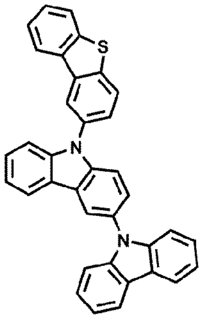
HT-13

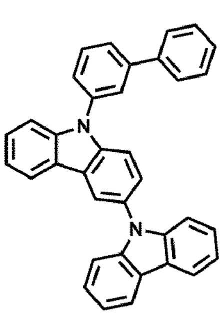
HT-14

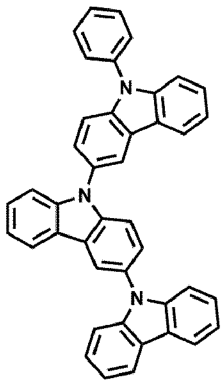
HT-15

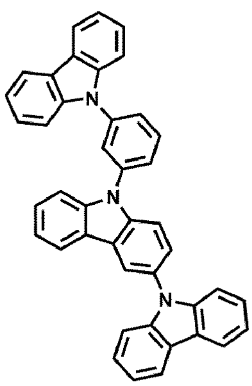
HT-16

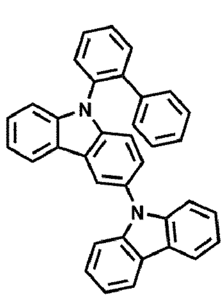
HT-17

<Groupe II>

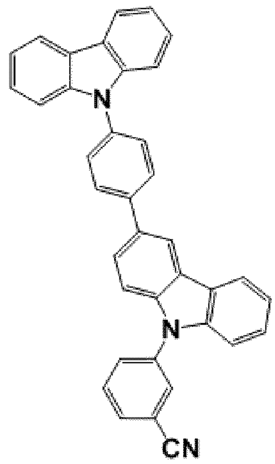

ET-1

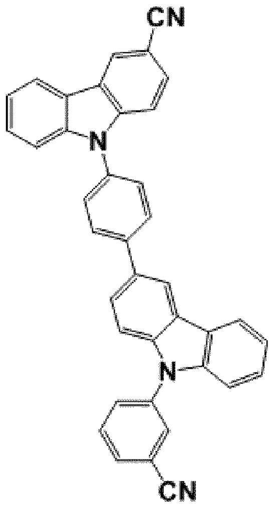

ET-2

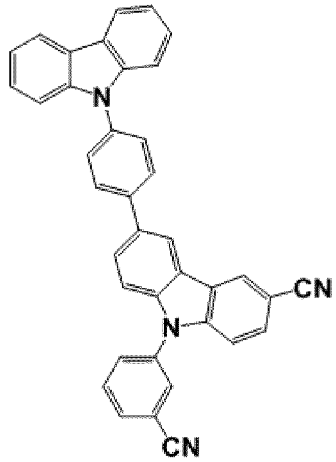

ET-3

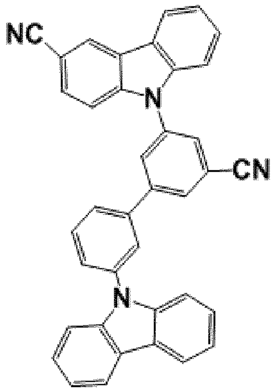

ET-4

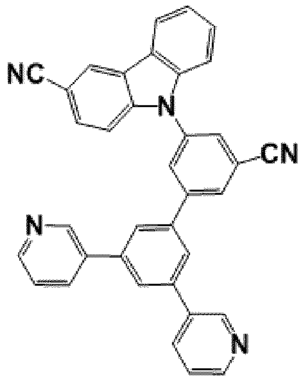

ET-5

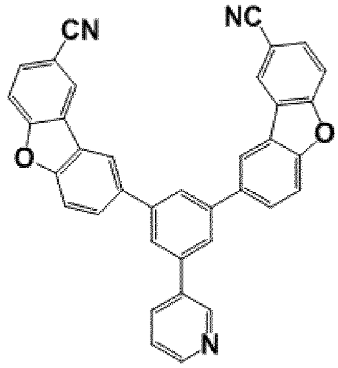

ET-6

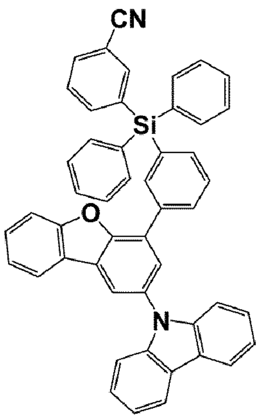

ET-7

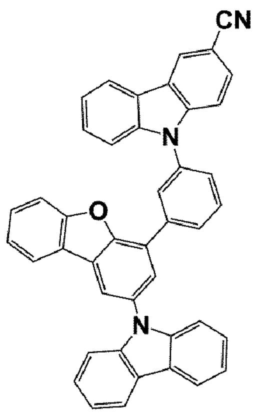

ET-8

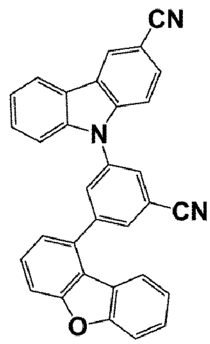

ET-9

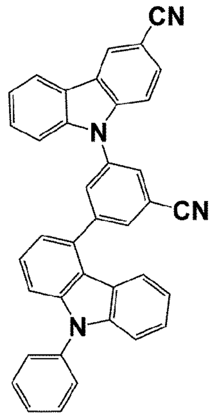

ET-10

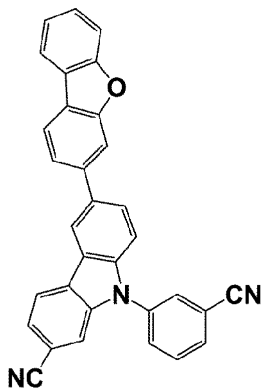

ET-11

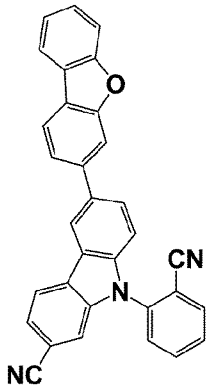

ET-12

<Groupe III-I>

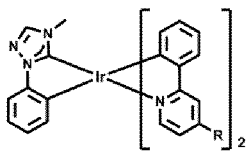

1 (R = H)
2 (R = Me)
3 (R = *iso*-Pr)
4 (R = *tert*-Bu)
5 (R = $NMe_2$)

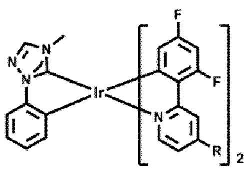

6 (R = H)
7 (R = Me)
8 (R = *iso*-Pr)
9 (R = *tert*-Bu)
10 (R = $NMe_2$)

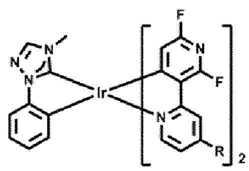

11 (R = H)
12 (R = Me)
13 (R = *iso*-Pr)
14 (R = *tert*-Bu)
15 (R = $NMe_2$)

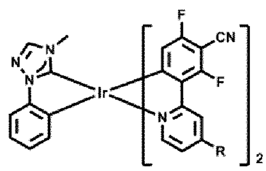

16 (R = H)
17 (R = Me)
18 (R = *iso*-Pr)
19 (R = *tert*-Bu)
20 (R = $NMe_2$)

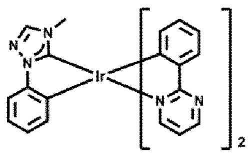

21

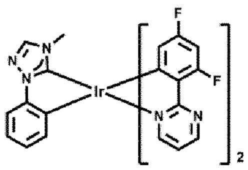

22

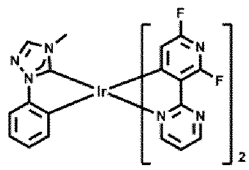

23

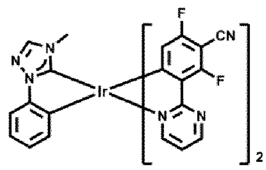

24

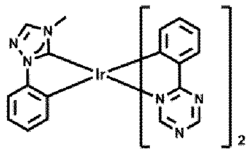

25

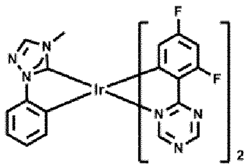

26

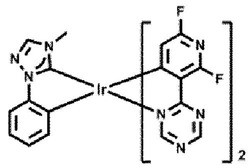

27

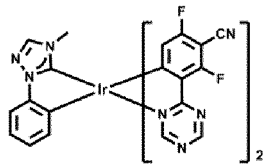

28

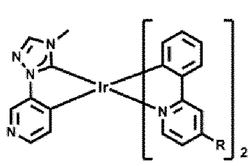

29 (R = H)
30 (R = Me)
31 (R = *iso*-Pr)
32 (R = *tert*-Bu)
33 (R = $NMe_2$)

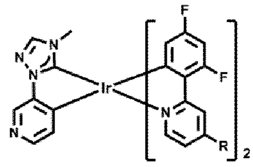

34 (R = H)
35 (R = Me)
36 (R = *iso*-Pr)
37 (R = *tert*-Bu)
38 (R = $NMe_2$)

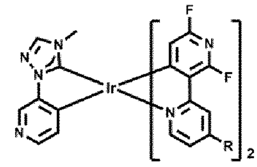

39 (R = H)
40 (R = Me)
41 (R = *iso*-Pr)
42 (R = *tert*-Bu)
43 (R = $NMe_2$)

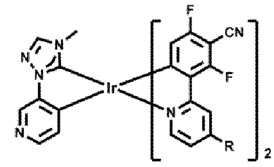

44 (R = H)
45 (R = Me)
46 (R = *iso*-Pr)
47 (R = *tert*-Bu)
48 (R = $NMe_2$)

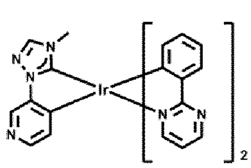

49

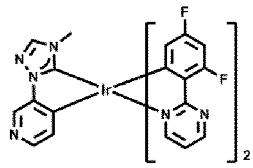

50

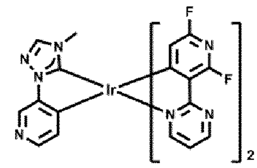

51

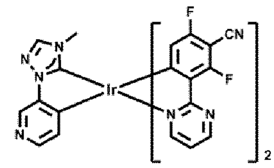

52

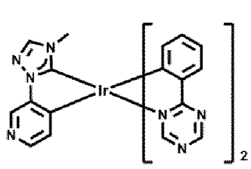

53

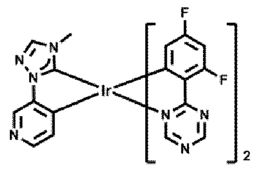

54

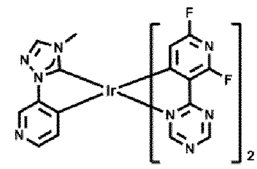

55

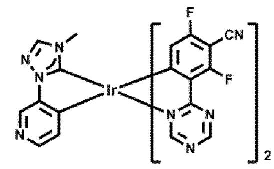

56

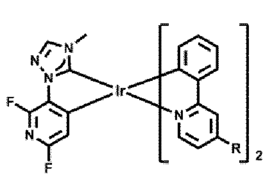

57 (R = H)
58 (R = Me)
59 (R = *iso*-Pr)
60 (R = *tert*-Bu)
61 (R = $NMe_2$)

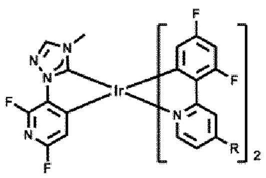

62 (R = H)
63 (R = Me)
64 (R = *iso*-Pr)
65 (R = *tert*-Bu)
66 (R = $NMe_2$)

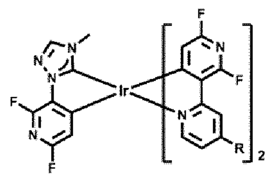

67 (R = H)
68 (R = Me)
69 (R = *iso*-Pr)
70 (R = *tert*-Bu)
71 (R = $NMe_2$)

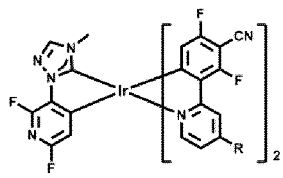

72 (R = H)
73 (R = Me)
74 (R = *iso*-Pr)
75 (R = *tert*-Bu)
76 (R = $NMe_2$)

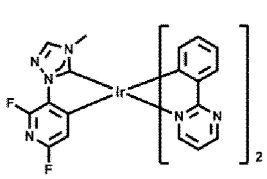

77

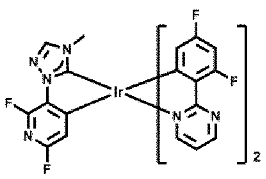

78

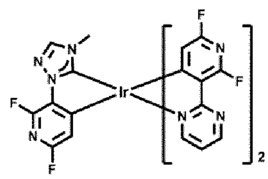

79

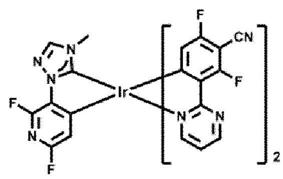

80

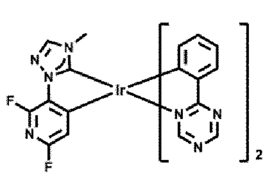

81

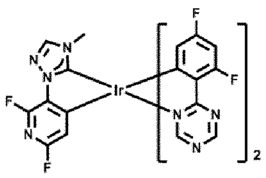

82

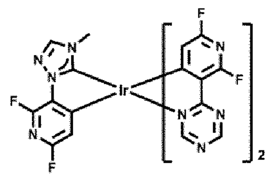

83

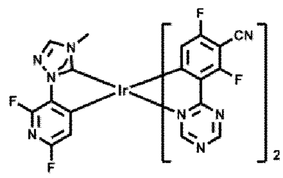

84

<Groupe III-2>

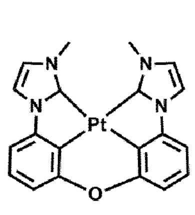

PD1

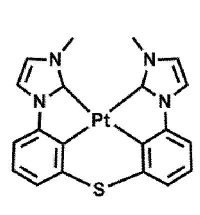

PD2

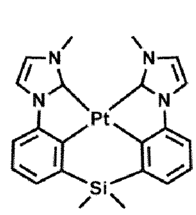

PD3

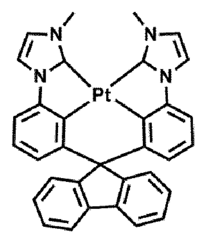

PD4

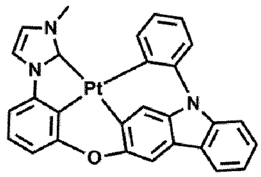

PD5

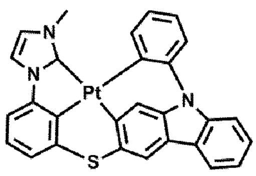

PD6

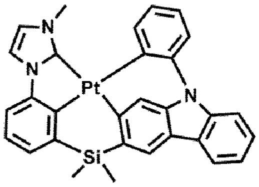

PD7

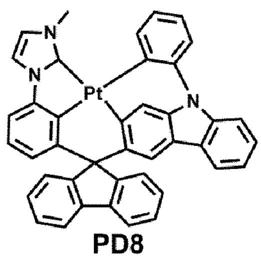

PD8

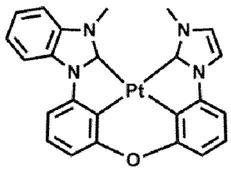

PD9

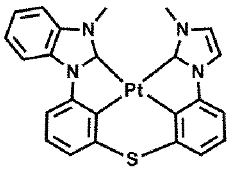

PD10

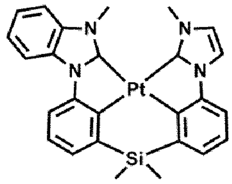

PD11

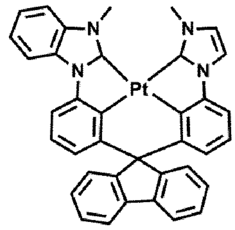

PD12

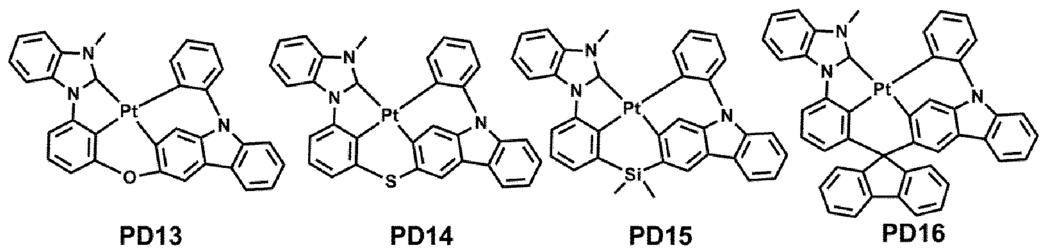

PD13 PD14 PD15 PD16

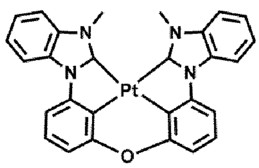

PD17

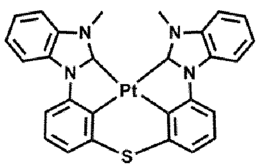

PD18

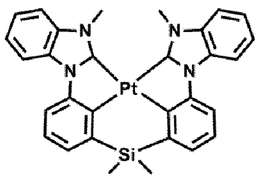

PD19

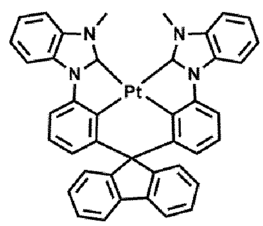

PD20

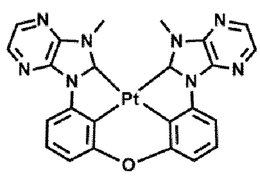

PD21

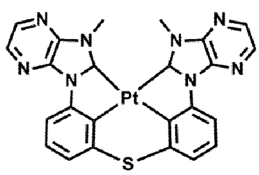

PD22

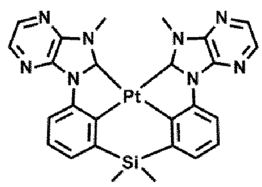

PD23

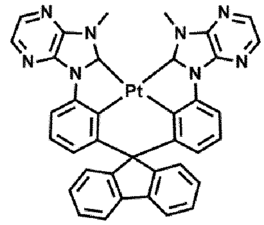

PD24

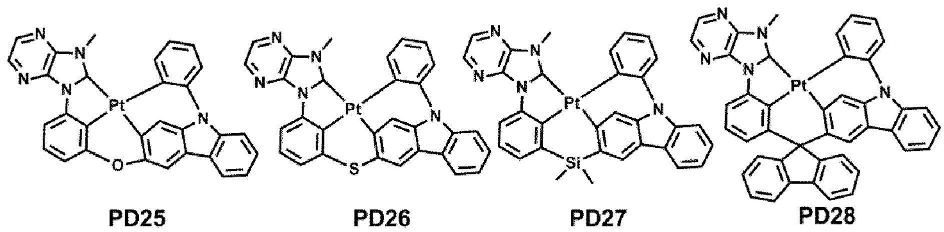

PD25 PD26 PD27 PD28

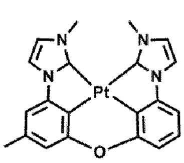

PD29

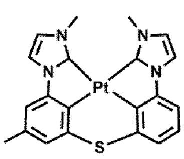

PD30

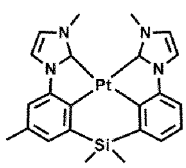

PD31

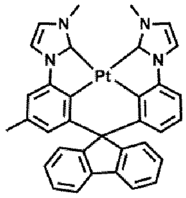

PD32

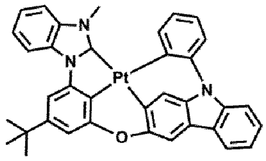

PD33

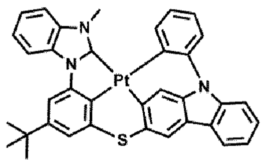

PD34

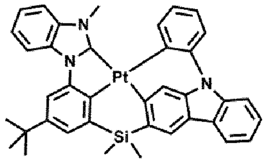

PD35

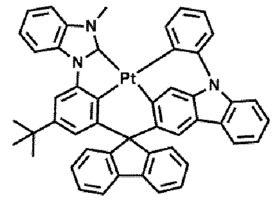

PD36

<Groupe IV>

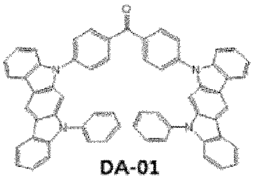

DA-01

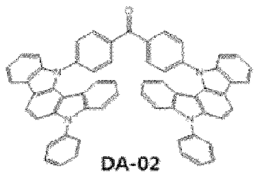

DA-02

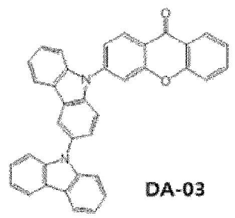

DA-03

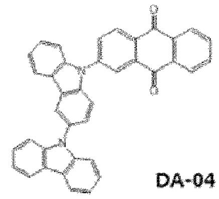

DA-04

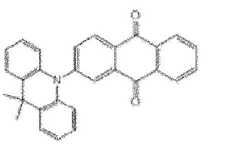

DA-05

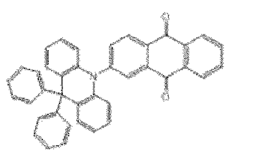

DA-06

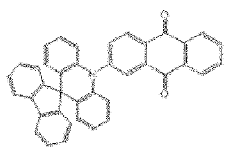

DA-07

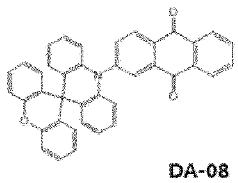

DA-08

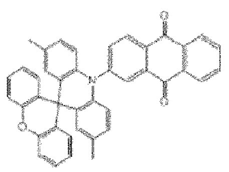

DA-09

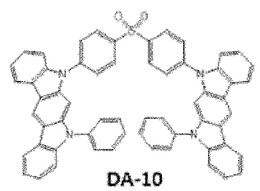

DA-10

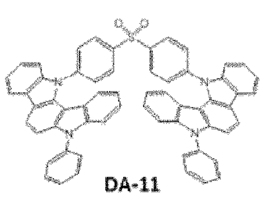

DA-11

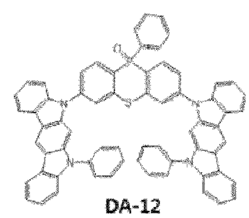

DA-12

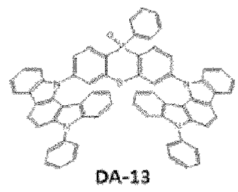
DA-13

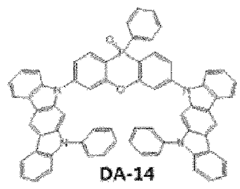
DA-14

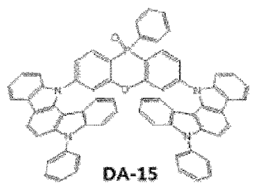
DA-15

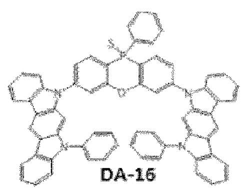
DA-16

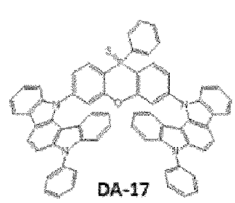
DA-17

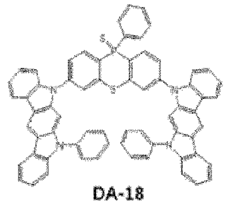
DA-18

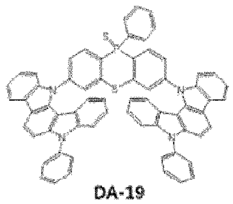
DA-19

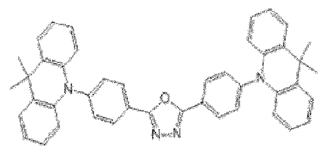
DA-20

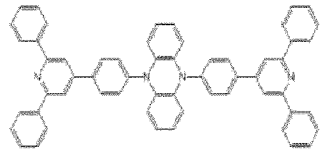
DA-21

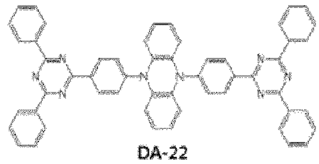
DA-22

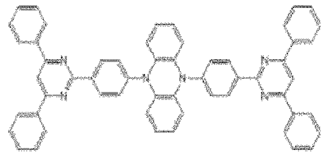
DA-23

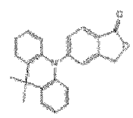
DA-24

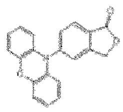
DA-25

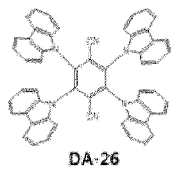
DA-26

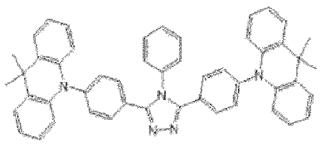
DA-27

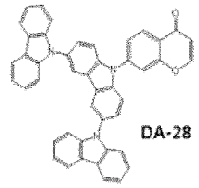
DA-28

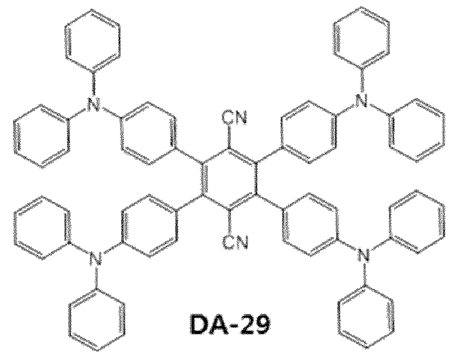
DA-29

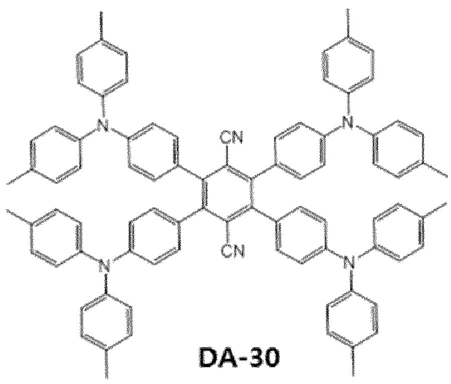
DA-30

**11.** Dispositif organique d'émission de lumière (10, 20, 30, 40), selon l'une quelconque des revendications 1 à 10, dans lequel :

la première électrode (110) est une anode,
la seconde électrode (190) est une cathode,
la couche organique (150) comprend en outre une région de transport de trous entre la première électrode (110) et la couche d'émission et/ou une région de transport d'électrons entre la couche d'émission et la seconde électrode (190),
la région de transport de trous comprend une couche d'injection de trous, une couche de transport de trous, une couche auxiliaire d'émission et/ou une couche de blocage d'électrons, et
la région de transport d'électrons comprend une couche de blocage de trous, une couche de transport d'électrons et/ou une couche d'injection d'électrons, facultativement dans laquelle la couche de blocage de trous comprend un matériau de blocage de trous représenté par la formule 2A ou la formule 2B :

<Formule 2A>

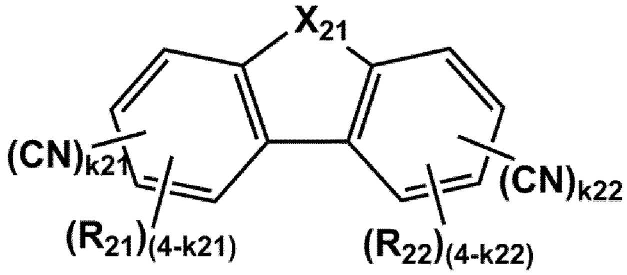

<Formule 2B>

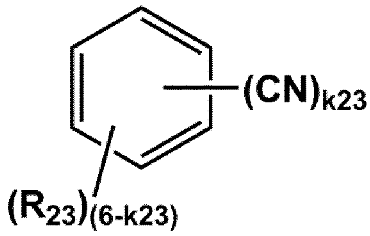

dans lequel, dans les formules 2A et 2B,
$X_{21}$ est choisi parmi O, S, $N(R_{24})$ et $C(R_{24})(R_{25})$,
k21 et k22 sont chacun indépendamment choisis parmi 0, 1, 2, 3 et 4, où la somme de k21 et k22 vaut 1 ou plus,
k23 est choisi parmi 1, 2, 3, 4, 5 et 6,
$R_{21}$ à $R_{25}$ sont chacun indépendamment choisis parmi :

un groupe représenté par $*-(L_{21})_{a21}-A_{21}$, un hydrogène, un deutérium, -F, un groupe cyano, un groupe alkyle en $C_1$-$C_{60}$, un groupe cyclique contenant de l'azote appauvri en électrons π, un groupe cyclique sans azote appauvri en électrons π, $-C(Q_1)(Q_2)(Q_3)$, $-Si(Q_1)(Q_2)(Q_3)$, $-B(Q_1)(Q_2)$, $-N(Q_1)(Q_2)$, $-S(=O)(Q_1)$, $-S(=O)_2(Q_1)$, $-P(=O)(Q_1)(Q_2)$ et $-P(=S)(Q_1)(Q_2)$ ;
un groupe cyclique contenant de l'azote appauvri en électrons π et un groupe cyclique sans azote appauvri en électrons π, chacun substitué par au moins l'un choisi parmi un deutérium, -F, un groupe cyano, un groupe alkyle en $C_1$-$C_{60}$, un groupe cyclique contenant de l'azote appauvri en électrons π, un groupe cyclique sans azote appauvri en électrons π, $-C(Q_{31})(Q_{32})(Q_{33})$, $-Si(Q_{31})(Q_{32})(Q_{33})$, $-B(Q_{31})(Q_{32})$, $-N(Q_{31})(Q_{32})$, $-S(=O)(Q_{31})$, $-S(=O)_2(Q_{31})$, $-P(=O)(Q_{31})(Q_{32})$ et $-P(=S)(Q_{31})(Q_{32})$ ; et
un groupe cyclique contenant de l'azote appauvri en électrons π et un groupe cyclique sans azote appauvri en électrons π, chacun substitué par au moins l'un choisi parmi un groupe cyclique contenant de l'azote appauvri en électrons π et un groupe cyclique sans azote appauvri en électrons π qui sont chacun substitués par au moins l'un choisi parmi un deutérium, -F, un groupe cyano, un groupe alkyle en $C_1$-$C_{60}$, un groupe cyclique contenant de l'azote appauvri en électrons π, un groupe cyclique sans azote appauvri en électrons π, $-C(Q_{21})(Q_{22})(Q_{23})$, $-Si(Q_{21})(Q_{22})(Q_{23})$, $-B(Q_{21})(Q_{22})$, $-N(Q_{21})(Q_{22})$, $-S(=O)(Q_{21})$, $-S(=O)_2(Q_{21})$, $-P(=O)(Q_{21})(Q_{22})$ et $-P(=S)(Q_{21})(Q_{22})$,

$L_{21}$ est choisi parmi :

un groupe cyclique contenant de l'azote appauvri en électrons π, un groupe cyclique sans azote appauvri en électrons π, $-C(Q_1)(Q_2)-$, $-Si(Q_1)(Q_2)-$, $-B(Q_1)-$, $-N(Q_1)-$, $-S(=O)-$, $-S(=O)_2-$, $-P(=O)(Q_1)-$ et $-P(=S)(Q_1)-$ ; et
un groupe cyclique contenant de l'azote appauvri en électrons π et un groupe cyclique sans azote appauvri en électrons π, chacun substitué par au moins l'un choisi parmi un deutérium, -F, un groupe cyano, un groupe alkyle en $C_1$-$C_{60}$, un groupe cyclique contenant de l'azote appauvri en électrons π, un groupe cyclique sans azote appauvri en électrons π, $-C(Q_{31})(Q_{32})(Q_{33})$, $-Si(Q_{31})(Q_{32})(Q_{33})$, $-B(Q_{31})(Q_{32})$, $-N(Q_{31})(Q_{32})$, $-S(=O)(Q_{31})$, $-S(=O)_2(Q_{31})$, $-P(=O)(Q_{31})(Q_{32})$ et $-P(=S)(Q_{31})(Q_{32})$ ;
a21 est choisi parmi 1, 2 et 3,

$A_{21}$ est choisi parmi :

un groupe cyclique contenant de l'azote appauvri en électrons π et un groupe cyclique sans azote appauvri en électrons π,
un groupe cyclique contenant de l'azote appauvri en électrons π et un groupe cyclique sans azote appauvri en électrons π, chacun substitué par au moins l'un choisi parmi un deutérium, -F, un groupe cyano, un groupe alkyle en $C_1$-$C_{60}$, un groupe cyclique contenant de l'azote appauvri en électrons π, un groupe cyclique sans azote appauvri en électrons π, $-C(Q_{31})(Q_{32})(Q_{33})$, $-Si(Q_{31})(Q_{32})(Q_{33})$, $-B(Q_{31})(Q_{32})$, $-N(Q_{31})(Q_{32})$, $-S(=O)(Q_{31})$, $-S(=O)_2(Q_{31})$, $-P(=O)(Q_{31})(Q_{32})$ et $-P(=S)(Q_{31})(Q_{32})$ ; et
un groupe cyclique contenant de l'azote appauvri en électrons π et un groupe cyclique sans azote appauvri en électrons π, chacun substitué par au moins l'un choisi parmi un groupe cyclique contenant de l'azote appauvri en électrons π et un groupe cyclique sans azote appauvri en électrons π qui sont chacun substitués

par au moins l'un choisi parmi un deutérium, -F, un groupe cyano, un groupe alkyle en $C_1$-$C_{60}$, un groupe cyclique contenant de l'azote appauvri en électrons $\pi$, un groupe cyclique sans azote appauvri en électrons $\pi$, -C($Q_{21}$)($Q_{22}$)($Q_{23}$), -Si($Q_{21}$)($Q_{22}$)($Q_{23}$), -B($Q_{21}$)($Q_{22}$), -N($Q_{21}$)($Q_{22}$), -S(=O)($Q_{21}$), -S(=O)$_2$($Q_{21}$), -P(=O)($Q_{21}$)($Q_{22}$) et -P(=S)($Q_{21}$)($Q_{22}$), et

$Q_1$ à $Q_3$, $Q_{21}$ à $Q_{23}$ et $Q_{31}$ à $Q_{33}$ sont chacun indépendamment choisis parmi un hydrogène, un deutérium, -F, -Cl, -Br, -I, un groupe hydroxyle, un groupe cyano, un groupe nitro, un groupe amidino, un groupe hydrazino, un groupe hydrazono, un groupe alkyle en $C_1$-$C_{60}$, un groupe alcényle en $C_2$-$C_{60}$, un groupe alcynyle en $C_2$-$C_{60}$, un groupe alkoxy en $C_1$-$C_{60}$, un groupe cycloalkyle en $C_3$-$C_{10}$, un groupe hétérocycloalkyle en $C_1$-$C_{10}$, un groupe cycloalcényle en $C_3$-$C_{10}$, un groupe hétérocycloalcényle en $C_1$-$C_{10}$, un groupe aryle en $C_6$-$C_{60}$, un groupe aryloxy en $C_6$-$C_{60}$, un groupe arylthio en $C_6$-$C_{60}$, un groupe hétéroaryle en $C_1$-$C_{60}$, un groupe hétéroaryloxy en $C_1$-$C_{60}$, un groupe hétéroarylthio en $C_1$-$C_{60}$, un groupe polycyclique condensé non aromatique monovalent, un groupe hétéropolycyclique condensé non aromatique monovalent, un groupe biphényle et un groupe terphényle.

**12.** Appareil comprenant :

un transistor en couches minces comprenant une électrode source, une électrode drain et une couche d'activation ;

une pièce d'étanchéité ; et

le dispositif organique d'émission de lumière (10, 20, 30, 40) selon l'une quelconque des revendications 1 à 11, dans lequel la première électrode (110) du dispositif organique d'émission de lumière (10, 20, 30, 40) est électriquement connectée à l'électrode source ou l'électrode drain du transistor en couches minces.

FIG. 1

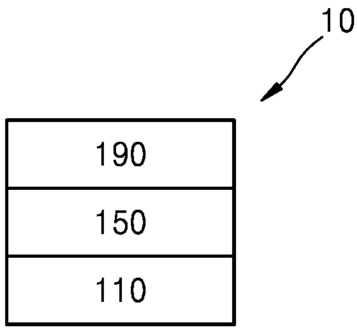


FIG. 2

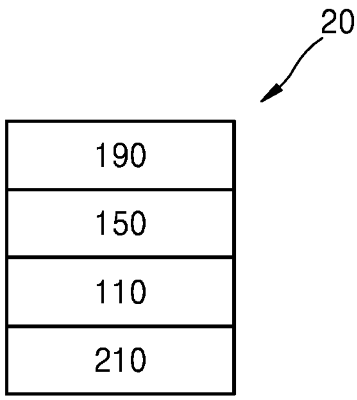

FIG. 3

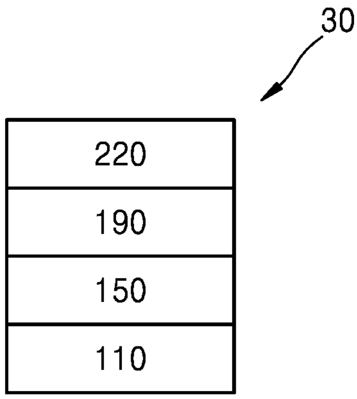


FIG. 4

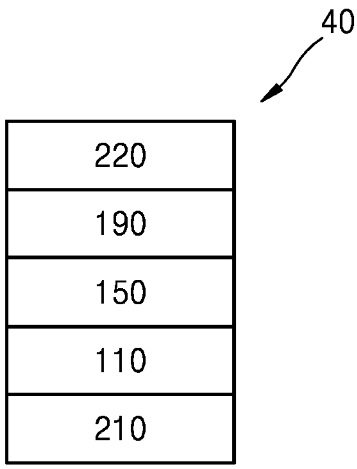

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 2018033987 A1
- WO 2019128105 A1
- EP 3800679 A1